(19) Europäisches Patentamt
European Patent Office
Office européen des brevets

(11) EP 4 711 374 A2

# (12) EUROPEAN PATENT APPLICATION

(43) Date of publication:
**18.03.2026 Bulletin 2026/12**

(21) Application number: **25199600.5**

(22) Date of filing: **02.09.2025**

(51) International Patent Classification (IPC):
***C07F 15/00*** *(2006.01)* ***C07B 59/00*** *(2006.01)*
***C09K 11/06*** *(2006.01)* ***H10K 50/11*** *(2023.01)*
***H10K 85/30*** *(2023.01)*

(52) Cooperative Patent Classification (CPC):
**C07F 15/0086; C07B 59/004; C09K 11/06; H10K 50/11; H10K 85/342**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **13.09.2024 KR 20240126173**

(71) Applicant: **Samsung Display Co., Ltd.**
**Yongin-si, Gyeonggi-do 17113 (KR)**

(72) Inventors:
- **BAE, Hyejin**
  **16678 Suwon-si (KR)**
- **KIM, Hwang Suk**
  **16678 Suwon-si (KR)**
- **MIN, Minsik**
  **16678 Suwon-si (KR)**
- **CHUNG, Yeon Sook**
  **16678 Suwon-si (KR)**
- **CHOI, Hyesung**
  **16678 Suwon-si (KR)**
- **HEO, Joon**
  **16678 Suwon-si (KR)**
- **KANG, Hosuk**
  **16678 Suwon-si (KR)**
- **KIM, Jong Soo**
  **16678 Suwon-si (KR)**
- **SON, Youngmok**
  **16678 Suwon-si (KR)**
- **WON, Joonghee**
  **16678 Suwon-si (KR)**
- **LEE, Yeonkyung**
  **16678 Suwon-si (KR)**
- **JU, Kyeongsik**
  **16678 Suwon-si (KR)**

(74) Representative: **Elkington and Fife LLP**
**Prospect House**
**8 Pembroke Road**
**Sevenoaks, Kent TN13 1XR (GB)**

## (54) ORGANOMETALLIC COMPOUND AND ORGANIC LIGHT-EMITTING DEVICE INCLUDING THE SAME

(57) Provided are an organometallic compound represented by Formula 1 and an organic light-emitting device including the same. In Formula 1, $M_1$ is a transition metal, $L_{11}$ is a ligand represented by Formula 1-1, $L_{12}$ is an organic ligand, n11 is 1, n12 is 0, 1, or 2, and descriptions for other substituent are provided in the specification:

Formula 1 $M_1(L_{11})_{n11}(L_{12})_{n12}$

EP 4 711 374 A2

Formula 1-1

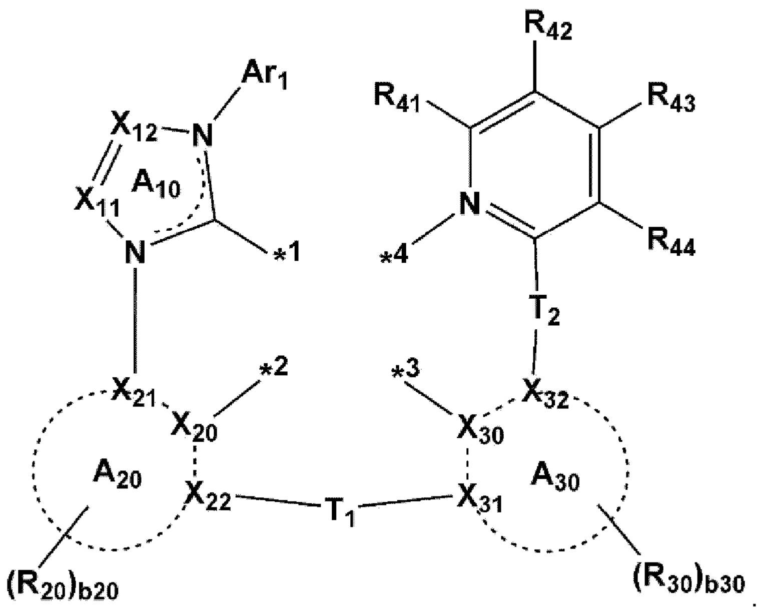

FIG. 1

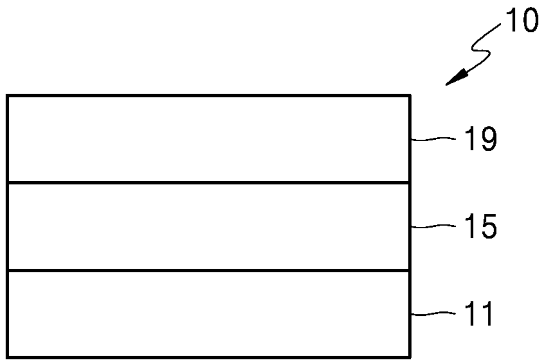

**Description**

FIELD OF THE INVENTION

The disclosure relates to an organometallic compound and an organic light-emitting device including the same.

BACKGROUND OF THE INVENTION

Organic light-emitting devices are self-emissive devices that have excellent characteristics in terms of viewing angles, response time, brightness, driving voltage, response speed, and the like, and produce full-color images.

For example, an organic light-emitting device includes an anode, a cathode, and an organic layer between the anode and the cathode, wherein the organic layer includes an emission layer. A hole transport region may be provided between the anode and the emission layer, and an electron transport region may be provided between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. When the excitons transition from an excited state to a ground state, light is emitted.

SUMMARY OF THE INVENTION

Provided are a novel organometallic compound and an organic light-emitting device using the same.

Additional aspects will be set forth in part in the description which follows and, in part, will be apparent from the description, or may be learned by practice of the presented embodiments of the disclosure.

According to an aspect of the disclosure, provided is an organometallic compound represented by Formula 1:

Formula 1 M1(L11)n11(L12)n12

wherein, in Formula 1,

$M_1$ may be a transition metal,
$L_{11}$ may be a ligand represented by Formula 1-1,
$L_{12}$ may be an organic ligand,
n11 may be 1,
n12 may be 0, 1, or 2,

Formula 1-1

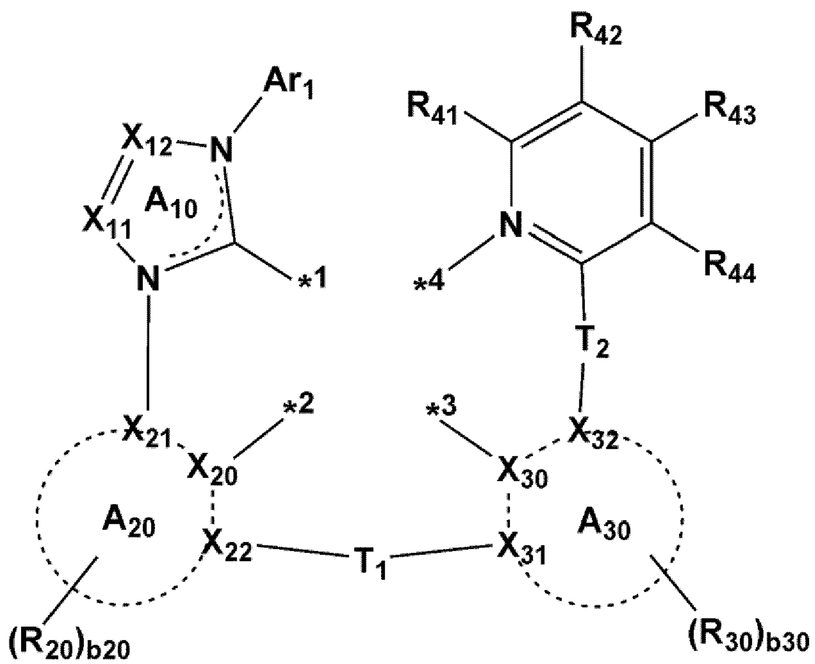

wherein, in Formula 1-1,
*1 to *4 each indicate a binding site to $M_1$,
$A_{10}$ may be an N-containing heterocyclic group,
$A_{20}$ and $A_{30}$ may each independently be a $C_5$-$C_{30}$ carbocyclic group or a $C_1$-$C_{30}$ heterocyclic group,
$T_1$ may be a single bond, *-N($R_1$)-*', *-B($R_1$)-*', *-P($R_1$)-*', *-C($R_1$)($R_2$)-*', *-Si($R_1$)($R_2$)-*', *-Ge($R_1$)($R_2$)-*', *-S-*', *-Se-*', *-O-*', *-C(=O)-*', *-S(=O)-*', *-S(=O)$_2$-*', *-C($R_1$)=C($R_2$)-*', *-C(=S)-*', or *-C=C-*',
$T_2$ may be a single bond, *-N($R_3$)-*', *-B($R_3$)-*', *-P($R_3$)-*', *-C($R_3$)($R_4$)-*', *-Si($R_3$)($R_4$)-*', *-Ge($R_3$)($R_4$)-*', *-S-*', *-Se-*', *-O-*', *-C(=O)-*', *-S(=O)-*', *-S(=O)$_2$-*', *-C($R_3$)=C($R_4$)-*', *-C(=S)-*', or *-C=C-*',
$X_{11}$ may be C($R_{11}$) or N, and $X_{12}$ may be C($R_{12}$) or N,
$X_{20}$ may be C or N, and $X_{30}$ may be C or N,
$X_{21}$, $X_{22}$, $X_{31}$, and $X_{32}$ may each independently be C or N,
$Ar_1$ may be a group represented by Formula 2,

Formula 2

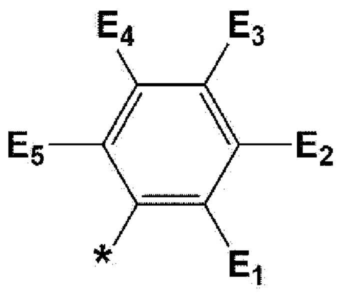

wherein, in Formula 2,
$E_1$ and $E_5$ may each independently be deuterium, -F, -Cl, -Br, -I, -SF$_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), or -P(=O)($Q_8$)($Q_9$),
$E_2$ to $E_4$ may each independently be hydrogen, deuterium, -F, -Cl, -Br, -I, -SF$_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), or -P(=O)($Q_8$)($Q_9$),
* indicates a binding site to a neighboring atom,
$Ar_1$ may have an asymmetric structure,
$R_{11}$ and $R_{12}$ may each independently be hydrogen, deuterium, -F, -Cl, -Br, -I, - SF$_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group,

a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$),-Si($Q_3$)($Q_4$)($Q_5$), -Ge($Q_3$)($Q_4$)($Q_5$), -B($Q_6$)($Q_7$), or -P(=O)($Q_8$)($Q_9$),

$R_{11}$ and $R_{12}$ may optionally be bonded to each other to form a $C_5$-$C_{30}$ carbocyclic group unsubstituted or substituted with at least one $R_{10}$ or a $C_1$-$C_{30}$ heterocyclic group unsubstituted or substituted with at least one $R_{10}$,

$R_1$ to $R_4$, $R_{10}$, $R_{20}$, $R_{30}$, $R_{41}$, and $R_{44}$ may each independently be hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), or - P(=O)($Q_8$)($Q_9$),

at least two neighboring groups among $R_1$ to $R_4$, $R_{10}$, $R_{20}$, $R_{30}$, $R_{41}$, and $R_{44}$ may optionally be bonded together to form a substituted or unsubstituted $C_5$-$C_{30}$ carbocyclic group or a substituted or unsubstituted $C_1$-$C_{30}$ heterocyclic group,

at least two of $R_{20}$ in the number of b20 may optionally be linked together to form a substituted or unsubstituted $C_5$-$C_{30}$ carbocyclic group or a substituted or unsubstituted $C_1$-$C_{30}$ heterocyclic group,

at least two of $R_{30}$ in the number of b30 may optionally be linked together to form a substituted or unsubstituted $C_5$-$C_{30}$ carbocyclic group or a substituted or unsubstituted $C_1$-$C_{30}$ heterocyclic group,

b20 and b30 may each independently be 1, 2, 3, 4, 5, 6, 7, 8, 9, or 10,

when b20 is 2 or more, two or more of $R_{20}$ may be identical to or different from each other, and when b30 is 2 or more, two or more of $R_{30}$ may be identical to or different from each other,

$R_{42}$ may be a substituted or unsubstituted $C_1$-$C_{60}$ alkyl group, and may have a molecular weight of 18 g/mol or more,

$R_{43}$ may be deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), - Ge($Q_3$)($Q_4$)($Q_5$), -B($Q_6$)($Q_7$), or -P(=O)($Q_8$)($Q_9$),

at least one of $R_{42}$ and $R_{43}$ may have a molecular weight of 19 g/mol or more,

substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may each independently be

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group,

a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each substituted with deuterium, -F, -Cl, -Br, - **I,** -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a

$C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{11}$)($Q_{12}$),-Si($Q_{13}$)($Q_{14}$)($Q_{15}$), -Ge($Q_{13}$)($Q_{14}$)($Q_{15}$), -B($Q_{16}$)($Q_{17}$), -P(=O)($Q_{18}$)($Q_{19}$), or a combination thereof,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group,

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{19}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{21}$)($Q_{22}$), -Si($Q_{23}$)($Q_{24}$)($Q_{25}$),-Ge($Q_{23}$)($Q_{24}$)($Q_{25}$), -B($Q_{26}$)($Q_{27}$), -P(=O)($Q_{28}$)($Q_{29}$), or a combination thereof, or

-N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$), or-P(=O)($Q_{38}$)($Q_{39}$), and

$Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{19}$ cycloalkenyl group, a $C_1$-$C_{10}$ heterocycloalkenyl group, a $C_6$-$C_{60}$ aryl group, a $C_6$-$C_{60}$ aryl group substituted with a $C_1$-$C_{60}$ alkyl group, a $C_6$-$C_{60}$ aryl group substituted with a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group.

According to another aspect of the disclosure, an organic light-emitting device includes a first electrode, a second electrode, and an organic layer arranged between the first electrode and the second electrode and including an emission layer, wherein the organic layer includes at least one organometallic compound represented by Formula 1.

The emission layer may include the at least one organometallic compound, and the at least one organometallic compound included in the emission layer may act as a dopant.

## BRIEF DESCRIPTION OF THE DRAWINGS

The above and other aspects, features, and advantages of certain embodiments of the disclosure will be more apparent from the following description taken in conjunction with the accompanying drawings in which:

FIG. 1 which is a schematic cross-sectional view of an organic light-emitting device according to an embodiment;
FIG. 2 shows energy transfer according to an embodiment;
FIG. 3 shows energy transfer according to an embodiment; and
FIG. 4 shows energy transfer according to an embodiment.

## DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not

intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 20%, 10%, 5%, or 3% of the stated value.

An aspect of the disclosure provides an organometallic compound represented by Formula 1:

Formula 1 M1(L11)n11(L12)n12

wherein in Formula 1, $M_1$ may be a transition metal.

In an embodiment, $M_1$ in Formula 1 may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In an embodiment, $M_1$ may be Pd, Pt, or Au.

In an embodiment, $M_1$ in Formula 1 may be Pt or Pd.

In an embodiment, $M_1$ in Formula 1 may be Pt.

$L_{11}$ in Formula 1 may be a ligand represented by Formula 1-1:

Formula 1-1

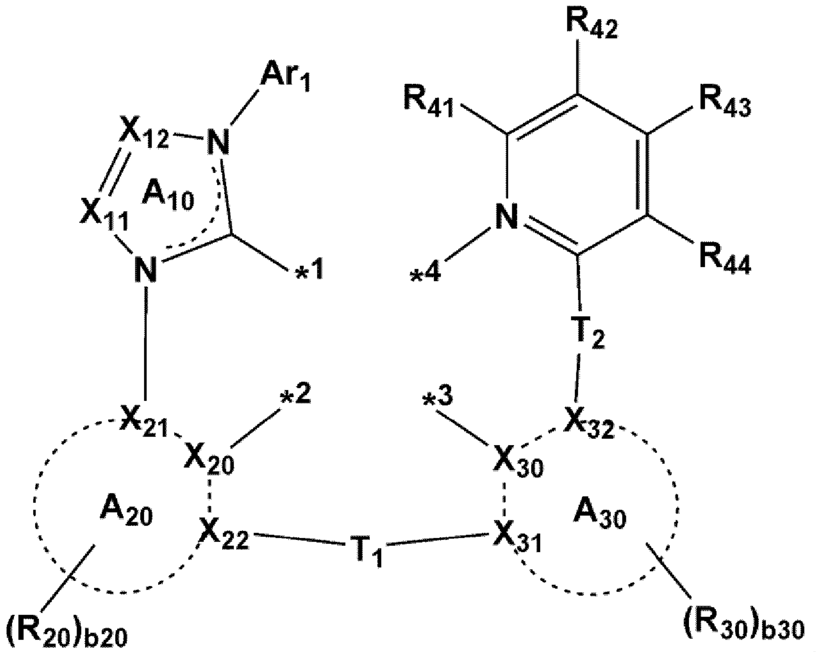

In Formula 1-1, *1 to *4 may each independently be a binding site to $M_1$.

In Formula 1, $A_{20}$ and $A_{30}$ may each independently be a $C_5$-$C_{30}$ carbocyclic group or a $C_1$-$C_{30}$ heterocyclic group.

In an embodiment, $A_{20}$ and $A_{30}$ may each independently be

a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, an indazole group, a benzoxazole group, a benzothiazole group, a benzoxadiazole group, a benzothiadiazole group, a benzotriazole group, a diazaindene group, a triazaindene group, a 5,6,7,8-tetrahydroisoquinoline group, or a 5,6,7,8-tetrahydroquinoline group.

In an embodiment, $A_{10}$ may be a group represented by one of Formulae A10-1 to A10-20:

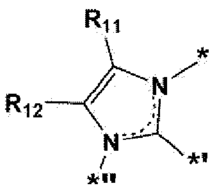

A10-1

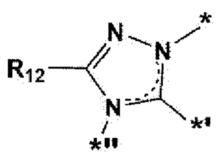

A10-2

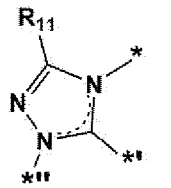

A10-3

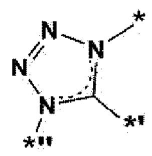

A10-4

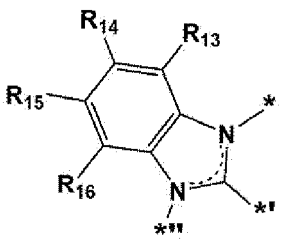
A10-5

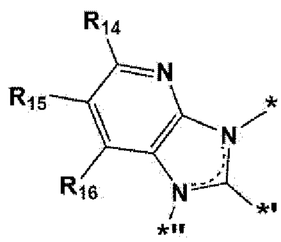
A10-6

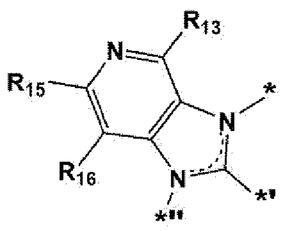
A10-7

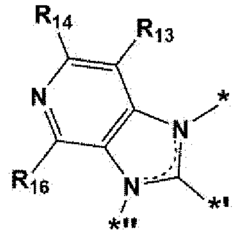
A10-8

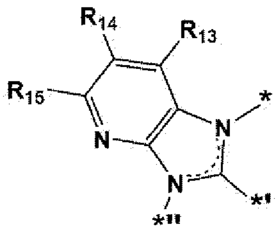
A10-9

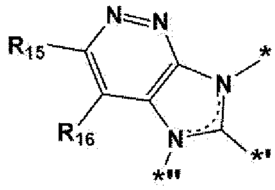
A10-10

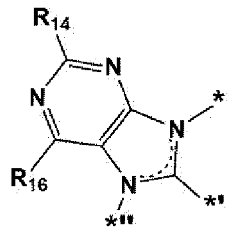
A10-11

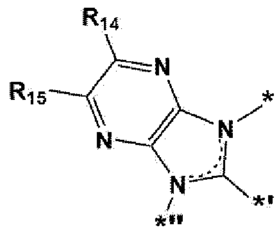
A10-12

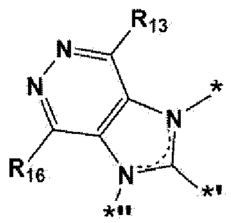
A10-13

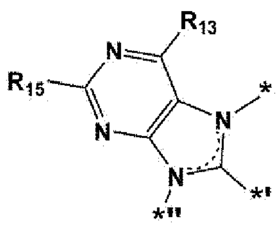
A10-14

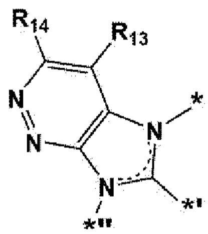
A10-15

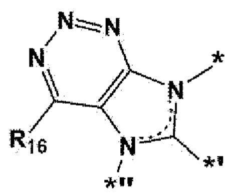
A10-16

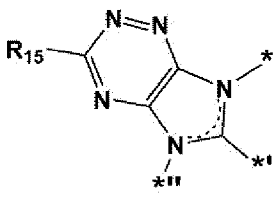
A10-17

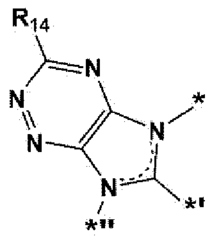
A10-18

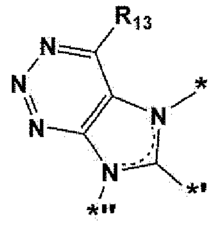
A10-19

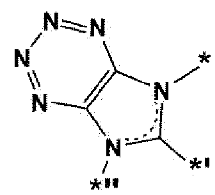
A10-20

.

In Formulae A10-1 to A10-20,

$R_{11}$ and $R_{12}$ may each as described elsewhere herein,
$R_{13}$ to $R_{16}$ may each independently be the same as described in connection with $R_{10}$, and
*, *', and *'' each indicate a binding site to a neighboring atom.

In an embodiment, * may indicate a binding site to $Ar_1$, *' may indicate a binding site to $M_1$, and *'' may indicate a binding site to $X_{21}$.

In an embodiment, $A_{20}$ may be a group represented by one of Formulae A20-1 to A20-13:

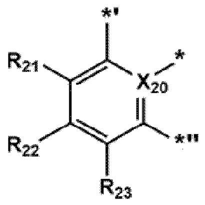
A20-1

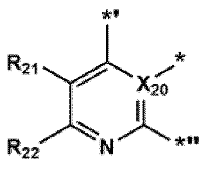
A20-2

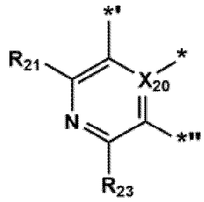
A20-3

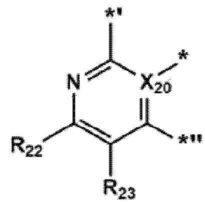
A20-4

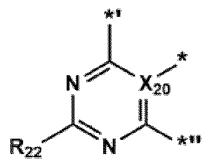
A20-5

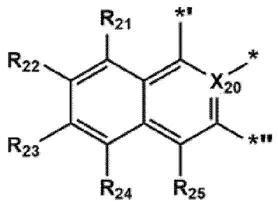
A20-6

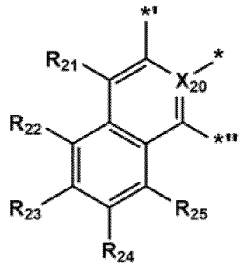
A20-7

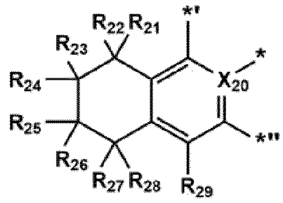
A20-8

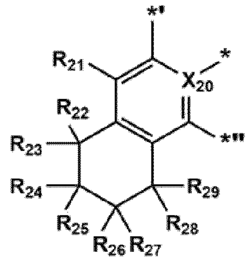
A20-9

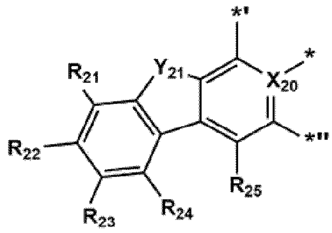
A20-10

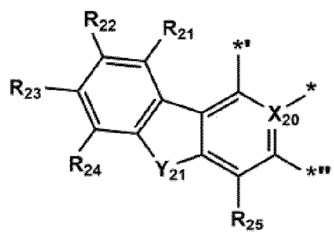
A20-11

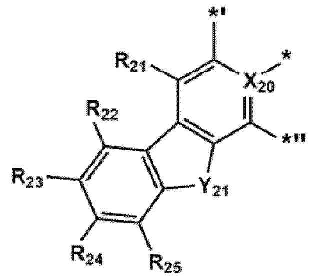
A20-12

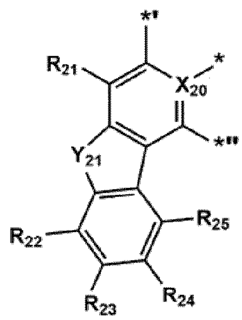
A20-13

In Formulae A20-1 to A20-13,

$X_{20}$ may be as described elsewhere herein,
$Y_{21}$ may be a single bond, O, S, $N(R_{26})$, $C(R_{26})(R_{27})$, or $Si(R_{26})(R_{27})$,
$R_{21}$ to $R_{29}$ may each independently be the same as described in connection with $R_{20}$, and
*, *', and *" each indicate a binding site to a neighboring atom.

In an embodiment, * may indicate a binding site to $M_1$, *' may indicate a binding site to N, and *" may indicate a binding site to $T_1$.

In an embodiment, $A_{30}$ may be a group represented by one of Formulae A30-1 to A30-12:

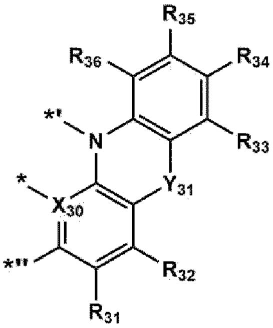
A30-1

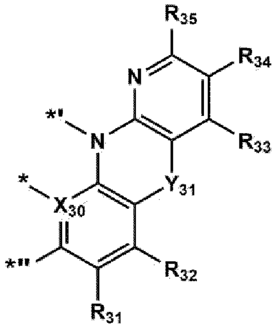
A30-2

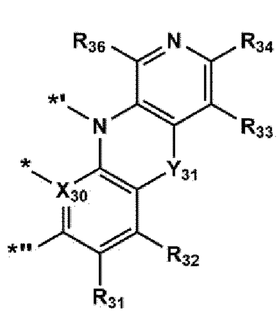
A30-3

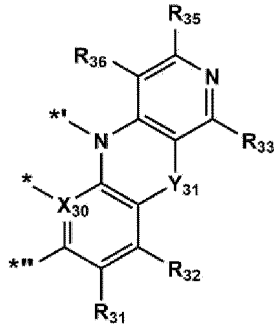
A30-4

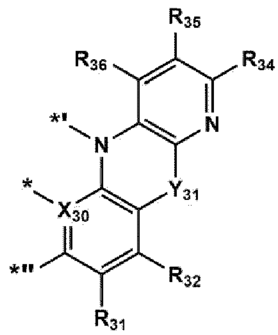

A30-5

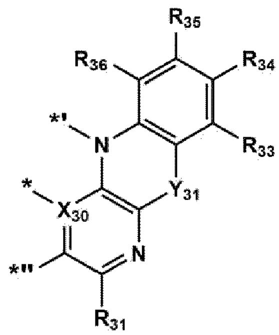

A30-6

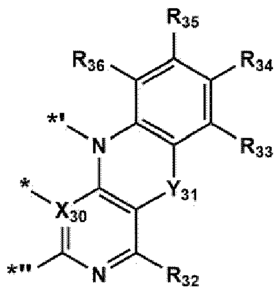

A30-7

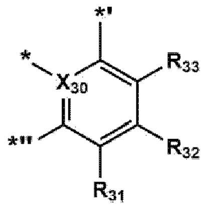

A30-8

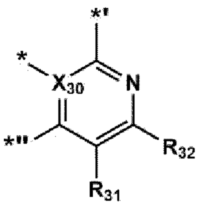

A30-9

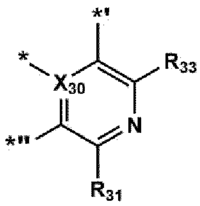

A30-10

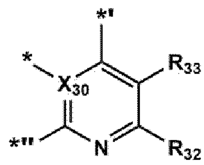

A30-11

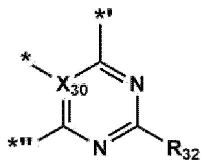

A30-12

In Formulae A30-1 to A30-12,

$X_{30}$ may be as described elsewhere herein,
$Y_{31}$ may be a single bond, O, S, $N(R_{37})$, $C(R_{37})(R_{38})$, or $Si(R_{37})(R_{38})$,
$R_{31}$ to $R_{38}$ may each independently be the same as described in connection with $R_{30}$, and
*, *', and *" each indicate a binding site to a neighboring atom.

In an embodiment, * may indicate a binding site to $M_1$, *' may indicate a binding site to $T_2$, and *" may indicate a binding site to $T_1$.

In Formula 1-1, $Ar_1$ may be a group represented by Formula 2:

Formula 2

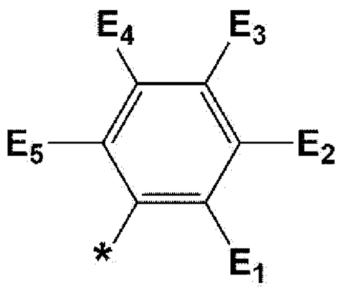

In Formula 2,

$E_1$ and $E_5$ may each independently be deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, or $-P(=O)(Q_8)(Q_9)$.

In an embodiment, $E_1$ and $E_5$ may each independently be a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, or - $P(=O)(Q_8)(Q_9)$.

In Formula 2, $E_2$ to $E_4$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, or - $P(=O)(Q_8)(Q_9)$.

In an embodiment, $E_2$ to $E_4$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkylthio group, or a substituted or unsubstituted $C_1$-$C_{60}$ alkoxy group.

In an embodiment, $E_2$ to $E_4$ may each independently be hydrogen deuterium, or a $C_1$-$C_{20}$ (e.g., $C_1$-$C_{10}$) alkyl group unsubstituted or substituted with deuterium.

In an embodiment, $E_2$ to $E_4$ may each independently be hydrogen or deuterium.

In Formula 2, * indicates a binding site to a neighboring atom.

In Formula 1-1, $Ar_1$ may have an asymmetric structure.

In an embodiment, $Ar_1$ may be a group represented by one of Formulae Ar1-1 to Ar1-13:

Formula Ar1-1

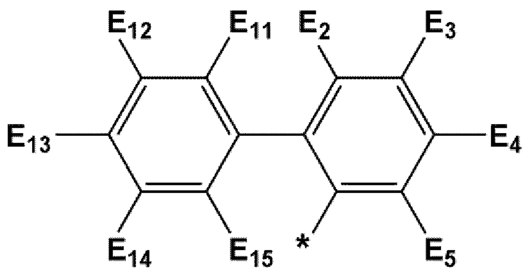

Formula Ar1-2

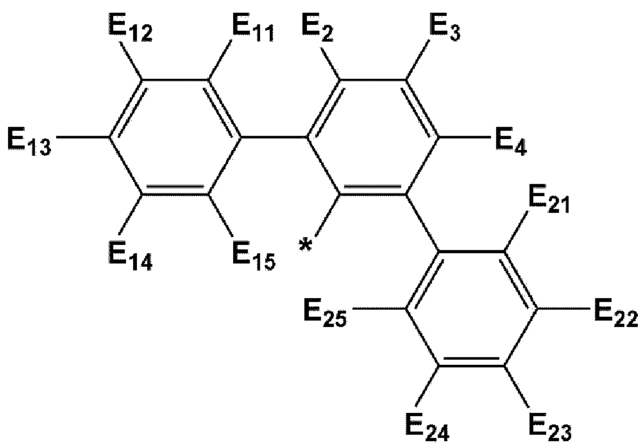

Formula Ar1-3

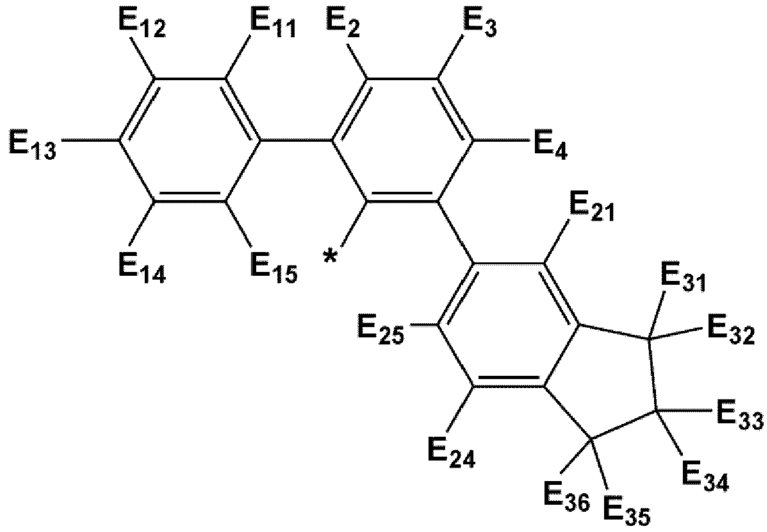

Formula Ar1-4

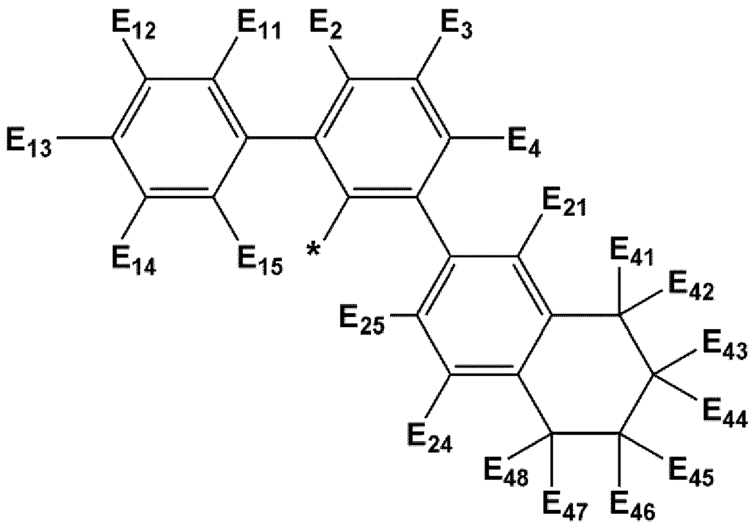

Formula Ar1-5

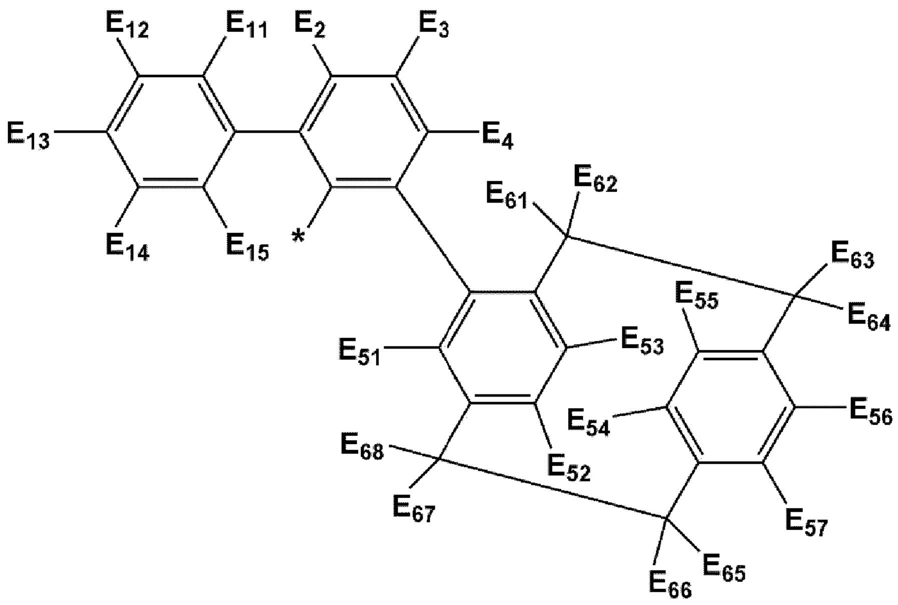

Formula Ar1-6

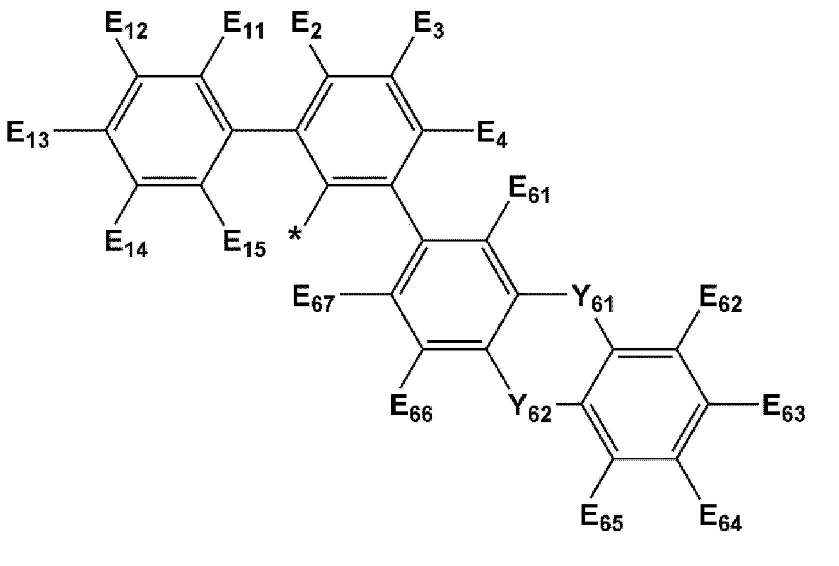

Formula Ar1-7

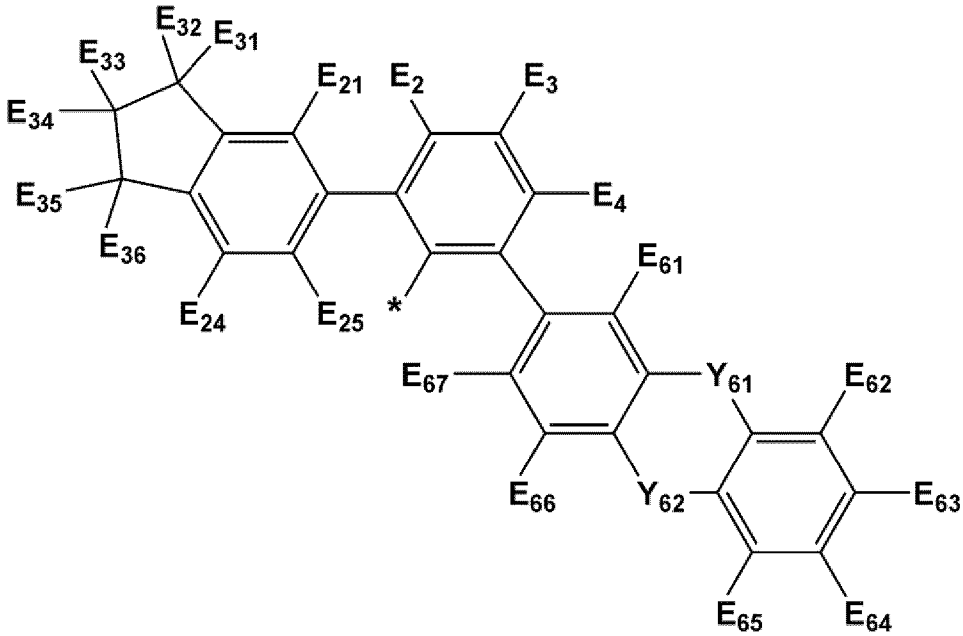

Formula Ar1-8

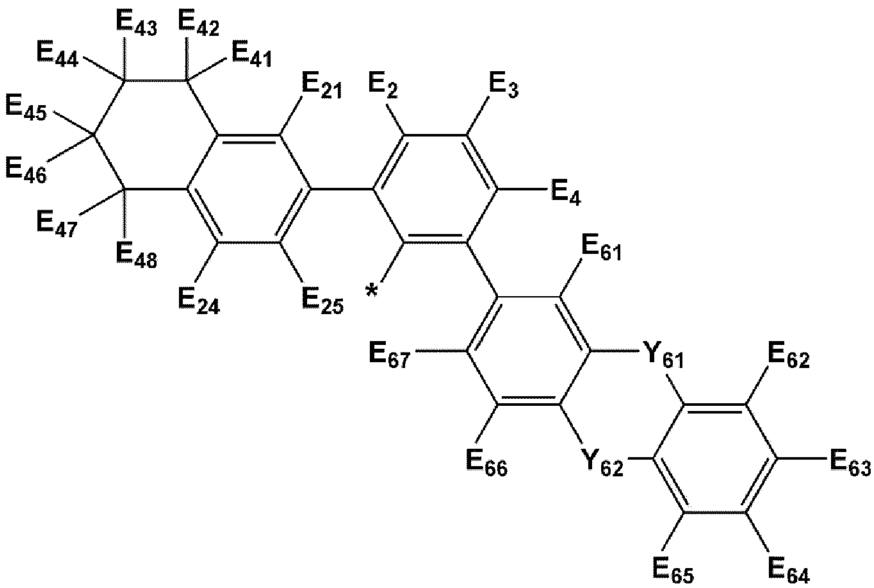

Formula Ar1-9

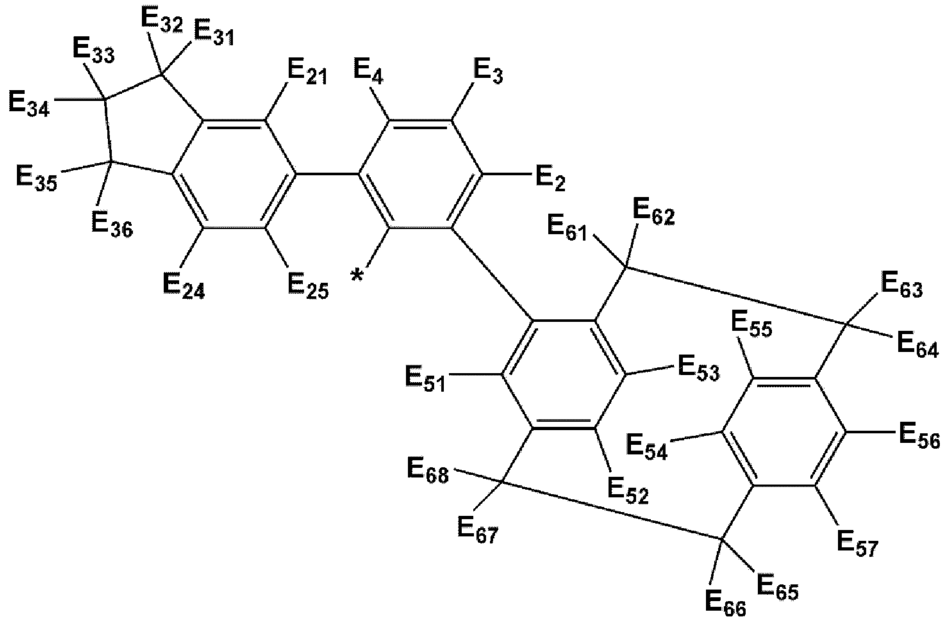

Formula Ar1-10

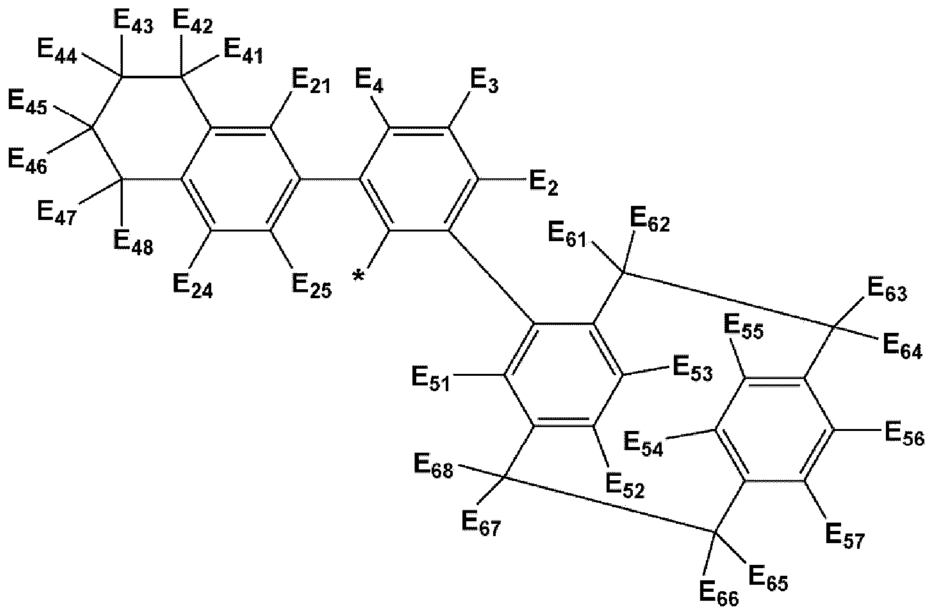

Formula Ar1-11

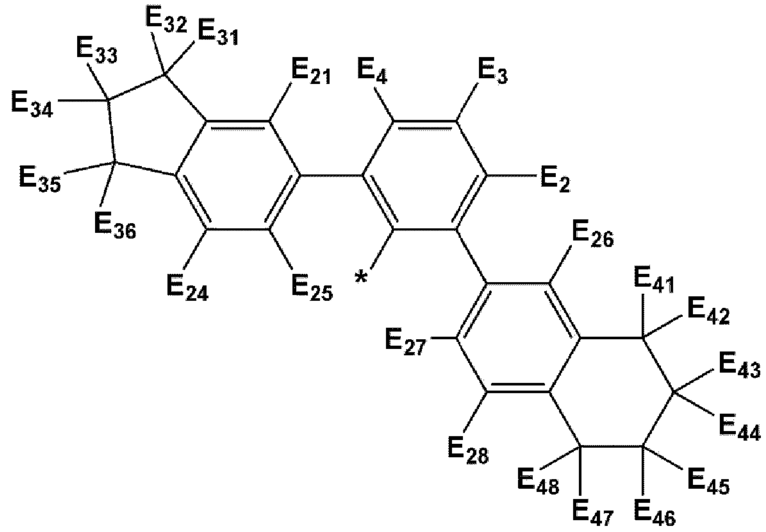

Formula Ar1-12

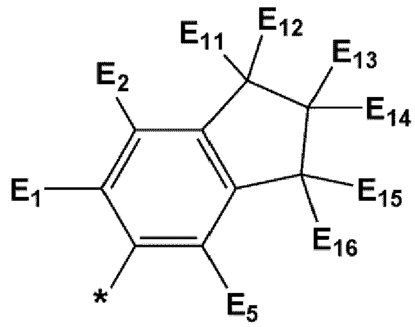

Formula Ar1-13

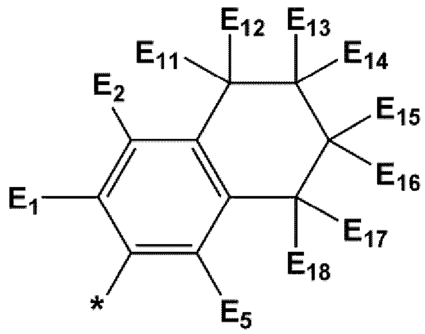

In Formulae Ar1-1 to Ar1-13,

$E_1$ to $E_5$ may each be as defined elsewhere herein,
$Y_{61}$ and $Y_{62}$ may each independently be a single bond, O, S, $N(E_{68})$, or $C(E_{68})(E_{69})$,
$E_{11}$ to $E_{18}$, $E_{21}$ to $E_{28}$, $E_{31}$ to $E_{36}$, $E_{41}$ to $E_{48}$, $E_{51}$ to $E_{57}$, and $E_{61}$ to $E_{69}$ may each independently be: hydrogen, deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid or a salt thereof, a sulfonic acid group or a salt thereof, a phosphate group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each substituted with deuterium, -F, -Cl, -Br, - I, $-CD_3$, $-CD_2H$, $-CDH_2$, $-CF_3$, $-CF_2H$, $-CFH_2$, a hydroxyl group, a

cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, or a combination thereof;

a $C_3$-$C_{19}$ cycloalkyl group, a $C_1$-$C_{10}$ heterocycloalkyl group, a $C_3$-$C_{19}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{19}$ cycloalkyl group, a $C_1$-$C_{10}$ heterocycloalkyl group, a $C_3$-$C_{19}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{19}$ cycloalkyl group, a $C_1$-$C_{10}$ heterocycloalkyl group, a $C_3$-$C_{19}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$,$-Ge(Q_{23})(Q_{24})(Q_{25})$, $-B(Q_{26})(Q_{27})$, $-P(=O)(Q_{28})(Q_{29})$, or a combination thereof; or

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, or-$P(=O)(Q_{38})(Q_{39})$,

two or more of: $E_{11}$ to $E_{18}$; $E_{21}$ to $E_{28}$; $E_{31}$ to $E_{36}$; $E_{41}$ to $E_{48}$; $E_{51}$ to $E_{57}$; and $E_{61}$ to $E_{69}$ may optionally be bonded together to form a substituted or unsubstituted $C_5$-$C_{30}$ carbocyclic group or a substituted or unsubstituted $C_1$-$C_{30}$ heterocyclic group, and

* indicates a binding site to a neighboring atom.

In an embodiment, $E_{11}$ to $E_{18}$, $E_{21}$ to $E_{28}$, $E_{31}$ to $E_{36}$, $E_{41}$ to $E_{48}$, $E_{51}$ to $E_{57}$, and $E_{61}$ to $E_{69}$ may each independently be:

hydrogen, deuterium, -F, -Cl, -Br, -I, a cyano group, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;

a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl

group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an isoindolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a $C_1$-$C_{60}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an isoindolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, or$-P(=O)(Q_{38})(Q_{39})$.

In an embodiment, $E_{11}$ to $E_{18}$, $E_{21}$ to $E_{28}$, $E_{31}$ to $E_{36}$, $E_{41}$ to $E_{48}$, $E_{51}$ to $E_{57}$, and $E_{61}$ to $E_{69}$ may each independently be:

hydrogen, deuterium, a $C_1$-$C_{30}$ alkyl group, a $C_6$-$C_{60}$ aryl group, or a $C_1$-$C_{60}$ heteroaryl group;

a $C_1$-$C_{30}$ alkyl group, a $C_6$-$C_{60}$ aryl group, or a $C_1$-$C_{60}$ heteroaryl group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a $C_1$-$C_{60}$ alkylthio group, a cyclopentyl group, a cyclohexyl group, a cycloheptyl group, a cyclooctyl group an adamantanyl group, a norbornanyl group, a norbornenyl group, a cyclopentenyl group, a cyclohexenyl group, a cycloheptenyl group, a phenyl group, a naphthyl group, a fluorenyl group, a methyl-substituted fluorenyl group, a phenyl-substituted fluorenyl group, a pyridinyl group, a pyrimidinyl group, or a combination thereof; or

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, or$-P(=O)(Q_{38})(Q_{39})$.

In an embodiment, $E_{11}$ to $E_{18}$, $E_{21}$ to $E_{28}$, $E_{31}$ to $E_{36}$, $E_{41}$ to $E_{48}$, $E_{51}$ to $E_{57}$, and $E_{61}$ to $E_{69}$ may each independently be:

hydrogen, deuterium, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group;

a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with deuterium;

a phenyl group, a naphthyl group, a fluorenyl group, a phenanthrenyl group, an anthracenyl group, a fluoranthenyl group, a triphenylenyl group, a pyrenyl group, or a chrysenyl group;

a phenyl group, a naphthyl group, a fluorenyl group, a phenanthrenyl group, an anthracenyl group, a fluoranthenyl group, a triphenylenyl group, a pyrenyl group, or a chrysenyl group, each substituted with deuterium, -F, -Cl, -Br, -I,

$-CD_3$, $-CD_2H$, $-CDH_2$,$-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a $C_1$-$C_{60}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof; or
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, or - $P(=O)(Q_{38})(Q_{39})$.

In Formula 1-1, $R_{11}$ and $R_{12}$ may each independently be hydrogen, deuterium, - F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, or - $P(=O)(Q_8)(Q_9)$, and
$R_{11}$ and $R_{12}$ may optionally be bonded to each other to form a $C_5$-$C_{30}$ carbocyclic group unsubstituted or substituted with at least one $R_{10}$ or a $C_1$-$C_{30}$ heterocyclic group unsubstituted or substituted with at least one $R_{10}$.

The first linking group may be $*-N(R_8)-*'$, $*-B(R_8)-*'$, $*-P(R_8)-*'$, $*-C(R_8)(R_9)-*'$, $*-Si(R_8)(R_9)-*'$, $*-Ge(R_8)(R_9)-*'$, *-S-*', *-Se-*', *-O-*1, *-C(=O)-*', *-S(=O)-*', $*-S(=O)_2-*'$, $*-C(R_8)=*'$, $*=C(R_8)-*'$, $*-C(R_8)=C(R_9)-*'$, *-C(=S)-*', or *-C=C-*', wherein $R_8$ and $R_9$ may each be the same as described in connection with $R_{10}$, and * and *'each indicate a binding site to a neighboring atom.

In an embodiment, $R_{11}$ and $R_{12}$ may optionally be bonded to each other, via a single bond, a double bond, or a first linking group, to form a $C_5$-$C_{30}$ carbocyclic group unsubstituted or substituted with at least one $R_{10}$ or a $C_1$-$C_{30}$ heterocyclic group unsubstituted or substituted with at least one $R_{10}$ (e.g., a cyclopentane group, a cyclohexane group, a cycloheptane group, a cyclooctane group, a benzene group, a fluorene group, a carbazole group, a xanthene group, an acridine group, or the like, each unsubstituted or substituted with at least one $R_{10}$).

In Formula 1-1, $R_1$ to $R_4$, $R_{10}$, $R_{20}$, $R_{30}$, $R_{41}$, and $R_{44}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, - $Ge(Q_3)(Q_4)(Q_5)$, $-B(Q_6)(Q_7)$, or $-P(=O)(Q_8)(Q_9)$,

at least two neighboring groups among $R_1$ to $R_4$, $R_{10}$, $R_{20}$, $R_{30}$, $R_{41}$, and $R_{44}$ may optionally be bonded together to form a substituted or unsubstituted $C_5$-$C_{30}$ carbocyclic group or a substituted or unsubstituted $C_1$-$C_{30}$ heterocyclic group, two or more of $R_{20}$ in the number of b20 may optionally be linked together to form a substituted or unsubstituted $C_5$-$C_{30}$ carbocyclic group or a substituted or unsubstituted $C_1$-$C_{30}$ heterocyclic group, and
at least two of $R_{30}$ in the number of b30 may optionally be linked together to form a substituted or unsubstituted $C_5$-$C_{30}$ carbocyclic group or a substituted or unsubstituted $C_1$-$C_{30}$ heterocyclic group.

In an embodiment, at least two of a plurality of $R_{20}$; or at least two neighboring groups among $R_1$ to $R_4$, $R_{10}$, $R_{20}$, $R_{30}$, $R_{41}$, and $R_{44}$ may optionally be linked together, via a single bond, a double bond, or a first linking group, to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$ (e.g., a fluorene group, a xanthene group, an acridine group, or the like, each unsubstituted or substituted with at least one $R_{10a}$). $R_{10a}$ may be the same as described in connection with $R_{10}$.

In Formula 1-1, b20 and b30 may each independently be 1, 2, 3, 4, 5, 6, 7, 8, 9, or 10, and
when b20 is 2 or more, two or more of $R_{20}$ may be identical to or different from each other, and when b30 is 2 or more, two or more of $R_{30}$ may be identical to or different from each other.

In an embodiment, $R_1$ to $R_4$, $R_{10}$ to $R_{12}$, $R_{20}$, $R_{30}$, $R_{41}$, and $R_{44}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{60}$ alkylthio group, or a $C_1$-$C_{20}$ alkoxy group;
a $C_1$-$C_{20}$ alkyl group or a $C_1$-$C_{20}$ alkoxy group, each substituted with deuterium,-F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{60}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
$-N(Q_1)(Q_2)$, $-Si(Q_3)(Q_4)(Q_5)$, $-Ge(Q_3)(Q_4)(Q_5)$, $-B(Q_6)(Q_7)$, or $-P(=O)(Q_8)(Q_9)$, and
$Q_1$ to $Q_9$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, or $-CD_2CDH_2$;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or

an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with deuterium, a $C_1$-$C_{10}$ alkyl group, a phenyl group, or a combination thereof.

In an embodiment, $R_1$ to $R_4$, $R_{10}$ to $R_{12}$, $R_{20}$, $R_{30}$, $R_{41}$, and $R_{44}$ may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, a group represented by one of Formulae 9-1 to 9-61, or a group represented by one of Formulae 10-1 to 10-369:

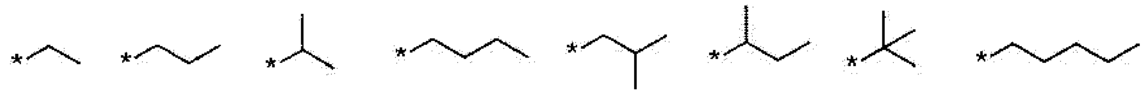

9-1 9-2 9-3 9-4 9-5 9-6 9-7 9-8

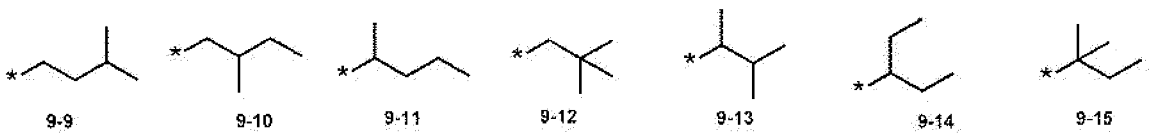

9-9 9-10 9-11 9-12 9-13 9-14 9-15

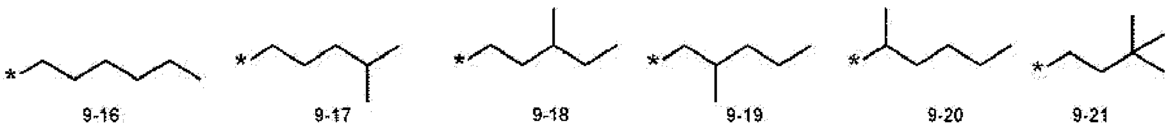

9-16 9-17 9-18 9-19 9-20 9-21

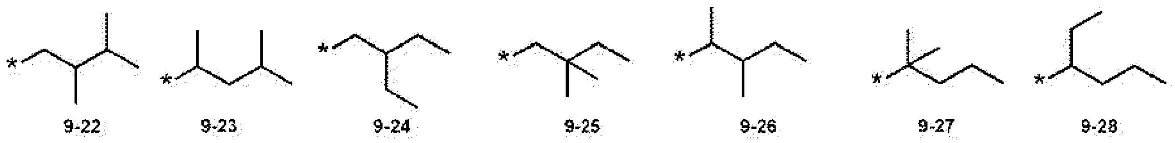

9-22 9-23 9-24 9-25 9-26 9-27 9-28

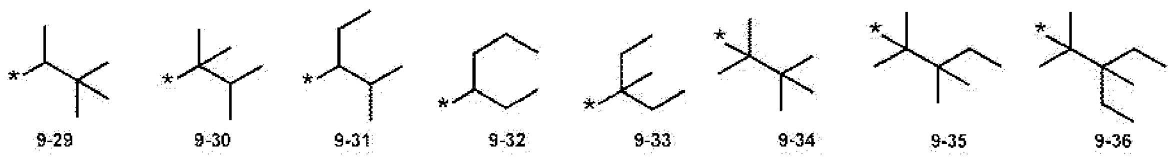

9-29 9-30 9-31 9-32 9-33 9-34 9-35 9-36

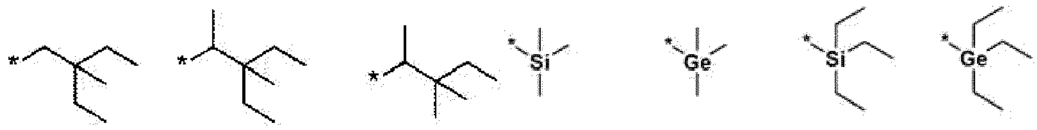

9-37 9-38 9-39 9-40 9-41 9-42 9-43

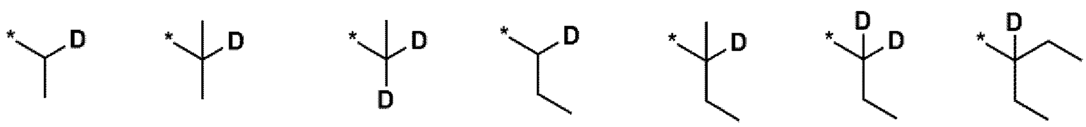

9-44 9-45 9-46 9-47 9-48 9-49 9-50

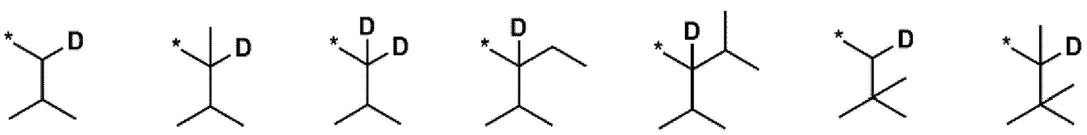

9-51 9-52 9-53 9-54 9-55 9-56 9-57

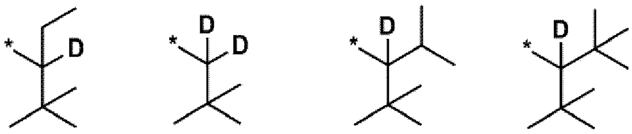
9-58 9-59 9-60 9-61

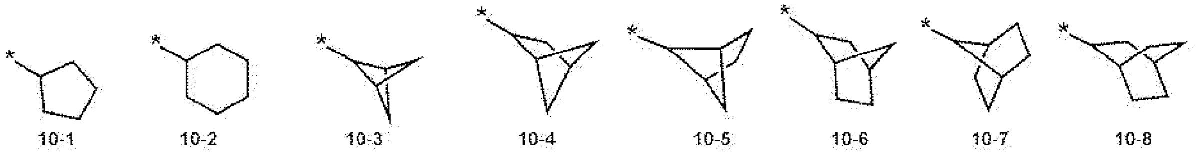
10-1 10-2 10-3 10-4 10-5 10-6 10-7 10-8

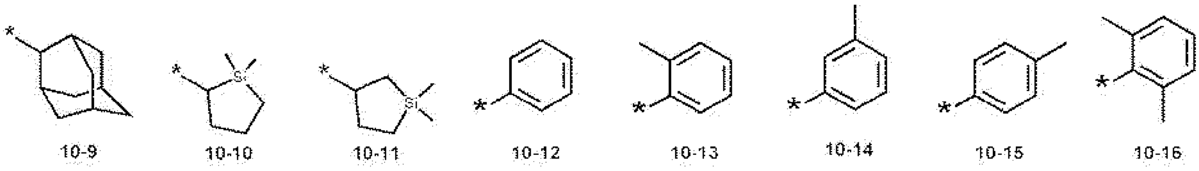
10-9 10-10 10-11 10-12 10-13 10-14 10-15 10-16

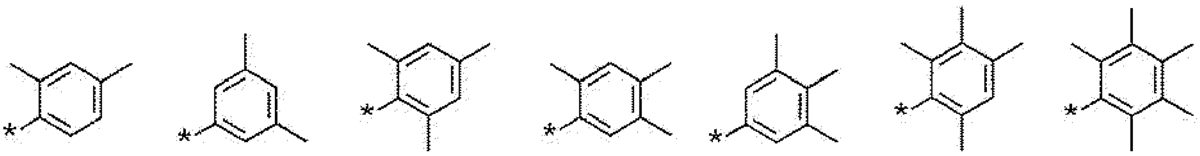
10-17 10-18 10-19 10-20 10-21 10-22 10-23

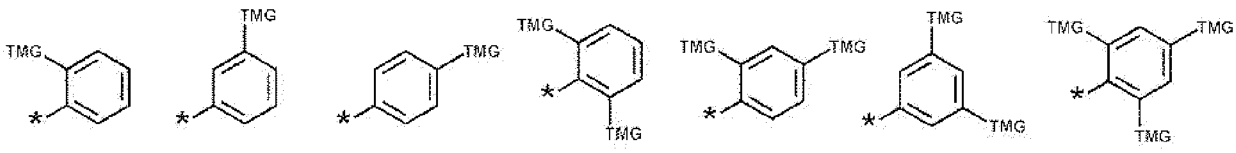
10-24 10-25 10-26 10-27 10-28 10-29 10-30

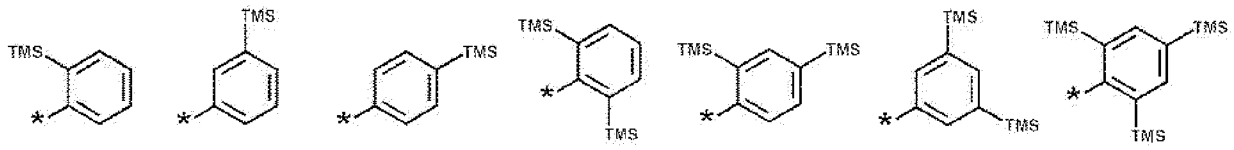
10-31 10-32 10-33 10-34 10-35 10-36 10-37

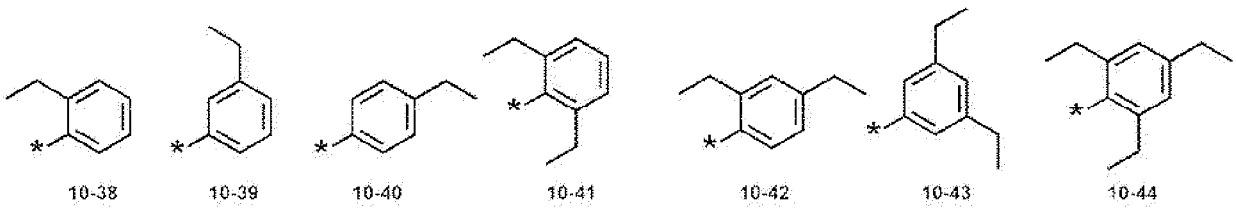
10-38 10-39 10-40 10-41 10-42 10-43 10-44

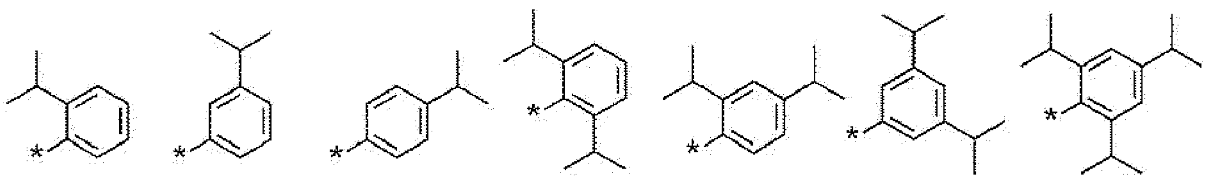
10-45 10-46 10-47 10-48 10-49 10-50 10-51

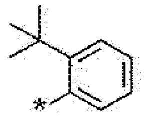
10-52

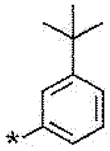
10-53

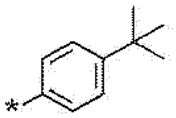
10-54

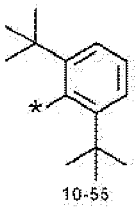
10-55

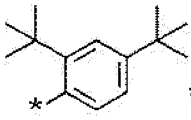
10-56

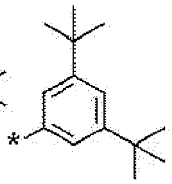
10-57

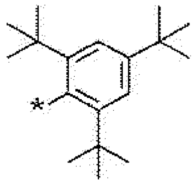
10-58

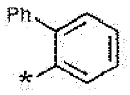
10-59

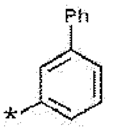
10-60

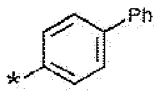
10-61

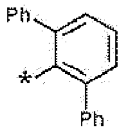
10-62

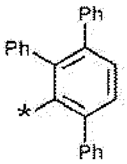
10-63

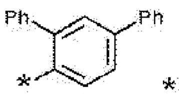
10-64

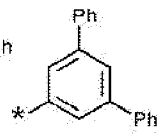
10-65

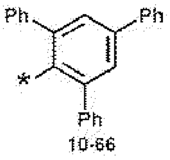
10-66

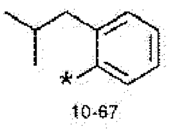
10-67

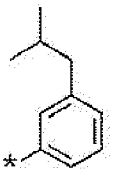
10-68

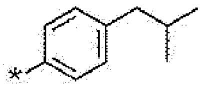
10-69

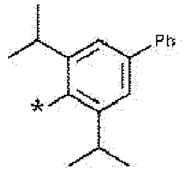
10-70

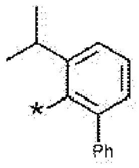
10-71

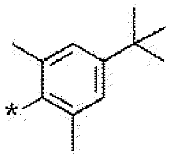
10-72

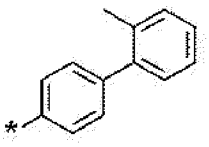
10-73

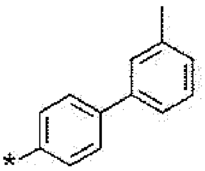
10-74

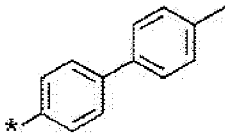
10-75

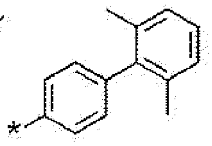
10-76

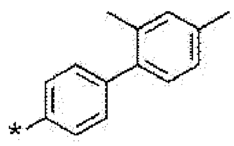
10-77

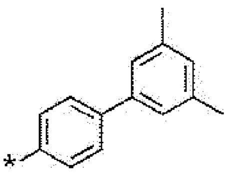
10-78

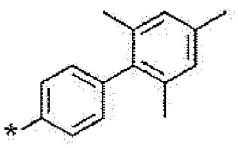
10-79

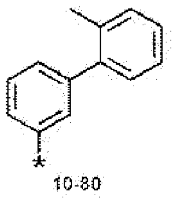
10-80

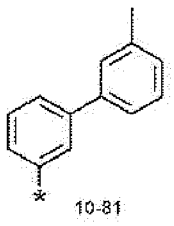
10-81

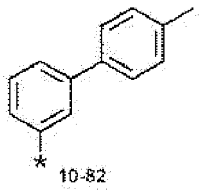
10-82

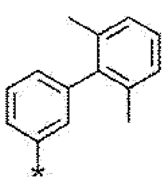
10-83

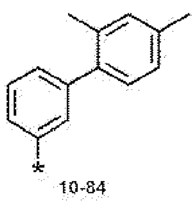
10-84

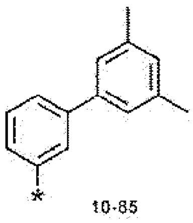
10-85

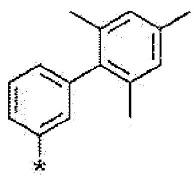
10-86

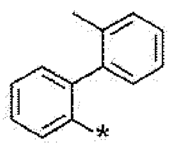
10-87

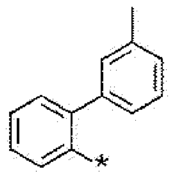
10-88

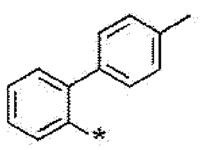
10-89

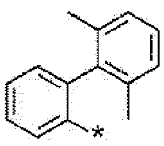
10-90

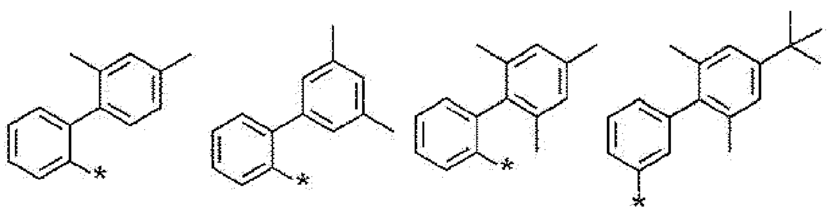
10-91

10-92

10-93

10-94

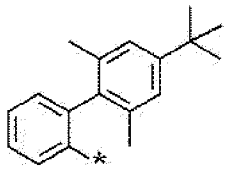
10-95

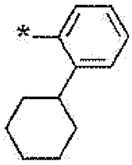
10-96

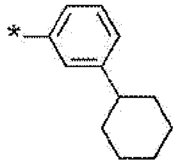
10-97

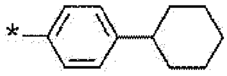
10-98

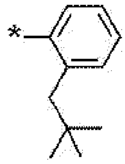
10-99

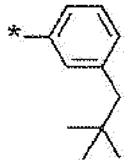
10-100

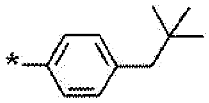
10-101

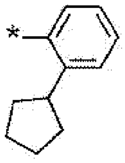
10-102

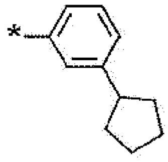
10-103

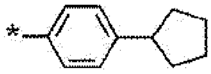
10-104

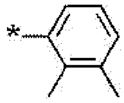
10-105

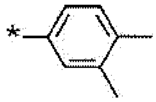
10-106

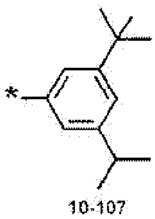
10-107

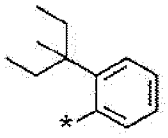
10-108

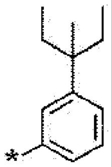
10-109

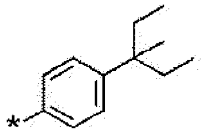
10-110

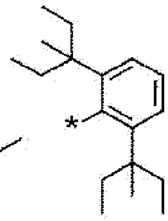
10-111

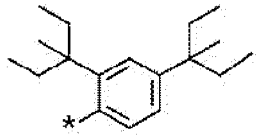
10-112

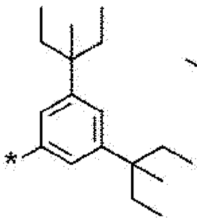
10-113

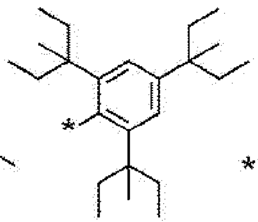
10-114

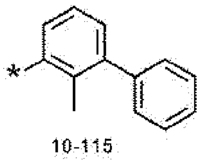
10-115

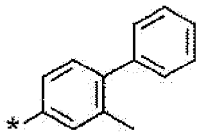
10-116

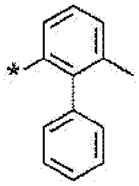
10-117

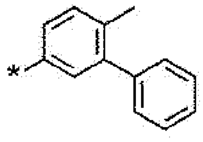
10-118

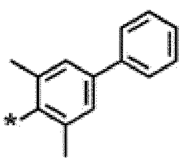
10-119

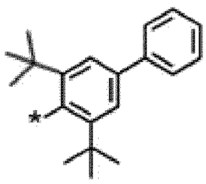
10-120

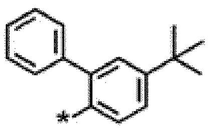
10-121

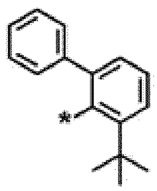
10-122

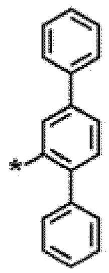
10-123

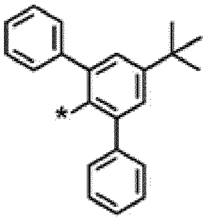
10-124

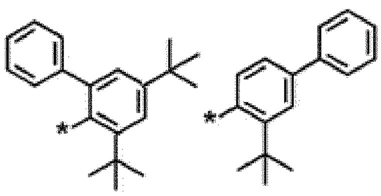
10-125 10-126

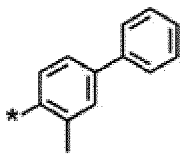
10-127

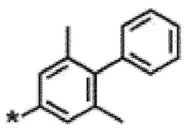
10-128

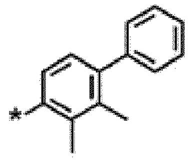
10-129

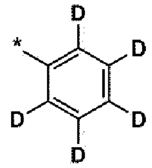
10-130

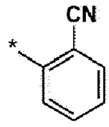
10-131

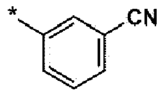
10-132

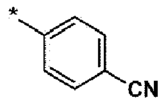
10-133

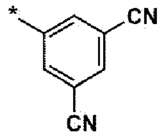
10-134

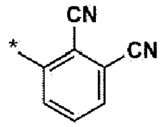
10-135

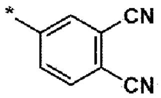
10-136

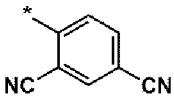
10-137

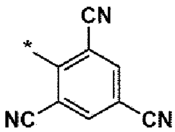
10-138

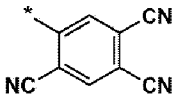
10-139

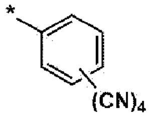
10-140

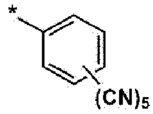
10-141

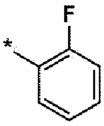
10-142

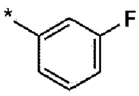
10-143

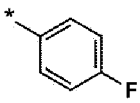
10-144

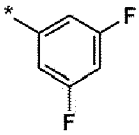
10-145

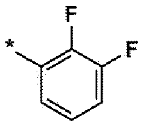
10-146

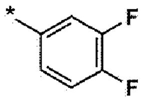
10-147

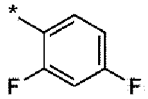
10-148

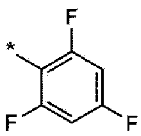
10-149

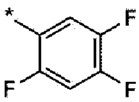
10-150

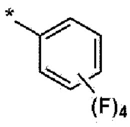
10-151

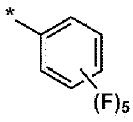
10-152

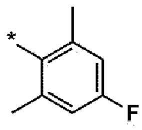
10-153

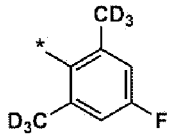
10-154

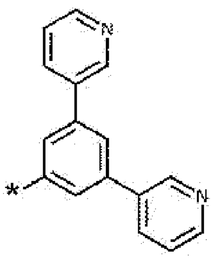
10-201

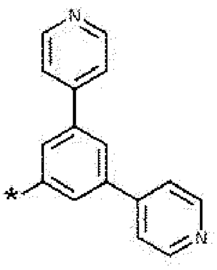
10-202

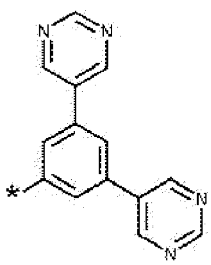
10-203

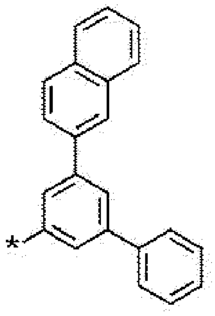
10-204

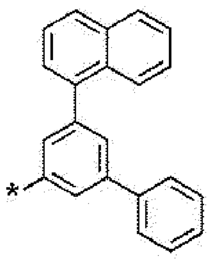
10-205

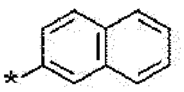
10-206

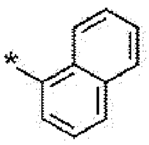
10-207

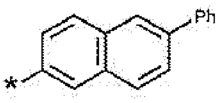
10-208

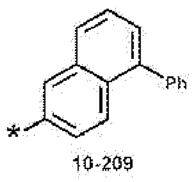
10-209

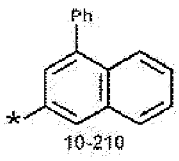
10-210

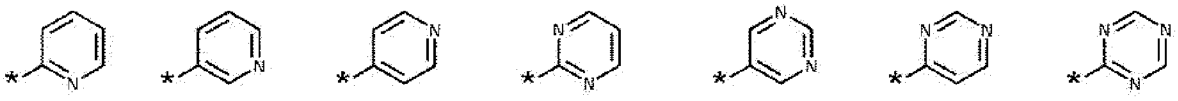
10-211 10-212 10-213 10-214 10-215 10-216 10-217

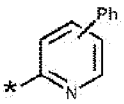
10-218
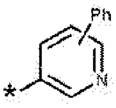
10-219
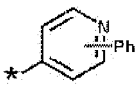
10-220
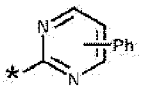
10-221
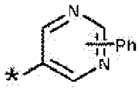
10-222
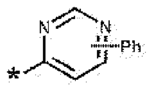
10-223
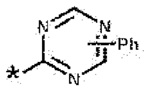
10-224

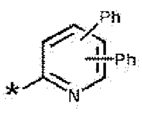
10-225
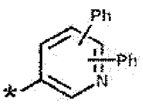
10-226
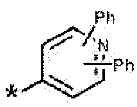
10-227
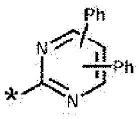
10-228
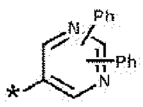
10-229
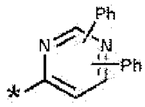
10-230
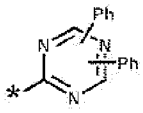
10-231

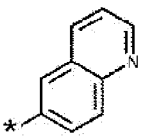
10-232
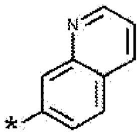
10-233
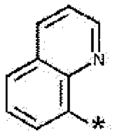
10-234
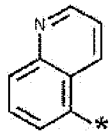
10-235
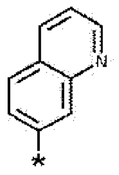
10-236
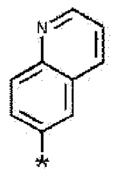
10-237

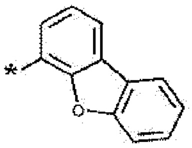
10-238
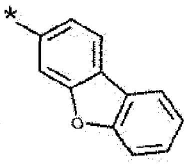
10-239
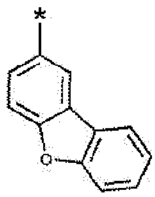
10-240
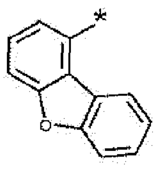
10-241
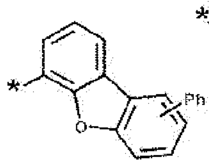
10-242
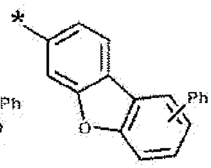
10-243

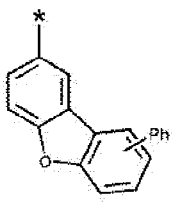
10-244
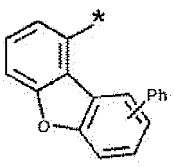
10-245
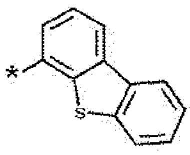
10-246
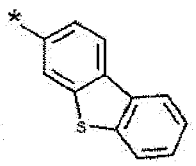
10-247
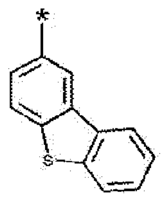
10-248
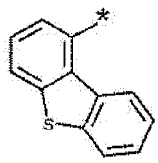
10-249

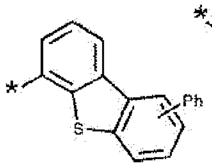
10-250
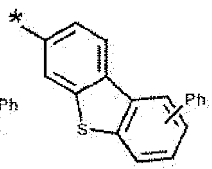
10-251
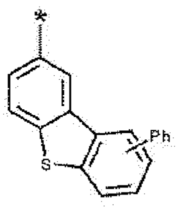
10-252
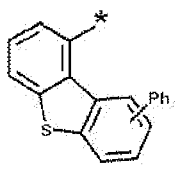
10-253
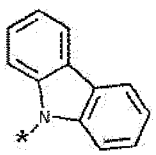
10-254
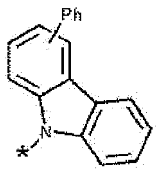
10-255

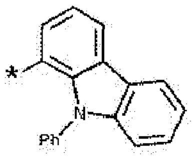
10-256
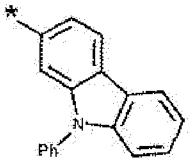
10-257
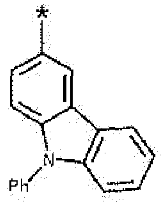
10-258
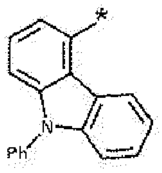
10-259
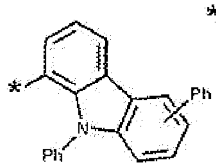
10-260
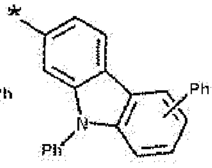
10-261

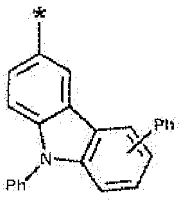
10-262
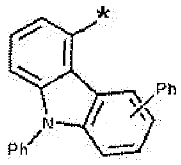
10-263
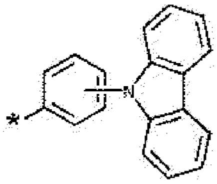
10-264
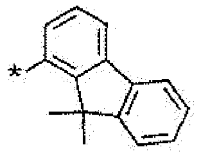
10-265
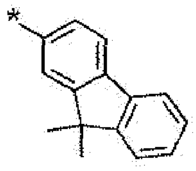
10-266
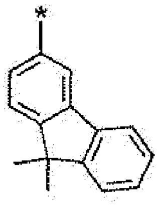
10-267

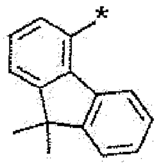
10-268
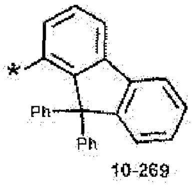
10-269
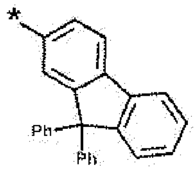
10-270
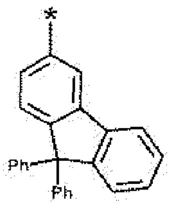
10-271
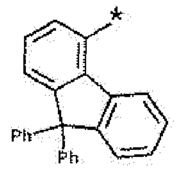
10-272

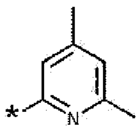
10-273
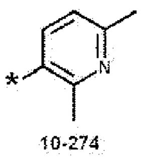
10-274
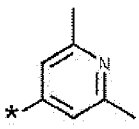
10-275
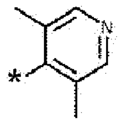
10-276
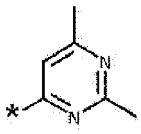
10-277
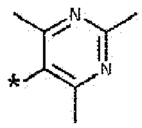
10-278
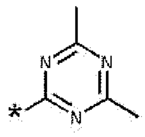
10-279

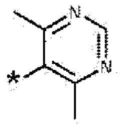
10-280
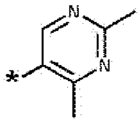
10-281
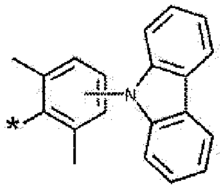
10-282
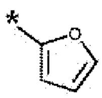
10-283
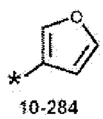
10-284
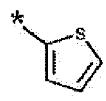
10-285
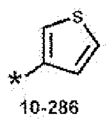
10-286

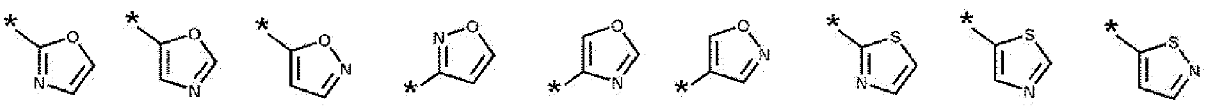
10-287 10-288 10-289 10-290 10-291 10-292 10-293 10-294 10-295

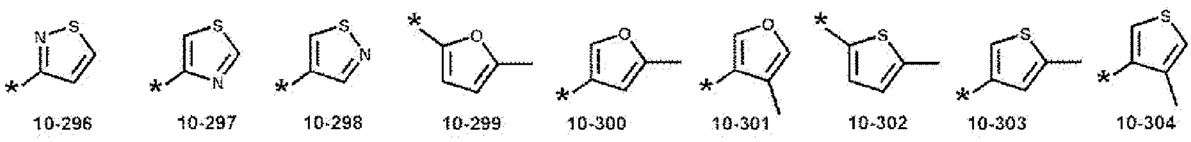
10-296 10-297 10-298 10-299 10-300 10-301 10-302 10-303 10-304

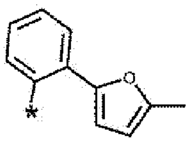
10-305
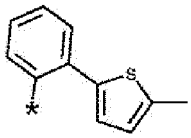
10-306
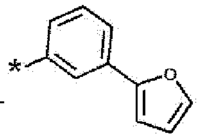
10-307
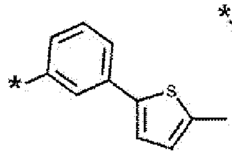
10-308
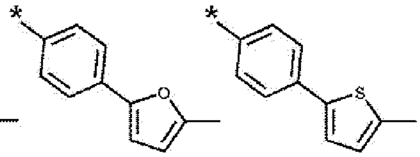
10-309
10-310

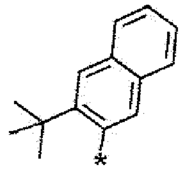
10-311
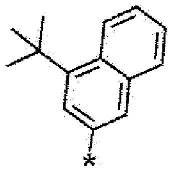
10-312
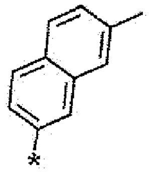
10-313
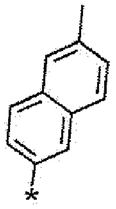
10-314
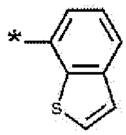
10-315
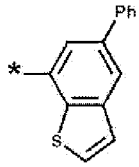
10-316
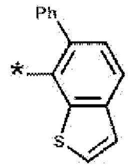
10-317

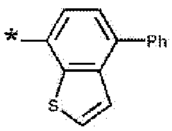
10-318
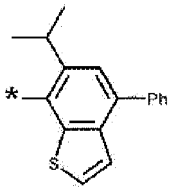
10-319
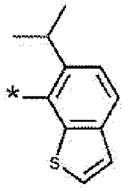
10-320
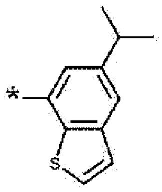
10-321
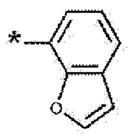
10-322
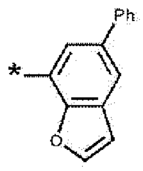
10-323
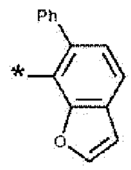
10-324

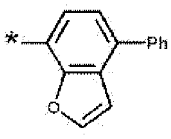
10-325
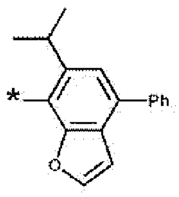
10-326
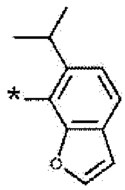
10-327
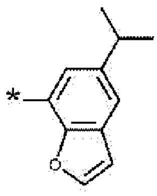
10-328
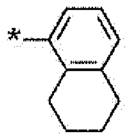
10-329
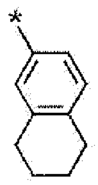
10-330
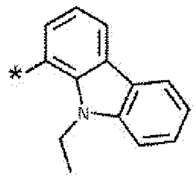
10-331

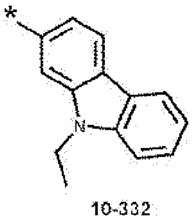
10-332
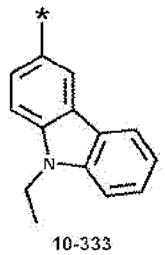
10-333
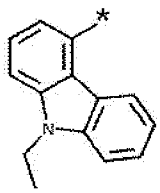
10-334
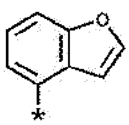
10-335
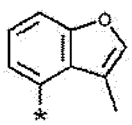
10-336
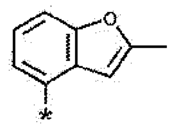
10-337

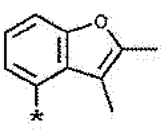
10-338
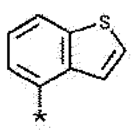
10-339
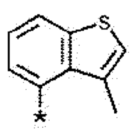
10-340
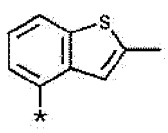
10-341
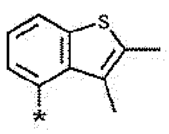
10-342
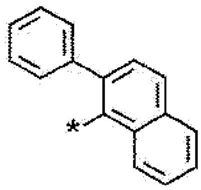
10-343

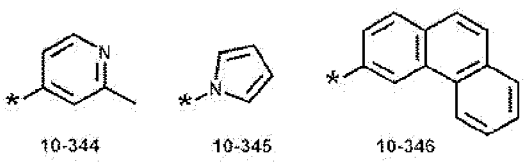
10-344
10-345
10-346
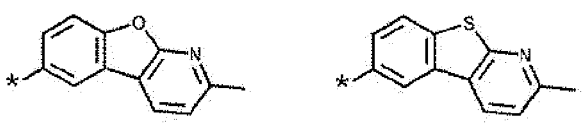
10-347
10-348

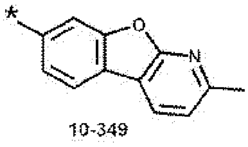
10-349

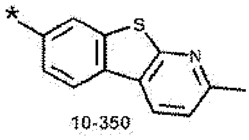
10-350

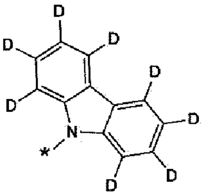
10-351

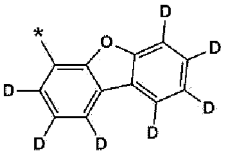
10-352

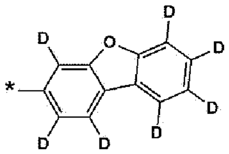
10-353

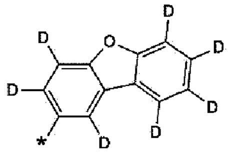
10-354

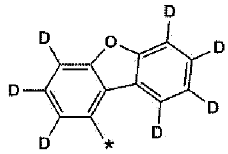
10-355

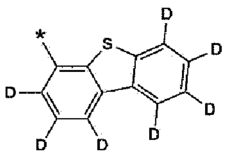
10-356

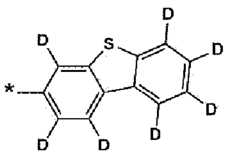
10-357

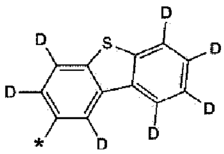
10-358

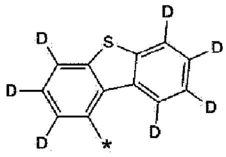
10-359

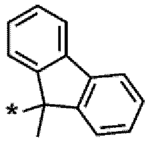
10-360

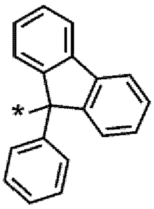
10-361

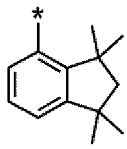
10-362

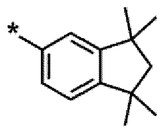
10-363

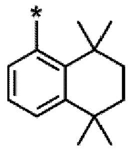
10-364

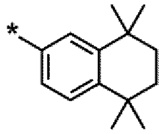
10-365

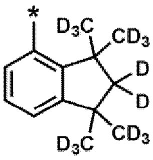
10-366

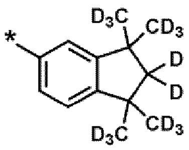
10-367

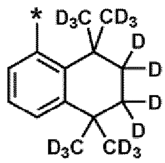
10-368

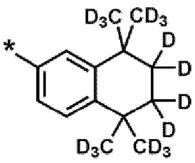
10-369

In Formulae 9-1 to 9-61 and 10-1 to 10-369, * indicates a binding site to a neighboring atom, "Ph" represents a phenyl group, "TMS" represents a trimethylsilyl group, and "TMG" represents a trimethylgermyl group.

In Formula 1-1, $R_{42}$ may be a substituted or unsubstituted $C_1$-$C_{60}$ alkyl group, and may have a molecular weight of 18 or more.

In an embodiment, $R_{42}$ may be: an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group; or

a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with deuterium.

In Formula 1-1, $R_{43}$ may be deuterium, -F, -Cl, -Br, -I, $-SF_5$, a hydroxyl group, a cyano group, a nitro group, an

amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, or $-P(=O)(Q_8)(Q_9)$.

In an embodiment, $R_{43}$ may be: deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{60}$ alkylthio group, or a $C_1$-$C_{20}$ alkoxy group;

a $C_1$-$C_{20}$ alkyl group or a $C_1$-$C_{20}$ alkoxy group, each substituted with deuterium,-F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an

oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or $-N(Q_1)(Q_2)$, $-Si(Q_3)(Q_4)(Q_5)$, $-Ge(Q_3)(Q_4)(Q_5)$, $-B(Q_6)(Q_7)$, or $-P(=O)(Q_8)(Q_9)$, and
$Q_1$ to $Q_9$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, or $-CD_2CDH_2$;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with deuterium, a $C_1$-$C_{10}$ alkyl group, a phenyl group, or a combination thereof.

In an embodiment, $R_{43}$ may be deuterium, -F, a cyano group, a nitro group, $-SF_5$, $-CH_3$, $-CD_3$, $-CD_2H$, $-CDH_2$, $-CF_3$, $-CF_2H$, $-CFH_2$, a group represented by one of Formulae 9-1 to 9-61, or a group represented by one of Formulae 10-1 to 10-369:
In Formula 1-1, at least one of $R_{42}$ and $R_{43}$ may have a molecular weight of 19 or more.
In an embodiment, $R_{42}$ and $R_{43}$ may each independently be: an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group; or
an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each substituted with deuterium.
In an embodiment, $Q_1$ to $Q_9$, $Q_{11}$ to $Q_{19}$, $Q_{21}$ to $Q_{29}$ and $Q_{31}$ to $Q_{39}$ described herein may each independently be:

deuterium, $-CH_3$, $-CD_3$, $-CD_2H$, $-CDH_2$, $-CH_2CH_3$, $-CH_2CD_3$, $-CH_2CD_2H$,$-CH_2CDH_2$, $-CHDCH_3$, $-CHDCD_2H$, $-CHDCDH_2$, $-CHDCD_3$, $-CD_2CD_3$, $-CD_2CD_2H$, or$-CD_2CDH_2$;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a neo-pentyl group, a phenyl group, or a naphthyl group, each substituted with deuterium, a $C_1$-$C_{10}$ alkyl group, a phenyl group, or a combination thereof.

In Formula 1-1, $X_{20}$ may be C or N, and $X_{30}$ may be C or N.
For example, $X_{20}$ may be C. In an embodiment, $X_{20}$ may be N.
In an embodiment, $X_{30}$ may be C. In an embodiment, $X_{30}$ may be N.
In Formula 1-1, $X_{21}$, $X_{22}$, $X_{31}$, and $X_{32}$ may each independently be C or N.
In an embodiment, $X_{21}$ may be C. In an embodiment, $X_{21}$ may be N.
For example, $X_{22}$ may be C. In an embodiment, $X_{22}$ may be N.
For example, $X_{31}$ may be C. In an embodiment, $X_{31}$ may be N.
For example, $X_{32}$ may be C. In an embodiment, $X_{32}$ may be N.
In Formula 1-1, a bond between $M_1$ and $A_{10}$, a bond between $M_1$ and $A_{20}$, a bond between $M_1$ and $A_{30}$, and a bond between $M_1$ and the pyridine group may each independently be a covalent bond or a dative (coordinate) bond.
In an embodiment, two of a bond between $M_1$ and $A_{10}$, a bond between $M_1$ and $A_{20}$, a bond between $M_1$ and $A_{30}$, and a bond between $M_1$ and the pyridine group may each be a covalent bond, and the other two may each be a dative bond.
In an embodiment, a bond between $M_1$ and $A_{10}$ may be a dative bond, a bond between $M_1$ and $A_{20}$ may be a covalent bond, a bond between $M_1$ and $A_{30}$ may be a covalent bond, and a bond between $M_1$ and the pyridine group may be a dative bond.
In an embodiment, the organometallic compound represented by Formula 1 may be represented by Formula 11 or 12:

Formula 11

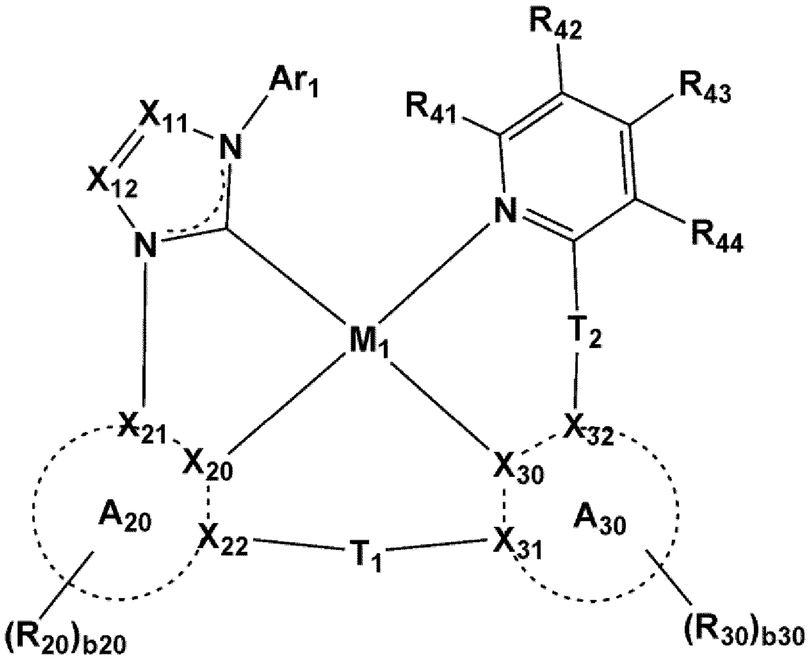

Formula 12

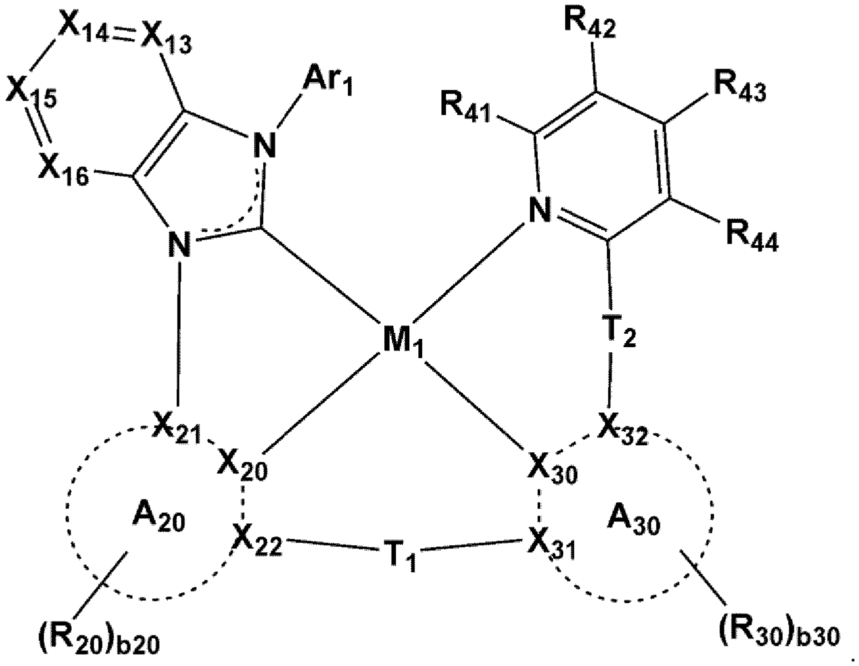

In Formulae 11 and 12,

$M_1$, $A_{20}$, $A_{30}$, $X_{11}$, $X_{12}$, $X_{20}$ to $X_{22}$, $X_{30}$ to $X_{32}$, $T_1$, $T_2$, $Ar_1$, $R_{20}$, $R_{30}$, $R_{41}$ to $R_{44}$, b20, and b30 may each be as described elsewhere herein, and
$X_{13}$ may be $C(R_{13})$ or N, $X_{14}$ may be $C(R_{14})$ or N, $X_{15}$ may be $C(R_{15})$ or N, and $X_{16}$ may be $C(R_{16})$ or N, and $R_{13}$ to $R_{16}$ may each independently be the same as described in connection with $R_{10}$.

In an embodiment, the organometallic compound represented by Formula 1 may be represented by Formula 21 or 22:

Formula 21

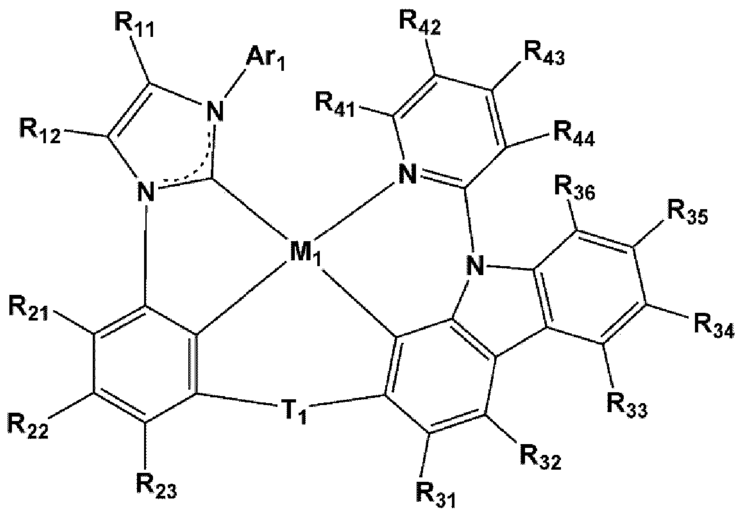

Formula 22

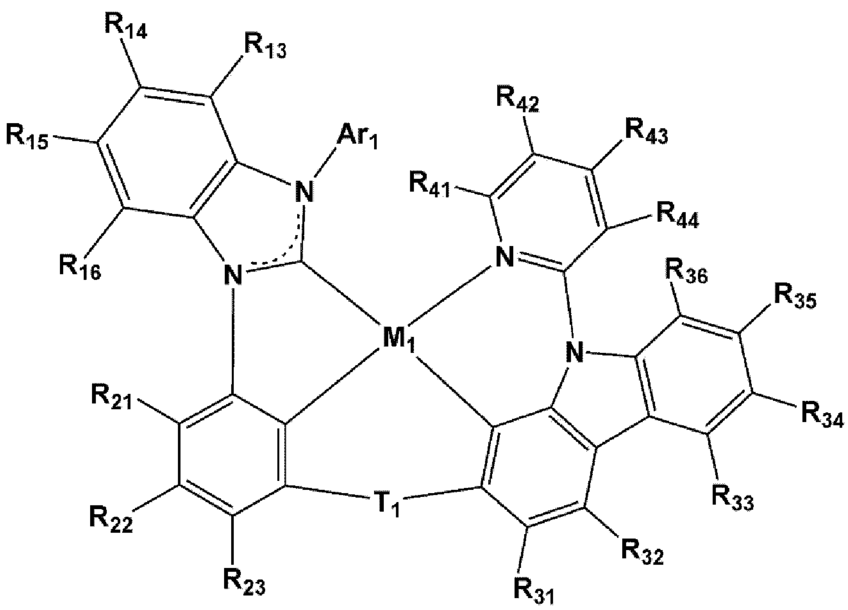

In Formulae 21 and 22,

$M_1$, $Ar_1$, $T_1$, $R_{11}$, $R_{12}$, and $R_{41}$ to $R_{44}$ may each be as described elsewhere herein,
$R_{13}$ to $R_{16}$ may each independently be the same as described in connection with $R_{10}$,
$R_{21}$ to $R_{23}$ may each independently be the same as described in connection with $R_{20}$, and
$R_{31}$ to $R_{36}$ may each independently be the same as described in connection with $R_{30}$.

In an embodiment, the organometallic compound may be electrically neutral.
In Formula 1, $L_{12}$ may be an organic ligand.
In an embodiment, $L_{12}$ may be a monodentate ligand or a bidentate ligand.
For example, $L_{12}$ in Formula 1 may be a ligand represented by one of Formulae 7-1 to 7-11, but embodiments are not limited thereto:

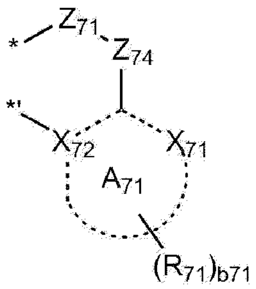

7-1

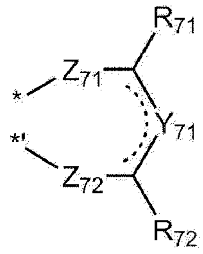

7-2

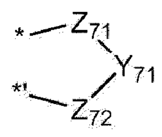

7-3

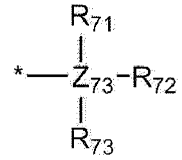

7-4

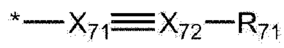

7-5

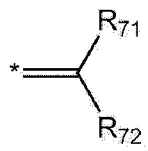

7-6

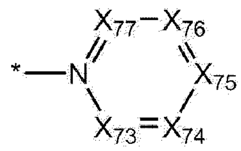

7-7

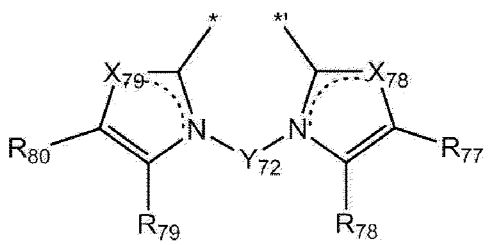

7-8

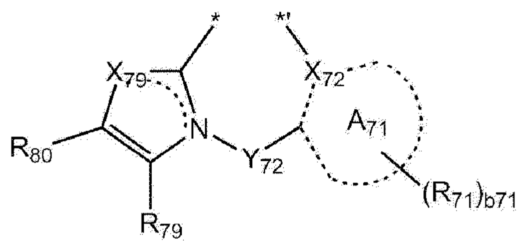

7-9

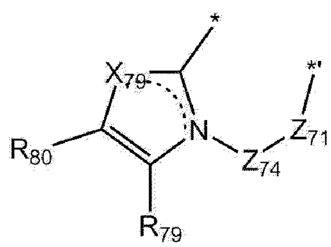

7-10

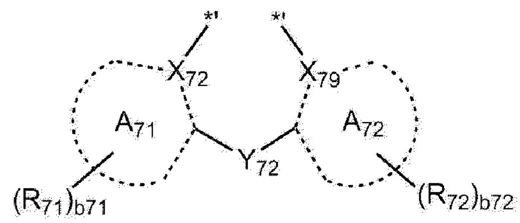

7-11

In Formulae 7-1 to 7-11,

$A_{71}$ and $A_{72}$ may each independently be a $C_5$-$C_{20}$ carbocyclic group or a $C_1$-$C_{20}$ heterocyclic group,
$X_{71}$ and $X_{72}$ may each independently be C or N,
$X_{73}$ may be N or C($Q_{73}$), $X_{74}$ may be N or C($Q_{74}$), $X_{75}$ may be N or C($Q_{75}$), $X_{76}$ may be N or C($Q_{76}$), $X_{77}$ may be N or C($Q_{77}$),
$X_{78}$ may be O, S or N($Q_{78}$), $X_{79}$ may be O, S or N($Q_{79}$),
$Y_{71}$ and $Y_{72}$ may each independently be a single bond, a double bond, a substituted or unsubstituted $C_1$-$C_5$ alkylene group, a substituted or unsubstituted $C_2$-$C_5$ alkenylene group, or a substituted or unsubstituted $C_6$-$C_{10}$ arylene group,
$Z_{71}$ and $Z_{72}$ may each independently be N, O, N($R_{74}$), P($R_{75}$)($R_{76}$), or As($R_{75}$)($R_{76}$),
$Z_{73}$ may be phosphorus (P) or arsenic (As),
$Z_{74}$ may be CO or $CH_2$,
$R_{71}$ to $R_{80}$ and $Q_{73}$ to $Q_{79}$ may each independently be hydrogen, deuterium, -F, - Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group,

a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group, wherein $R_{71}$ and $R_{72}$ may optionally be linked to each other to form a ring, $R_{77}$ and $R_{78}$ may optionally be linked to each other to form a ring, $R_{78}$ and $R_{79}$ may optionally be linked to each other to form a ring, and $R_{79}$ and $R_{80}$ may optionally be linked to each other to form a ring,

b71 and b72 may each independently be 1, 2, or 3, and

* and *' each indicate a binding site to a neighboring atom.

For example, $A_{71}$ and $A_{72}$ in Formula 7-1 may each independently be a benzene group, a naphthalene group, an imidazole group, a benzimidazole group, a pyridine group, a pyrimidine group, a triazine group, a quinoline group, or an isoquinoline group, but embodiments are not limited thereto.

For example, $X_{72}$ and $X_{79}$ in Formula 7-1 may each be N, but embodiments are not limited thereto.

For example, in Formula 7-7, $X_{73}$ may be $C(Q_{73})$, $X_{74}$ may be $C(Q_{74})$, $X_{75}$ may be $C(Q_{75})$, $X_{76}$ may be $C(Q_{76})$, and $X_{77}$ may be $C(Q_{77})$, but embodiments are not limited thereto.

In an embodiment, in Formula 7-8, $X_{78}$ may be $N(Q_{78})$, and $X_{79}$ may be $N(Q_{79})$, but embodiments are not limited thereto.

For example, $Y_{71}$ and $Y_{72}$ in Formulae 7-2, 7-3, and 7-8 may each independently be a substituted or unsubstituted methylene group or a substituted or unsubstituted phenylene group, but embodiments are not limited thereto.

For example, $Z_{71}$ and $Z_{72}$ in Formulae 7-1 and 7-2 may each be O, but embodiments are not limited thereto.

For example, $Z_{73}$ in Formula 7-4 may be P, but embodiments are not limited thereto.

For example, $R_{71}$ to $R_{80}$ and $Q_{73}$ to $Q_{79}$ in Formulae 7-1 to 7-11 may each independently be: hydrogen, deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, $-SF_5$, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, - F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkylphenyl group, a naphthyl group, a pyridinyl group, a pyrimidinyl group, or a combination thereof;

a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group;

a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a

cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, or an imidazopyrimidinyl group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{20}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, - $Si(Q_{11})(Q_{12})(Q_{13})$, $-B(Q_{11})(Q_{12})$, $-N(Q_{11})(Q_{12})$, or a combination thereof; or

$-Si(Q_1)(Q_2)(Q_3)$, $-B(Q_1)(Q_2)$, or $-N(Q_1)(Q_2)$, and

$Q_1$ to $Q_3$ and $Q_{11}$ to $Q_{13}$ may each independently be:

a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neopentyl group, a 3-pentyl group, a 3-methyl-2-butyl group, a phenyl group, a biphenyl group, a $C_1$-$C_{20}$ alkylphenyl group, or a naphthyl group; or

a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neopentyl group, a 3-pentyl group, a 3-methyl-2-butyl group, a phenyl group, or a naphthyl group, each substituted with deuterium, a phenyl group, or a combination thereof, but embodiments are not limited thereto.

In Formula 1, $L_{12}$ may be a ligand represented by one of Formulae 8-1 to 8-23, but embodiments are not limited thereto:

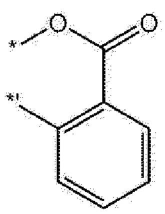
8-1

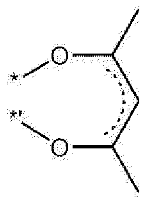
8-2

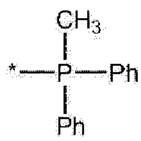
8-3

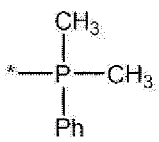
8-4

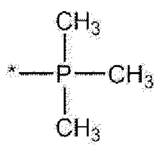
8-5

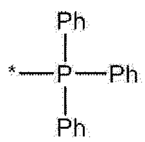
8-6

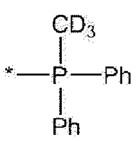
8-7

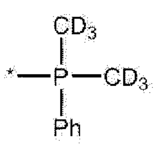
8-8

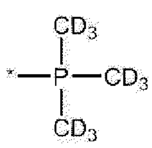
8-9

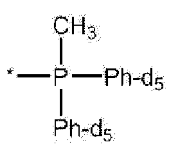
8-10

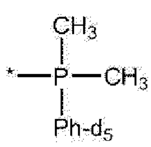
8-11

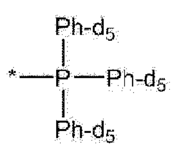
8-12

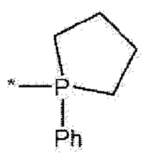
8-13

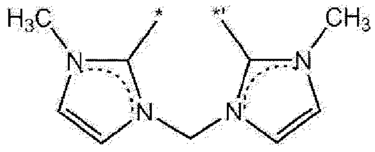

8-14

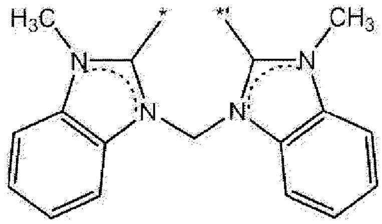

8-15

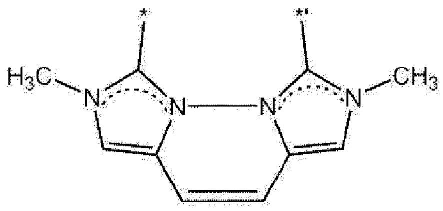

8-16

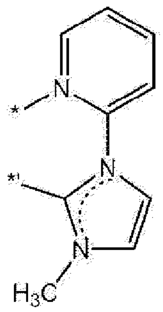

8-17

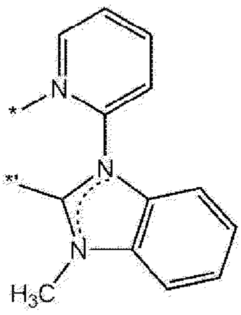

8-18

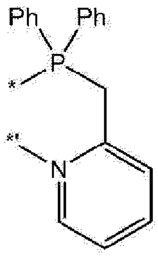

8-19

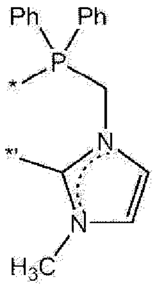

8-20

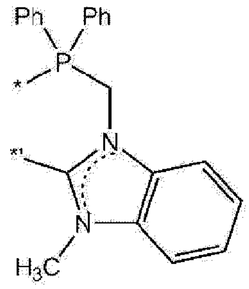

8-21

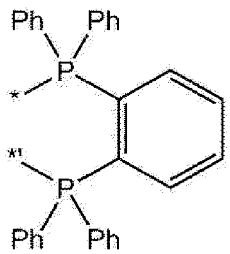

8-22

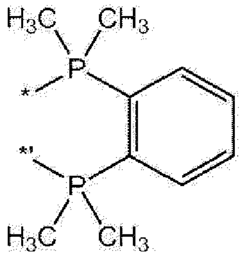

8-23

In Formulae 8-1 to 8-23,

Ph may be a phenyl group,
Ph-$d_5$ may be a phenyl group in which all hydrogens are each substituted with deuterium; and
* and *' each indicate a binding site to a neighboring atom.

In Formula 1, n11 may be 1, and n12 may be 0, 1, or 2.

In an embodiment, In Formula 1, $M_1$ may be Pt, n11 may be 1, and n12 may be 0, but embodiments are not limited thereto.

In an embodiment, the organometallic compound may be one of Compounds 1 to 324:

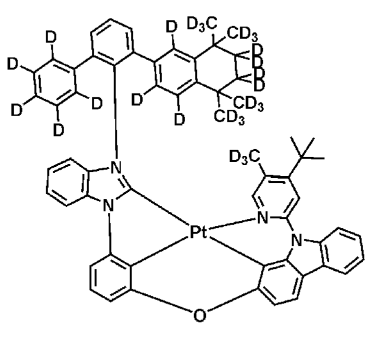

**1**

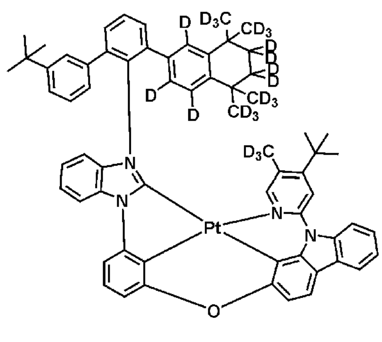

**2**

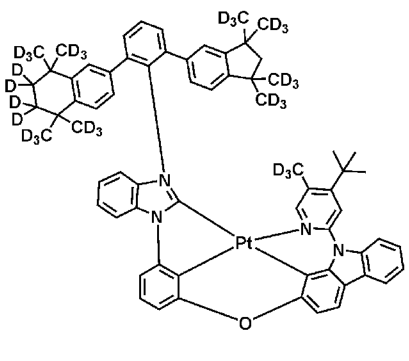

**3**

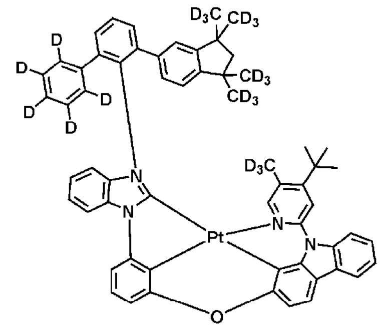

4

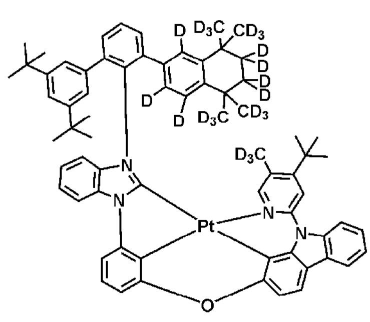

5

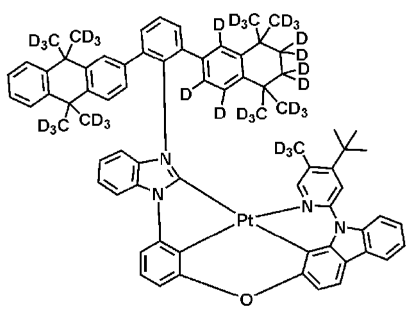

6

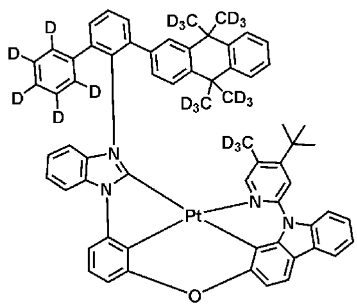

7

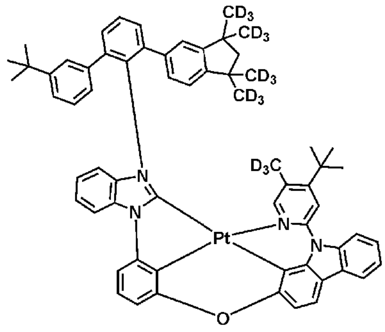

8

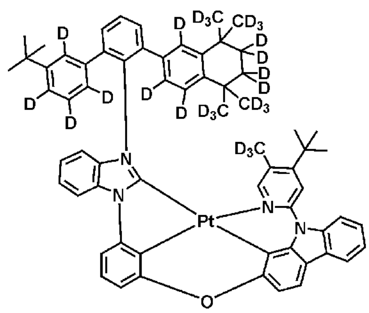

9

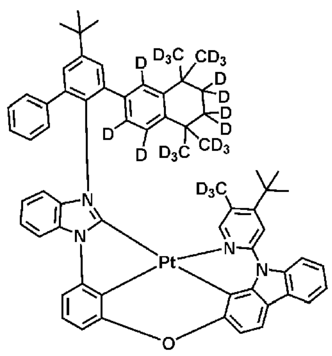

10

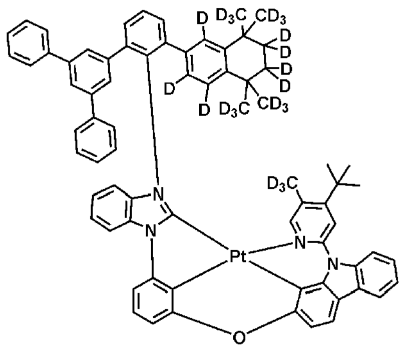

11

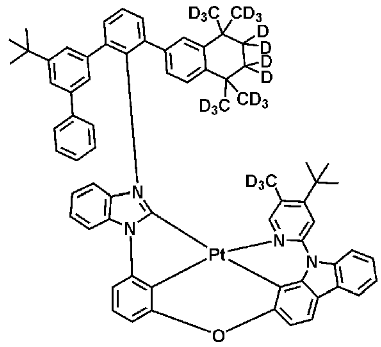

12

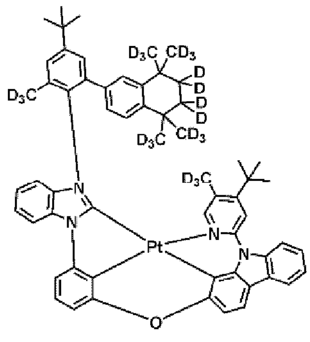

13

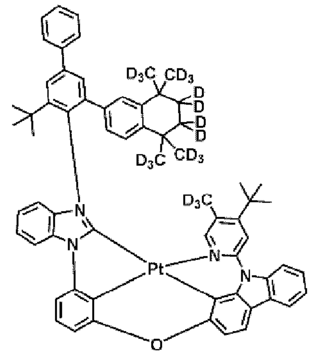

14

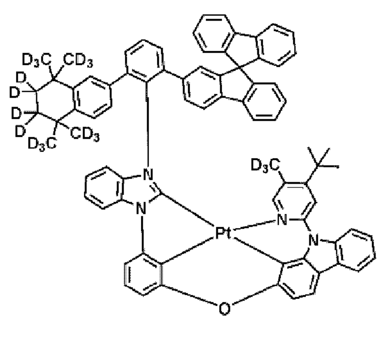

15

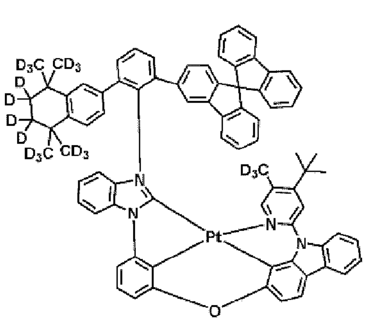

**16**

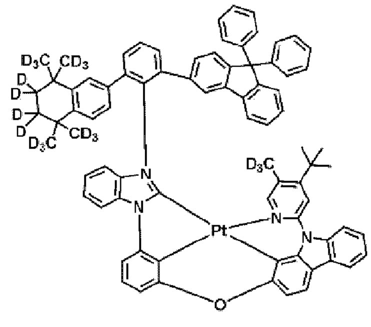

**17**

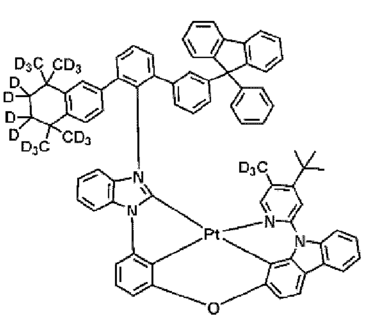

**18**

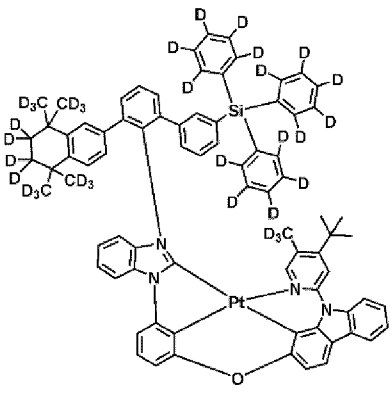

**19**

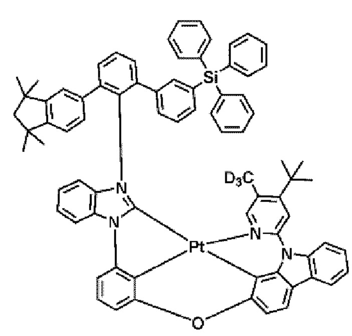

**20**

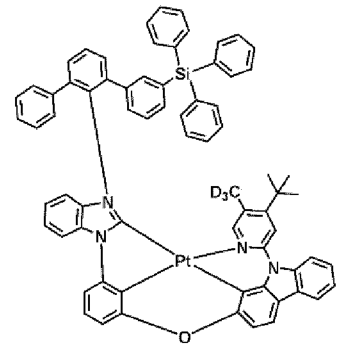

**21**

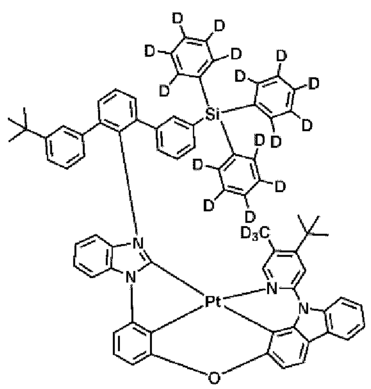

**22**

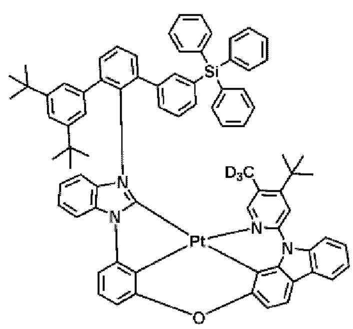

**23**

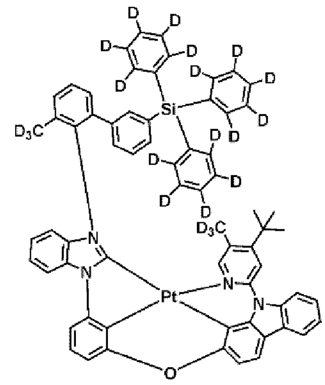

**24**

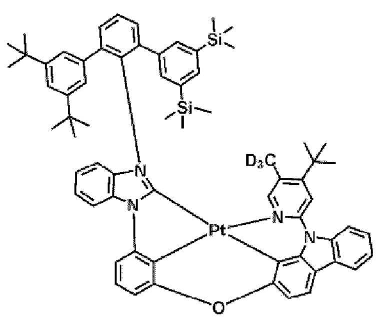

**25**

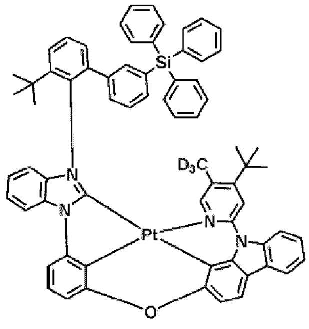

**26**

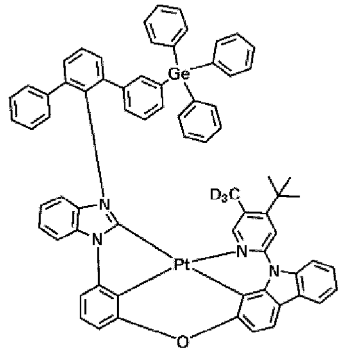

**27**

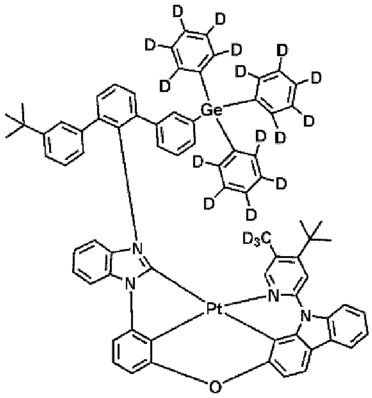

28

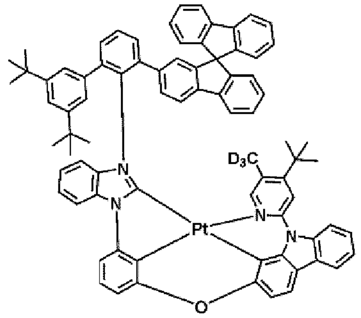

29

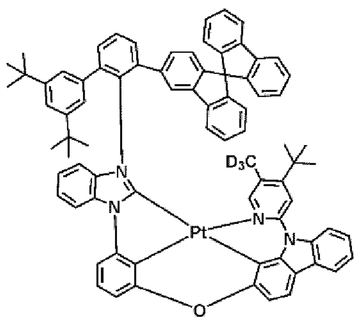

30

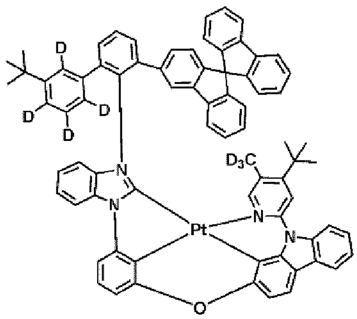

31

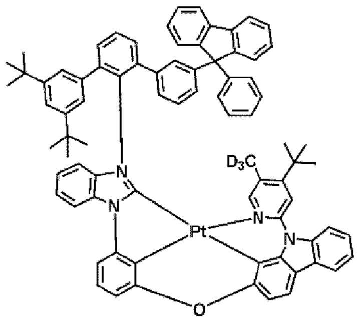

32

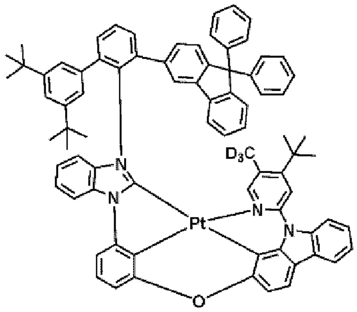

33

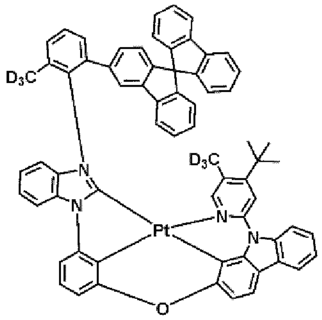

34

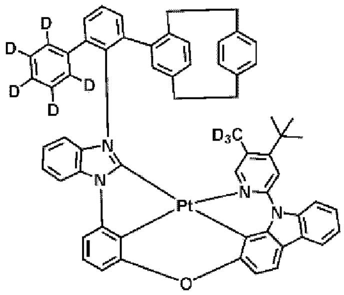

35

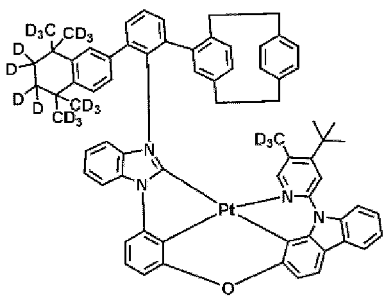

36

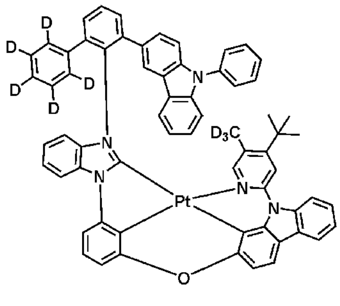

37

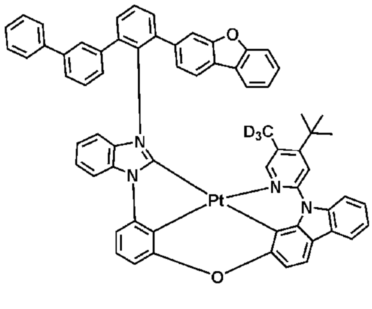

38

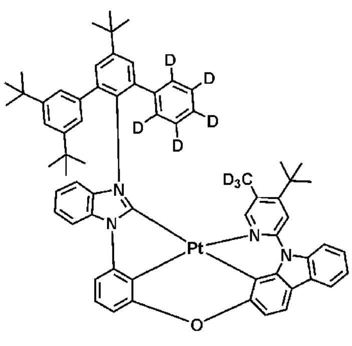

39

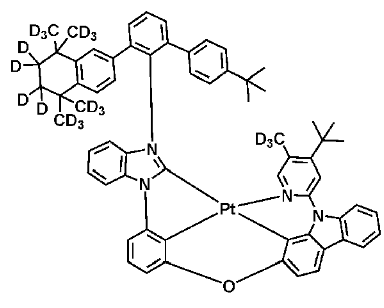

40

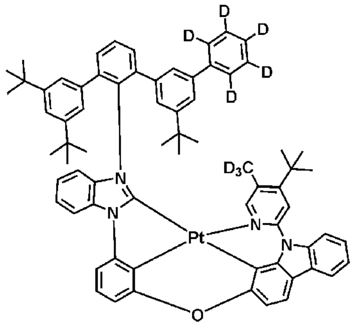

41

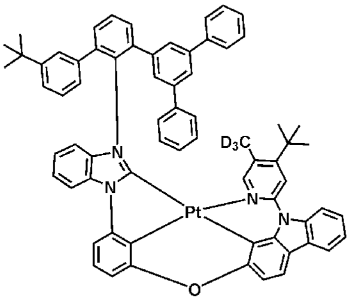

42

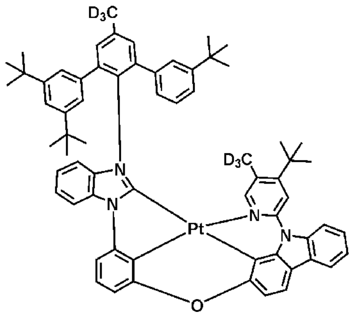

43

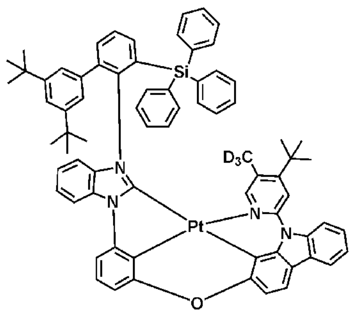

44

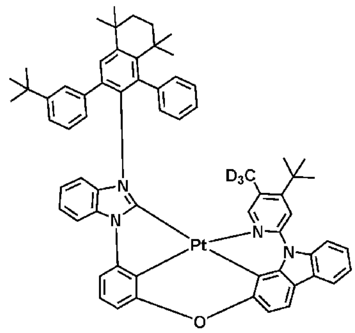

45

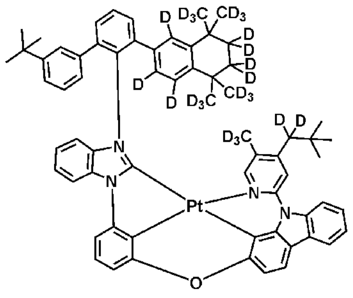

46

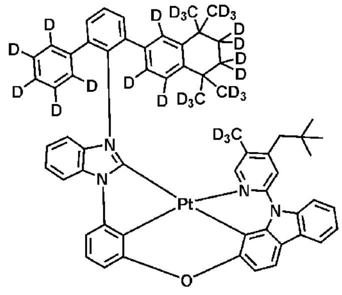

47

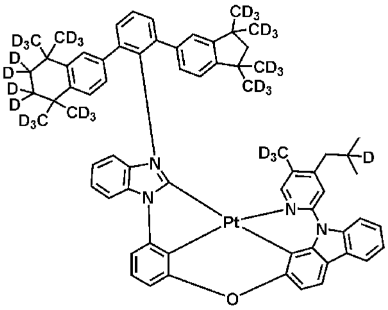

48

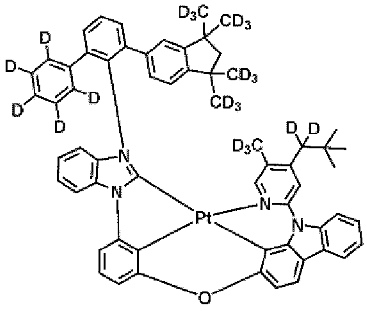

49

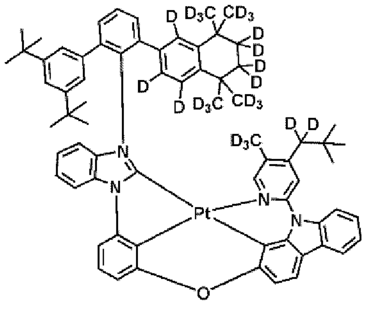

50

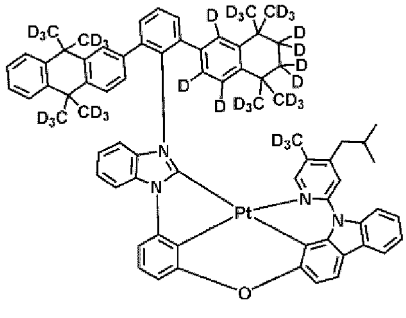

51

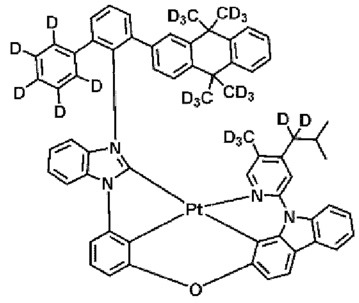

**52**

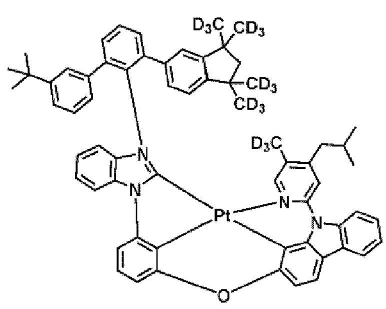

**53**

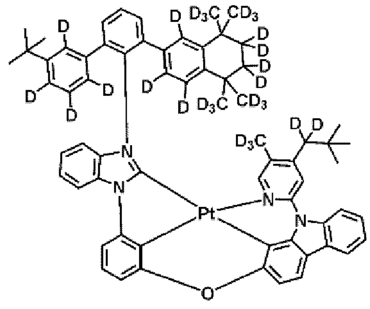

**54**

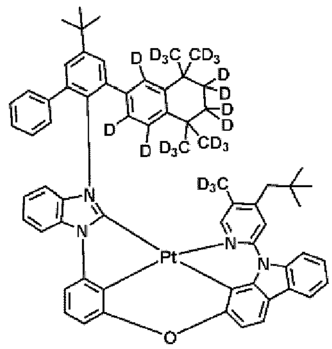

**55**

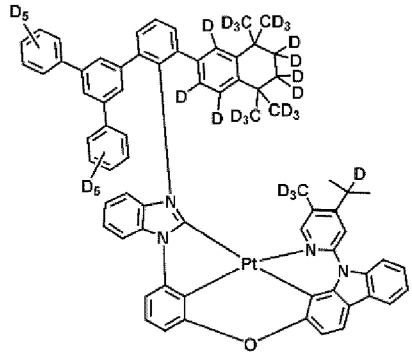

**56**

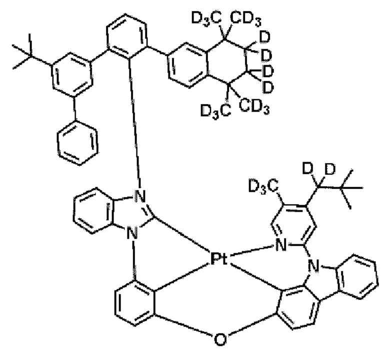

**57**

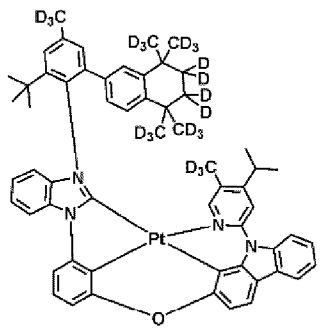

**58**

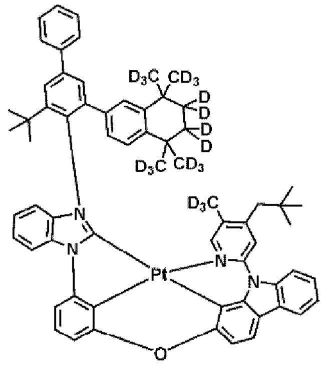

**59**

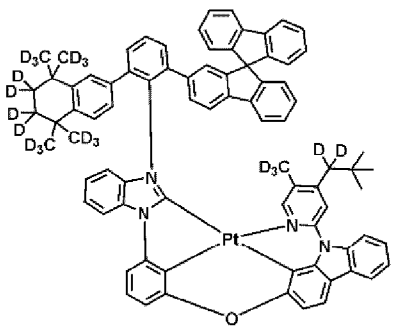

**60**

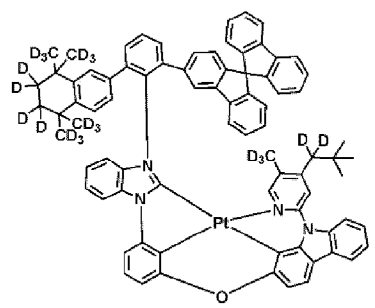

**61**

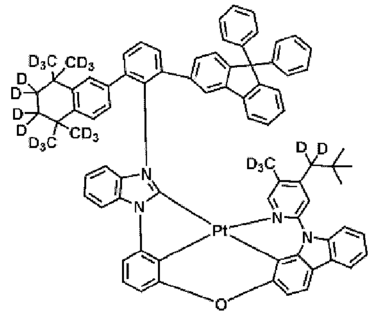

**62**

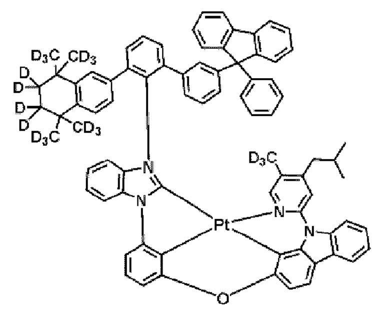

**63**

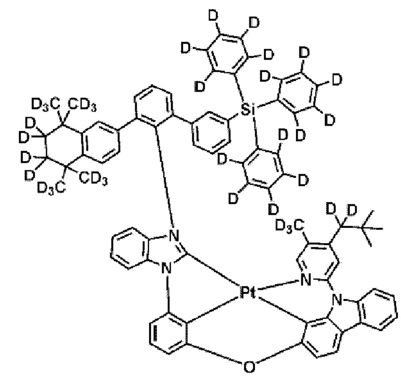

**64**

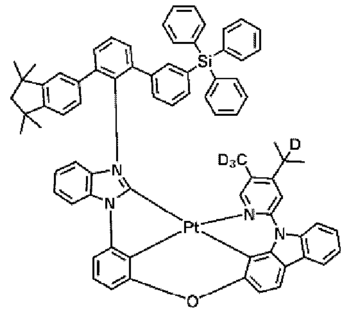

**65**

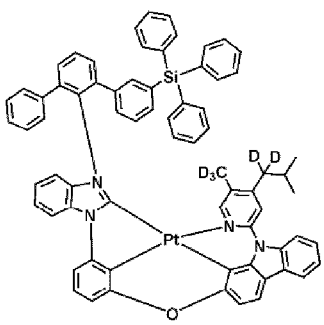

**66**

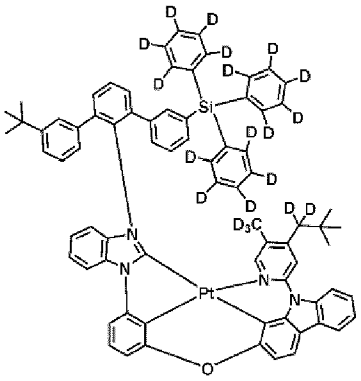

**67**

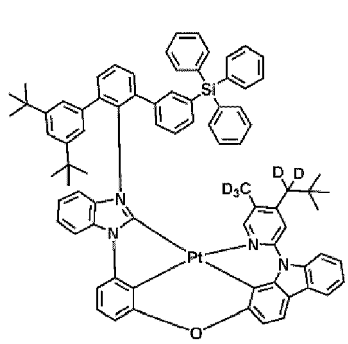

**68**

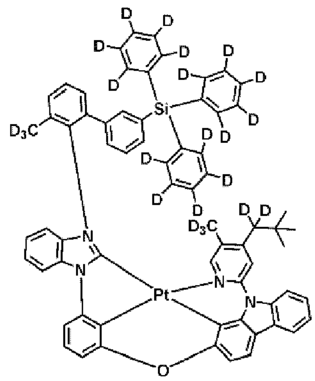

**69**

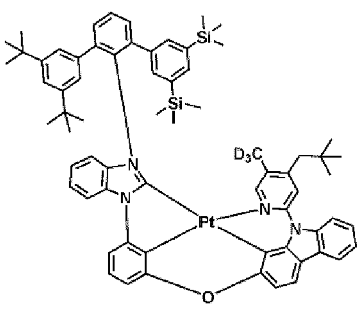

**70**

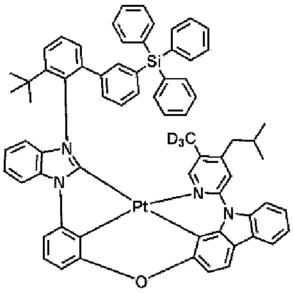

**71**

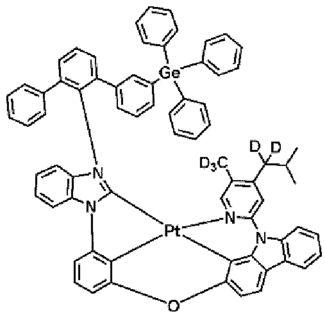

**72**

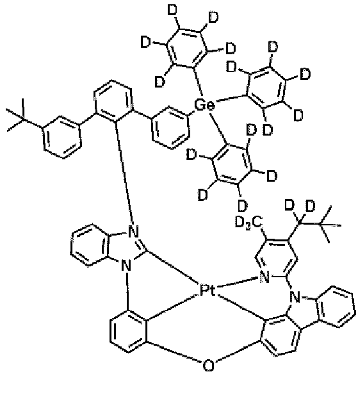

**73**

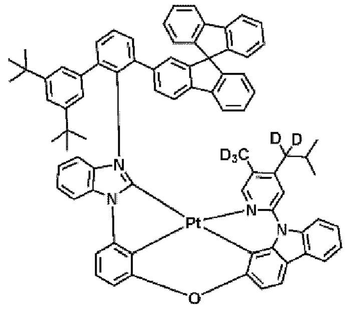

**74**

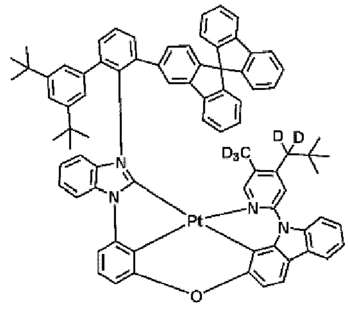

**75**

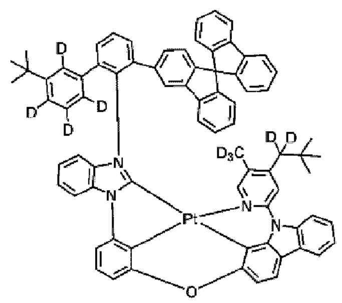

76

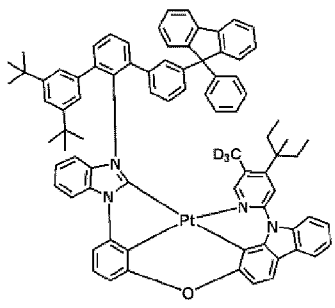

77

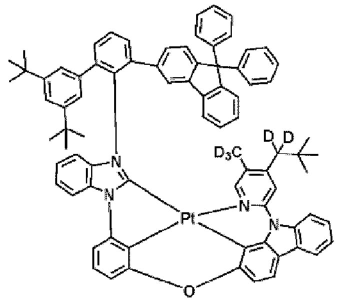

78

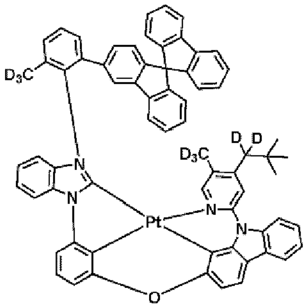

79

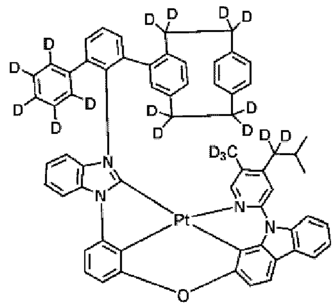

80

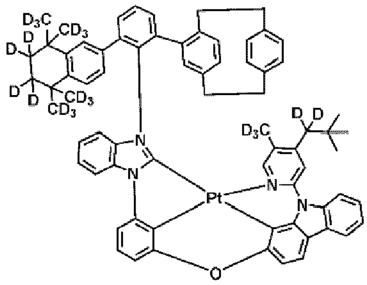

81

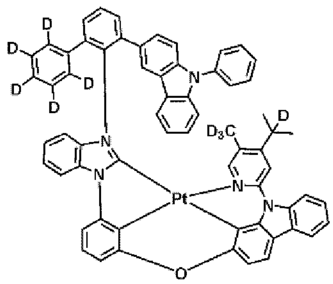

82

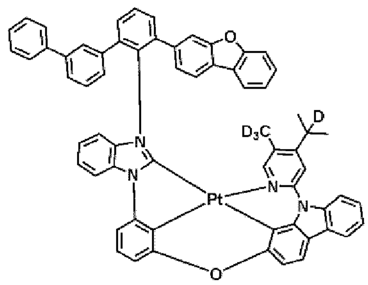

83

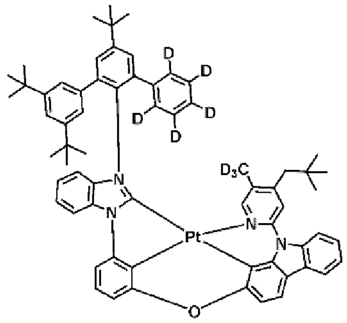

84

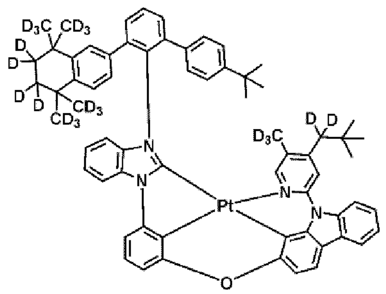

85

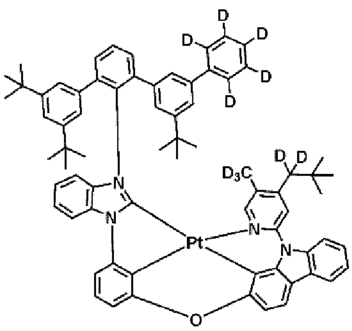

86

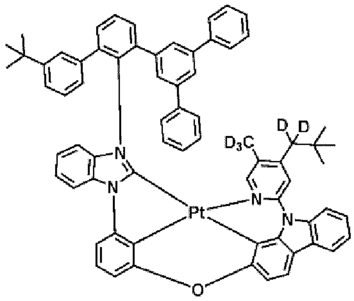

87

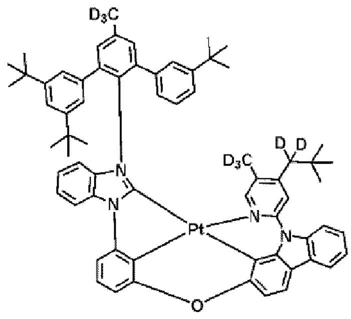

88

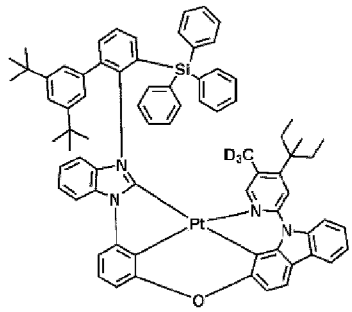

89

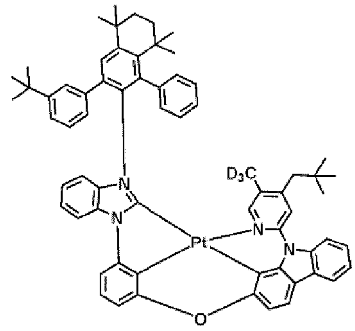

90

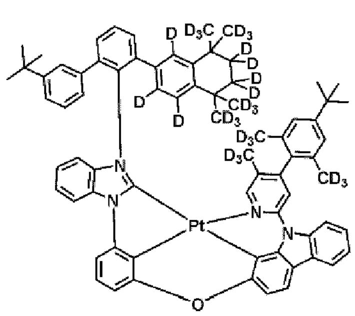

91

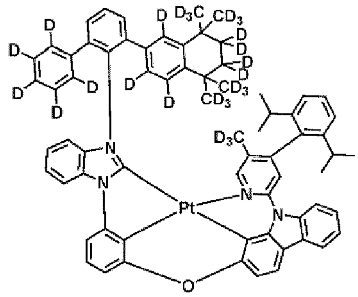

92

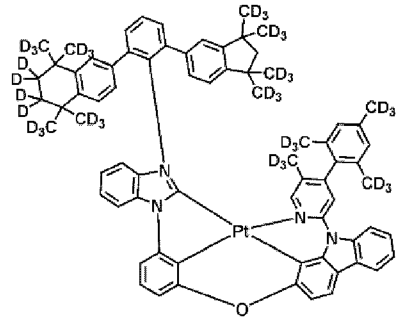

93

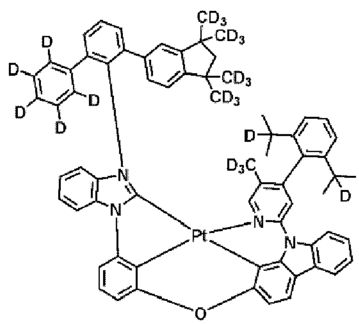

94

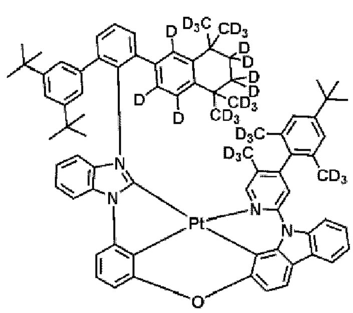

95

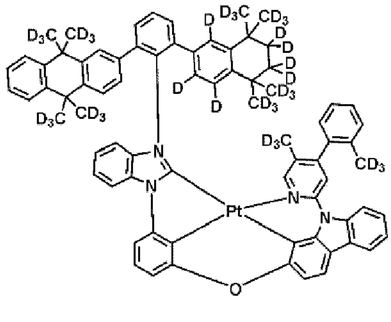

96

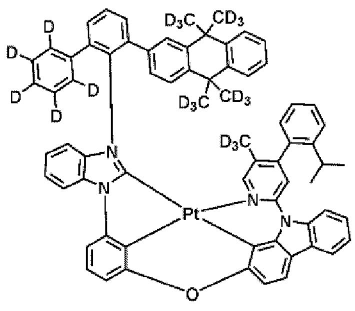

97

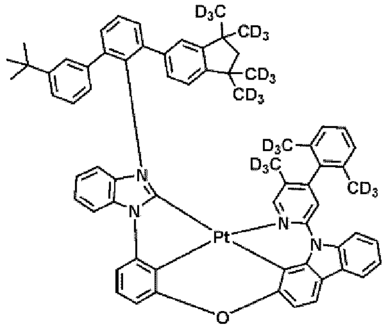

98

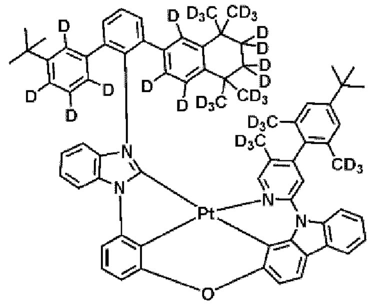

99

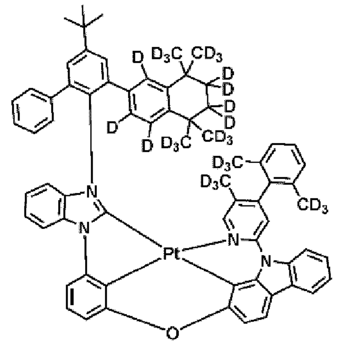

100

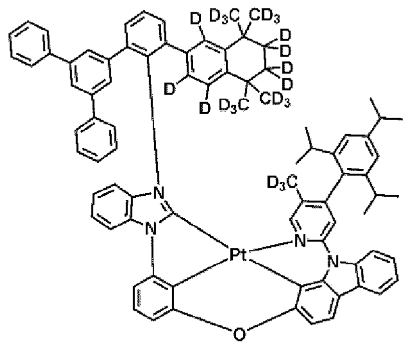

101

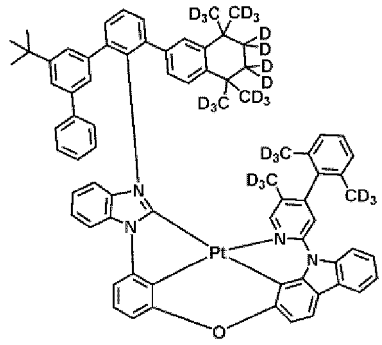

102

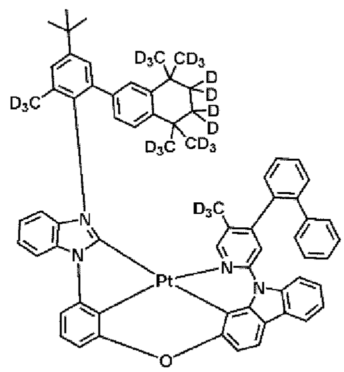

103

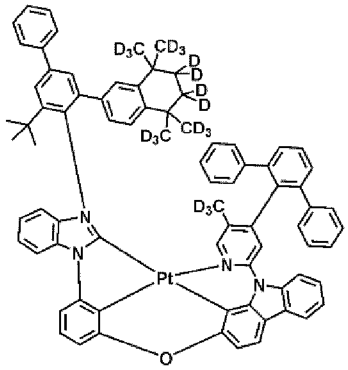

104

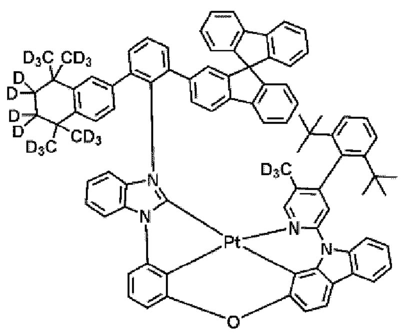

105

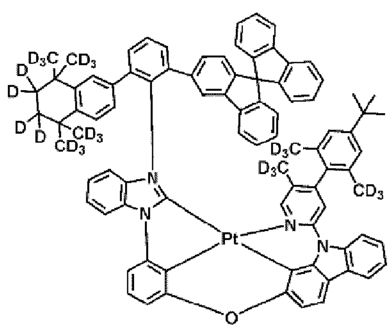

106

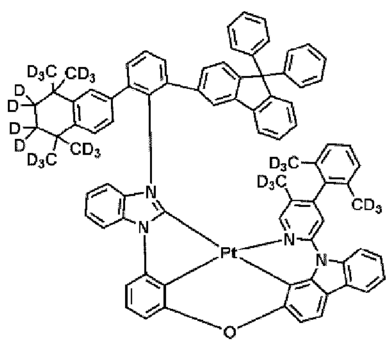

107

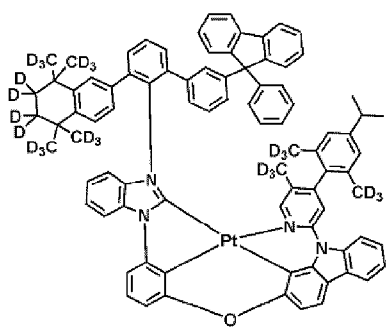

108

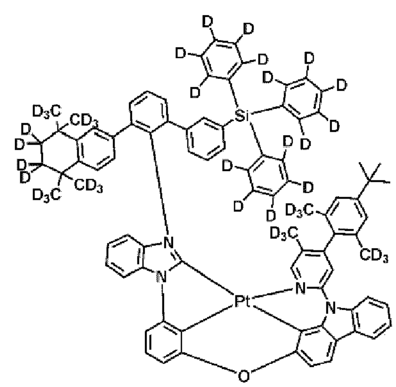

109

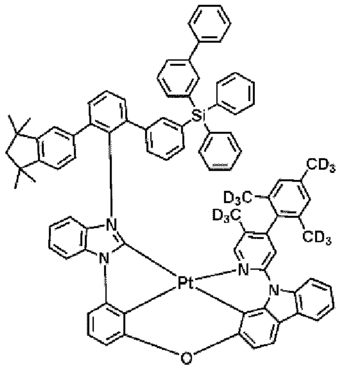

110

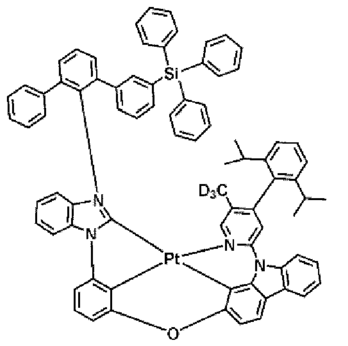

111

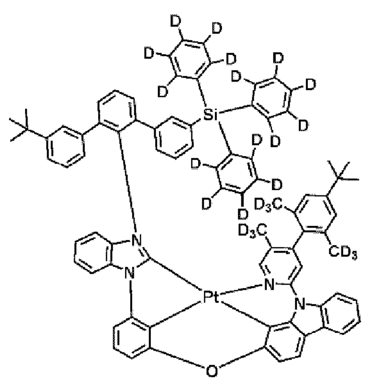

**112**

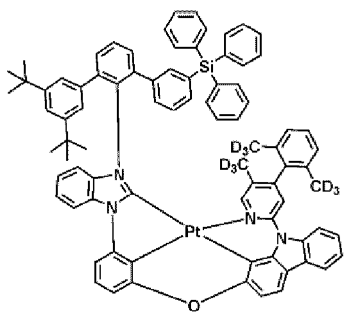

**113**

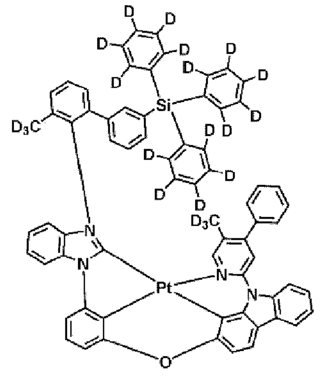

**114**

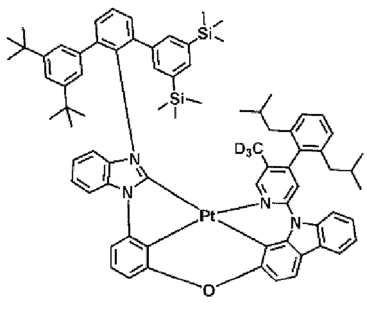

**115**

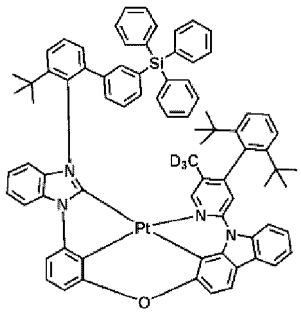

**116**

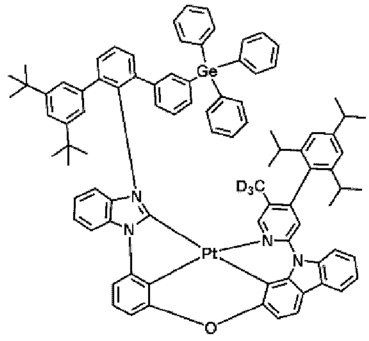

**117**

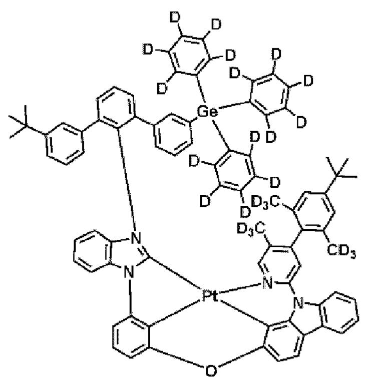

**118**

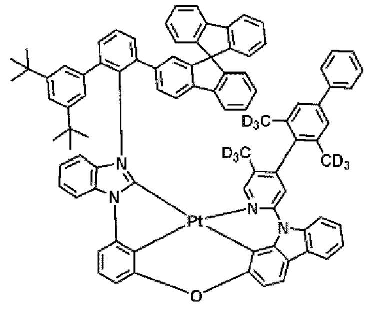

**119**

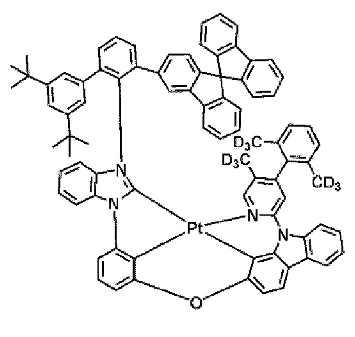

**120**

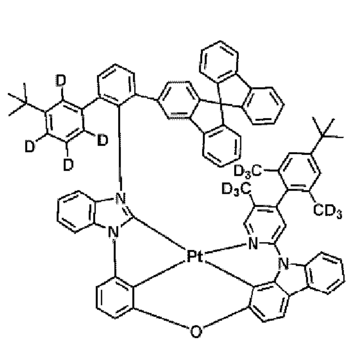

**121**

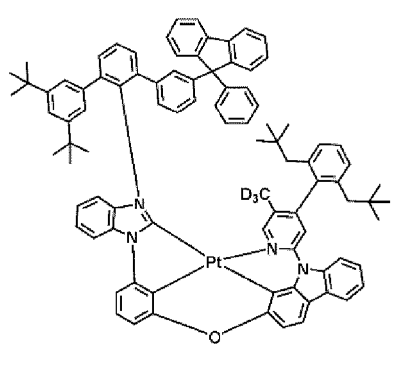

**122**

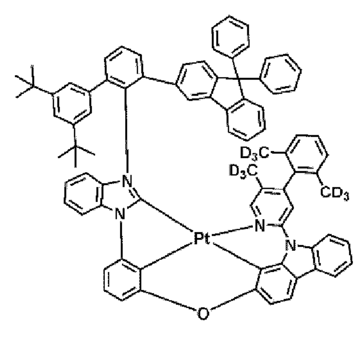

**123**

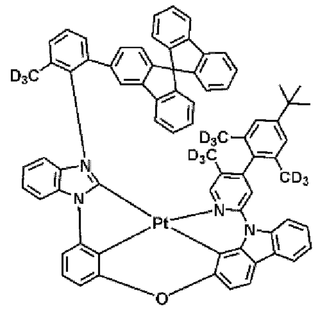

124

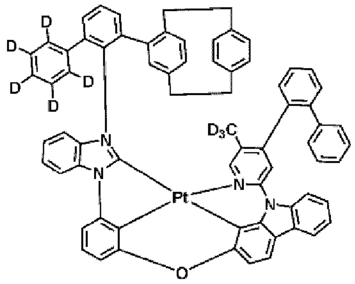

125

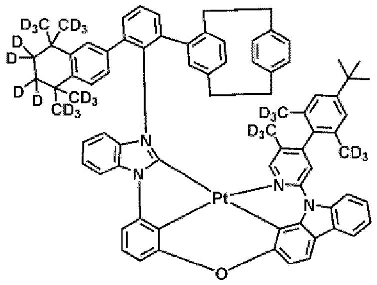

126

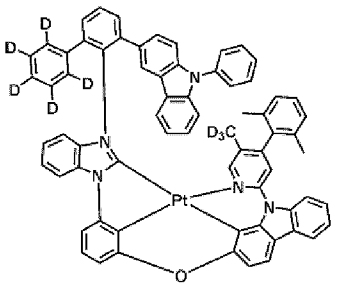

127

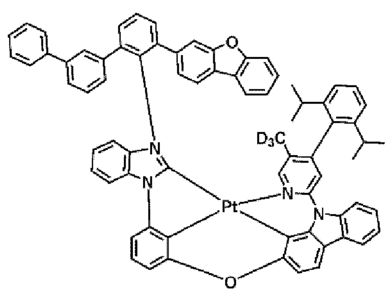

128

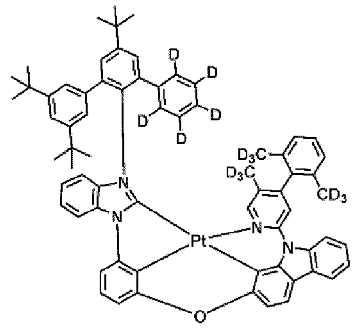

129

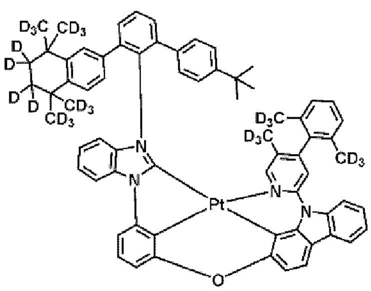

130

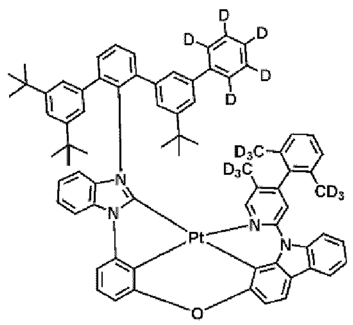

131

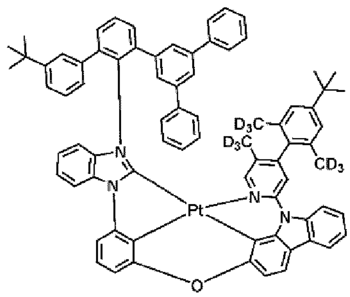

132

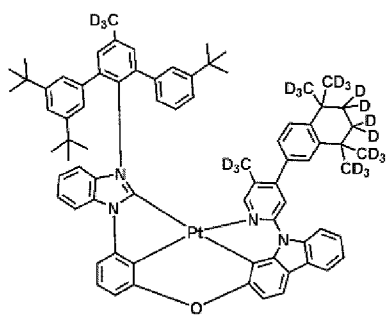

133

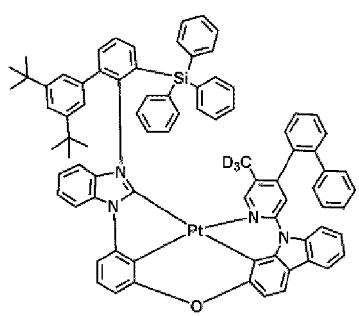

134

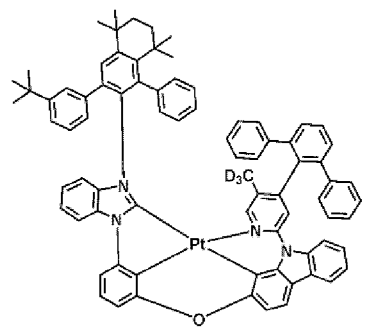

135

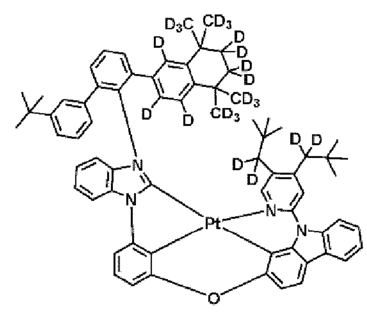

136

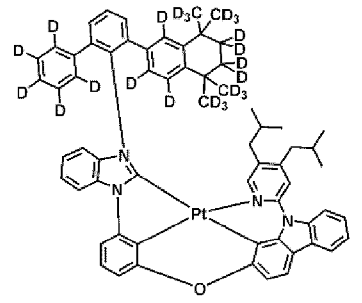

137

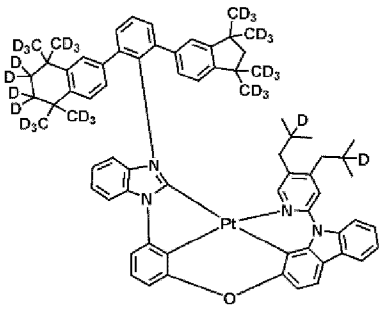

138

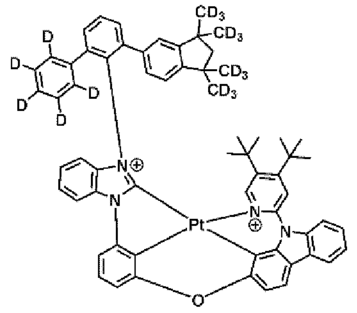

139

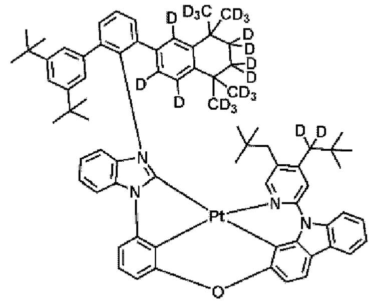

140

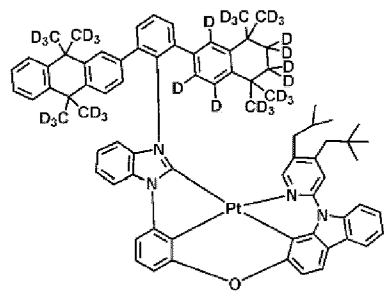

141

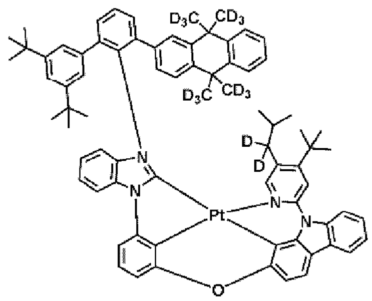

142

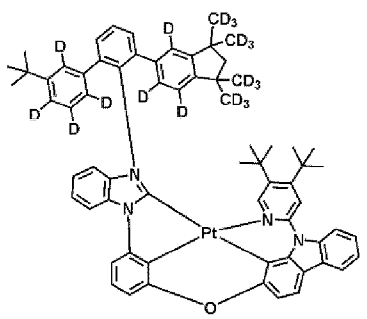

143

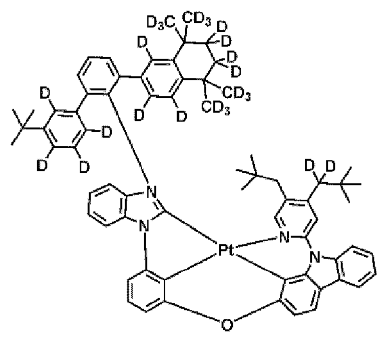

144

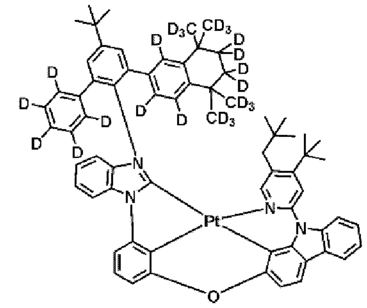

145

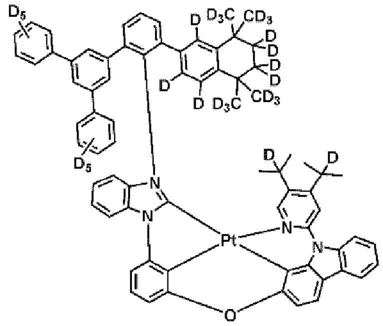

146

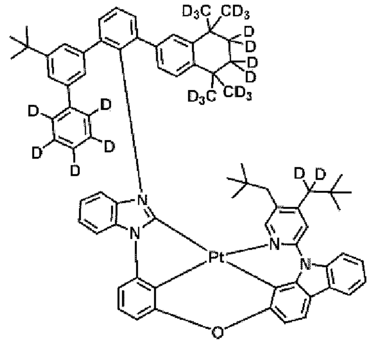

147

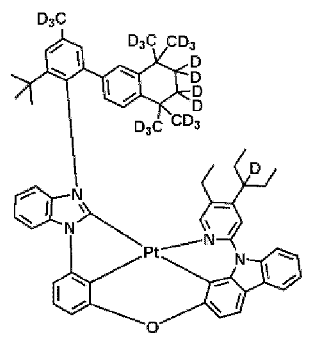

148

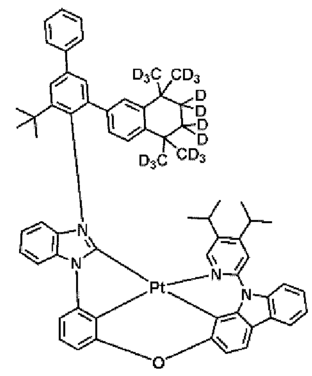

149

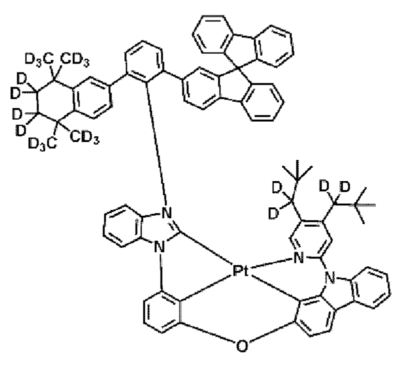

150

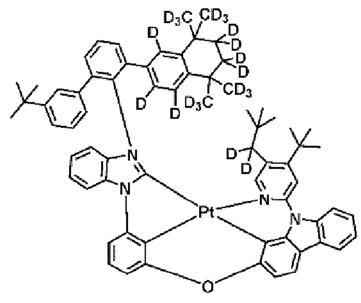

151

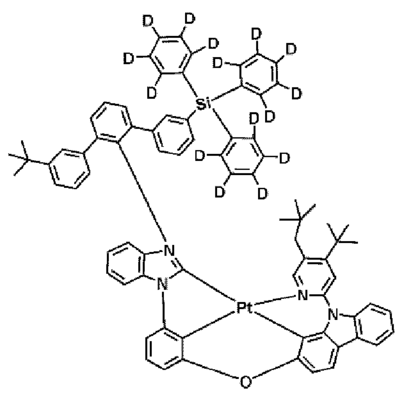

152

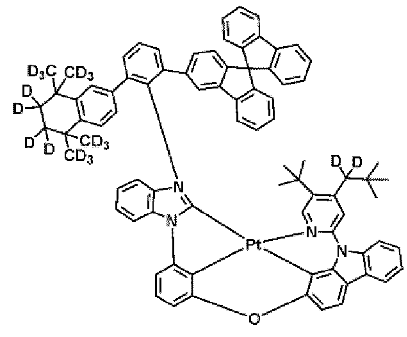

153

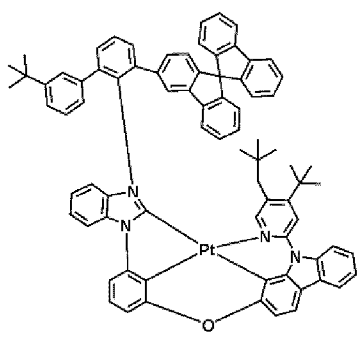

154

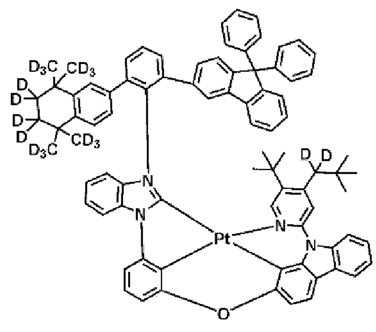

155

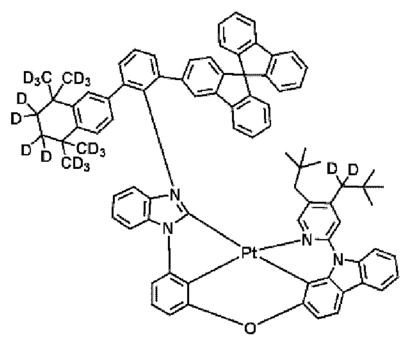

156

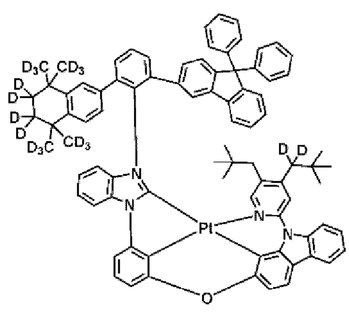

157

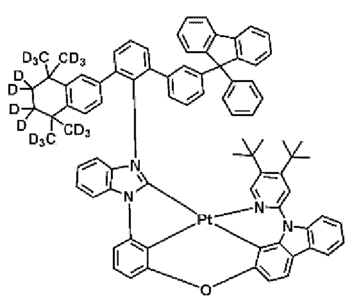

158

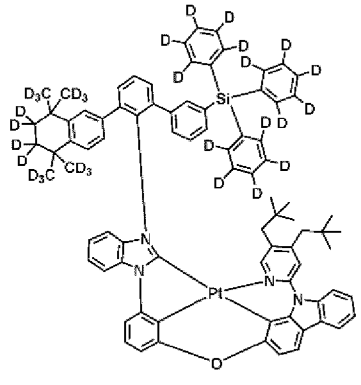

159

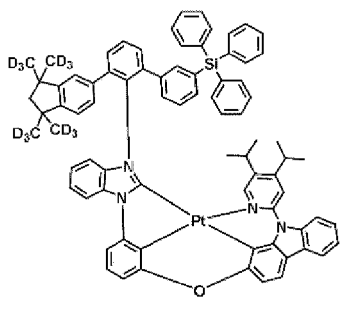

**160**

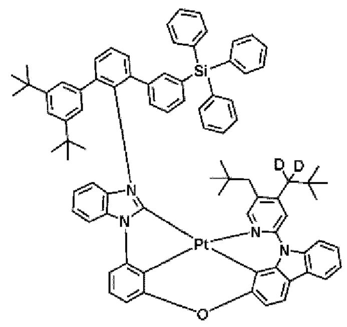

**161**

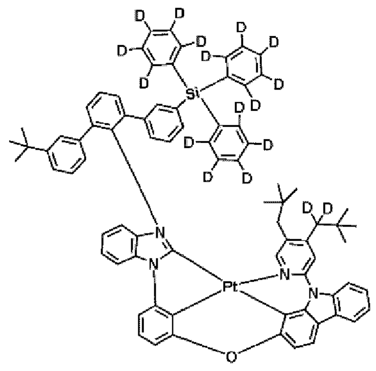

**162**

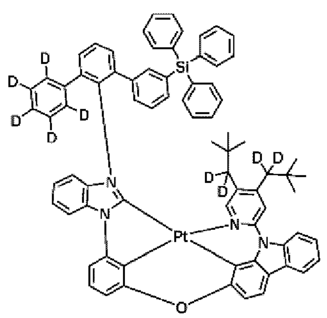

**163**

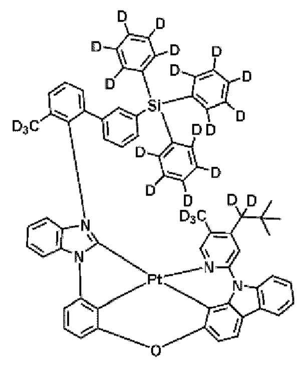

**164**

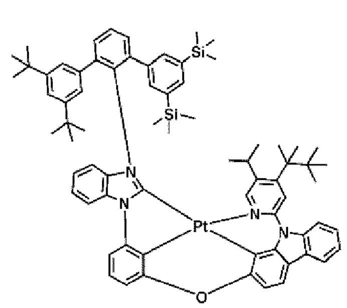

**165**

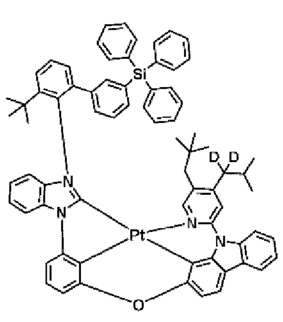

**166**

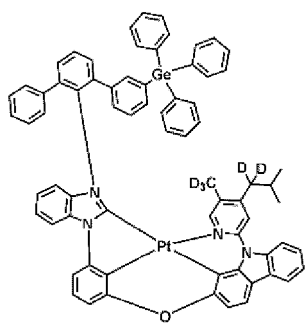

**167**

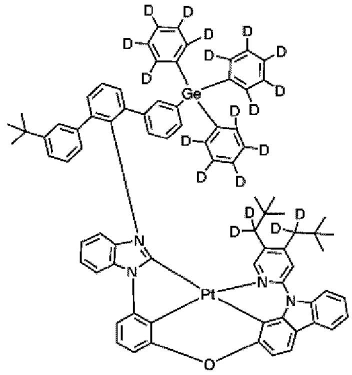

**168**

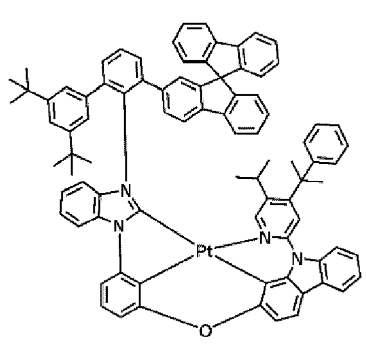

**169**

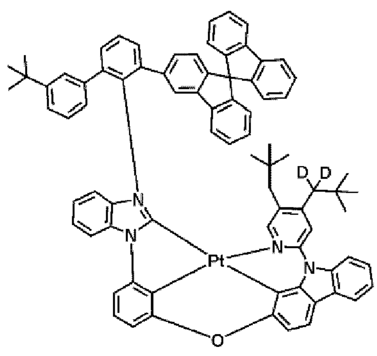

**170**

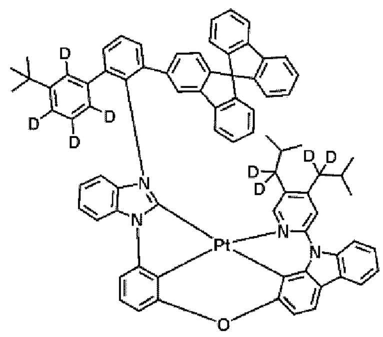

**171**

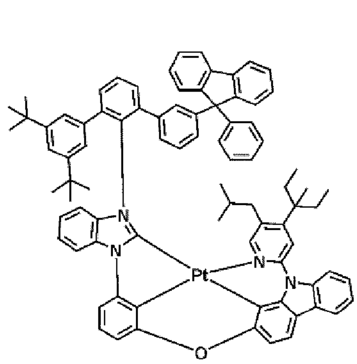

172

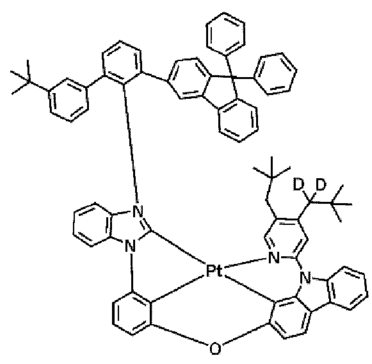

173

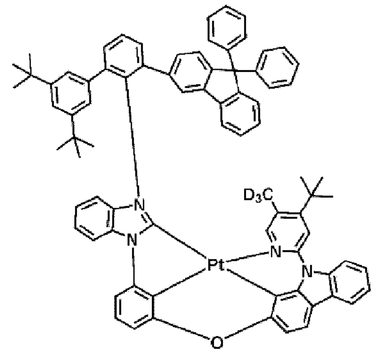

174

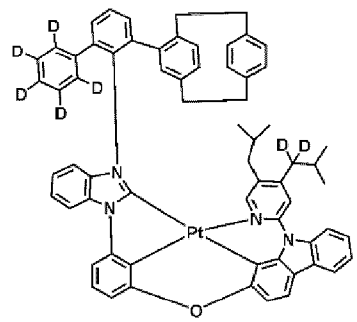

175

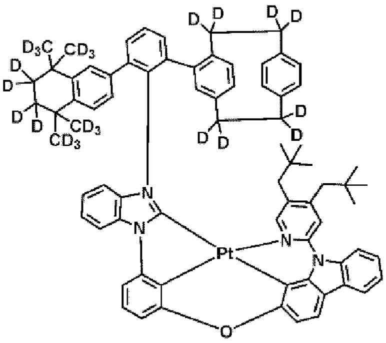

176

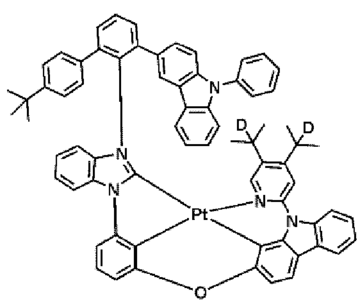

177

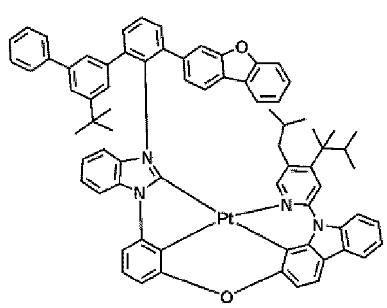

178

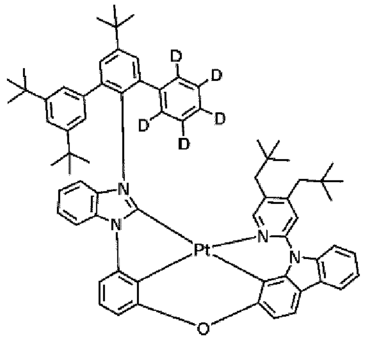

179

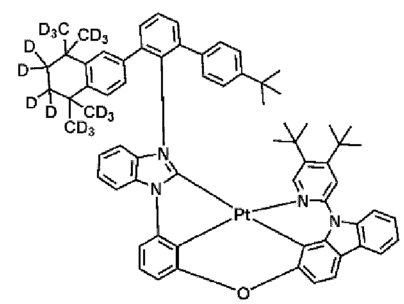

180

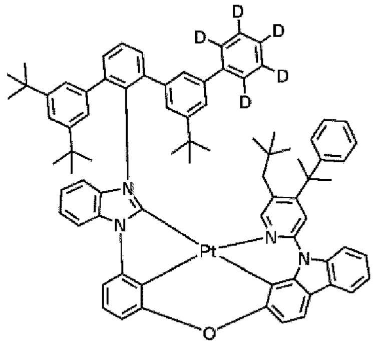

181

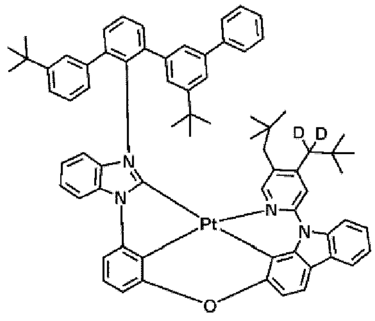

182

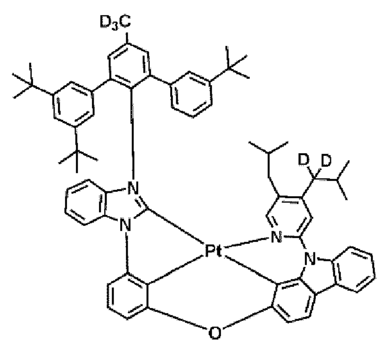

183

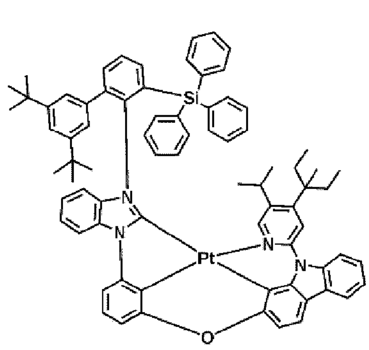

184

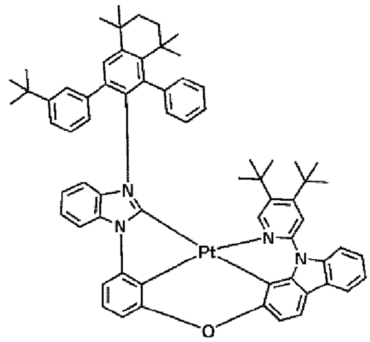

185

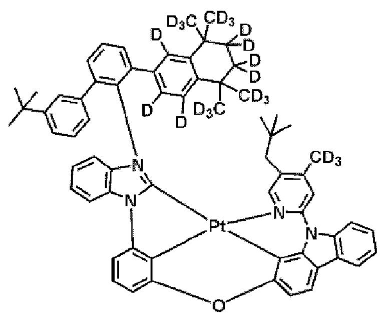

186

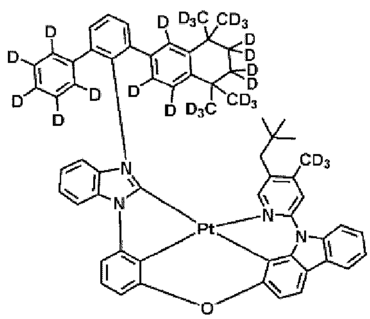

187

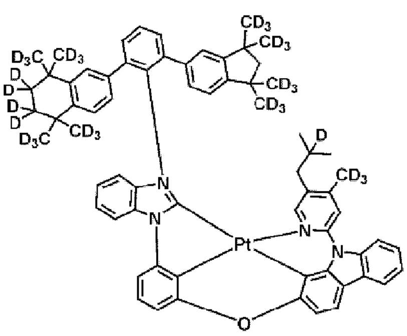

188

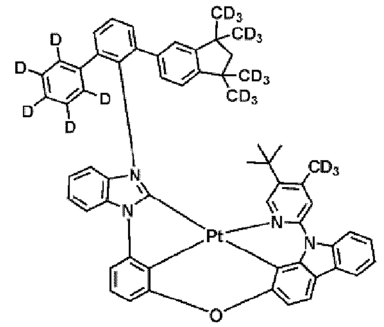

189

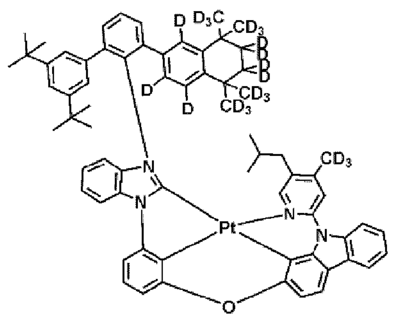

190

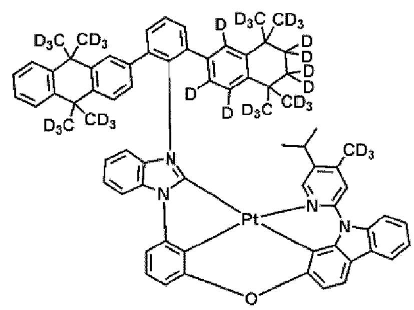

191

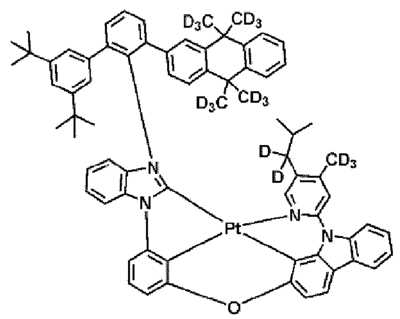

192

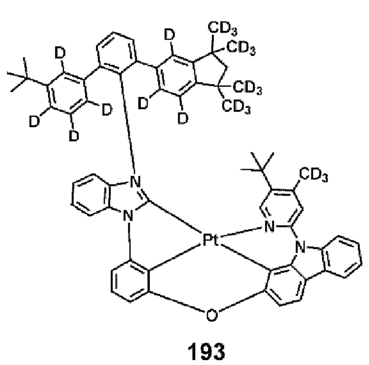

193

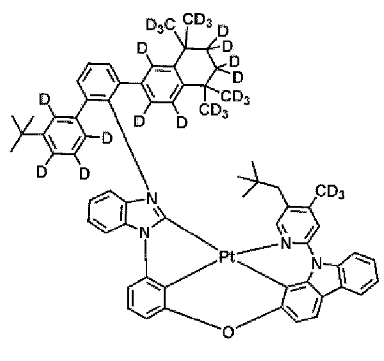

194

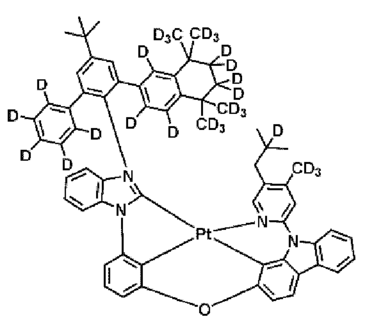

195

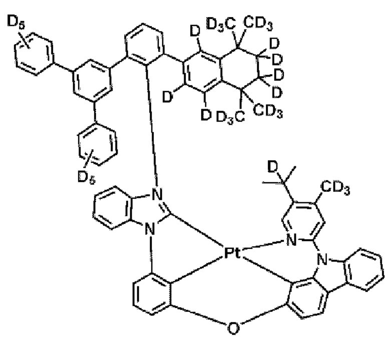

**196**

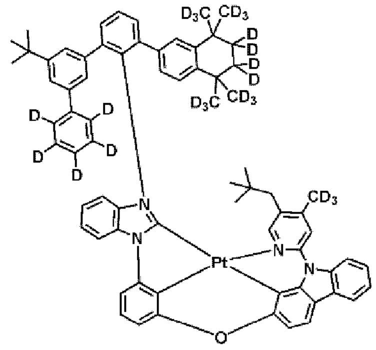

**197**

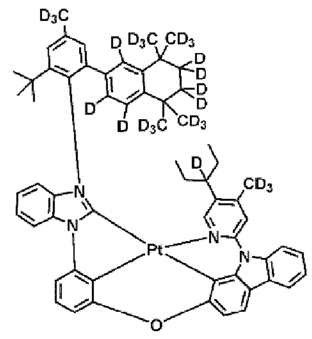

**198**

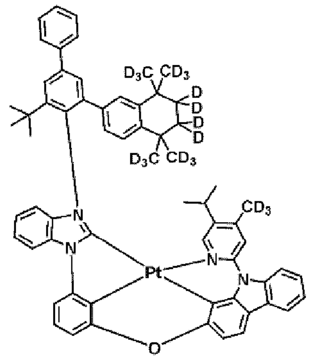

**199**

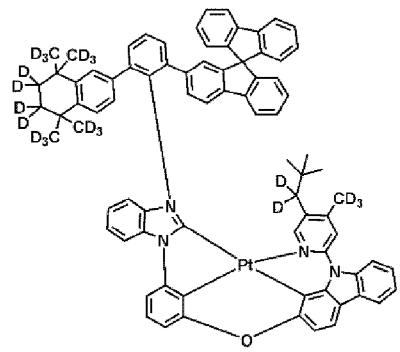

**200**

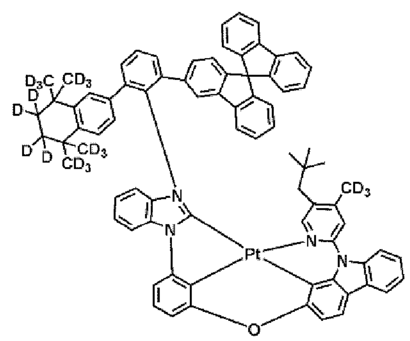

**201**

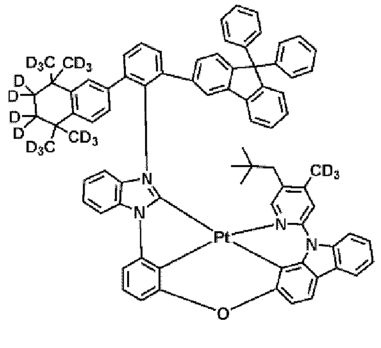

**202**

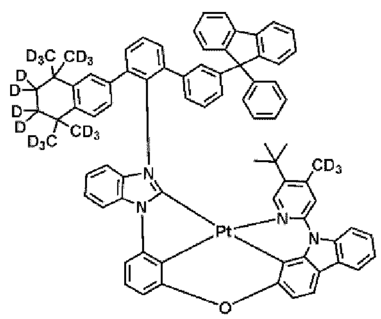

**203**

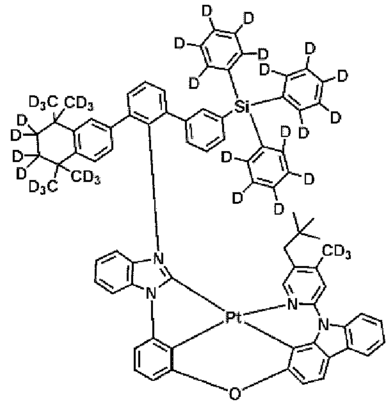

**204**

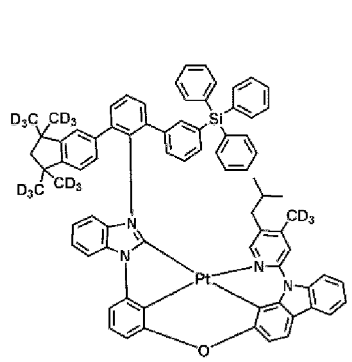

**205**

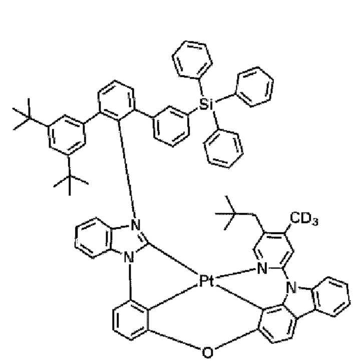

**206**

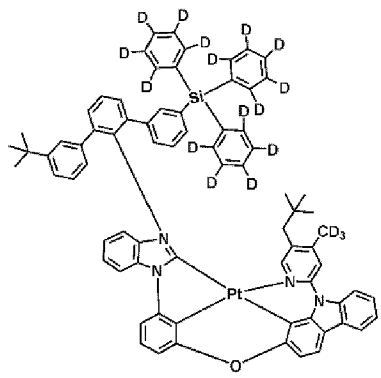

**207**

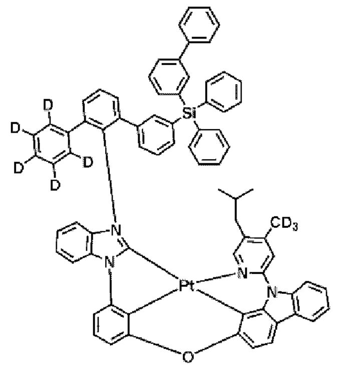

208

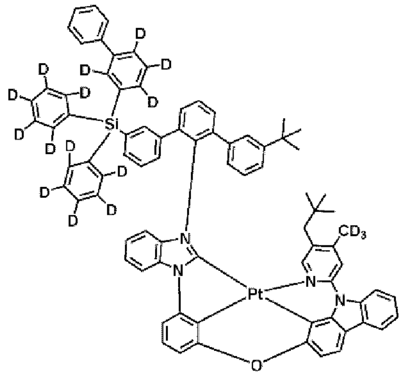

209

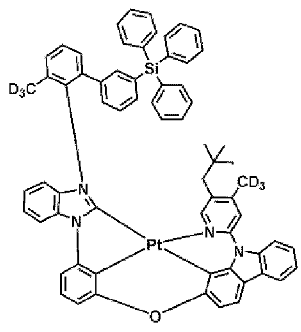

210

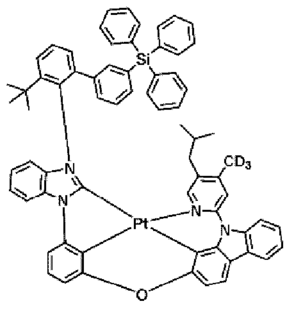

211

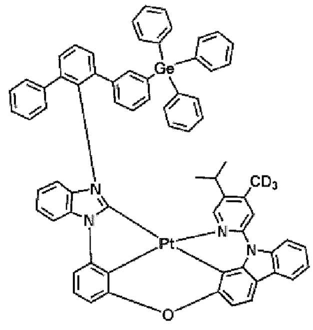

212

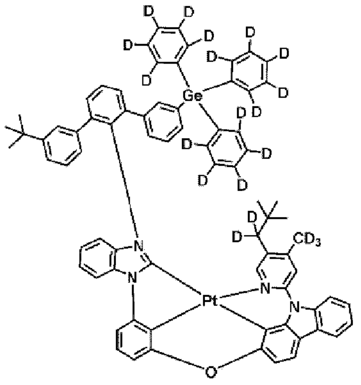

213

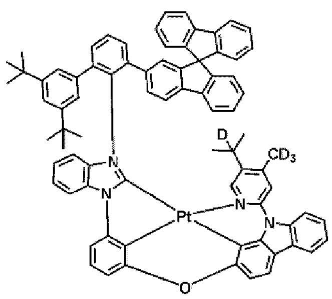

214

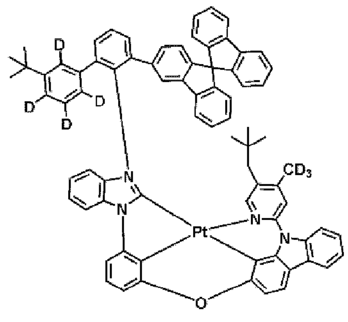

215

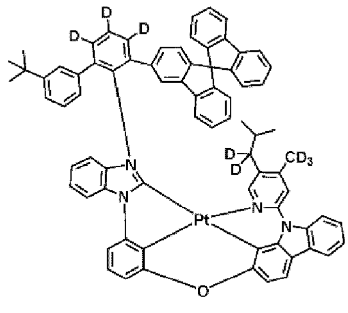

216

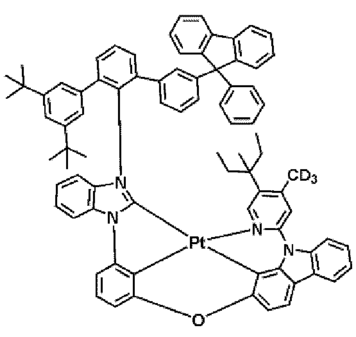

217

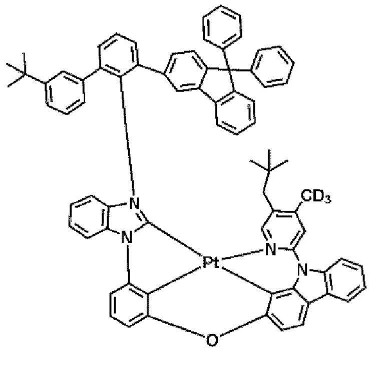

218

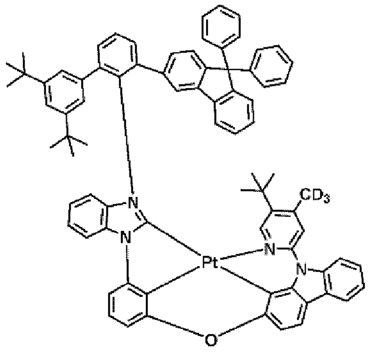

219

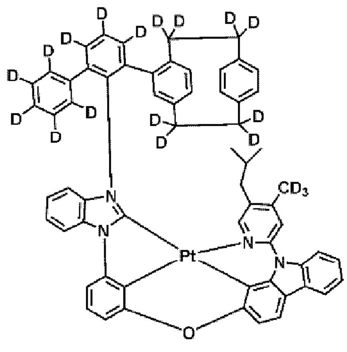

220

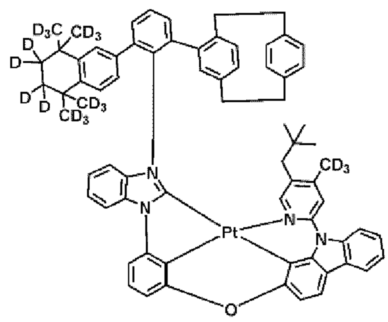

221

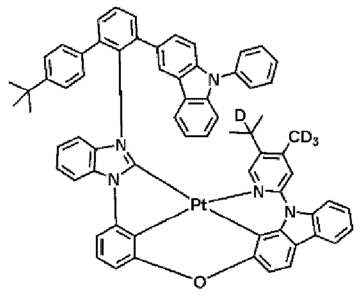

222

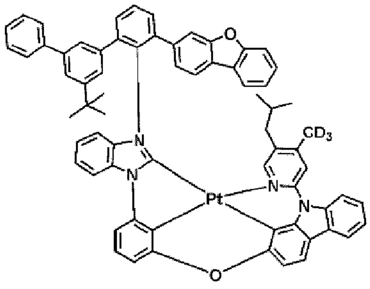

223

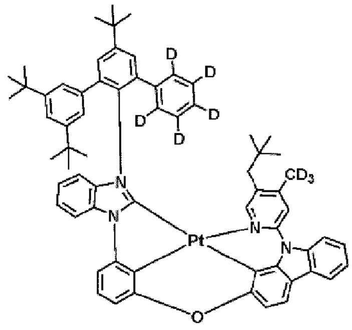

224

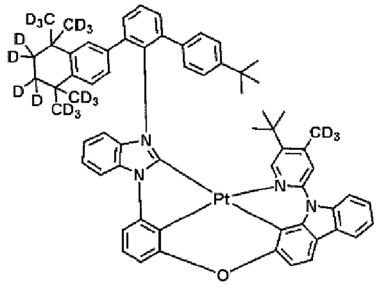

225

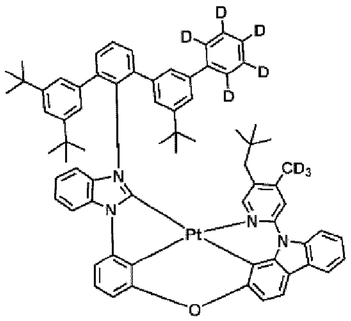

226

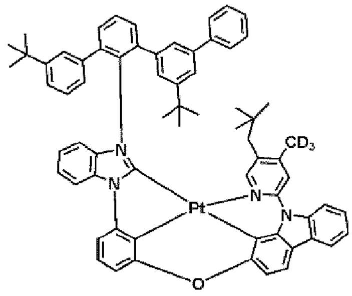

227

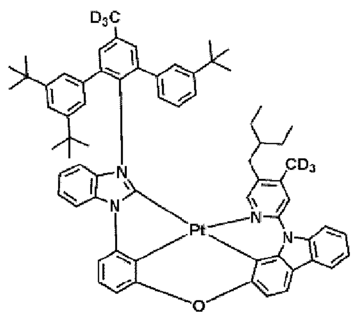

228

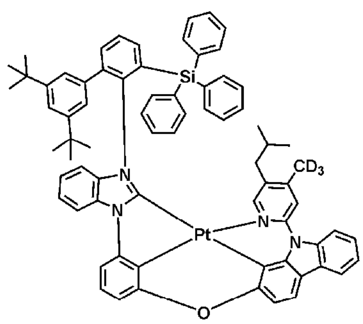

229

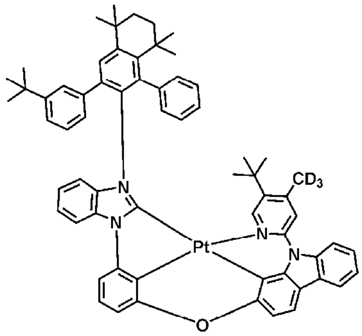

230

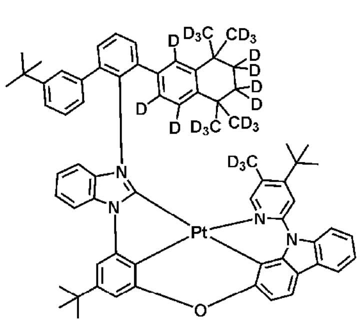

231

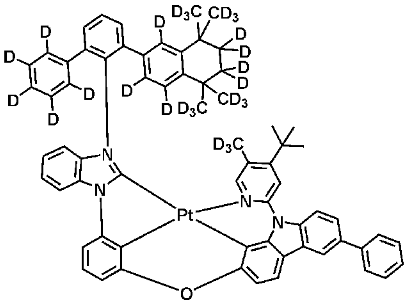

232

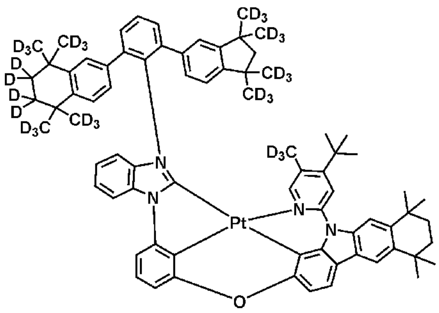

233

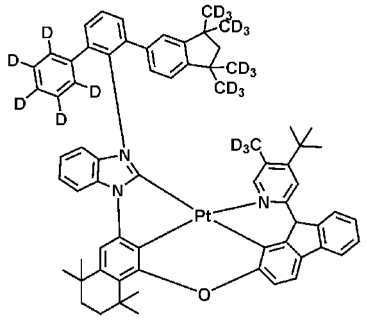

234

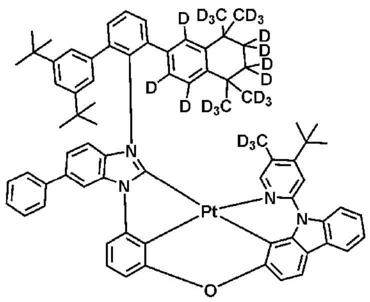

235

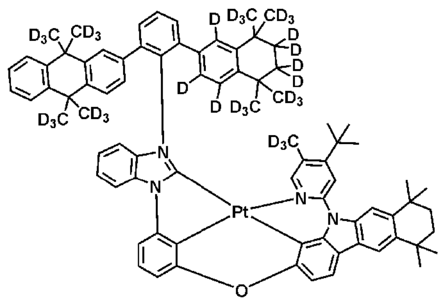

236

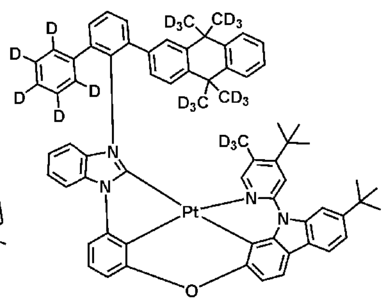

237

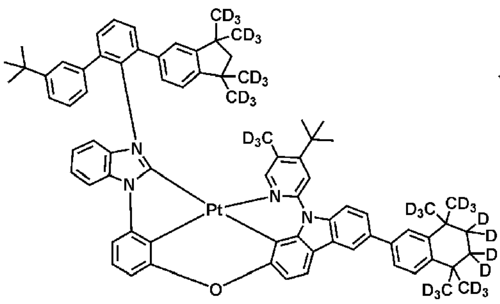

238

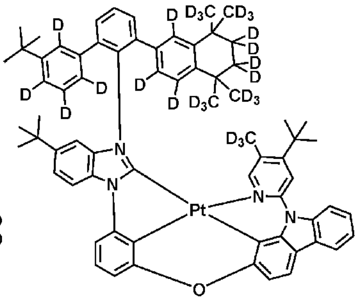

239

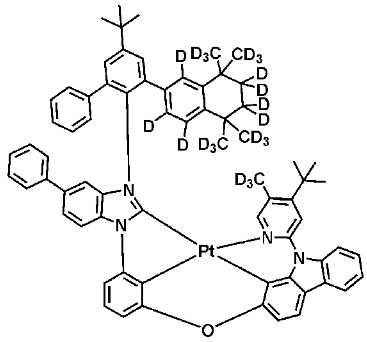

240

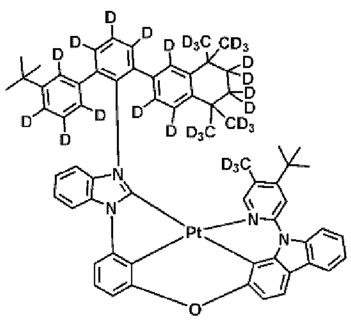

241

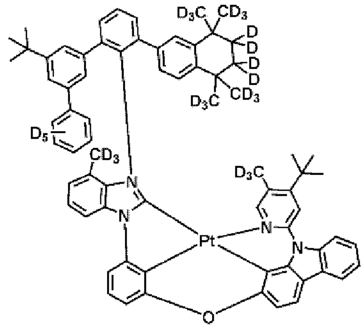

242

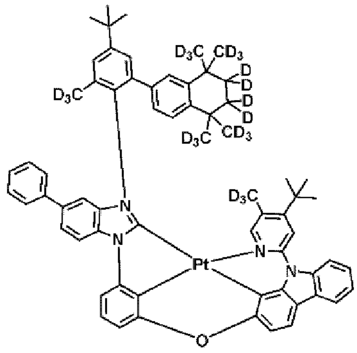

243

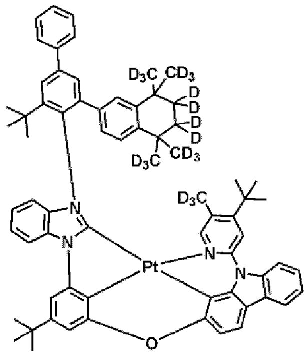

**244**

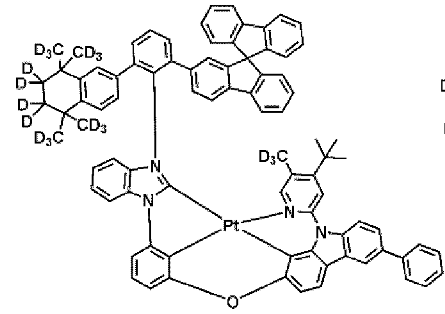

**245**

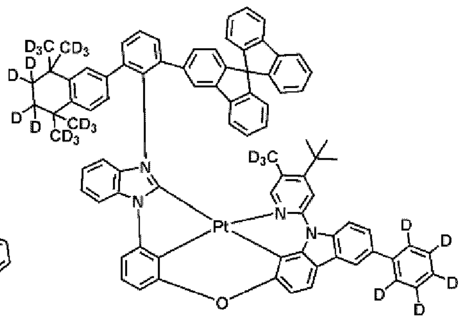

**246**

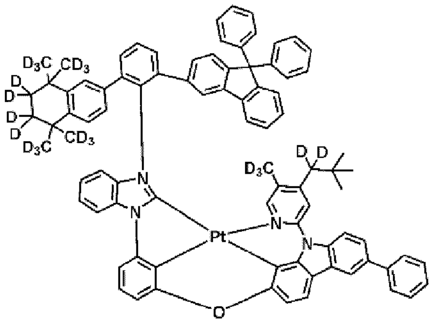

**247**

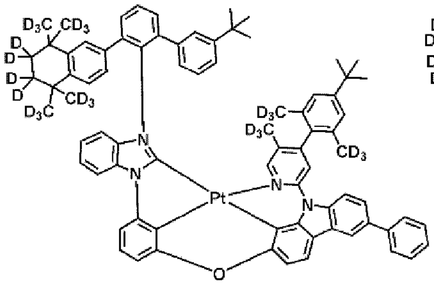

**248**

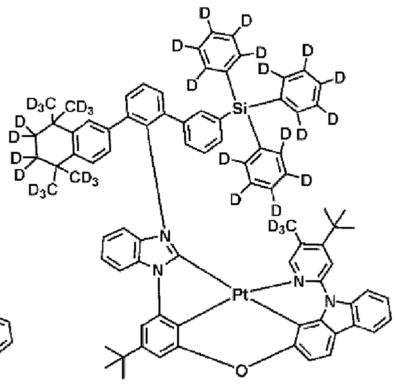

**249**

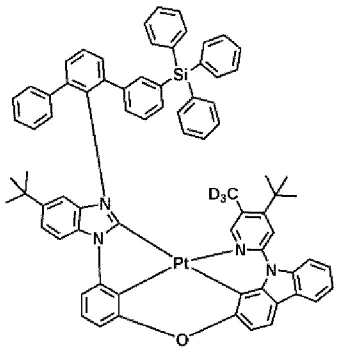

**250**

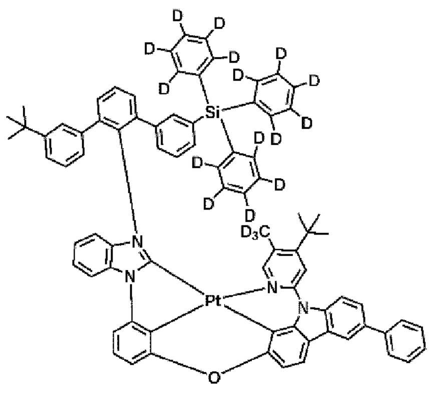

**251**

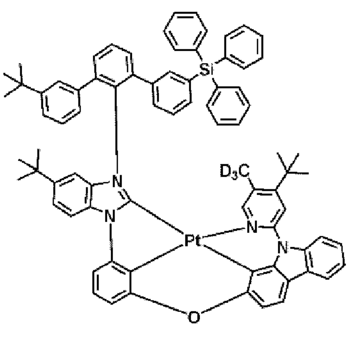

**252**

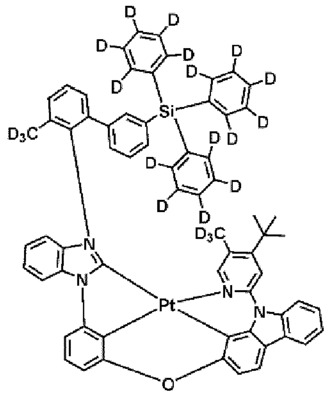

**253**

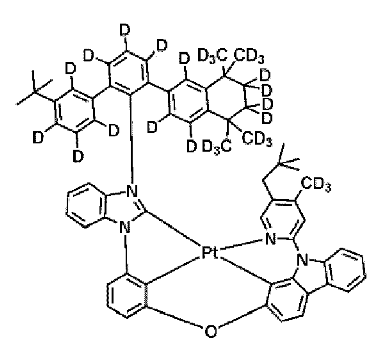

**254**

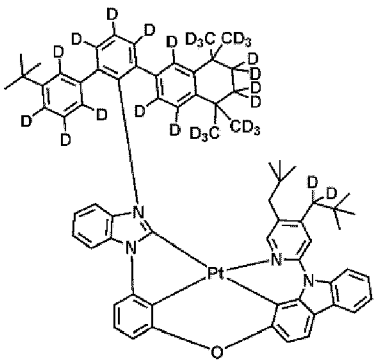

**255**

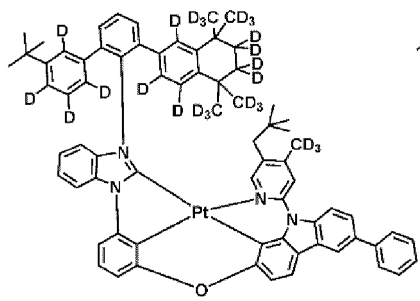

**256**

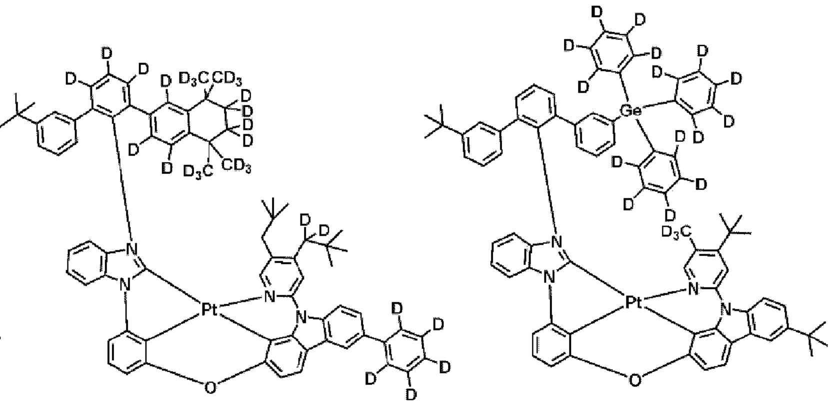

**257**

**258**

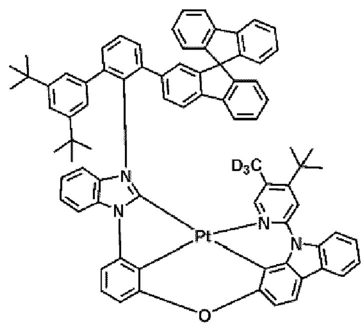

**259**

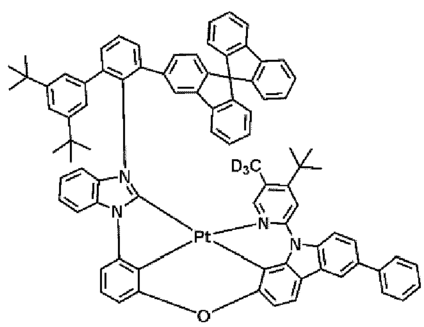

**260**

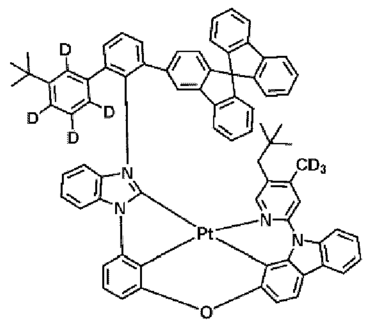

**261**

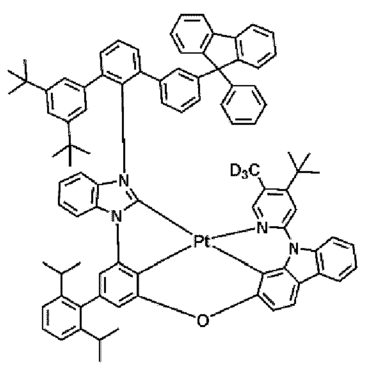

**262**

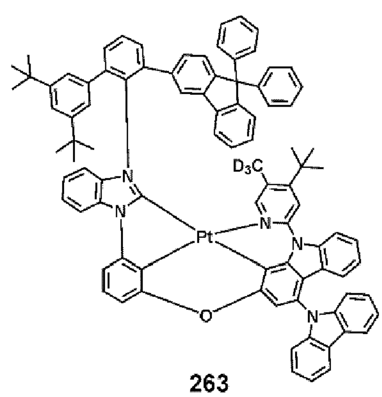

**263**

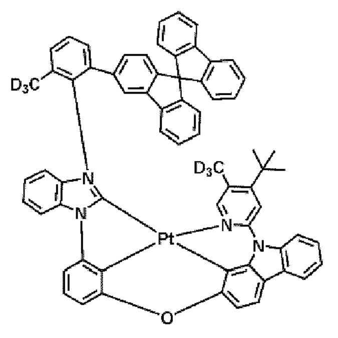

**264**

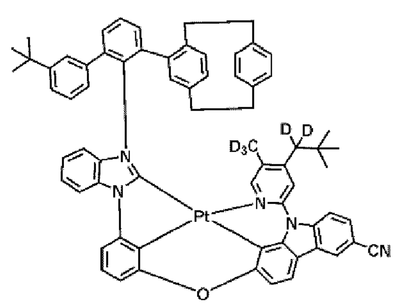

265

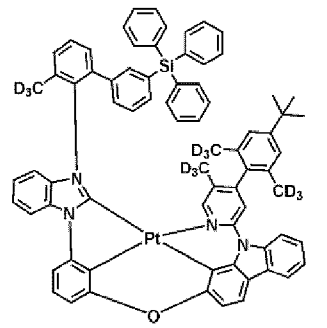

266

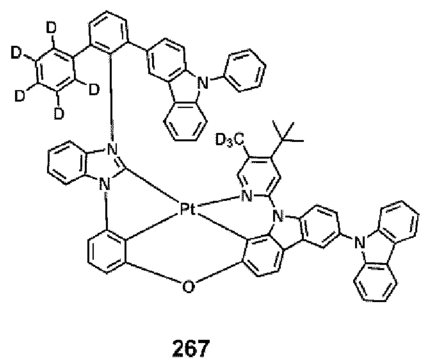

267

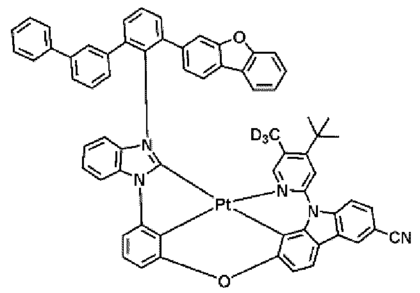

268

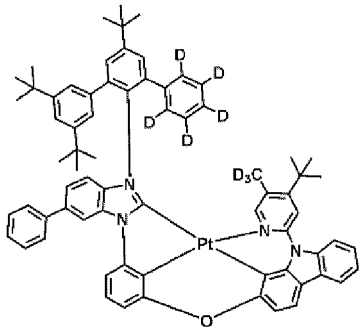

269

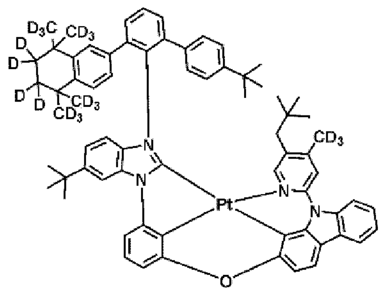

270

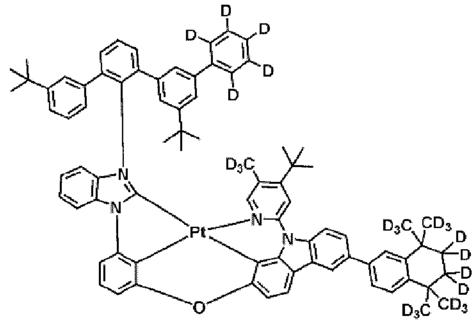

271

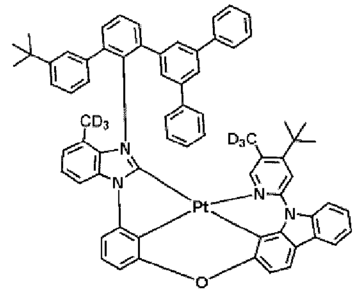

272

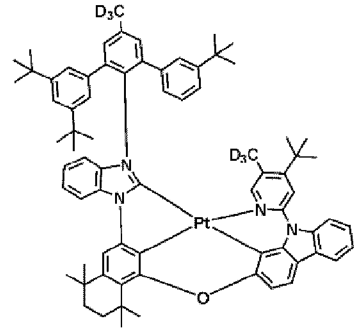

273

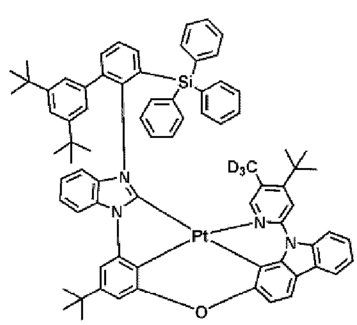

274

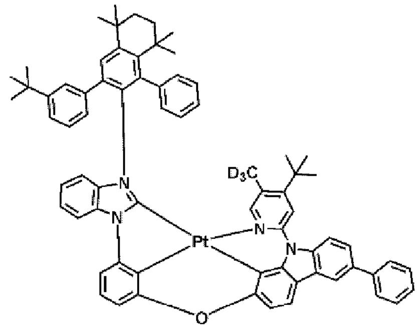

275

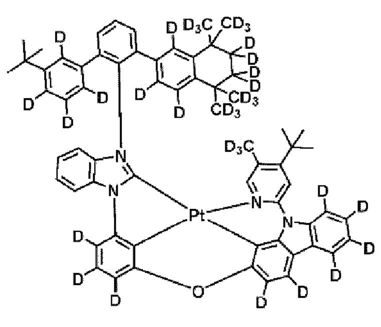

276

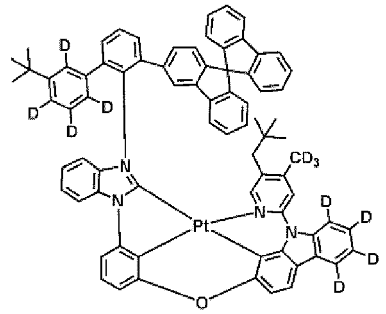

277

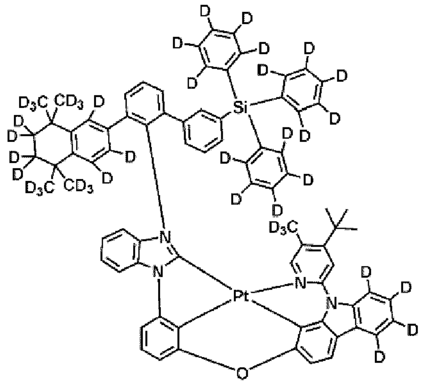

278

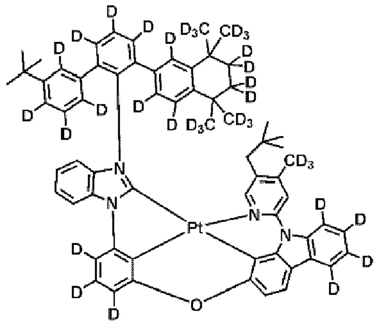

279

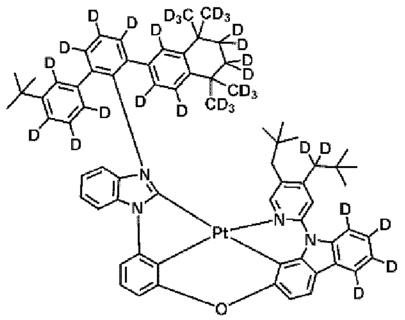

280

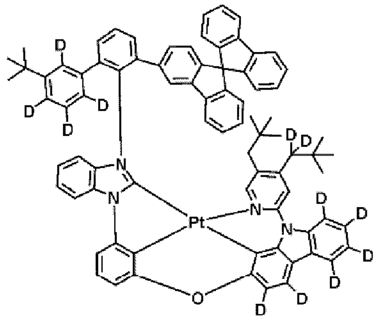

281

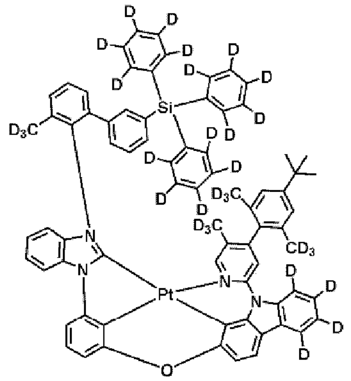

282

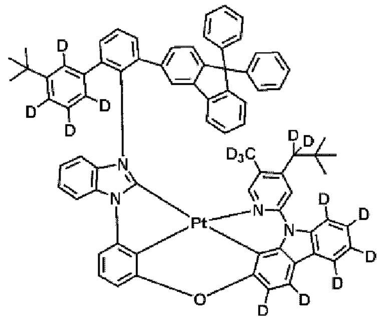

283

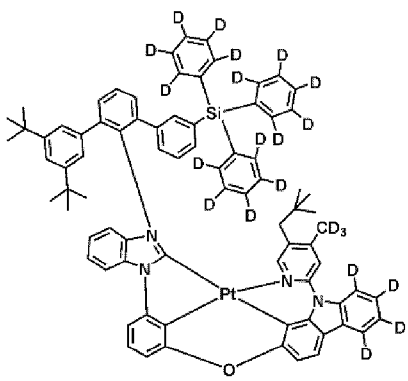

284

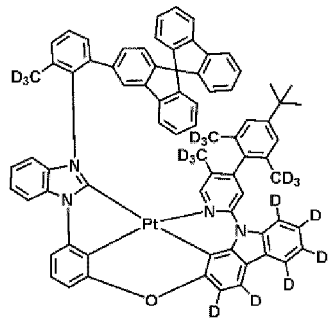

285

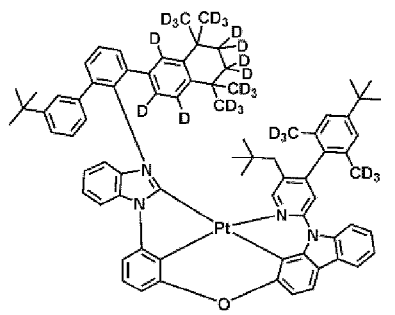

286

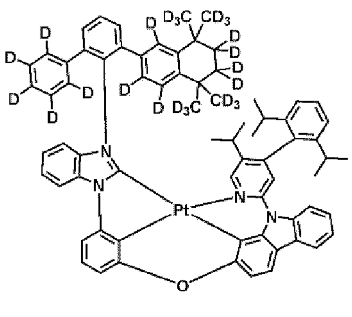

287

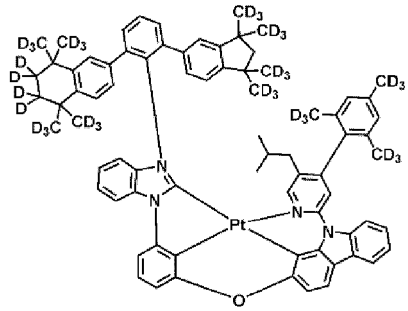

288

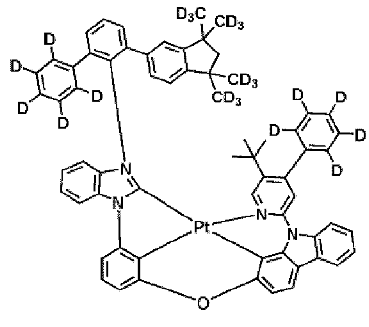

289

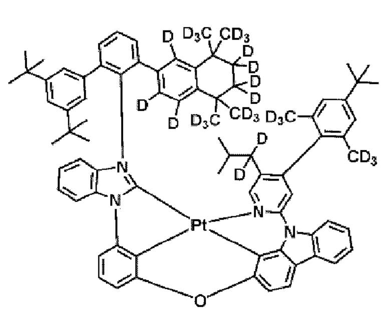

290

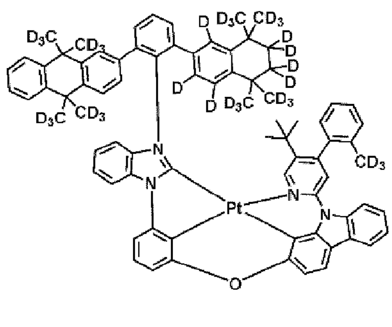

291

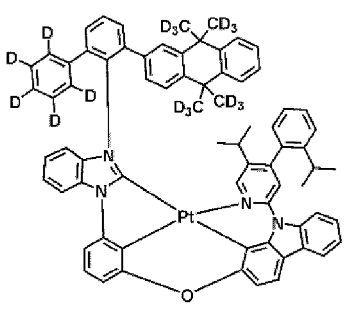

292

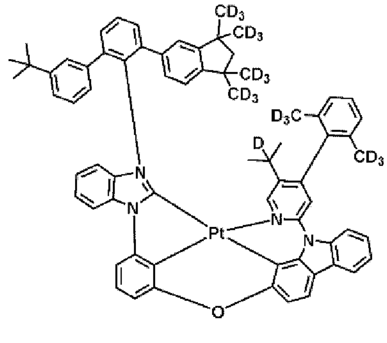

293

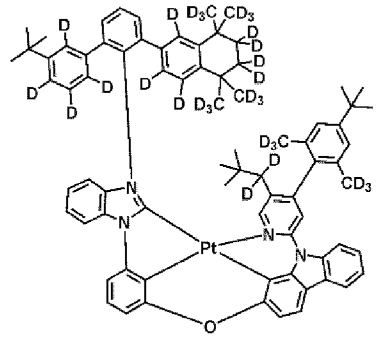

294

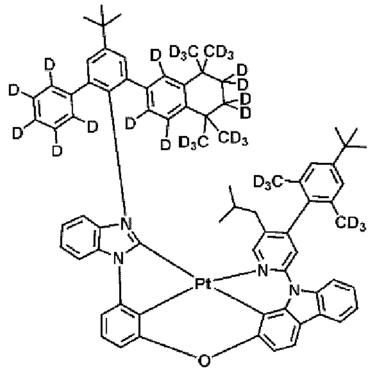

295

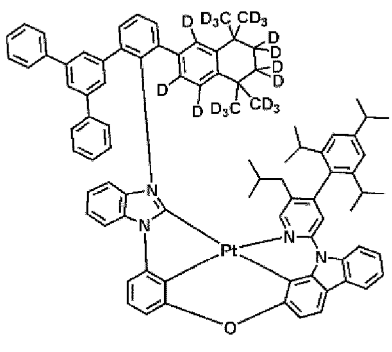

296

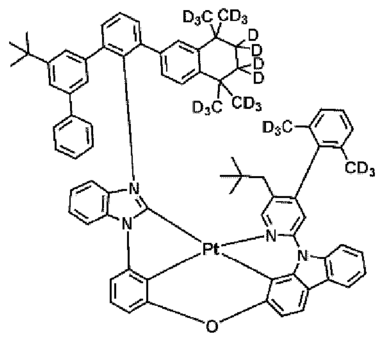

297

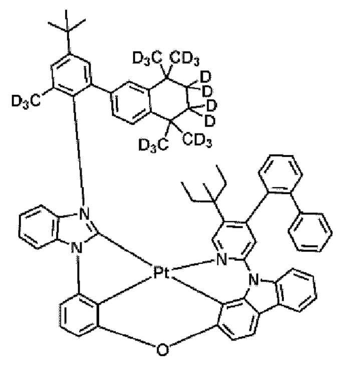

298

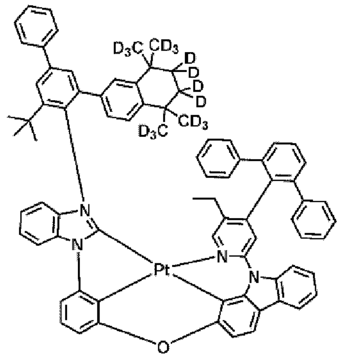

299

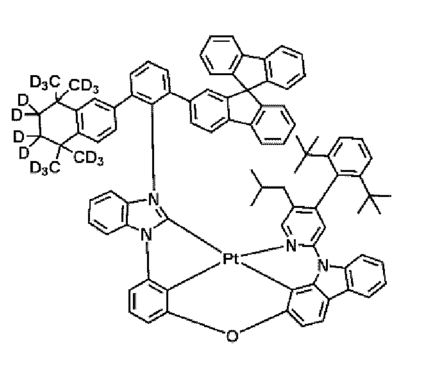

300

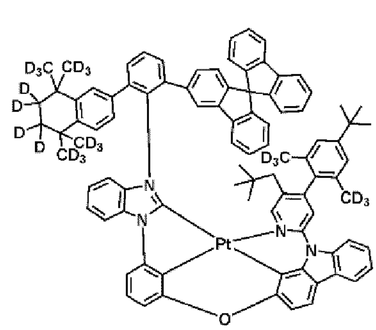

301

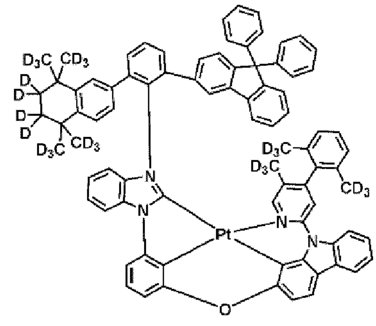

302

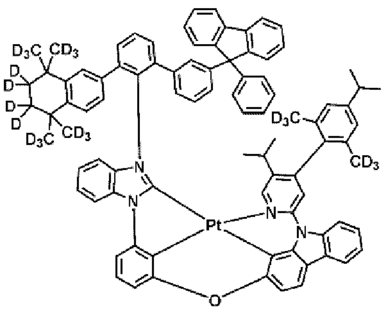

303

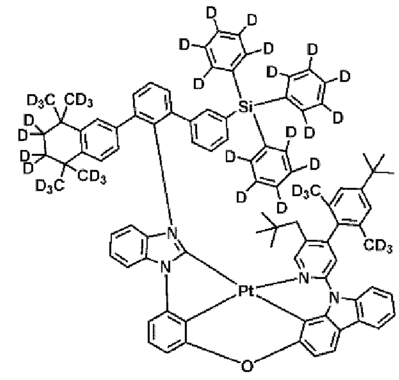

304

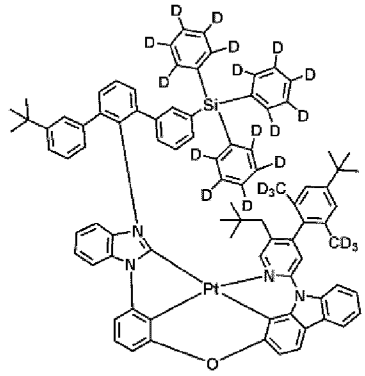

305

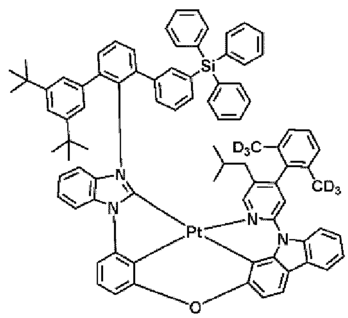

306

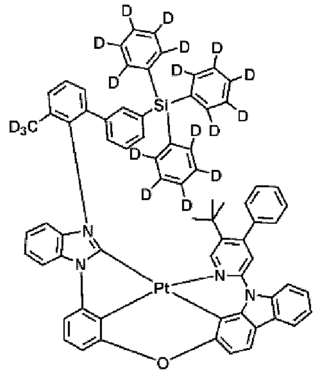

307

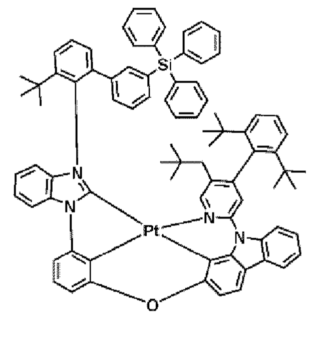

308

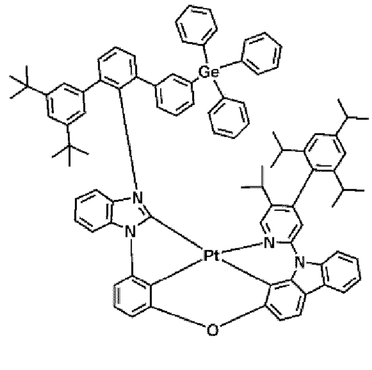

309

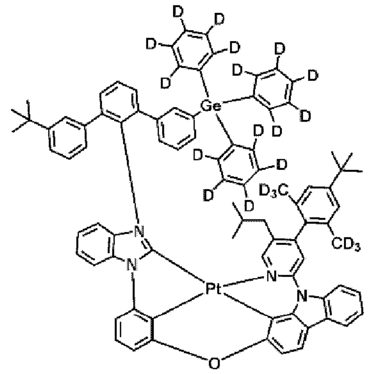

310

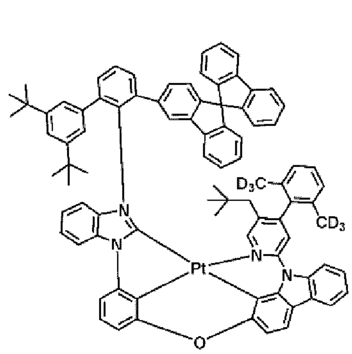

311

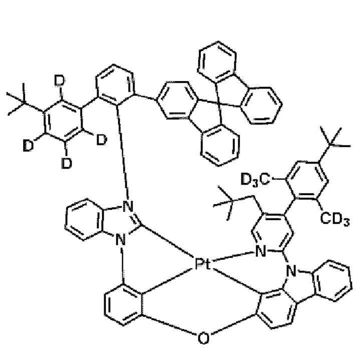

312

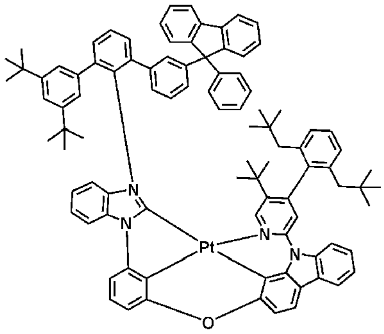

**313**

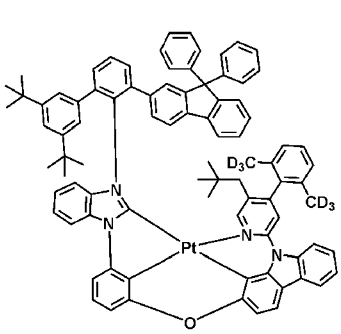

**314**

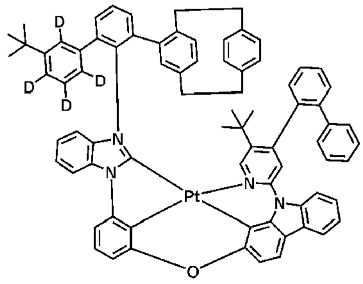

**315**

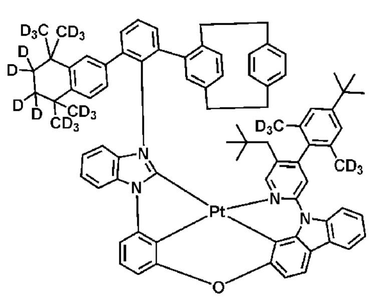

**316**

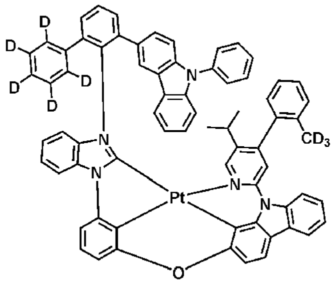

**317**

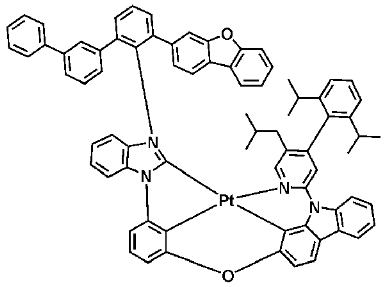

**318**

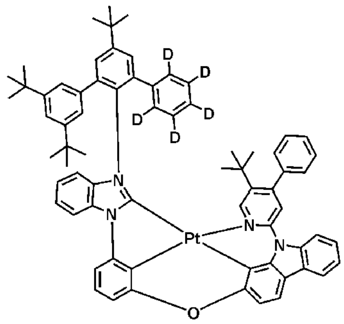

**319**

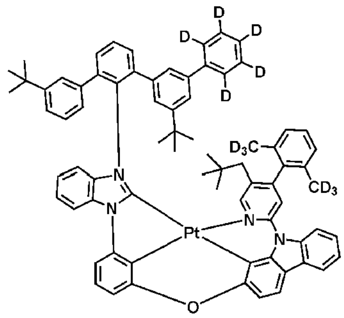

**320**

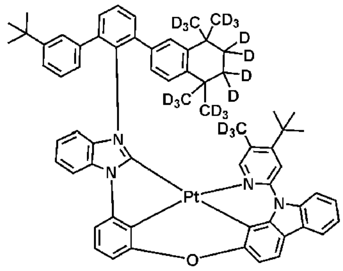

**321**

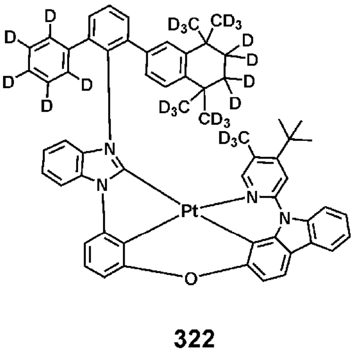

**322**

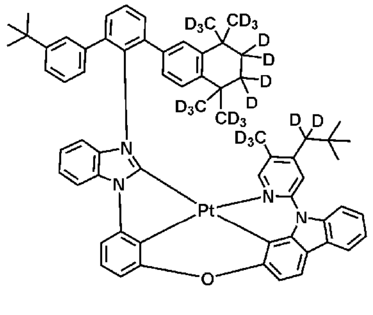

**323**

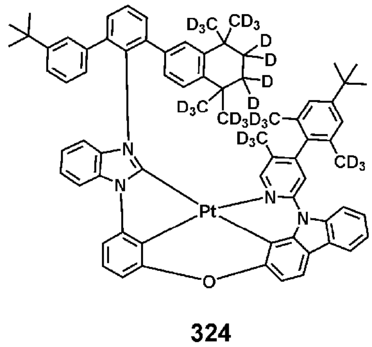

**324**

The organometallic compound represented by Formula 1 may satisfy the structure of Formula 1, and regarding $L_{11}$ which is the ligand represented by Formula 1-1, $A_{10}$ may be substituted with $Ar_1$ represented by Formula 2, and the pyridine ring may be substituted with $R_{42}$ and $R_{43}$. Due to such a structure, the organometallic compound may have improved photochemical stability, and may be suitable for deep blue light emission. Accordingly, an electronic device, for example, an organic light-emitting device, using the organometallic compound represented by Formula 1 may exhibit

excellent luminescence efficiency, lifespan, and color purity.

Although not particularly limited to a specific theory, the central metal atom, $M_{11}$, of the organometallic compound may be shielded by $Ar_1$, $R_{42}$, and $R_{43}$ having bulky structures and $Ar_1$ having an asymmetric structure. Also, when applied to an emission layer, an interaction between the organometallic compound and a host compound may be prevented, so that the structural stability of the organometallic compound may be improved. Accordingly, the efficiency and lifespan of an organic light-emitting device including the organometallic compound may be improved.

A highest occupied molecular orbital (HOMO) energy level, a lowest unoccupied molecular orbital (LUMO) energy level, and a $T_1$ energy level of certain compounds of the organometallic compound of Formula 1 may be evaluated by using the Gaussian 09 program with the molecular structure optimization obtained by B3LYP-based density functional theory (DFT), and results thereof are shown in Table 1.

Table 1

| Compound | HOMO (eV) | LUMO (eV) | $T_1$ (eV) |
|---|---|---|---|
| Compound 1 | -4.61 | -1.17 | 2.65 |
| Compound 2 | -4.62 | -1.21 | 2.64 |
| Compound 46 | -4.62 | -1.20 | 2.64 |
| Compound 91 | -4.63 | -1.21 | 2.64 |

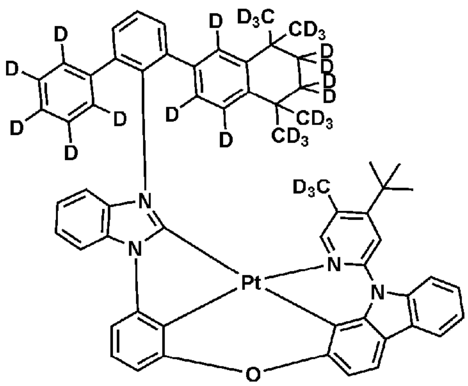

**1**

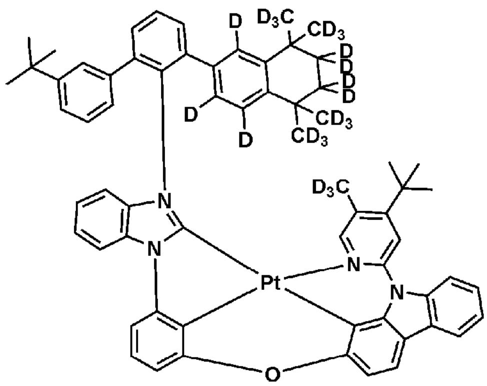

**2**

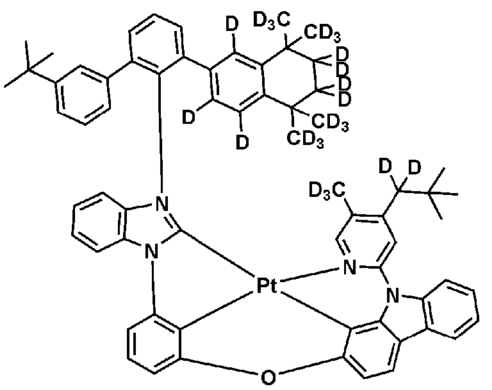

**46**

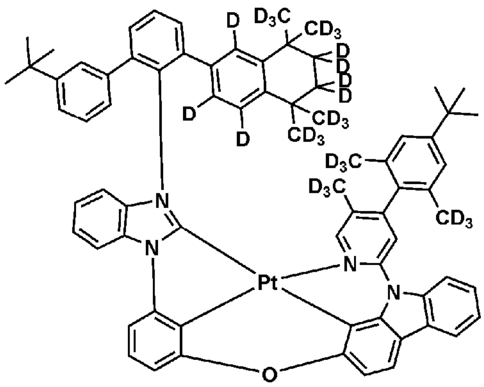

**91**

Referring to Table 1, it is confirmed that the organometallic compound represented by Formula 1 has electrical characteristics suitable for use as a dopant (e.g., an emitter or a sensitizer) of an electronic device such as an organic light-emitting device.

In an embodiment, a full width at half maximum (FWHM) of an emission peak of an emission spectrum or an electroluminescence spectrum of the organometallic compound may be 60 nm or less. For example, the FWHM of the emission peak of the emission spectrum or the electroluminescence spectrum of the organometallic compound may be in

a range of about 5 nm to about 50 nm, about 7 nm to about 40 nm, or about 10 nm to about 30 nm.

Synthesis methods of the organometallic compound represented by Formula 1 may be readily determined by one of ordinary skill in the art by referring to Synthesis Examples described below.

Confirmation of the structure of the organometallic compound represented by Formula 1 is not particularly limited. In an embodiment, the structure of the organometallic compound may be identified by a known method (e.g., proton, carbon, or phosphorus nuclear magnetic resonance spectroscopy (NMR), liquid chromatography-mass spectroscopy (LC-MS), and the like.

Electronic apparatus

Another aspect of the disclosure provides an electronic apparatus including the organometallic compound.

In an embodiment, the electronic apparatus may be an organic light-emitting device (OLED), an organic photodiode (OPD), or an organic solar cell (OSC).

Organic light-emitting device

Another aspect of the disclosure provides an organic light-emitting device including the organometallic compound.

In an embodiment, the organic light-emitting device may include: a first electrode; a second electrode; and an organic layer arranged between the first electrode and the second electrode and including an emission layer, wherein the organic layer may include the organometallic compound represented by Formula 1.

In an embodiment, the emission layer may include the organometallic compound.

In an embodiment, the emission layer may include a host and an emitter, and the emitter may include the organometallic compound.

In an embodiment, based on a weight, an amount of the host may be greater than that of the organometallic compound, in the emission layer.

In an embodiment, the emission layer may further include a sensitizer.

In an embodiment, the sensitizer may include a phosphorescent compound, a delayed fluorescence compound, or a combination thereof.

Detailed description of the aforementioned host, emitter, and sensitizer are provided herein.

When the organic light-emitting device includes the emission layer including the aforementioned organometallic compound represented by Formula 1, the organic light-emitting device may have a relatively narrow FWHM of the emission peak of the electroluminescence spectrum, excellent efficiency, and long lifespan characteristics.

In an embodiment, the organometallic compound may serve as a dopant (e.g., an emitter or a sensitizer) in the emission layer, and the emission layer may further include a host (that is, in the emission layer, an amount of the organometallic compound represented by Formula 1 may be smaller than that of the host).

In an embodiment, the emission layer may emit blue light. In an embodiment, the emission layer may emit blue light having a maximum emission wavelength in a range of about 400 nm to about 490 nm. In an embodiment, the emission layer may emit blue light having a maximum emission wavelength in a range of about 430 nm to about 480 nm.

The expression "(an emission layer) includes at least one organometallic compound represented by Formula 1" as used herein may include a case in which "(an emission layer) includes identical organometallic compounds represented by Formula 1" and a case in which "(an emission layer) includes two or more different organometallic compounds represented by Formula 1".

For example, the emission layer may include, as the organometallic compound, only Compound 1. In this regard, Compound 1 may be present in the emission layer of the organic light-emitting device. In an embodiment, the emission layer may include, as the organometallic compound, Compound 1, Compound 2, or a combination of Compound 1 and Compound 2.

FIG. 1 is a schematic cross-sectional view of an organic light-emitting device 10 according to an embodiment. Hereinafter, the structure and manufacturing method of the organic light-emitting device 10 according to an embodiment will be described in connection with FIG. 1.

In the FIG. 1, the organic light-emitting device 10 includes a first electrode 11, a second electrode 19 facing the first electrode 11, and an organic layer 15 arranged between the first electrode 11 and the second electrode 19.

The organic layer 15 includes an emission layer, a hole transport region may be arranged between the first electrode 11 and the emission layer, and an electron transport region may be arranged between the emission layer and the second electrode 19.

A substrate may be further disposed under the first electrode 11 or on the second electrode 19. The substrate may be a substrate commonly used in organic light-emitting devices, e.g., a glass substrate or a transparent plastic substrate, which have excellent mechanical strength, thermal stability, transparency, surface smoothness, ease of handling, and

water repellency.

First electrode 11

The first electrode 11 may be formed by, for example, depositing or sputtering, onto the substrate, a material for forming the first electrode 11. The first electrode 11 may be an anode. The material for forming the first electrode 11 may be a material with a high work function for easy hole injection.

The first electrode 11 may be a reflective electrode, a transflective electrode, or a transmissive electrode. When the first electrode 110 is a transmissive electrode, a material for forming the first electrode 110 may be indium tin oxide (ITO), indium zinc oxide (IZO), tin oxide ($SnO_2$), zinc oxide (ZnO), or a combination thereof, but embodiments are not limited thereto. In an embodiment, when the first electrode 110 is a semi-transmissive electrode or a reflective electrode, as a material for forming the first electrode 110, at least one of magnesium (Mg), silver (Ag), aluminum (Al), aluminum-lithium (Al-Li), calcium (Ca), magnesium-indium (Mg-In), magnesium-silver (Mg-Ag), or a combination thereof may be used, but embodiments are not limited thereto.

The first electrode 11 may have a single-layered structure or a multi-layered structure including two or more layers.

Emission layer 15

The emission layer 15 may include the organometallic compound.

With reference to FIG. 2, in an embodiment, the emission layer may include the organometallic compound as an emitter.

In an embodiment, the emission layer may further include a host (hereinafter referred to as 'Host A') wherein Host A is the not the same as the organometallic compound). Host Amay be understood by referring to the description of the host material provided herein, but embodiments are not limited thereto.

Referring to FIG. 2, the energy transfer according to an embodiment is described as follows.

In an embodiment, 25 % of singlet excitons are formed in Host A of the emission layer, and these singlet excitons formed in Host A may be transferred to the organometallic compound through Förster energy transfer (or, Förster resonance energy transfer (FRET)). In addition, 75 % of triplet excitons formed in Host A of the emission layer may be transferred to the organometallic compound through Dexter energy transfer. At least a part of the singlet energy of the organometallic compound may be transferred to the triplet energy by intersystem crossing (ISC), and the organometallic compound may accordingly emit phosphorescence. In one or more embodiment, at least a part of the triplet energy of the organometallic compound may be transferred to the singlet energy by reverse intersystem crossing (RISC), and the organometallic compound may accordingly emit delayed fluorescence (or thermally activated delayed fluorescence (TADF).

In an embodiment, a ratio of luminescent components emitted from the organometallic compound to the total luminescent components emitted from the emission layer may be 80 % or more, for example, 90 % or more. In an embodiment, a ratio of luminescent components emitted from the organometallic compound to the total luminescent components emitted from the emission layer may be 95 % or more.

Here, the organometallic compound may emit phosphorescence or delayed fluorescence, whereas the host may not emit light.

In an embodiment, when the emission layer further includes Host A in addition to the organometallic compound, the amount of the organometallic compound in the emission layer may be, based on 100 parts by weight of the emission layer, 50 parts by weight or less, for example, 30 parts by weight less or less, and the amount of Host A in the emission layer amount may be, based on 100 parts by weight of the emission layer, 50 parts by weight or more, for example, 70 parts by weight or more, but embodiments are not limited thereto.

With reference to FIG. 3, in an embodiment, the organometallic compound may serve as a sensitizer, and the emission layer may further include a fluorescent emitter.

In an embodiment, the emission layer may further include a host (hereinafter referred to as 'Host B', wherein Host B is not the same as the organometallic compound and the fluorescent emitter) and a fluorescent emitter (hereinafter referred to as "Fluorescent emitter B', wherein Fluorescent emitter B is not the same as Host B and the organometallic compound). Host B and Fluorescent emitter B may be understood by referring to a host material and a fluorescent emitter material described below, but embodiments are not limited thereto.

In an embodiment, a ratio of luminescent components emitted from Fluorescent emitter B to the total emission luminescent components emitted from the emission layer may be 80 % or more, for example, 90 % or more (or for example, 95 % or more). For example, Fluorescent emitter B may emit fluorescence. In addition, Host D and Sensitizer B may not each emit light.

Referring to FIG. 3, the energy transfer according to an embodiment is described as follows.

In an embodiment, 75 % proportion of triplet excitons formed in Host B of the emission layer may be transferred to the organometallic compound through the Dexter energy transfer, and energy of 25 % proportion of singlet excitons formed in Host B of the emission layer may be transferred to the singlet and triplet energy of the organometallic compound, wherein at least a part of the energy transferred to the singlet energy of the organometallic compound may be transferred to the triplet energy by ISC, and then, the triplet energy of the organometallic compound may be transferred to Fluorescent emitter B by FRET. Also, at least a part of the triplet energy of the organometallic compound may be transferred to the singlet energy first by RISC, and then, to the Fluorescent emitter B.

Accordingly, all of the singlet and triplet excitons generated in the emission layer may be transferred to the emitter, thereby obtaining the organic light-emitting device having improved efficiency. In addition, since an organic light-emitting device can be obtained with significantly reduced energy loss, the lifespan characteristics of the organic light-emitting device can be improved.

In an embodiment, the amount of the organometallic compound in the emission layer may be selected within a range of about 5 wt% to about 50 wt%, for example, about 10 wt% to about 30 wt%. When the content is within this range, energy transfer in the emission layer may be effectively occurred. Thus, the organic light-emitting device may have high efficiency and long lifespan.

In an embodiment, an amount of Fluorescent emitter B in the emission layer may be selected within a range of about 0.01 wt% to about 15 wt%, for example, about 0.05 wt% to about 3 wt%, but embodiments are not limited thereto.

With reference to FIG. 4, In an embodiment, the organometallic compound may be used as a sensitizer, and the emission layer may further include a delayed fluorescence emitter.

In an embodiment, the emission layer may further include a host (hereinafter referred to as 'Host C', wherein Host C is not the same as the organometallic compound and the delayed fluorescence emitter) and a delayed fluorescence emitter (hereinafter referred to as 'Delayed fluorescence emitter C', wherein Delayed fluorescence emitter C is not the same as Host C and the organometallic compound). Host C and Delayed fluorescence emitter C may be understood by referring to a host material and a delayed fluorescence emitter material described below, but embodiments are not limited thereto.

In an embodiment, a ratio of luminescent components emitted from Delayed fluorescent emitter C to the total luminescent components emitted from the emission layer may be 80 % or more, for example, 90 % or more (or for example, 95 % or more). For example, Fluorescent emitter C may emit fluorescence. In addition, Host D and Sensitizer B may not each emit light.

Referring to FIG. 4, the energy transfer according to an embodiment is described as follows.

In an embodiment, 75 % proportion of triplet excitons formed in Host C of the emission layer may be transferred to the organometallic compound through the Dexter energy transfer, and energy of 25 % proportion of singlet excitons formed in Host C of the emission layer may be transferred to the singlet and triplet energy of the organometallic compound, wherein at least a part of the energy transferred to the singlet energy of the organometallic compound may be transferred to the triplet energy by ISC, and then, the triplet energy of the organometallic compound may be transferred to Delayed fluorescent emitter C by FRET. Also, at least a part of the triplet energy of the organometallic compound may be transferred to the singlet energy first by RISC, and then, to the Delayed fluorescent emitter C.

Accordingly, all of the singlet and triplet excitons generated in the emission layer may be transferred to the emitter, thereby obtaining the organic light-emitting device having improved efficiency. In addition, since an organic light-emitting device can be obtained with significantly reduced energy loss, the lifespan characteristics of the organic light-emitting device can be improved.

In an embodiment, the amount of the organometallic compound in the emission layer may be selected within a range of about 5 wt% to about 50 wt%, for example, about 10 wt% to about 30 wt%. When the content is within this range, energy transfer in the emission layer may be effectively occurred. Thus, the organic light-emitting device may have high efficiency and long lifespan.

In an embodiment, an amount of Delayed fluorescent emitter C in the emission layer may be selected within a range of about 0.01 wt% to about 15 wt%, for example, about 0.05 wt% to about 3 wt%, but embodiments are not limited thereto.

Host in emission layer

In an embodiment, the host may not include a metal atom.

In an embodiment, the host may include at least one compound of a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine

oxide-containing compound, a sulfoxide-containing compound, and a sulfonyl-containing compound.

For example, the host may be a compound, which includes at least one carbazole ring and at least one cyano group, or a phosphine oxide-containing compound.

In an embodiment, the host may consist of one type of host. When the host consists of one type of host, the one type of host may be a bipolar host, an electron-transporting host, or a hole-transporting host, which will be described below.

In an embodiment, the host may be a mixture of two or more types of different hosts. For example, the host may include a hole-transporting host, an electron-transporting host, a bipolar host, or a combination thereof.

In an embodiment, the host may be a mixture of an electron-transporting host and an hole-transporting host, a mixture of two types of different electron-transporting hosts, or a mixture of two types of different hole-transporting hosts. The electron-transporting host and the hole-transporting host may be understood by referring to the related description to be presented herein.

In an embodiment, the host may include: an electron-transporting host including at least one electron-transporting moiety; and a hole-transporting host not including an electron-transporting moiety.

The electron-transporting (ET) moiety used herein may be a cyano group, a π electron-deficient nitrogen-containing cyclic group, or a group represented by one of the following Formulae:

ET-moiety

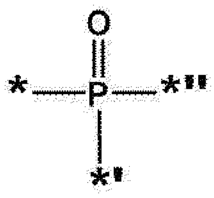 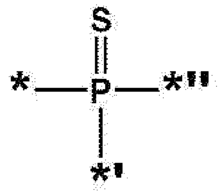 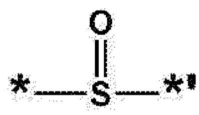 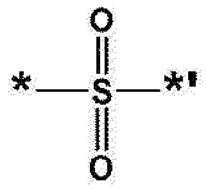

wherein, in the formulae above, *, *', and *" each indicate a binding site to a neighboring atom.

In an embodiment, the electron-transporting host in the emission layer may include at least one of a cyano group and a π-electron deficient nitrogen-containing cyclic group.

In an embodiment, the electron-transporting host in the emission layer may include at least one cyano group.

In an embodiment, the electron-transporting host in the emission layer may include at least one cyano group and at least one π electron-deficient nitrogen-containing cyclic group.

In an embodiment, in the emission layer, the hole-transporting host may include a hole-transporting (HT) moiety, and may not include an electron-transporting moiety.

The hole transporting moiety may be a π electron-rich $C_3$-$C_{60}$ cyclic group ora group represented by Formula HT-moiety:

HT-moiety

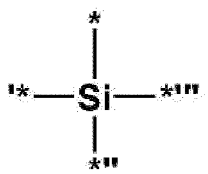

wherein, in the formula above, *, *', *", and *''' each indicate a binding site to a neighboring atom.

In an embodiment, the host may include an electron-transporting host and a hole-transporting host, wherein the electron-transporting host may include at least one π electron-deficient nitrogen-free cyclic group and at least one electron-transporting moiety, and the hole-transporting host may include at least one π electron-deficient nitrogen-free cyclic group and may not include an electron-transporting moiety.

The term "π electron-deficient nitrogen-containing cyclic group" used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group; or a condensed cyclic group in which two or more π electron- efficient nitrogen-containing cyclic groups are condensed with each other.

In an embodiment, the π electron-deficient nitrogen-free cyclic group may be or a benzene group, a heptalene

group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, or a condensed cyclic group of two or more $\pi$ electron-deficient nitrogen-free cyclic groups, but embodiments are not limited thereto.

In an embodiment, when the host is a mixture of the electron-transporting host and the hole-transporting host, a weight ratio of the electron-transporting host and the hole-transporting host may be in a range of about 1:9 to about 9:1, for example, about 2:8 to about 8:2, or for example, about 4:6 to about 6:4, or for example, 5:5. When the weight ratio of the electron transport host and the hole transport host satisfies the above-described ranges, the hole-and-electron transport balance in the emission layer may be made.

In an embodiment, the bipolar host may include at least one electron-transporting moiety and at least one hole transport moiety.

In an embodiment, the host may include both a first compound and a second compound, wherein

i) the first compound may be a hole-transporting host, and the second compound may be an electron-transporting host,
ii) the first compound may be an electron-transporting host, and the second compound may be a hole transport host,
iii) the first compound and the second compound may each be a bipolar host,
iv) the first compound may be a hole-transporting host, and the second compound may be a bipolar host,
v) the first compound may be an electron-transporting host, and the second compound may be a bipolar host,
vi) the first compound may be a bipolar host, and the second compound may be a hole-transporting host, or
vii) the first compound may be a bipolar host, and the second compound may be an electron-transporting host.

The host may include at least one TPBi, TBADN, ADN (also referred to as "DNA"), CBP, CDBP, TCP, mCP, Compound H50, or Compound H51:

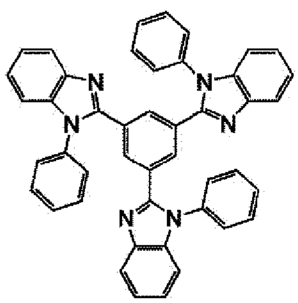

TPBi

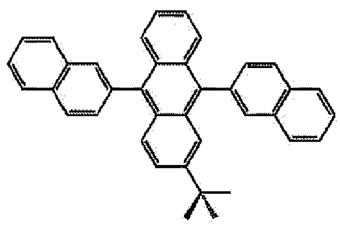

TBADN

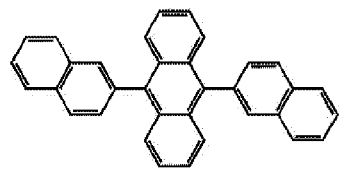

ADN

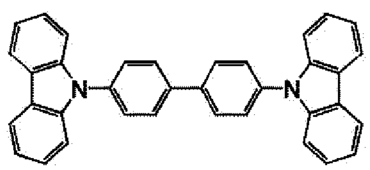

CBP

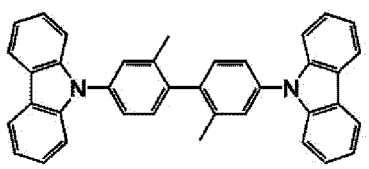

CDBP

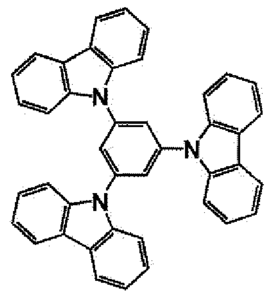

TCP

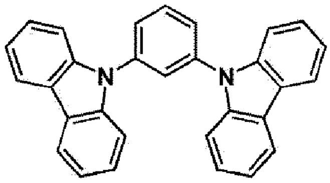

mCP

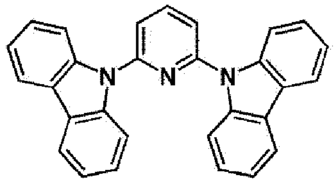

H50

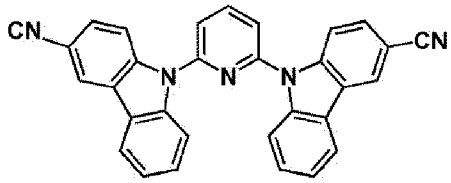

H51

In one or more embodiments, the host may further include a compound represented by Formula 301:

Formula 301

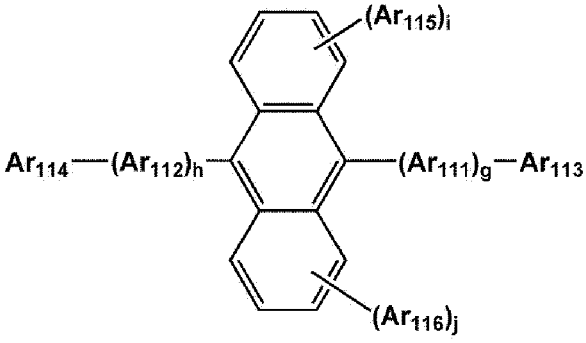

wherein $Ar_{111}$ and $Ar_{112}$ in Formula 301 may each independently be:

a phenylene group, a naphthylene group, a phenanthrenylene group, and a pyrenylene group; and
a phenylene group, a naphthylene group, a phenanthrenylene group, and a pyrenylene group, each substituted with at least one a phenyl group, a naphthyl group, or an anthracenyl group.

$Ar_{113}$ to $Ar_{116}$ in Formula 301 may each independently be:

a $C_1$-$C_{10}$ alkyl group, a phenyl group, a naphthyl group, a phenanthrenyl group, or a pyrenyl group; and
a phenyl group, a naphthyl group, a phenanthrenyl group, and a pyrenyl group, each substituted with at least one a phenyl group, a naphthyl group, or an anthracenyl group.

g, h, i, and j in Formula 301 may each independently be an integer from 0 to 4, and may be, for example, 0, 1, or 2.
$Ar_{113}$ to $Ar_{116}$ in Formula 301 may each independently be:

a $C_1$-$C_{10}$ alkyl group, substituted with at least one a phenyl group, a naphthyl group, or an anthracenyl group;
a phenyl group, a naphthyl group, an anthracenyl group, a pyrenyl, a phenanthrenyl group, or a fluorenyl group;
a phenyl group, a naphthyl group, an anthracenyl group, a pyrenyl group, a phenanthrenyl group, and a fluorenyl group, each substituted with at least one deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a phenyl group, a naphthyl group, an anthracenyl group, a pyrenyl group, a phenanthrenyl group, or a fluorenyl group; or

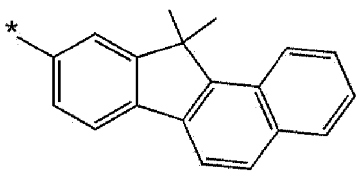

,

but embodiments are not limited thereto.

In an embodiment, the host may include a compound represented by Formula 302:

Formula 302

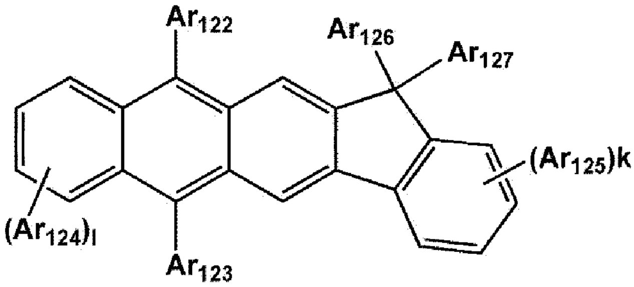

In Formula 302, $Ar_{122}$ to $Ar_{125}$ may each be the same as described in connection with $Ar_{113}$ in Formula 301.

In Formula 302, $Ar_{126}$ and $Ar_{127}$ may each independently be a $C_1$-$C_{10}$ alkyl group (e.g., a methyl group, an ethyl group, or a propyl group).

In Formula 302, k and l may each independently be an integer from 0 to 4. For example, k and l may be 0, 1, or 2.

In an embodiment, the host may include at least one compound of Compounds H1 to H31:

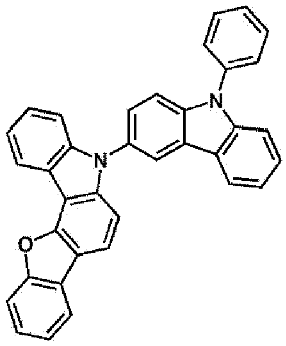

H1

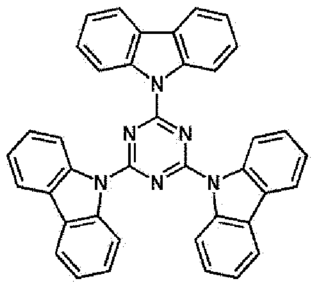

H2

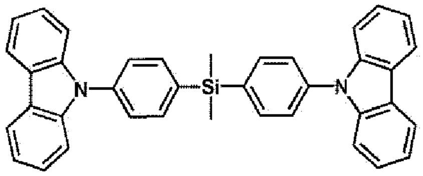

H3

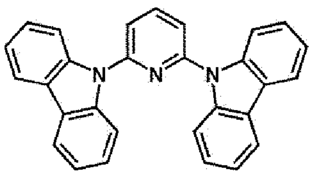

H4

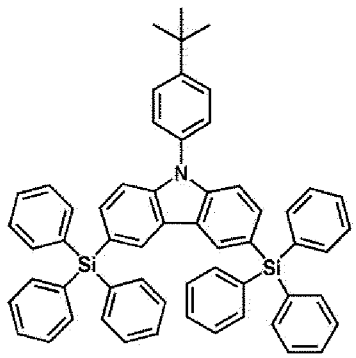

H5

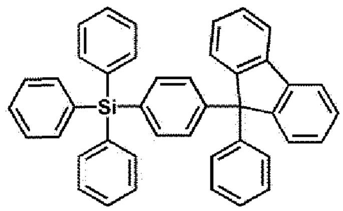

H6

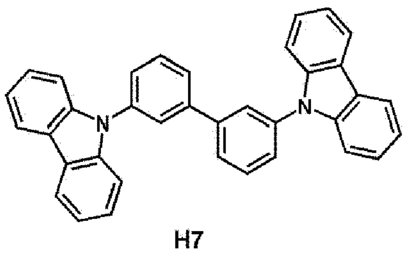

H7

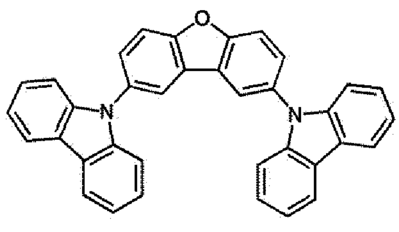

H8

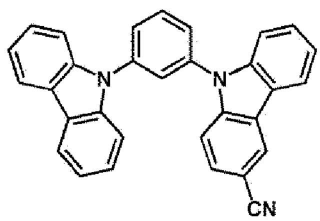

H9

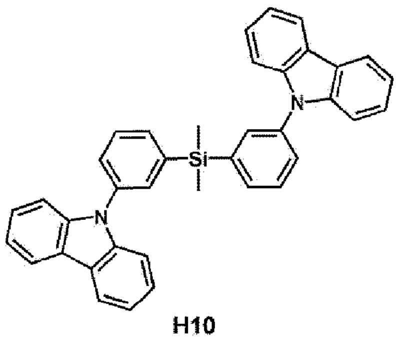

H10

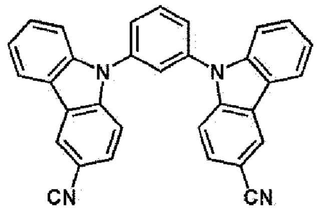

H11

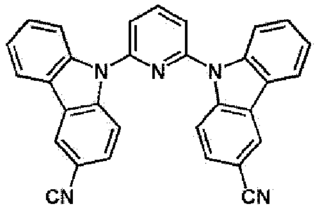

H12

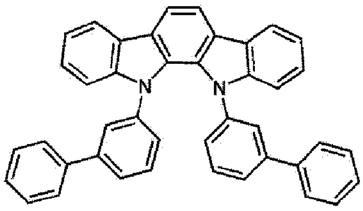

H13

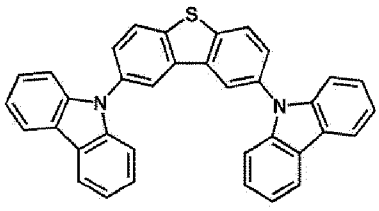

H14

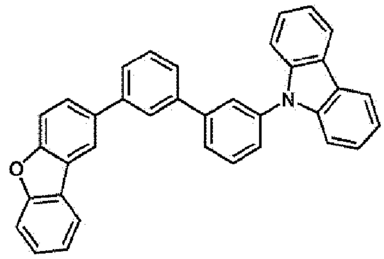

H15

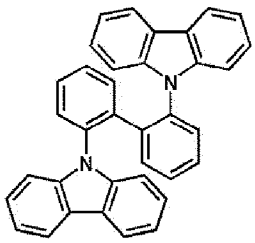

H16

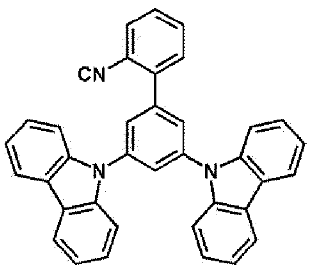

H17

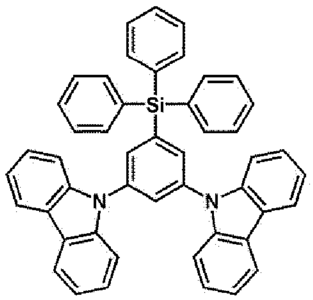

H18

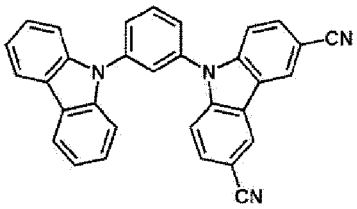

H19

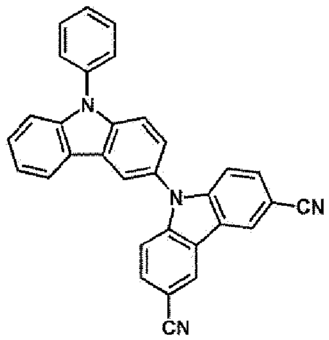

H20

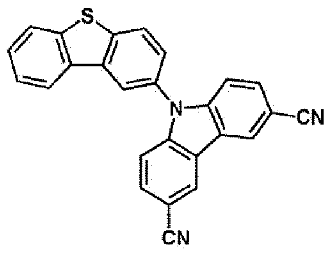

H21

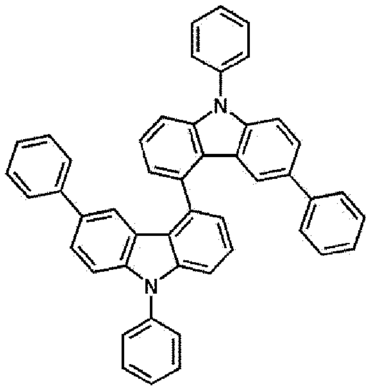

H22

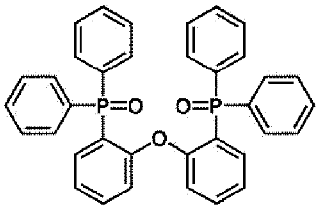

H23

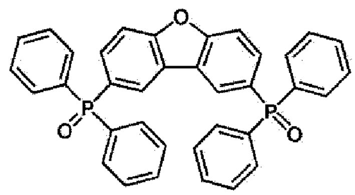

H24

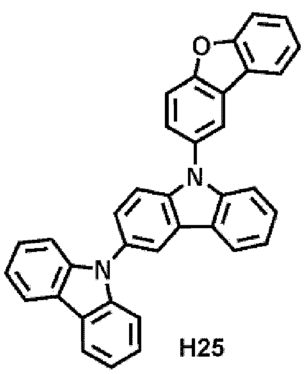

H25

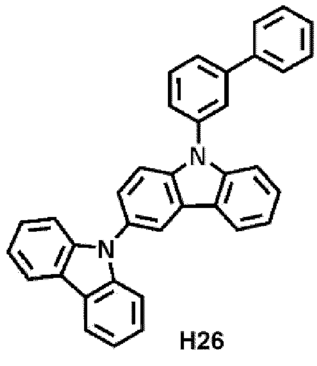

H26

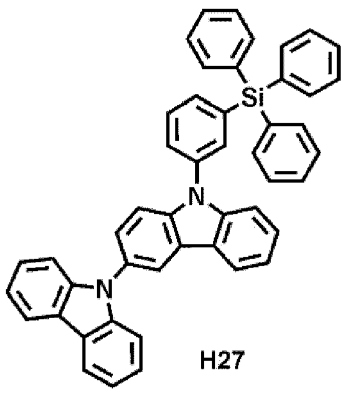

H27

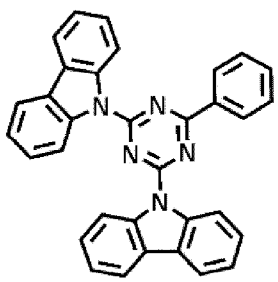

H28

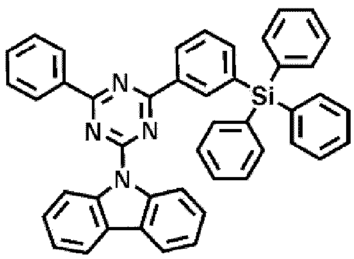

H29

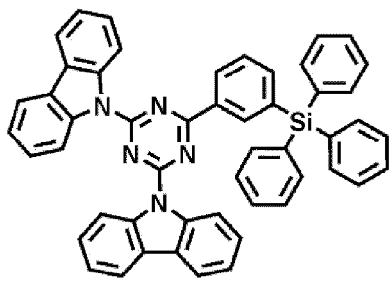

H30

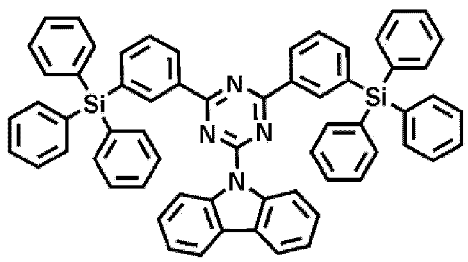

H31

In an embodiment, the host may consist of one type of compound. For example, the one type of compound may be optionally the first material (e.g., a hole-transporting host) or the second material (e.g., an electron-transporting host), or a combination thereof.

In an embodiment, the host may include two or more types of compound. For example, the host may include: two or more types of different hole-transporting hosts; two or more types of different electron-transporting hosts; or a combination of one or more types of hole-transporting hosts and one or more types of electron-transporting hosts.

Emitter in emission layer

The emitter may emit light.

In an embodiment, the emitter may include the organometallic compound.

In an embodiment, the emitter may be a fluorescent emitter and/or a delayed fluorescence emitter that emits fluorescence and/or delayed fluorescence, respectively. Accordingly, a decay time of the emitter ($T_{decay}(E)$) may be less than 100 μs.

The $T_{decay}(E)$ may be measured from a time-resolved photoluminescence (TRPL) spectrum at room temperature of a 40 nm-thick film, wherein the film is obtained by vacuum-depositing the host and the emitter included in the emission layer at a weight ratio of 90:10 on a quartz substrate at a vacuum degree of $10^{-7}$ torr.

In an embodiment, the emitter may include a 4-membered or greater carbocyclic group or a 4-membered or greater heterocyclic group.

In an embodiment, the emitter may be a metal-free organic compound.

In an embodiment, the emitter may be a compound represented by one of Formulae 51 to 54:

Formula 51

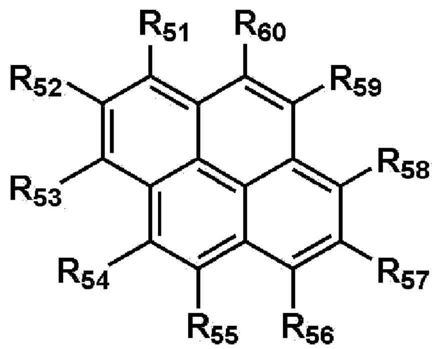

Formula 52

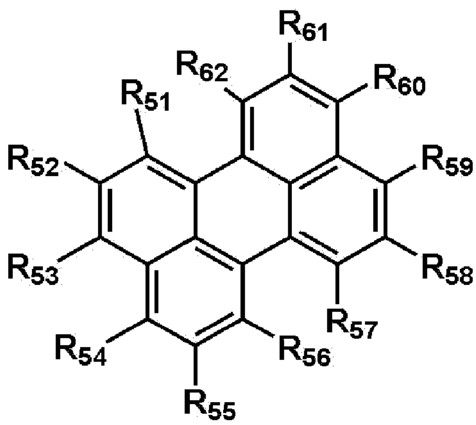

Formula 53

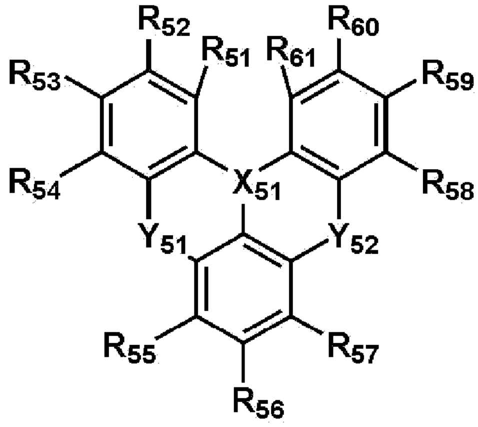

Formula 54

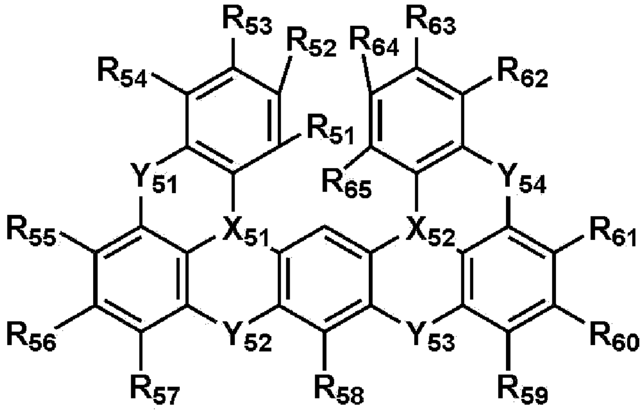

In Formulae 51 to 54,

$X_{51}$ and $X_{52}$ may each independently be N or B,
$Y_{51}$ may be a single bond, O, S, Se, $N(R_{501})$, $B(R_{501})$, $C(R_{501})(R_{502})$, or $Si(R_{501})(R_{502})$,
$Y_{S2}$ may be a single bond, O, S, Se, $N(R_{503})$, $B(R_{503})$, $C(R_{503})(R_{504})$, or $Si(R_{503})(R_{504})$,
$Y_{53}$ may be a single bond, O, S, Se, $N(R_{505})$, $B(R_{505})$, $C(R_{505})(R_{506})$, or $Si(R_{505})(R_{506})$,
$Y_{54}$ may be a single bond, O, S, Se, $N(R_{507})$, $B(R_{507})$, $C(R_{507})(R_{508})$, or $Si(R_{507})(R_{508})$,
$R_{51}$ to $R_{65}$ and $R_{501}$ to $R_{508}$ may each independently be hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkylheteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,
two or more of $R_{51}$ to $R_{65}$ and $R_{501}$ to $R_{508}$ may optionally be bonded together to form a $C_5$-$C_{30}$ carbocyclic group unsubstituted or substituted with at least one $R_5$ or a $C_1$-$C_{30}$ heterocyclic group unsubstituted or substituted with at least one $R_5$,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the

substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_2$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ hetero arylthio group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each substituted with deuterium, -F, -Cl, -Br, - I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, $-N(Q_{14})(Q_{15})$, $-B(Q_{16})(Q_{17})$, - $P(=O)(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_2$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, - $Ge(Q_{21})(Q_{22})(Q_{23})$, $-N(Q_{24})(Q_{25})$, $-B(Q_{26})(Q_{27})$, $-P(=O)(Q_{28})(Q_{29})$, or a combination thereof; or
$-Si(Q_{31})(Q_{32})(Q_{33})$, $-Ge(Q_{31})(Q_{32})(Q_{33})$, $-N(Q_{34})(Q_{35})$, $-B(Q_{36})(Q_{37})$, or - $P(=O)(Q_{38})(Q_{39})$, and
$Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a $C_1$-$C_{60}$ heteroaryloxy group, a $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In an embodiment, $R_{51}$ to $R_{65}$ and $R_{501}$ to $R_{508}$ may each be the same as described in connection with $R_1$.
In an embodiment, the emitter may be a condensed polycyclic compound or a styryl compound.
In an embodiment, the emitter may include one of a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a picene-containing core, a perylene-containing core, a pentacene-containing core, an indenoanthracene-containing core, a tetracene-containing core, a bisanthracene-containing

core, or a core represented by one of Formulae 501-1 to 501-21:

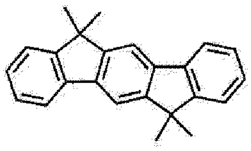
501-1

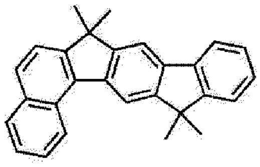
501-2

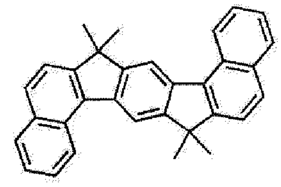
501-3

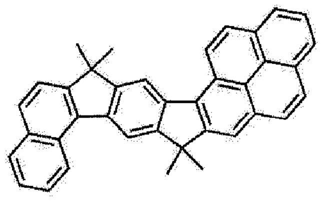
501-4

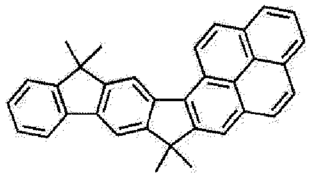
501-5

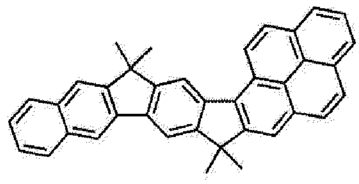
501-6

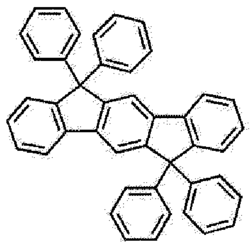
501-7

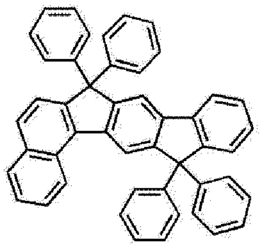
501-8

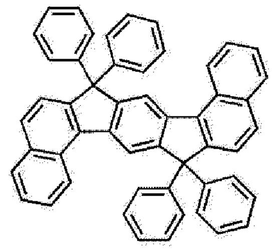
501-9

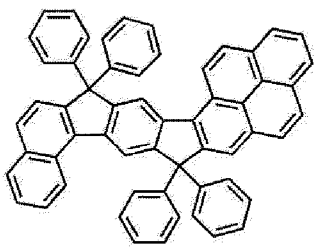
501-10

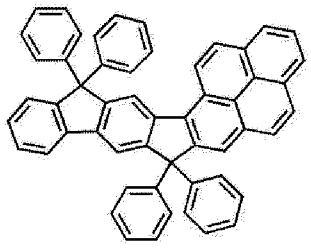
501-11

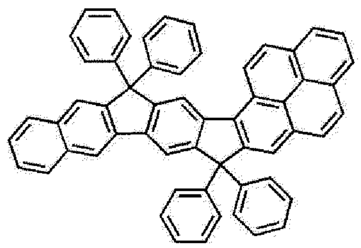
501-12

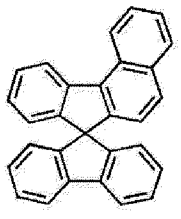
501-13

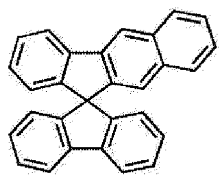
501-14

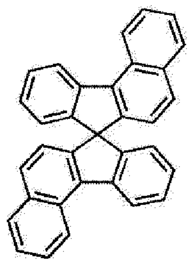
501-15

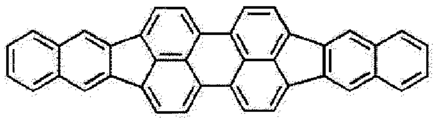

501-16

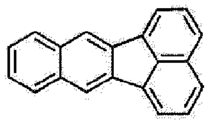

501-17

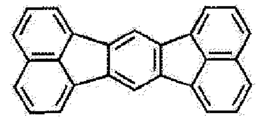

501-18

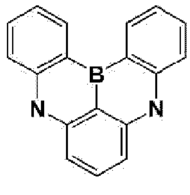

501-19

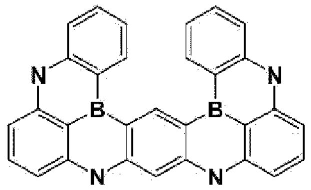

501-20

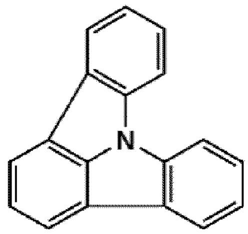

501-21

.

In an embodiment, the emitter may be represented by Formula 501:

Formula 501

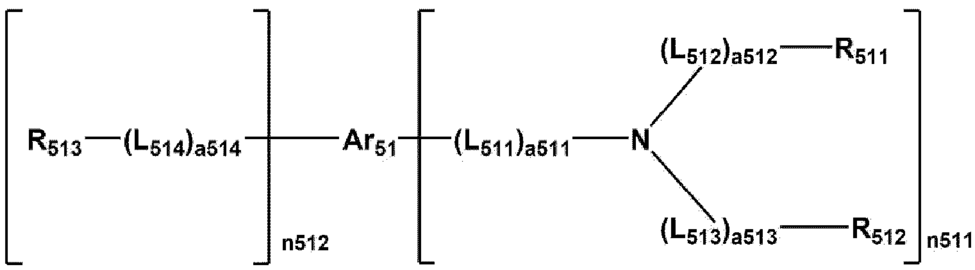

.

In Formula 501,

$Ar_{51}$ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a picene group, a perylene group, a pentacene group, an indenoanthracene group, a tetracene group, a bisanthracene group, or a group represented by one of Formulae 501-1 to 501-21, each unsubstituted or substituted with deuterium, -F, -Cl, -Br, -I, a hydroxyl group, a cyano group, a nitro group, an amidino group, a hydrazine group, a hydrazone group, a sulfonic acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $Si(Q_{511})(Q_{512})(Q_{513})$, $-Ge(Q_{511})(Q_{512})(Q_{513})$, $-C(Q_{511})(Q_{512})(Q_{513})$, $-B(Q_{511})(Q_{512})$, - $N(Q_{511})(Q_{512})$, $-P(Q_{511})(Q_{512})$, $-C(=O)(Q_{511})$, $-S(=O)(Q_{511})$, $-S(=O)_2(Q_{511})$, - $P(=O)(Q_{511})(Q_{512})$, $-P(=S)(Q_{511})(Q_{512})$, or a combination thereof:

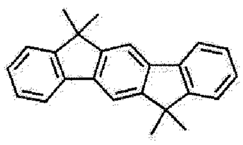

501-1

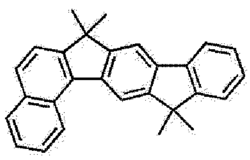

501-2

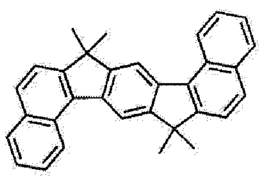

501-3

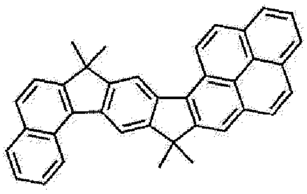

501-4

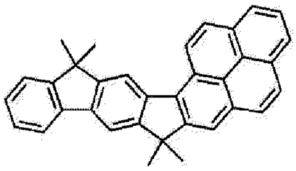

501-5

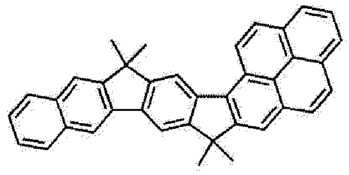

501-6

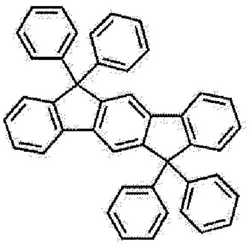

501-7

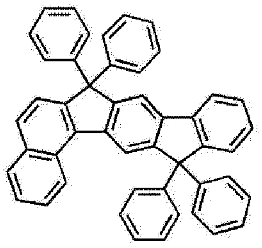

501-8

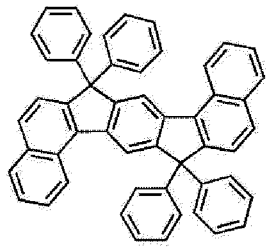

501-9

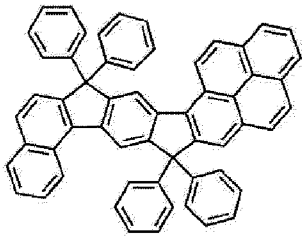

501-10

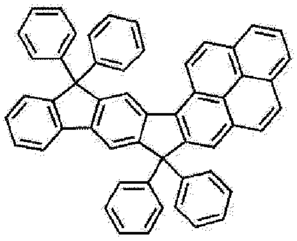

501-11

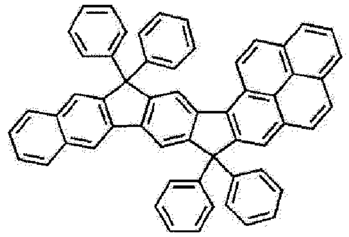

501-12

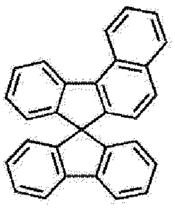

501-13

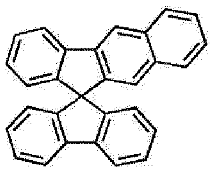

501-14

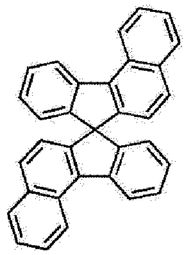

501-15

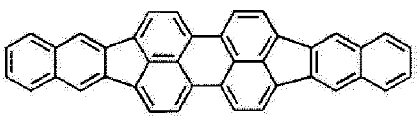

501-16

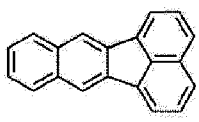

501-17

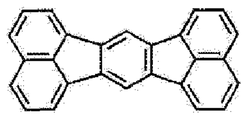

501-18

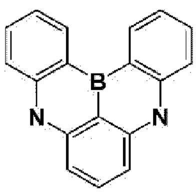

501-19

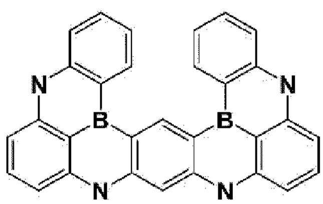

501-20

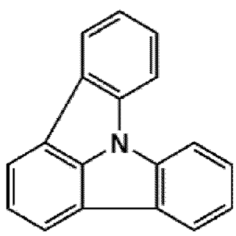

501-21

$L_{511}$ to $L_{514}$ may each independently be a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

a511 to a514 may each independently be 0, 1, 2, or 3,

$R_{511}$ to $R_{513}$ may each independently be a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_1$-$C_{60}$ heteroaryl group, a substituted or unsubstituted $C_2$-$C_{60}$ alkyl heteroaryl group, a substituted or unsubstituted monovalent non-aromatic condensed polycyclic group, or a substituted or unsubstituted monovalent non-aromatic condensed heteropolycyclic group,

wherein $Q_{511}$ to $Q_{513}$ may each independently be hydrogen, deuterium, -F, -Cl, - Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a $C_1$-$C_{60}$ alkyl group substituted with at least one of deuterium, -F, a cyano group, a $C_1$-$C_{20}$ alkyl group, and a $C_6$-$C_{30}$ aryl group, and a $C_6$-$C_{60}$ aryl group substituted with at least one of deuterium, -F, a cyano group, a $C_1$-$C_{20}$ alkyl group, or a $C_6$-$C_{30}$ aryl group, and

n511 and n512 may each independently be 0, 1, 2, 3, 4, 5, or 6.

In an embodiment, in Formula 51, a sum of n511 and n512 may be 1 or greater, but embodiments are not limited thereto.

In an embodiment, in Formula 51, $R_{511}$ and $R_{512}$ may each independently be : a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, and a dibenzothiophenyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, and a dibenzothiophenyl group, each substituted with at least one deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group.

In an embodiment, the emitter may be one of Group FD1:

Group FD1

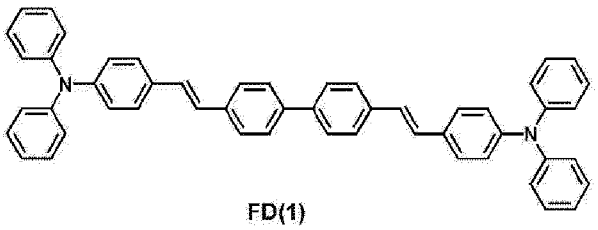

FD(1)

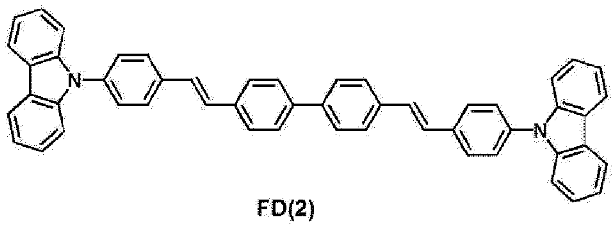

FD(2)

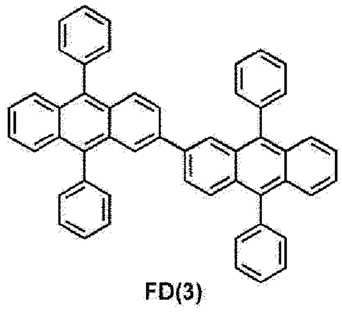

FD(3)

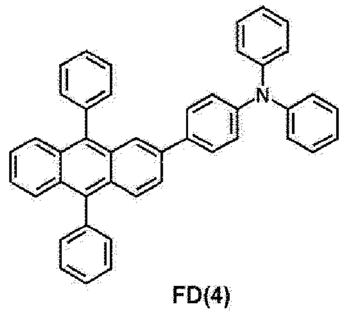

FD(4)

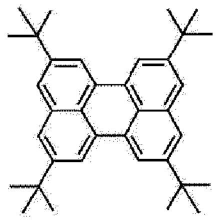

FD(5)

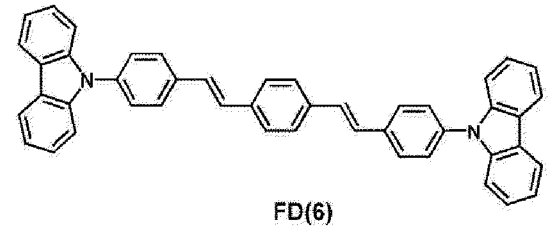

FD(6)

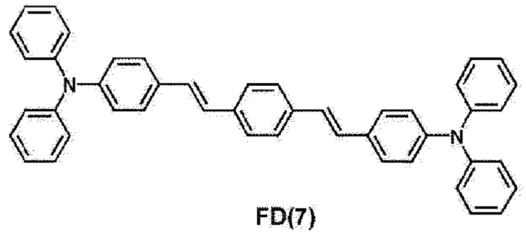

FD(7)

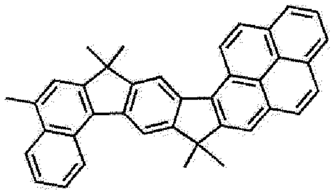

FD(8)

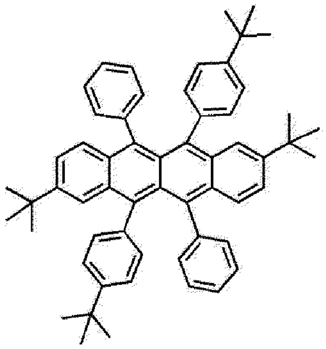

FD(9)

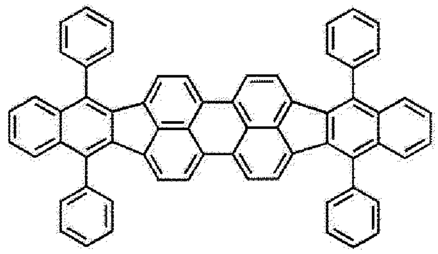

FD(10)

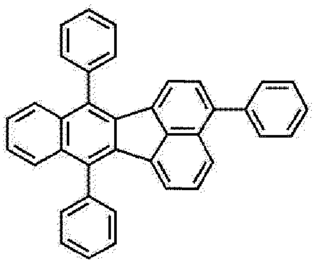

FD(11)

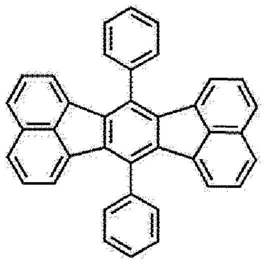

FD(12)

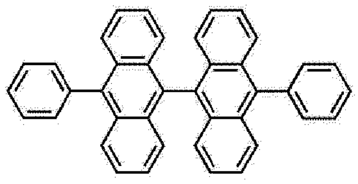

FD(13)

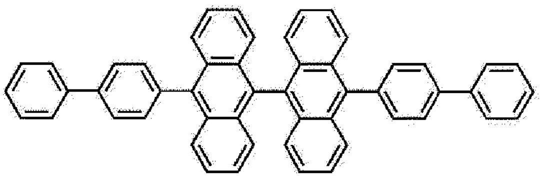

FD(14)

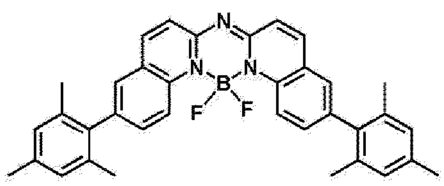

FD(15)

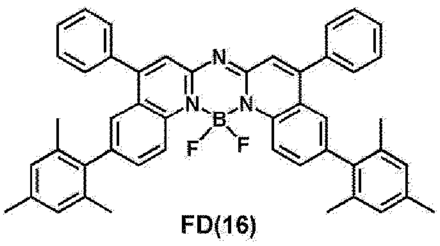

FD(16)

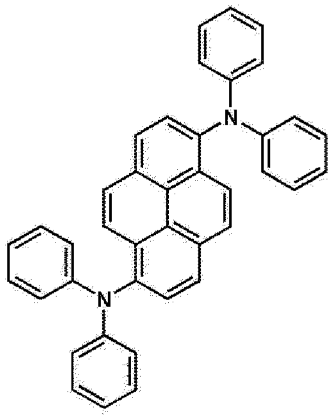

FD1

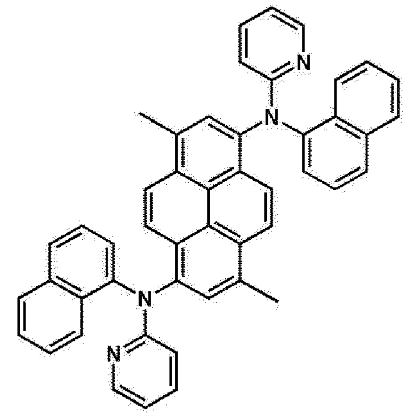

FD2

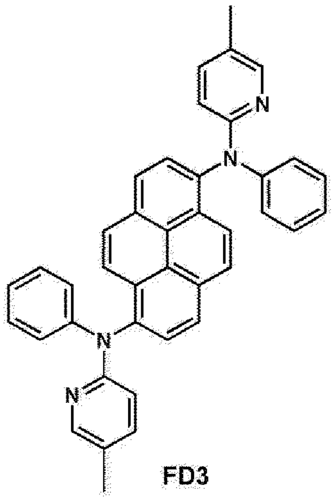

FD3

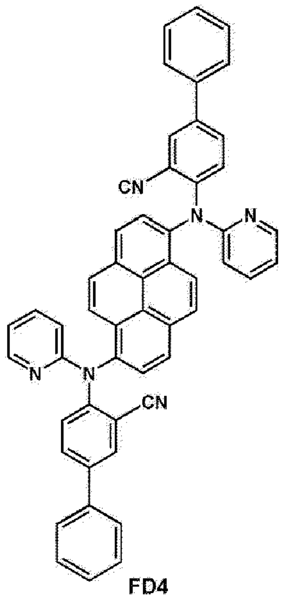

FD4

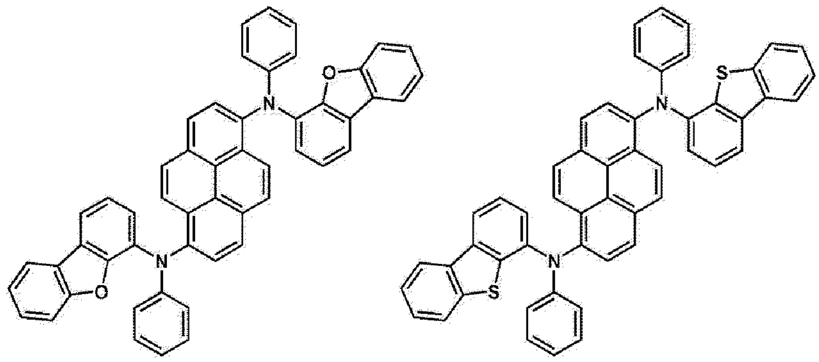

FD5

FD6

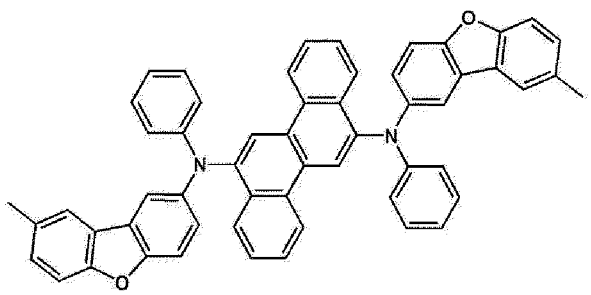

FD7

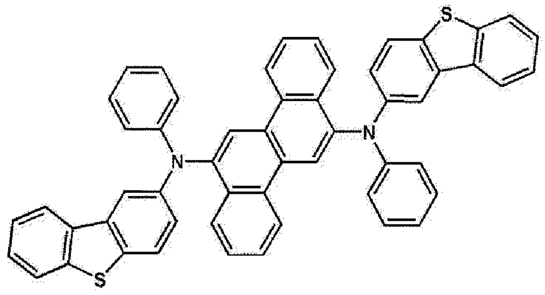

FD8

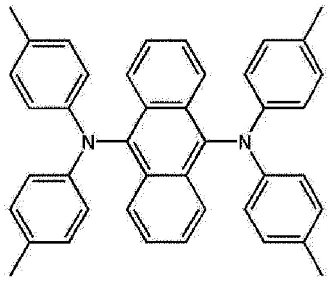

FD9

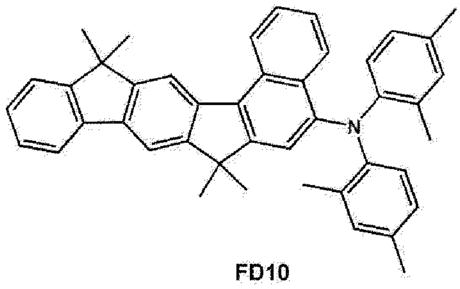

FD10

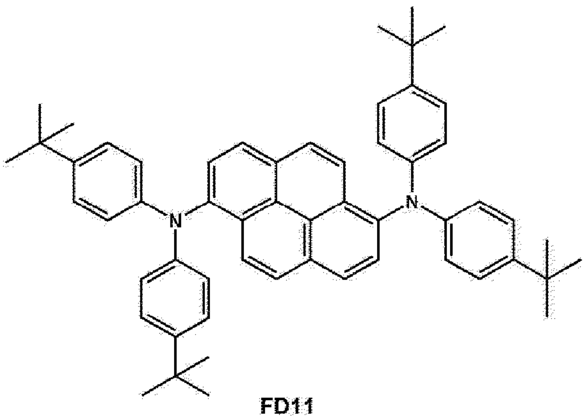

FD11

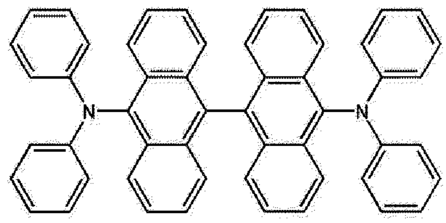

FD12

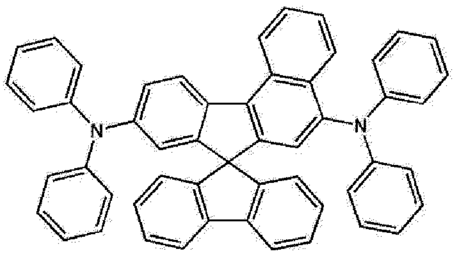

FD13

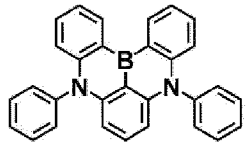

BD1-1

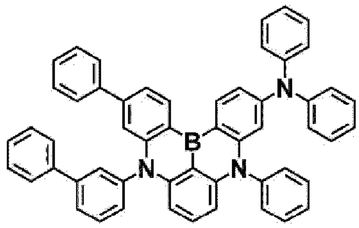

BD1-2

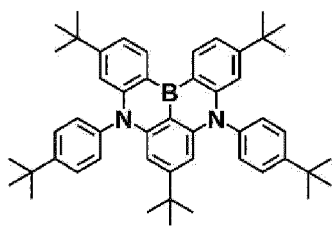

BD1-3

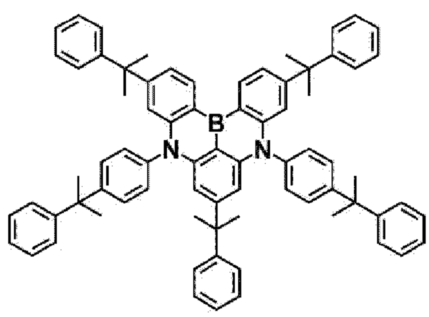

BD1-4

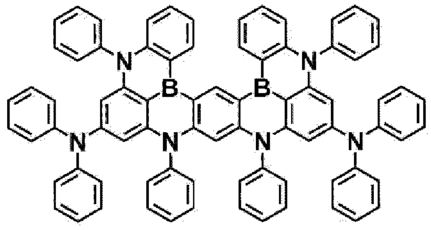

BD1-5

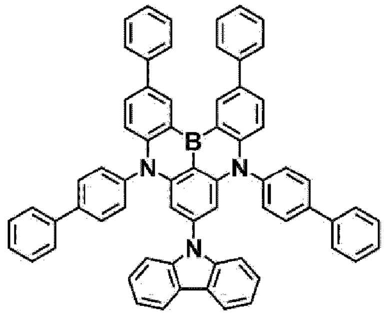

BD1-6

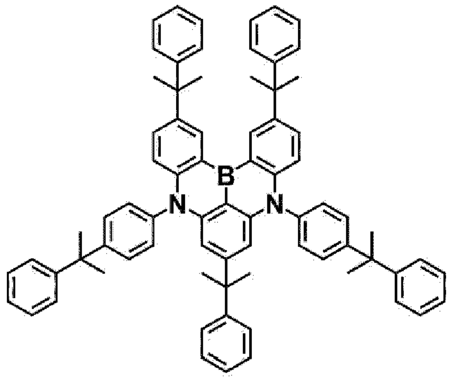

BD1-7

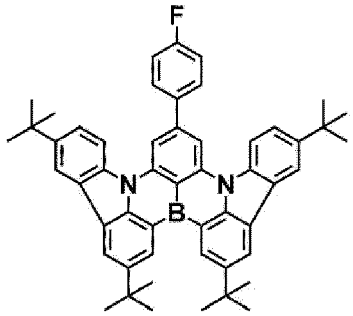

BD1-8

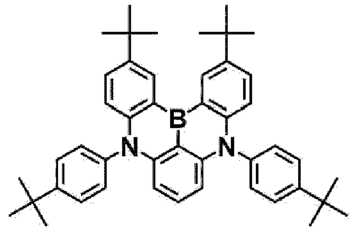

BD1-9

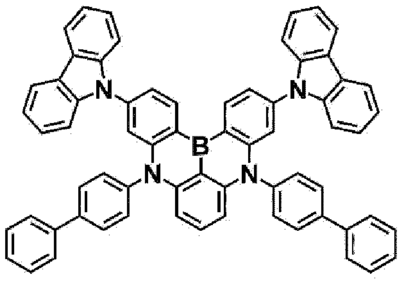

BD1-10

The maximum emission wavelength of an emission spectrum of the emitter may be about 400 nm or greater and about 650 nm or lower. In an embodiment, the maximum emission wavelength of an emission spectrum of the fluorescence emitter may be about 400 nm or greater and about 550 nm or lower, about 400 nm or greater and about 495 nm or lower, or about 450 nm or greater and about 495 nm or lower, but embodiments are not limited thereto. The emitter may emit blue light to green light, for example, blue light, but embodiments are not limited thereto. The "maximum emission wavelength" as used herein refers to a wavelength of which the emission intensity is greatest. In other words, the "maximum emission wavelength" may be referred to as "peak emission wavelength".

The emission layer may have an emitter content in a range of about 0.01 wt% to about 15 wt%, but embodiments are not limited thereto.

In the emission layer, regarding a content of the host, a content of the sensitizer, and a content of the emitter, the content of the host may be greatest, and the content of the emitter may be smallest, but embodiments are not limited thereto.

The organic light-emitting device may satisfy Condition 1:

Condition 1

$$S1(H) > S1(S) \geq S1(E)$$

In Condition 1,

$S_1(H)$ indicates a lowest excited singlet energy level of the host,
$S_1(S)$ indicates a lowest excited singlet energy level of the sensitizer, and
$S_1(E)$ indicates a lowest excited singlet energy level of the emitter.
$S_1(H)$, $S_1(S)$, and $S_1(E)$ may respectively be obtained by calculation from PL spectrum obtained from a film having a thickness of 40 nm formed by vacuum-depositing the host, sensitizer, or emitter each on a quartz substrate at a vacuum degree of $10^{-7}$ torr.

When Condition 1 is satisfied, the emitter may emit light, and the organic light-emitting device may have improved

efficiency.

For example, when Condition 1 is satisfied, the emission ratio from the emitter in the organic light-emitting device may be 85 % or greater. That is, when the aforementioned range is satisfied, only the emitter may substantially emit light, whereas the exciplex and the sensitizer may not substantially emit light in the organic light-emitting device.

When the singlet and/or triplet excitons formed in the host are transferred to the sensitizer and the triplet excitons are converted into singlet excitons in the sensitizer through RISC, the singlet excitons are transferred to the emitter through FRET. As singlet excitons and triplet excitons of the host may all be transferred to the emitter, the organic light-emitting device may have significantly improved lifespan and efficiency.

The host and the sensitizer may satisfy Condition 2:

Condition 2

$$T1(H) \geq T1(S)$$

In Condition 2,

$T_1(H)$ indicates a lowest excited triplet energy level of the host, and
$T_1(S)$ is the lowest excitation triplet energy level of the sensitizer.
Sensitizer in emission layer
The sensitizer may include the organometallic compound.

In an embodiment, the sensitizer may further include a phosphorescent compound.

In an embodiment, the phosphorescent compound may include one type of metal.

In an embodiment, the phosphorescent compound may include at least one type of metal ($M_{11}$) such as a transition metal and an organic ligand ($L_{11}$), wherein $L_{11}$ and $M_{11}$ may form 1, 2, 3, or 4 cyclometallated rings.

In an embodiment, the phosphorescent compound may be represented by Formula 101:

Formula 101 $M_{11}(L_{11})_{n11}(L_{12})_{n12}$

wherein, in Formula 101,

$M_{11}$ may be a transition metal,
$L_{11}$ may be a ligand represented by one of Formulae 111-1 to 111-4,
$L_{12}$ may be a monodentate ligand or a bidentate ligand,
n11 may be 1,
n12 may be 0, 1, or 2,

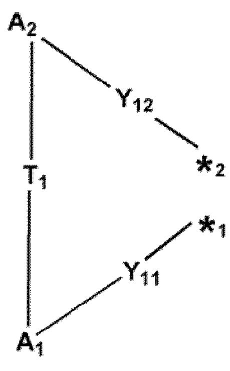
111-1

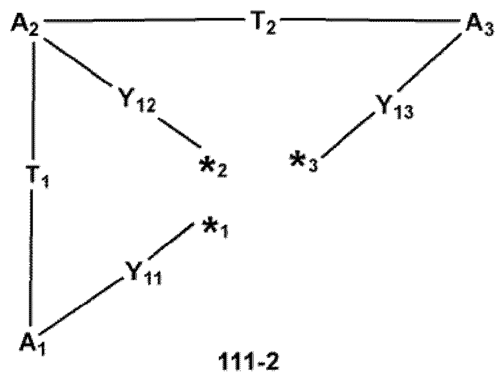
111-2

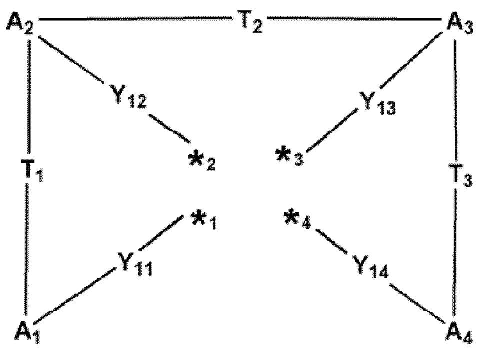

111-3

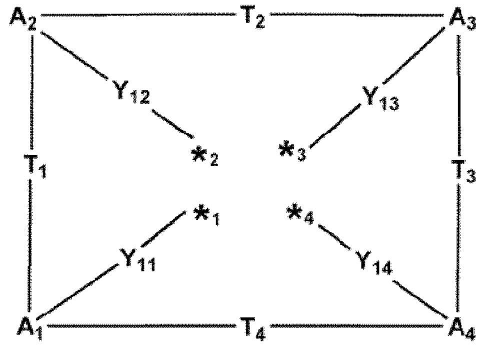

111-4

wherein, in Formulae 111-1 to 111-4,

$A_1$ to $A_4$ may each independently be a substituted or unsubstituted $C_5$-$C_{30}$ carbocyclic group, a substituted or unsubstituted $C_1$-$C_{30}$ heterocyclic group, or a noncyclic group,

$Y_{11}$ to $Y_{14}$ may each independently be a chemical bond, O, S, N($R_{91}$), B($R_{91}$), P($R_{91}$), or C($R_{91}$)($R_{92}$),

$T_1$ to $T_4$ may each independently be a single bond, a double bond, *-N($R_{93}$)-*', *-B($R_{93}$)-*', *-P($R_{93}$)-*', *-C($R_{93}$)($R_{94}$)-*', *-Si($R_{93}$)($R_{94}$)-*', *-Ge($R_{93}$)($R_{94}$)-*', *-S-*', *-Se-*', *-O-*', *-C(=O)-*', *-S(=O)-*', *-S(=O)$_2$-*', *-C($R_{93}$)=*', *=C($R_{93}$)-*', *-C($R_{93}$)=C($R_{94}$)-*', *-C(=S)-*', or *-C=C-*',

a substituent of the substituted $C_5$-$C_{30}$ carbocyclic group, a substituent of the substituted $C_1$-$C_{30}$ heterocyclic group, and $R_{91}$ to $R_{94}$ may each independently be hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), -C($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$), or -P(=S)($Q_1$)($Q_2$), wherein the substituent of the substituted $C_5$-$C_{30}$ carbocyclic group and the substituent of the substituted $C_1$-$C_{30}$ heterocyclic group are not hydrogen,

*1, *2, *3, and *4 each indicate a binding site to $M_{11}$, and

$Q_1$ to $Q_3$ may each independently be hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, a $C_1$-$C_{60}$ alkyl group that is substituted with at least one deuterium, -F, a cyano group, a $C_1$-$C_{60}$ alkyl group, and a $C_6$-$C_{60}$ aryl group, and a $C_6$-$C_{60}$ aryl group that is substituted with at least one deuterium, -F, a cyano group, a $C_1$-$C_{60}$ alkyl group, or a $C_6$-$C_{60}$ aryl group.

In an embodiment, the transition metal may include platinum (Pt), palladium (Pd), gold (Au), iridium (Ir), osmium (Os), titanium (Ti), zirconium (Zr), hafnium (Hf), europium (Eu), terbium (Tb), thulium (Tm), or rhodium (Rh).

In an embodiment, the sensitizer may further include a delayed fluorescence compound.

In an embodiment, the delayed fluorescence compound may be represented by Formula 101 or 102:

Formula 101 Formula 102

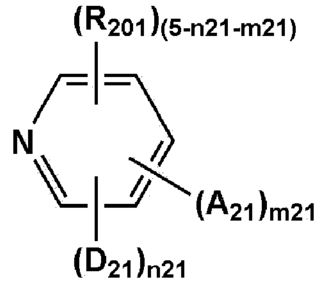

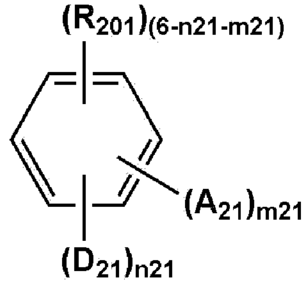

In Formulae 101 and 102,

$A_{21}$ may be an acceptor group,
$D_{21}$ may be a donor group,
m21 may be 1, 2, or 3, and n21 may be 1, 2, or 3,
the sum of n21 and m21 in Formula 101 may be 5 or less, and the sum of n21 and m21 in Formula 102 may be 6 or less,
$R_{201}$ may be hydrogen, deuterium, -F, -Cl, -Br, -I, -$SF_5$, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkylheteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -$Si(Q_1)(Q_2)(Q_3)$, -$Ge(Q_1)(Q_2)(Q_3)$, -$C(Q_1)(Q_2)(Q_3)$, -$B(Q_1)(Q_2)$, -$N(Q_1)(Q_2)$, -$P(Q_1)(Q_2)$, - $C(=O)(Q_1)$, -$S(=O)(Q_1)$, -$S(=O)_2(Q_1)$, -$P(=O)(Q_1)(Q_2)$, or -$P(=S)(Q_1)(Q_2)$, wherein a plurality of $R_{201}$ may optionally be bonded together to form a substituted or unsubstituted $C_5$-$C_{30}$ carbocyclic group or a substituted or unsubstituted $C_1$-$C_{30}$ heterocyclic group, and
$Q_1$ to $Q_3$ may each independently be hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, a $C_1$-$C_{60}$ alkyl group that is substituted with at least one deuterium, -F, a cyano group, a $C_1$-$C_{60}$ alkyl group, or a $C_6$-$C_{60}$ aryl group, or a $C_6$-$C_{60}$ aryl group that is substituted with at least one deuterium, -F, a cyano group, a $C_1$-$C_{60}$ alkyl group, and a $C_6$-$C_{60}$ aryl group.

In an embodiment, in Formulae 101 and 102, $D_{21}$ may be a substituted or unsubstituted $\pi$ electron-deficient nitrogen-free cyclic group.

In an embodiment, the $\pi$ electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; a or nd a condensed cyclic group of two or more $\pi$ electron-deficient nitrogen-free cyclic groups, but embodiments are not limited thereto.

In an embodiment, in Formulae 101 and 102, $A_{21}$ may be : -F, a cyano group, or a π electron-deficient nitrogen-containing cyclic group;

a $C_1$-$C_{60}$ alkyl group, an π-electron deficient nitrogen-containing cyclic group, and an π electron-deficient nitrogen-free cyclic group, each substituted with at least one -F and a cyano group; and
an π-electron deficient nitrogen-containing cyclic group, each substituted with at least one of deuterium, a $C_1$-$C_{60}$ alkyl group, an π -electron deficient nitrogen-containing cyclic group, or an π electron-deficient nitrogen-free cyclic group.

In an embodiment, the π electron-deficient nitrogen-free cyclic group is the same as described above.

The term "π electron-deficient nitrogen-containing cyclic group" as used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, or a benzimidazole group; and a condensed cyclic group of two or more π electron-deficient nitrogen-containing cyclic groups.

In an embodiment, an amount of the sensitizer in the organic layer may be greater than an amount of the emitter in the organic layer. For example, a volume ratio of the sensitizer and the emitter may be in a range of about 30:0.1 to about 10:3 or about 10:0.1 to about 20:5. In an embodiment, a weight ratio of the sensitizer and the emitter may be in a range of about 10:0.1 to about 20:5. In an embodiment, a weight ratio of the host and the sensitizer in the organic layer may be in a range of about 60:40 to about 95:5 or about 70:30 to about 90:10. In an embodiment, the weight ratio of the host and the sensitizer in the organic layer may be in a range of about 60:40 to about 95:5. When the amount is satisfied within the ranges above, the organic light-emitting device may have improved luminescence efficiency and/or long lifespan characteristics.

FIG. 1 is a schematic cross-sectional view of an organic light-emitting device 10 according to an embodiment. Hereinafter, the structure and manufacturing method of the organic light-emitting device 10 according to an embodiment will be described with reference to FIG. 1. The organic light-emitting device 10 may have a structure in which a first electrode 11, an organic layer 15, and a second electrode 19 are sequentially stacked.

A substrate may be further disposed under the first electrode 11 or on the second electrode 19. The substrate may be a substrate commonly used in organic light-emitting devices, e.g., a glass substrate or a transparent plastic substrate, which have excellent mechanical strength, thermal stability, transparency, surface smoothness, ease of handling, and water repellency.

The first electrode 11 may be formed by, for example, depositing or sputtering, onto the substrate, a material for forming the first electrode 11. The first electrode 11 may be an anode. The material for forming the first electrode 11 may be a material with a high work function for easy hole injection. The first electrode 11 may be a reflective electrode, a transflective electrode, or a transmissive electrode. The material for forming the first electrode 11 may be indium tin oxide (ITO), indium zinc oxide (IZO), tin oxide ($SnO_2$), or zinc oxide (ZnO). In an embodiment, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 may be disposed on the first electrode 11.

The organic layer 15 may include a hole transport region, an emission layer, and an electron transport region.

The hole transport region may be disposed between the first electrode 11 and the emission layer.

The hole transport region may include an HIL, a hole transport layer, an electron blocking layer, a buffer layer, or a combination thereof.

The hole transport region may include only either an HIL or a hole transport layer. In an embodiment, the hole transport region may have a HIL/hole transport layer structure or a HIL/hole transport layer/electron blocking layer structure, in which respective layers of each structure are sequentially stacked in the stated order from the first electrode 11.

When the hole transport region includes an HIL, the HIL may be formed on the first electrode 11 by using various methods, for example, vacuum deposition, spin coating, casting, and/or Langmuir-Blodgett (LB) deposition.

When the hole injection layer is formed by a vacuum deposition method, deposition conditions may vary depending on a compound used as a material for forming the hole injection layer, a structure and thermal characteristics of the desired hole injection layer, and the like. For example, a deposition temperature may be about 100 °C to about 500 °C, a

vacuum pressure may be about $10^{-8}$ torr to about $10^{-3}$ torr, and a deposition rate may be about 0.01 Angstrom per second (Å/sec) to about 100 Å/sec, but embodiments are not limited thereto.

When the hole injection layer is formed by a spin coating method, coating conditions may vary depending on a compound used as a material for forming the hole injection layer, a structure and thermal characteristics of the desired hole injection layer, and the like. For example, a coating rate may be about 2,000 rpm to about 5,000 rpm, and a temperature at which heat treatment is performed to remove a solvent after coating may be about 80 °C to about 200 °C, but embodiments are not limited thereto.

The conditions for forming the hole transport layer and the electron blocking layer may be referred to the description provided for the conditions for forming the HIL.

The hole transport region may include at least one m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, and a compound represented by Formula 202 below:

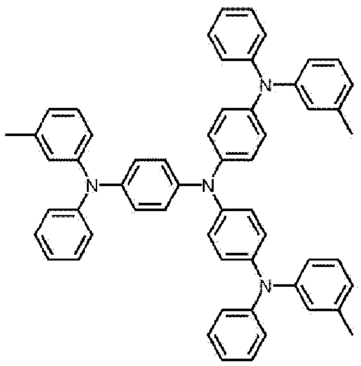

m-MTDATA

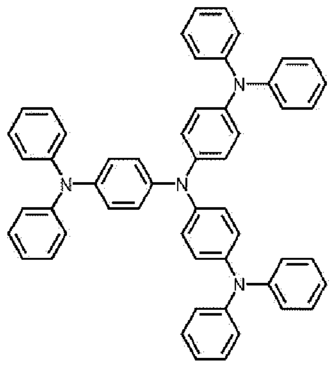

TDATA

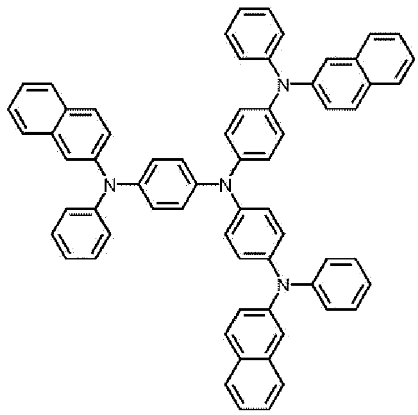

2-TNATA

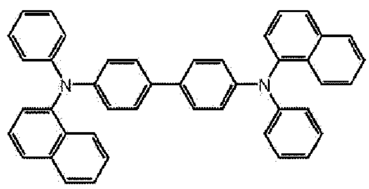

NPB

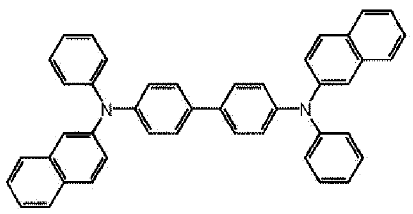

β-NPB

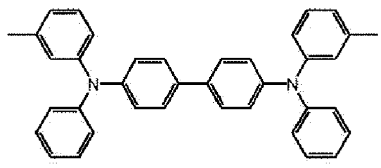

TPD

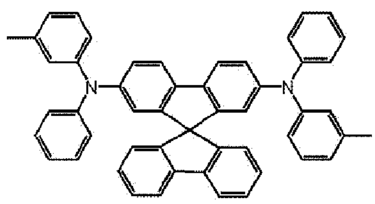

Spiro-TPD

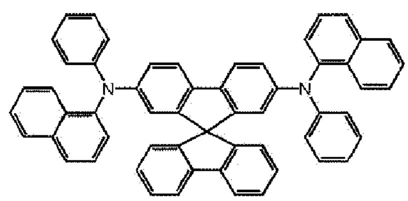

Spiro-NPB

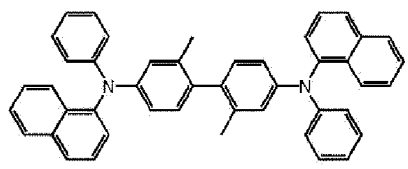

methylated NPB

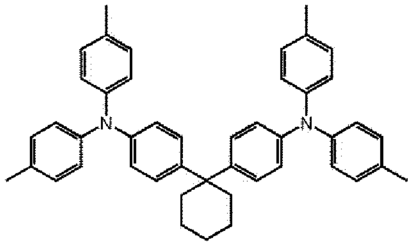

TAPC

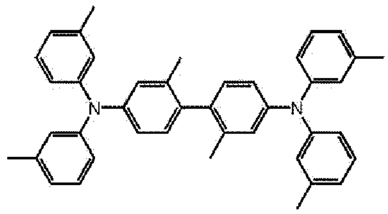

HMTPD

Formula 201

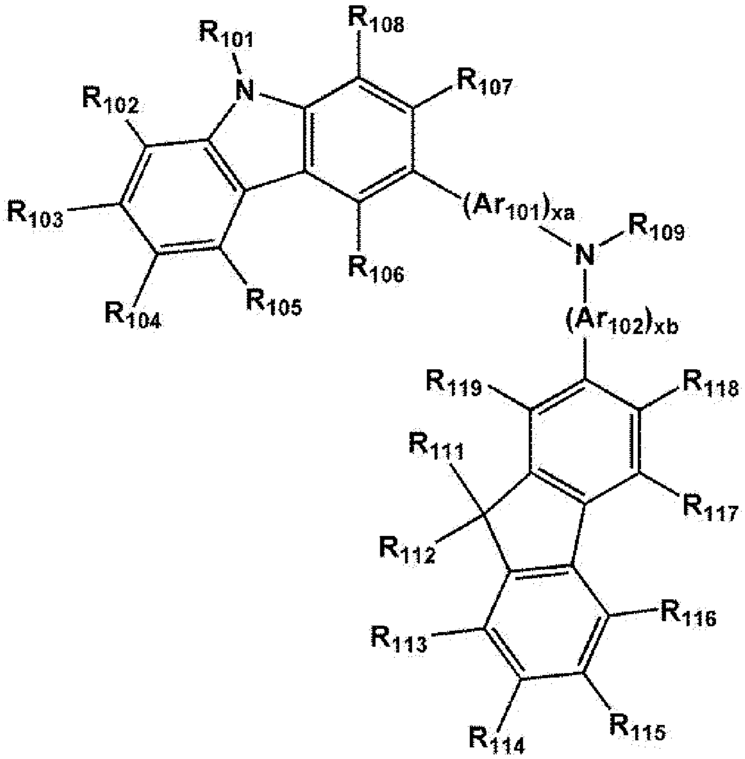

Formula 202

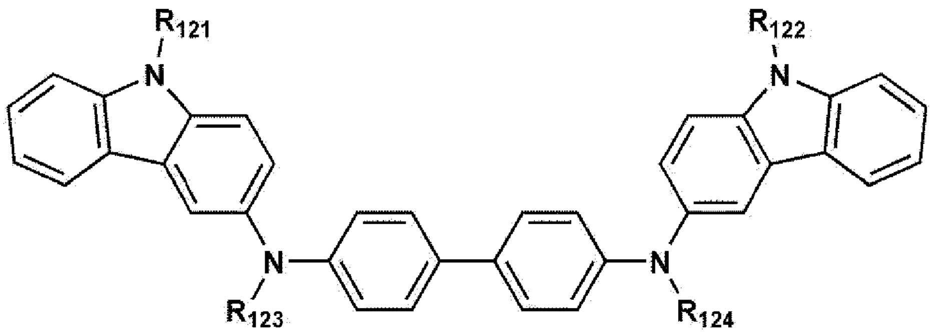

.

In Formula 201, $Ar_{101}$ and $Ar_{102}$ may each independently be:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene

group; or

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1, and xb may be 0, but xa and xb are not limited thereto.

$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, pentyl group, or a hexyl group), or a $C_1$-$C_{10}$ alkoxy group (e.g., a methoxy group, an ethoxy group, a propoxy group, a butoxy group, or a pentoxy group);

a $C_1$-$C_{10}$ alkyl group or a $C_1$-$C_{10}$ alkoxy group, each substituted with deuterium, - F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, or a combination thereof;

a phenyl group, a naphthyl group, an anthracenyl group, a fluorenyl group, or a pyrenyl group; or

a phenyl group, a naphthyl group, an anthracenyl group, a fluorenyl group, or a pyrenyl group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or a combination thereof, but embodiments are not limited thereto.

$R_{109}$ in Formula 201 may be:

a phenyl group, a naphthyl group, an anthracenyl group, or a pyridinyl group; or

a phenyl group, a naphthyl group, an anthracenyl group, or a pyridinyl group, each substituted with deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{20}$ alkyl group, a $C_1$-$C_{20}$ alkoxy group, a phenyl group, a naphthyl group, an anthracenyl group, a pyridinyl group, or a combination thereof.

In an embodiment, the compound represented by Formula 201 may be represented by Formula 201A, but embodiments are not limited thereto:

Formula 201A

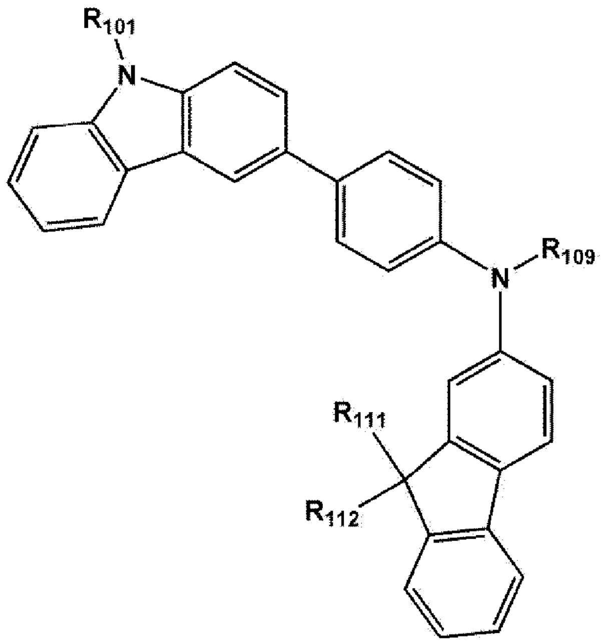

In Formula 201A, $R_{101}$, $R_{111}$, $R_{112}$, and $R_{109}$ may each be as described herein.

For example, the compound represented by Formula 201 and the compound represented by Formula 202 may include, but are not limited to, compounds HT1 to HT20:

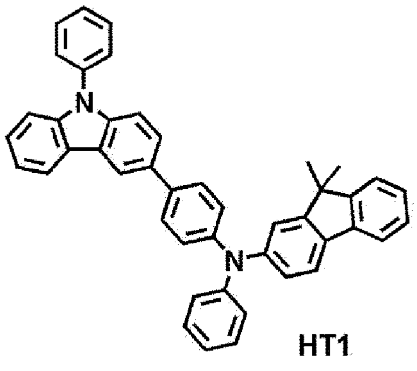

HT1

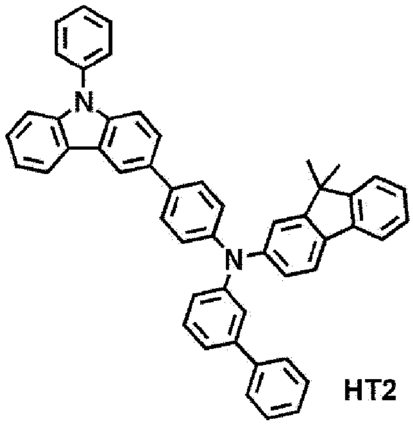

HT2

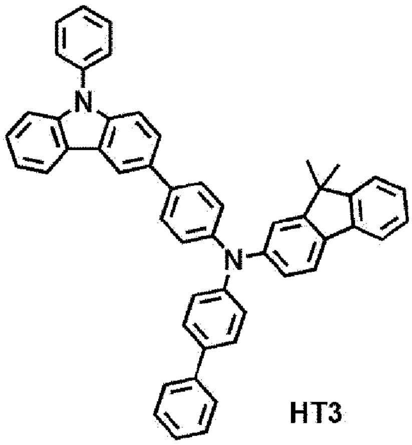

HT3

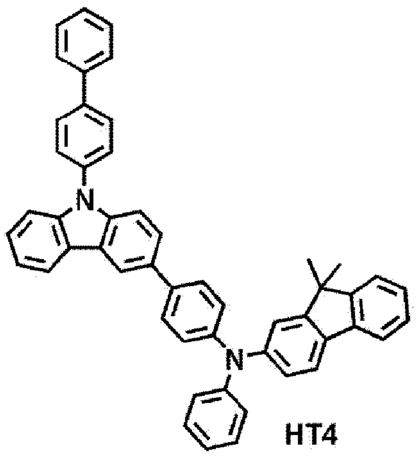

HT4

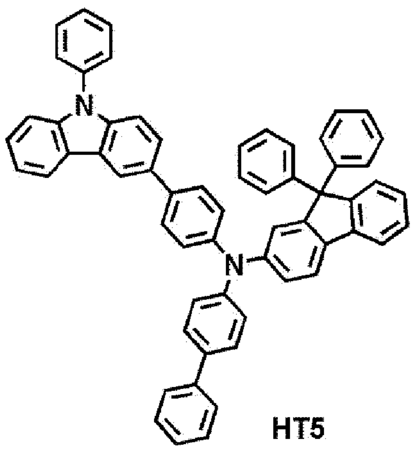

HT5

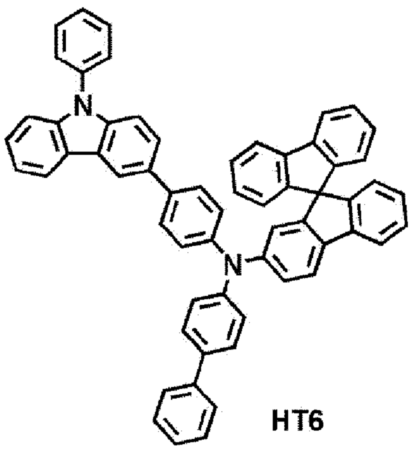

HT6

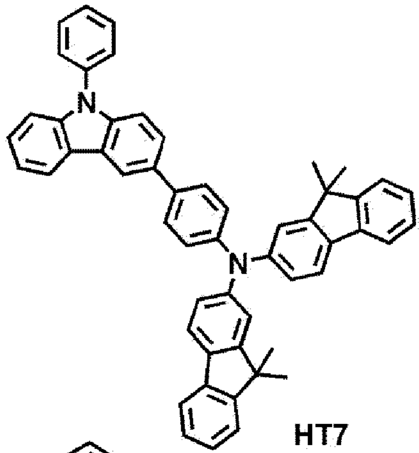

HT7

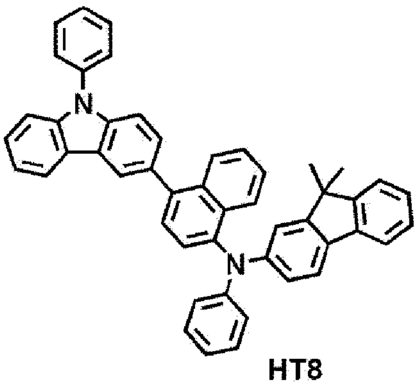

HT8

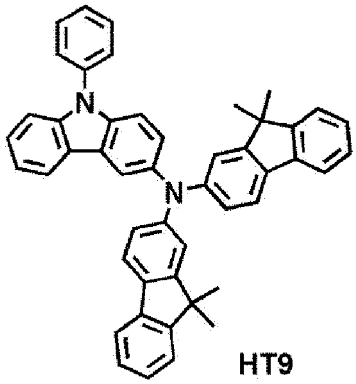

HT9

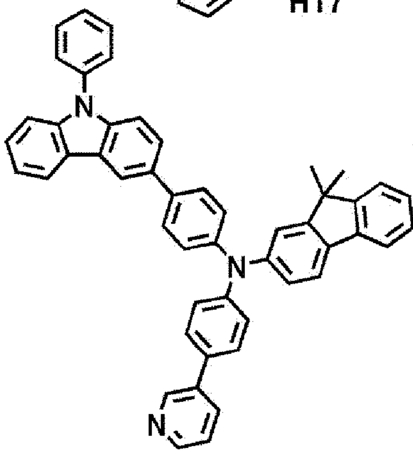

HT10

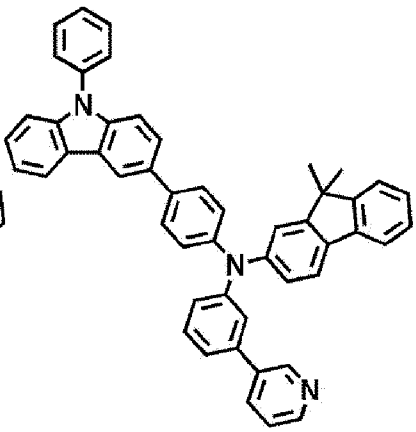

HT11

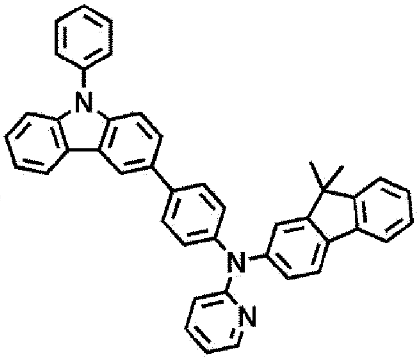

HT12

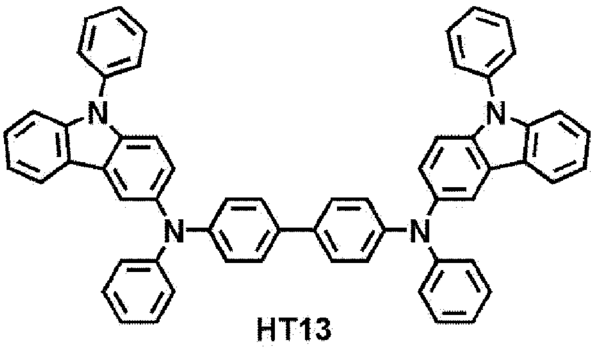

HT13

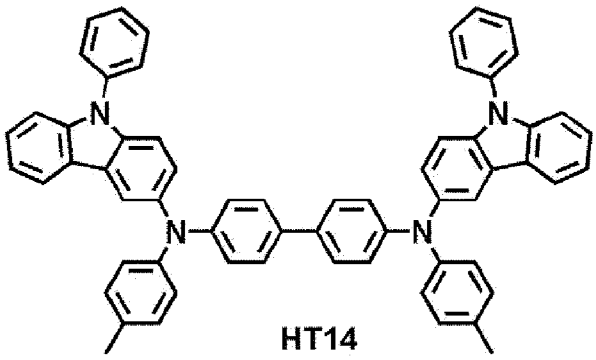

HT14

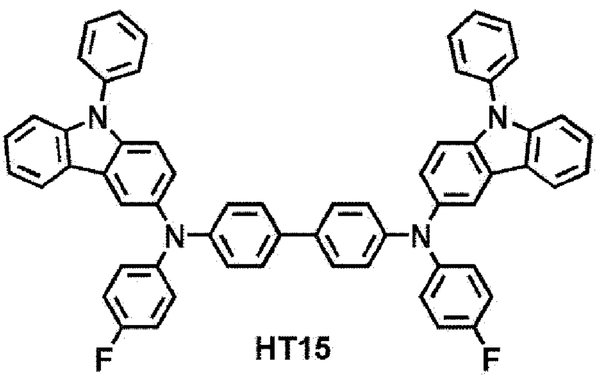

HT15

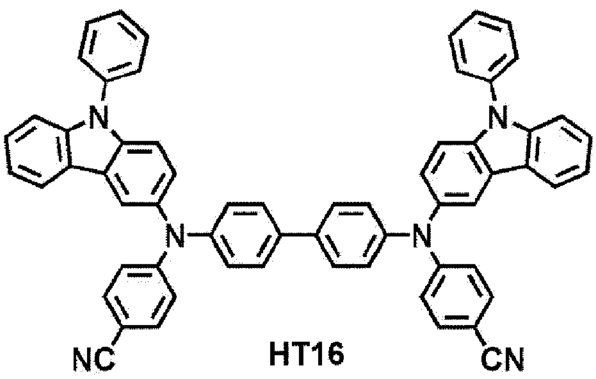

HT16

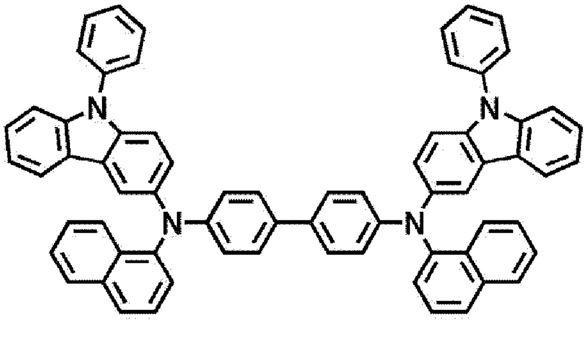

HT17

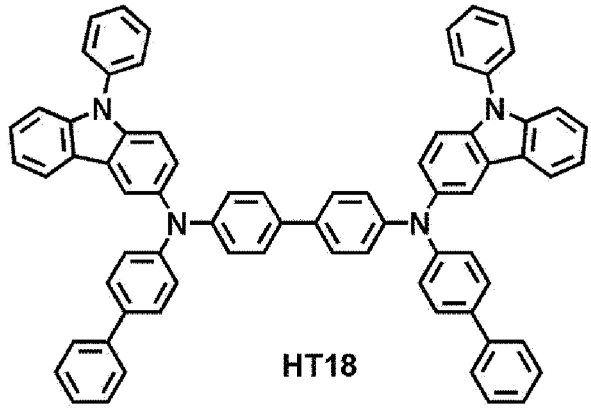

HT18

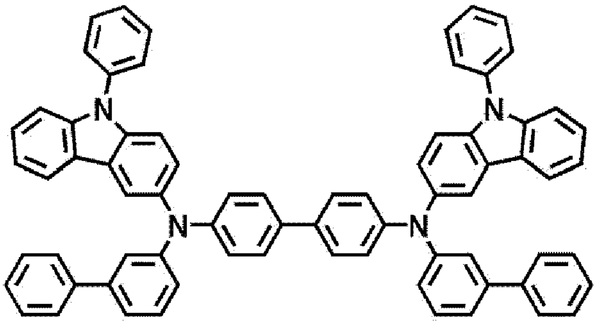

HT19

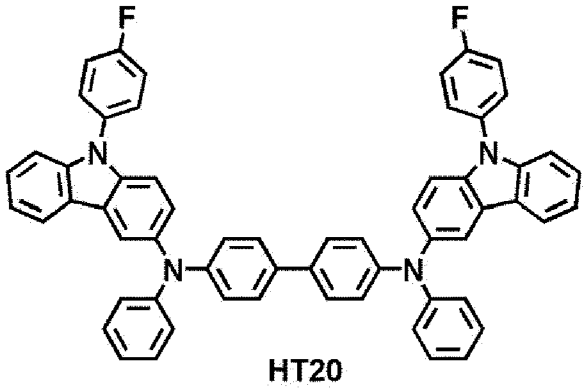

HT20

.

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the HIL, and the hole transport layer are within these ranges, satisfactory hole transporting characteristics may be obtained without a substantial increase in driving voltage.

The hole transport region may further include, in addition to the above-described materials, a charge-generation material for improving conductivity. The charge-generation material may be homogeneously or non-homogeneously dispersed in the hole transport region.

The charge-generation material may be, for example, a p-dopant. The p-dopant may be, but is not limited to, one of a quinone derivative, a metal oxide, and a cyano group-containing compound. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide; and a cyano group-containing compound, such as Compound HT-D1 or F12, but are not limited thereto:

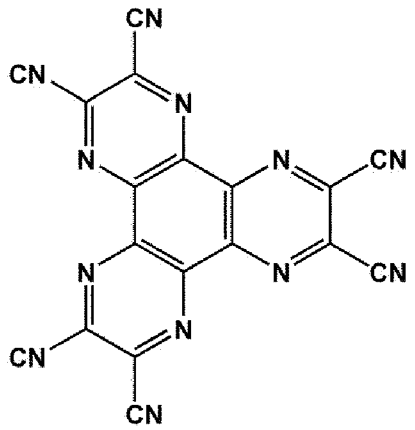

HT-D1

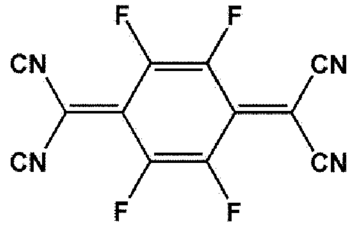

F4-TCNQ

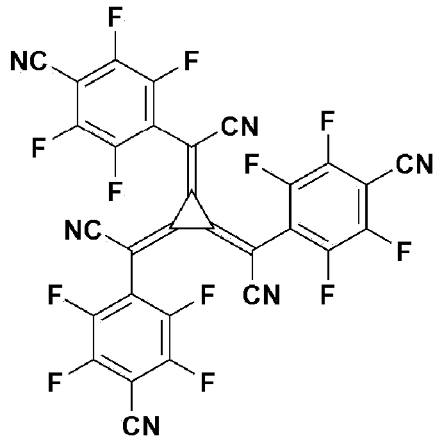

F12

The hole transport region may include a buffer layer.

The buffer layer may compensate for an optical resonance distance according to a wavelength of light emitted from the emission layer 15, and thus, efficiency of a formed organic light-emitting device may be improved.

The emission layer (EML) may be formed on the hole transport region by vacuum deposition, spin coating, casting, LB deposition, or the like. When the emission layer is formed by vacuum deposition or spin coating, the deposition or coating conditions may generally be similar to those applied in forming the HIL although the deposition or coating conditions may vary according to a material that is used to form the hole transport layer.

In an embodiment, when the hole transport region includes an electron blocking layer, a material for forming the electron blocking layer may be , but is not limited to, the above-described materials that may be used in the hole transport region and a host material described below. For example, when the hole transport region includes an electron blocking layer, a material for forming the electron blocking layer may be mCP, which will be described below.

When the organic light-emitting device is a full-color organic light-emitting device, the emission layer may be patterned into a red emission layer, a green emission layer, and a blue emission layer. In an embodiment, the emission layer may have a structure in which a red emission layer, a green emission layer, and/or a blue emission layer are stacked, and thus, various modifications such as emission of white light are possible.

When the emission layer includes a host and a dopant, the amount of the dopant may generally be in a range of about 0.01 parts by weight to about 15 parts by weight with respect to 100 parts by weight of the host, but embodiments are not limited thereto.

A thickness of the emission layer may be in a range of about 100 Å to about 1,000 Å, for example, about 200 Å to about 600 Å. When the thickness of the emission layer is within the range described above, excellent luminescence characteristics may be obtained without a substantial increase in driving voltage.

Next, an electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure, and the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be referred to the description provided for the conditions for forming the hole injection layer.

When the electron transport region includes a hole blocking layer, the hole blocking layer may include, for example, at least one of BCP, Bphen, and Balq (shown further below), but embodiments are not limited thereto:

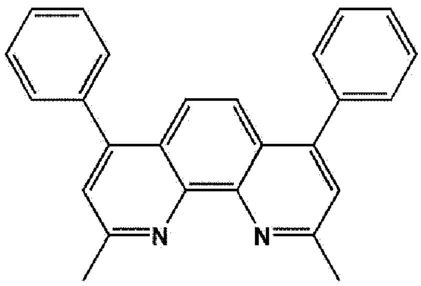

BCP

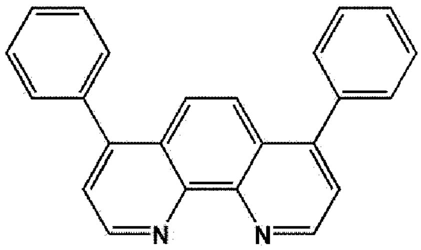

Bphen

A thickness of the hole blocking layer may be in a range of about 20 Å to about 1,000 Å, for example, about 30 Å to about 300 Å. When the thickness of the hole blocking layer is within these ranges, excellent hole blocking characteristics may be obtained without a substantial increase in driving voltage.

The electron transport layer may further include at least one BCP, Bphen, $Alq_3$, BAlq, TAZ, and NTAZ:

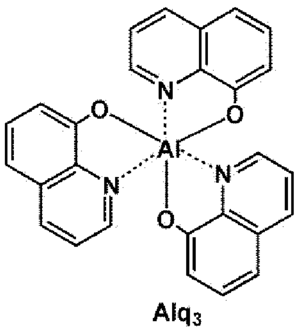

$Alq_3$

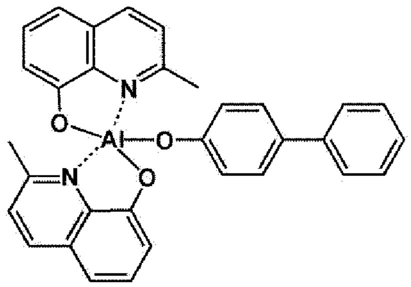

BAlq

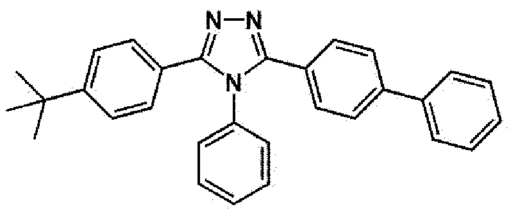

TAZ

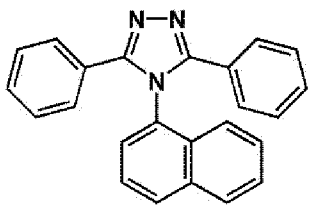

NTAZ

In an embodiment, the electron transport layer may include at least one of ET1 to ET25, but embodiments are not limited thereto:

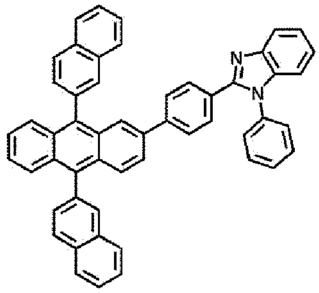
ET1

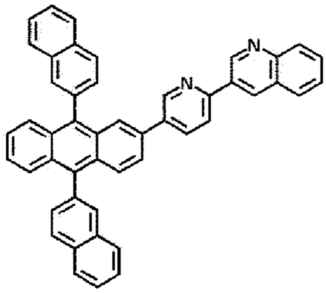
ET2

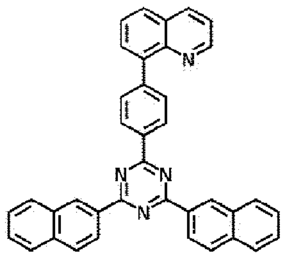
ET3

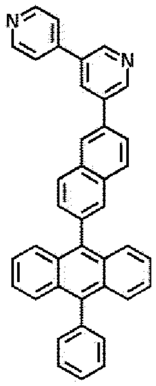
ET4

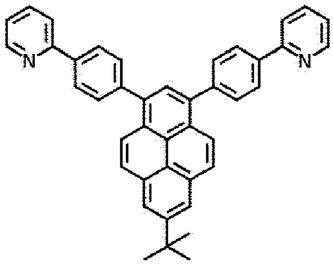
ET5

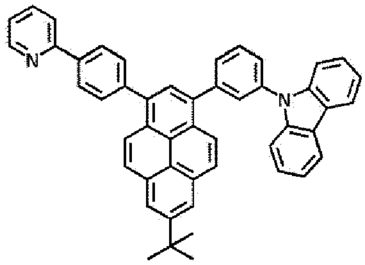
ET6

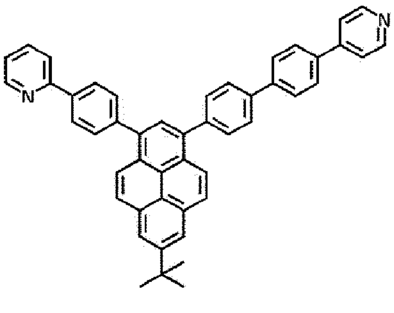
ET7

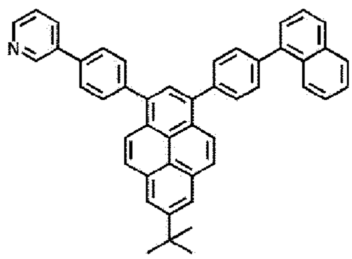
ET8

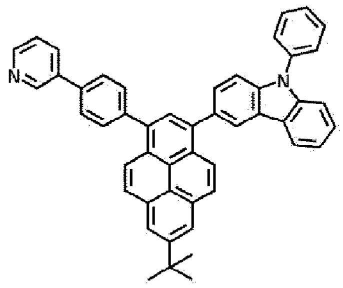
ET9

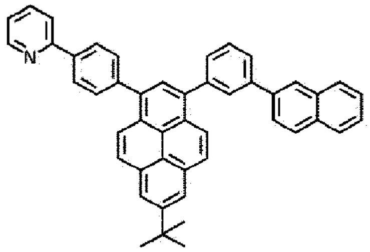
ET10

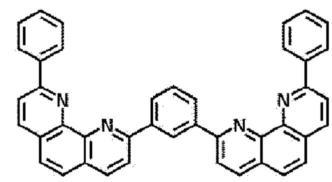
ET11

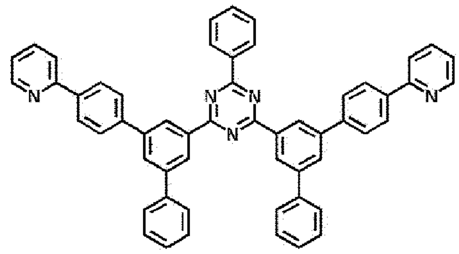
ET12

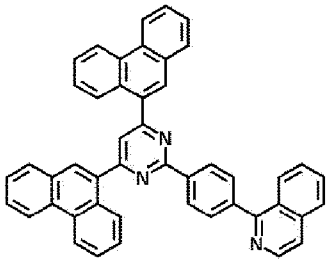

ET13

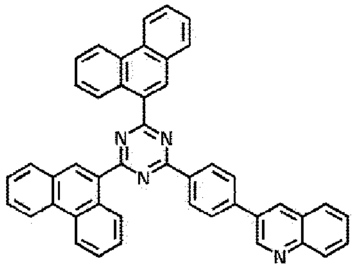

ET14

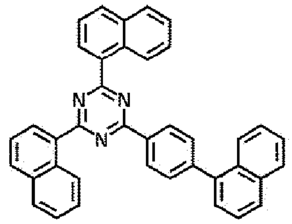

ET15

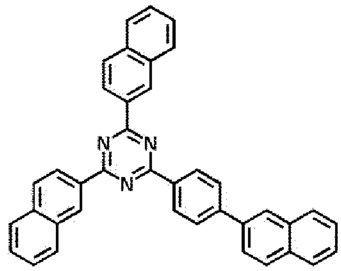

ET16

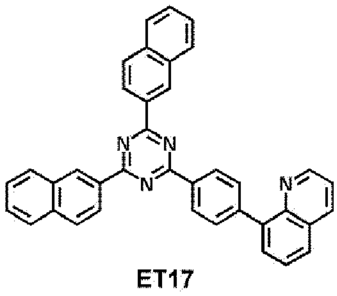

ET17

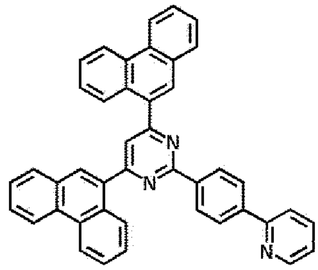

ET18

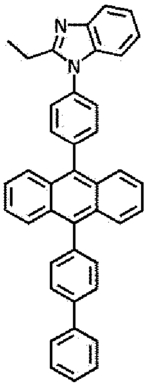

ET19

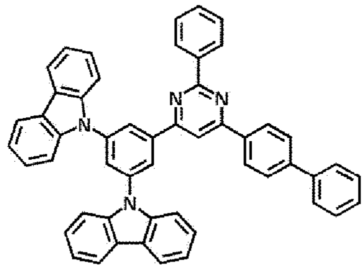

ET20

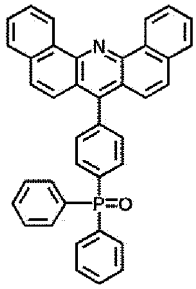

ET21

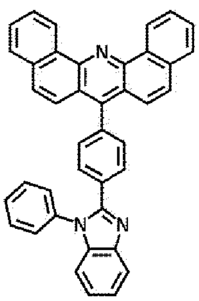

ET22

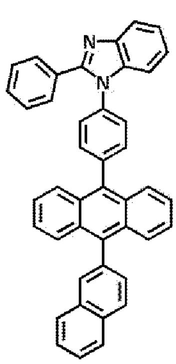

ET23

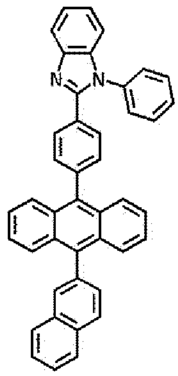

ET24

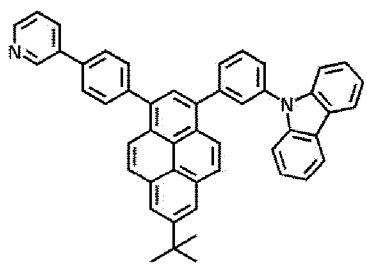

ET25

A thickness of the electron transport layer may be in a range of about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may further include a metal-containing material, in addition to the material as described above.

The metal-containing material may include a Li complex. The Li complex may include, for example, Compound

ET-D1 (lithium quinolate, LiQ) or ET-D2:

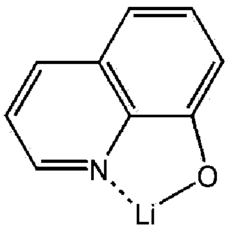

ET-D1

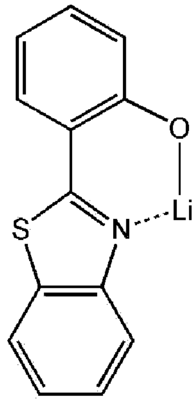

ET-D2

The electron transport region may include an electron injection layer (EIL) that facilitates the injection of electrons from the second electrode 19.

The EIL may include LiQ, LiF, NaCl, CsF, $Li_2O$, BaO, or a combination thereof.

A thickness of the electron injection layer may be in a range of about 1 Å to about 100 Å, for example, about 3 Å to about 90 Å. When the thickness of the electron injection layer is within the range as described above, satisfactory electron injection characteristics may be obtained without a substantial increase in driving voltage.

Second electrode 19

The second electrode 19 may be disposed on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In an embodiment, to manufacture a top-emission type light-emitting device, various modifications, such as formation of a transmissive second electrode using ITO or IZO, is possible.

The organic light-emitting device has been described with reference to FIG. 1, but embodiments are not limited thereto.

Another aspect provides an electronic apparatus including the organic light-emitting device.

The electronic apparatus may further include a thin-film transistor in addition to the organic light-emitting device as described above. The thin-film transistor may include a source electrode, a drain electrode, and an active layer, wherein any one of the source electrode and the drain electrode may be electrically connected to any one of the first electrode and the second electrode of the organic light-emitting device.

Another aspect provides a diagnostic composition including the organometallic compound represented by Formula 1.

The diagnostic composition may include at least one type of organometallic compound represented by Formula 1.

The organometallic compound represented by Formula 1 provides high luminescence efficiency, and accordingly, the diagnostic composition including the at least one organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl

group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" as used herein refers to a monovalent group represented by -$OA_{101}$ (wherein $A_{101}$ is the $C_1$-$C_{60}$ alkyl group), and non-limiting examples thereof include a methoxy group, an ethoxy group, and an isopropyloxy group.

Examples of the $C_1$-$C_{60}$ alkoxy group, a $C_1$-$C_{20}$ alkoxy group or $C_1$-$C_{10}$ alkoxy group are a methoxy group, an ethoxy group, a propoxy group, a butoxy group, and a pentoxy group.

The term "$C_1$-$C_{60}$ alkylthio group" as used herein refers to a monovalent group represented by -$SA_{101}$ (wherein $A_{101}$ is the $C_1$-$C_{60}$ alkyl group), and non-limiting examples thereof include a methylthio group, an ethylthio group, and an isopropylthio group. In some embodiments, the alkylthio group is a $C_1$-$C_{20}$ alkylthio group, or a $C_1$-$C_{10}$ alkylthio group.

The term "$C_2$-$C_{60}$ alkenyl group" as used herein refers to a structure containing at least one carbon-carbon double bond in the middle or at the end of the $C_2$-$C_{60}$ alkyl group, and non-limiting examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof are an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_3$-$C_{10}$ cycloalkyl group" as used herein may include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, and the like.

The term "$C_1$-$C_{10}$ heterocycloalkyl group" as used herein refers to a monovalent saturated cyclic group having at least one heteroatom such as N, O, P, Si, or S as a ring-forming atom and 1 to 10 carbon atoms, and non-limiting examples thereof include a tetrahydrofuranyl group and a tetrahydrothiophenyl group. The term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group are a silolanyl group, a silinanyl group, tetrahydrofuranyl group, a tetrahydro-2H-pyranyl group, and a tetrahydrothiophenyl group.

The term "$C_3$-$C_{10}$ cycloalkenyl group" as used herein refers to a monovalent cyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_2$-$C_{10}$ heterocycloalkenyl group" as used herein refers to a monovalent cyclic group that has at least one hetero atom such as N, O, P, Si, or S as a ring-forming atom, 2 to 10 carbon atoms, and at least one carbon-carbon double bond in its ring. Non-limiting examples of the $C_1$-$C_{10}$ heterocycloalkenyl group include a 2,3-dihydrofuranyl group and a 2,3-dihydrothiophenyl group. The term "$C_2$-$C_{10}$ heterocycloalkenylene group" as used herein refers to a divalent group having the same structure as the $C_2$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused with each other. $C_6$-$C_{60}$ aryl group may include a structure in which at least one carbocyclic aromatic ring is condensed with at least one cycloalkane ring, for example, a structure in which one benzene ring is condensed with one cyclohexane or cyclopentane ring.

The term "$C_7$-$C_{60}$ alkylaryl group" as used herein refers to a $C_6$-$C_{60}$ aryl group substituted with at least one $C_1$-$C_{60}$ alkyl group.

The term "$C_1$-$C_{60}$ heteroaryl group" as used herein refers to a monovalent group having a cyclic aromatic system that has at least one heteroatom such as N, O, P, Si, or S as a ring-forming atom, and 1 to 60 carbon atoms. The term "$C_1$-$C_{60}$ heteroarylene group" as used herein refers to a divalent group having a carbocyclic aromatic system that has at least one heteroatom such as N, O, P, Si, or S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused with each other.

The term "$C_2$-$C_{60}$ alkylheteroaryl group" as used herein refers to a $C_1$-$C_{60}$ heteroaryl group substituted with at least one $C_1$-$C_{60}$ alkyl group.

The term "$C_6$-$C_{60}$ aryloxy group" as used herein refers to -$OA_{102}$ (wherein $A_{102}$ is the $C_6$-$C_{60}$ aryl group), and the term "$C_6$-$C_{60}$ arylthio group" as used herein refers to - $SA_{103}$ (wherein $A_{103}$ is the $C_6$-$C_{60}$ aryl group).

The $C_1$-$C_{60}$ heteroaryloxy group used herein indicates -$OA_{104}$ (wherein $A_{104}$ is a $C_1$-$C_{60}$ heteroaryl group), and the $C_1$-$C_{60}$ heteroarylthio group indicates -$SA_{105}$ (wherein $A_{105}$ is the $C_1$-$C_{60}$ heteroaryl group).

The term "monovalent non-aromatic condensed polycyclic group" as used herein refers to a monovalent group (for example, having 8 to 60 carbon atoms) having two or more rings condensed with each other, only carbon atoms as ring-forming atoms, and no aromaticity in its entire structure. Non-limiting examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed with each other, a heteroatom such as N, O, P, Si, or S, other than carbon atoms, as a ring-forming atom, and no aromaticity in its entire structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{1a}$)" as used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, an indene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{1a}$).

The term "$C_1$-$C_{30}$ heterocyclic group" as used herein refers to a saturated or unsaturated cyclic group having, as a ring-forming atom, at least one heteroatom such as N, O, Si, P, or S other than 1 to 30 carbon atoms. The $C_1$-$C_{30}$ heterocyclic group may be a monocyclic group or a polycyclic group. Examples of the "$C_1$-$C_{30}$ heterocyclic group (unsubstituted or substituted with at least one $R_{1a}$)" as used herein may include a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group (each unsubstituted or substituted with at least one $R_{1a}$).

In the present specification, TMS represents * -$Si(CH_3)_3$, and TMG represents * - $Ge(CH_3)_3$.

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl

group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each substituted with deuterium, -F, -Cl, -Br, - I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $-B(Q_{16})$(Q17), -$P(=O)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, or a combination thereof; or

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, or - $P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a $C_1$-$C_{60}$ heteroaryloxy group, a $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

Hereinafter, compounds and organic light-emitting devices, according to an embodiment, will be described in further detail with reference to Synthesis Example and Examples. However, the following examples are not intended to limit the scope of the disclosure. The wording "'B' was used instead of 'A'" used in describing Synthesis Examples means that an amount of 'A' used was identical to an amount of 'B' used, in terms of a molar equivalent.

Examples

Synthesis Example 1: Synthesis of Compound 2

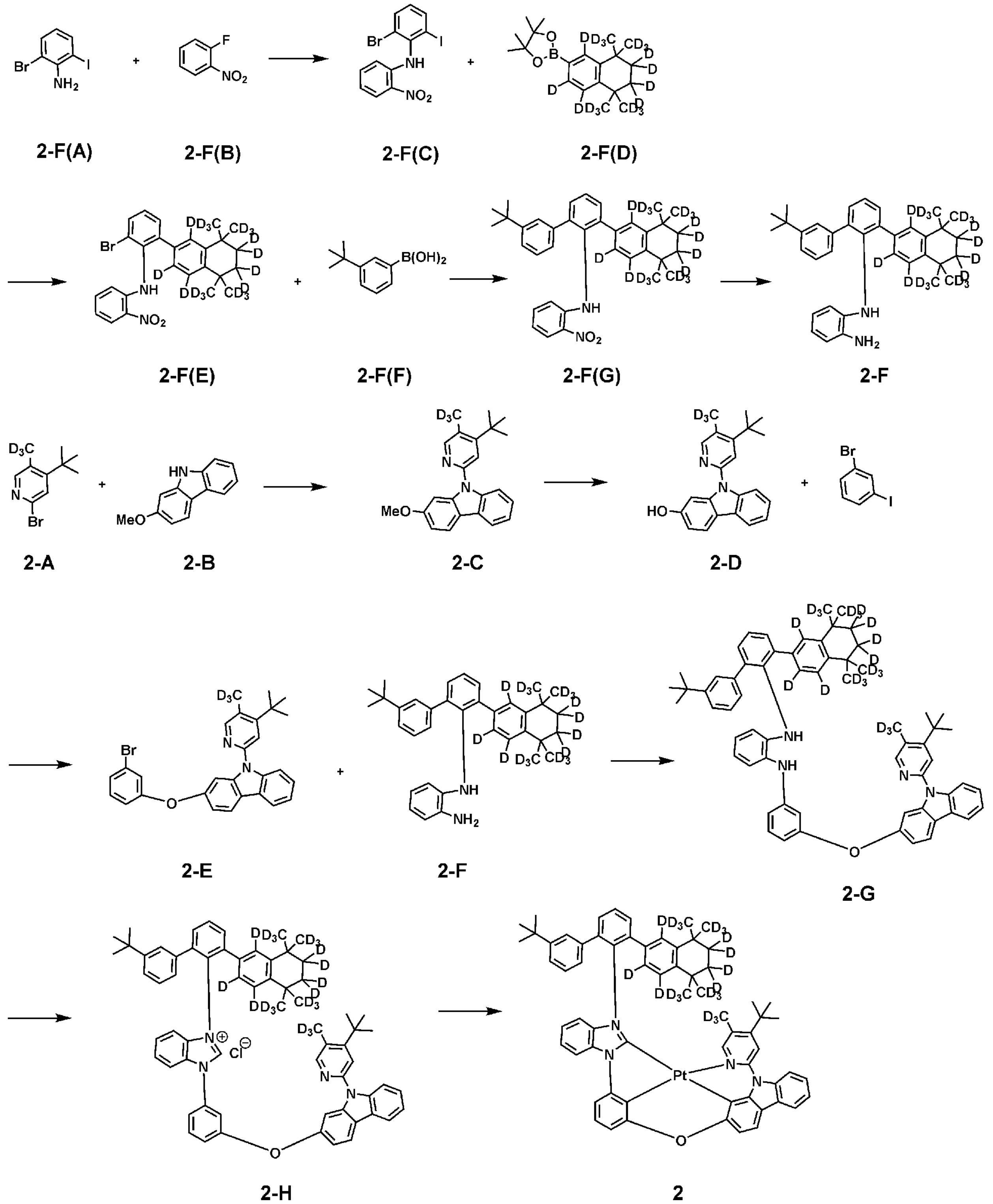

2-F(A) 2-F(B) 2-F(C) 2-F(D)

2-F(E) 2-F(F) 2-F(G) 2-F

2-A 2-B 2-C 2-D

2-E 2-F 2-G

2-H 2

(1) Synthesis of Compound 2-F

(1-1) Synthesis of Compound 2-F(C)

Compound 2-F(A) (15.0 g, 50 mmol), Compound 2-F(B) (7.10 g, 50 mmol), and $Cs_2CO_3$ (65.6 g, 201 mmol) were mixed with 350 ml of DMF and stirred at 110 °C for 24 hours. After completion of the reaction, the mixture was cooled at room temperature and was subjected to an extraction process using saturated $NH_4Cl$ and MC. An organic layer extracted therefrom was dried with anhydrous $MgSO_4$ and filtered, and the filtrate was concentrated under reduced pressure. The

resulting product was subjected to silica gel column chromatography to obtain 16.0 g (yield of 76 %) Compound 2-F(C).
HPLC-MS: 417.9 $[M+H]^+$

(1-2) Synthesis of Compound 2-F(E)

Compound 2-F(C) (16.0 g, 38 mmol), Compound 2-F(D) (12.6 g, 38 mmol), $Pd(PPh_3)_4$ (4.41 g, 3.8 mmol), and $K_2CO_3$(15.8 g, 114 mmol) were mixed with 380 ml of 1,4-dioxane:$H_2O$ (3:1) and stirred at 100 °C for 12 hours. After completion of the reaction, the mixture was cooled at room temperature and was subjected to an extraction process using saturated $NH_4Cl$ and MC. An organic layer extracted therefrom was dried with anhydrous $MgSO_4$ and filtered, and the filtrate was concentrated under reduced pressure. The resulting product was subjected to silica gel column chromatography to obtain 16.3 g (yield of 86 %) of Compound 2-F(E).
HPLC-MS: 497.17 $[M+H]^+$

(1-3) Synthesis of Compound 2-F(G)

Compound 2-F(E) (10 g, 20 mmol), Compound 2-F(F) (4.31 g, 24 mmol), $Pd_2(dba)_3$ (1.85 g, 2.0 mmol), SPhos (1.74 mmol), and $K_2CO_3$ (4.2 g, 30 mmol) were mixed with 200 mL of 1,4-dioxane:$H_2O$ (3:1) and stirred at 100 °C for 12 hours. After completion of the reaction, the mixture was cooled at room temperature and was subjected to an extraction process using saturated $NH_4Cl$ and MC. An organic layer extracted therefrom was dried with anhydrous $MgSO_4$ and filtered, and the filtrate was concentrated under reduced pressure. The resulting product was subjected to silica gel column chromatography to obtain 9.0 g (yield of 81 %) of Compound 2-F(G).
HPLC-MS: 551.47 $[M+H]^+$

(1-4) Synthesis of Compound 2-F

In a round-bottom flask, [Compound 2-F(G)] (9.0 g,14 mmol), Pd/C (10 wt% on carbon, 1.8 g ), and ammonium formate (18.11 g, 361 mmol) were added and mixed with ethanol (180 mL) and stirred under reflux at 80 °C for 4 hours. After completion of the reaction, the temperature was lowered to room temperature, and then, following filteration through celite, EA and a saturated aqueous ammonium chloride solution were added to the reaction mixture. An organic solution layer was obtained by an extraction process using EA, dried with anhydrous $MgSO_4$, and then filtered. The filtrate was concentrated and purified by silica gel chromatography, so as to obtain 7.8 g (yield of 75 %) of Compound 2-F.
HPLC-MS: 520.46 $[M+H]^+$

(2) Synthesis of Compound 2-C

Compound 2-A (7.0 g, 20 mmol), Compound 2-B (7.31 g, 36 mmol), $Pd_2(dba)_3$ (2.77 g, 3 mmol), SPhos (2.49 g, 6 mmol), and $NaO^tBu$ (4.37 g, 45 mmol) were mixed with 150 ml of toluene and stirred at 110 °C for 12 hours. After completion of the reaction, the mixture was cooled at room temperature and was subjected to an extraction process using saturated ammonium chloride ($NH_4Cl$) and methylene chloride (MC). An organic layer separated therefrom was dried with anhydrous magnesium sulfate ($MgSO_4$) and filtered, and the filtrate was concentrated under reduced pressure. The resulting product was subjected to silica gel column chromatography to obtain 9.8 g (yield of 93 %) of Compound 2-C.
HPLC-MS: 348.17 $[M+H]^+$

(3) Synthesis of Compound 2-D

Compound 2-C (9.8 g, 28 mmol) was dissolved in 280 ml of MC, and the mixed solution was cooled at 0 °C. Then, 1.0 M $BBr_3$ (56 ml, 56 mmol) was slowly added dropwise thereto. The mixed solution was stirred at room temperature for 2 hours. After completion of the reaction, the mixture was cooled to 0 °C, and water was added dropwise thereto. The residual $BBr_3$ was subjected to a quenching process. After neutralizing the solution with saturated sodium bicarbonate ($NaHCO_3$), an organic layer obtained by an extraction process using MC was dried with anhydrous $MgSO_4$ and filtered, and the filtrate was concentrated under reduced pressure. The resulting product was subjected to silica gel chromatography to obtain 7.2 g (yield of 77 %) of Compound 2-D.
HPLC-MS: 334.16 $[M+H]^+$

(4) Synthesis of Compound 2-E

Compound 2-D (7.2 g, 22 mmol), 1-bromo-3-iodobenzene (6.72 g, 24 mmol), CuI (1.36 g, 7 mmol), picolinic acid (1.17 g, 9.50 mmol), and $K_3PO_4$ (12.60 g, 59 mmol) were mixed with 250 ml of DMSO and stirred at 100 °C for 12 hours.

After completion of the reaction, the mixture was cooled at room temperature and was subjected to an extraction process using saturated $NH_4Cl$ and ethyl acetate (EA). An organic layer separated therefrom was dried with anhydrous $MgSO_4$ and filtered, and the filtrate was concentrated under reduced pressure. The resulting product was subjected to silica gel chromatography to obtain 9.2 g (yield of 79 %) of Compound 2-E.
HPLC-MS: 490.08 $[M+H]^+$

(5) Synthesis of Compound 2-G

In a round-bottom flask, Compound 2-E (5.98 g, 12 mmol), Compound 2-F (6.35 g, 12 mmol), $Pd_2(dba)_3$ (1.12 g, 1 mmol), SPhos (1 g, 2 mmol), and NaOtBu (1.76 g, 18 mmol) were added and mixed with 100 ml of toluene and stirred under reflux at 110 °C for 12 hours. After completion of the reaction, the temperature was lowered to room temperature, and then, ethyl acetate and a saturated aqueous ammonium chloride solution were added to the reaction mixture. An organic solution layer was obtained by an extraction process using EA, dried with anhydrous $MgSO_4$, and then filtered. The filtrate was concentrated and purified by silica gel chromatography to obtain 10.6 g (yield of 93 %) of Compound 2-G.
HPLC-MS: 927.68 $[M+H]^+$

(6) Synthesis of Compound 2-H

In a round-bottom flask, Compound 2-G (10.6 g, 11 mmol) and p-toluene sulfonic acid (0.18 g, 2 mmol) were added and mixed with 80 ml of triethyl orthoformate and stirred under reflux at 80 °C for 12 hours. After completion of the reaction, the temperature was lowered to room temperature, and then, EA and a saturated aqueous ammonium chloride solution were added to the reaction mixture. An organic solution layer was obtained by an extraction process using EA, dried with anhydrous $MgSO_4$, and then filtered. The filtrate was concentrated and purified by silica gel chromatography to obtain 10.5 g (yield of 94 %) of Compound 2-H.
HPLC-MS: 937.87 $[M+H]^+$

(7) Synthesis of Compound 2

In a round-bottom flask, Compound 2-H (9 g, 4.70 mmol), $K_2PtCl_4$ (4.06 g, 5.17 mmol), and NaOAc (2.41 g, 29 mmol) were added and mixed with 80 ml of dioxane. The mixed solution was stirred under reflux at 100 °C for 12 hours. After completion of the reaction, the temperature was lowered to room temperature, and then, EA and a saturated aqueous ammonium chloride solution were added to the reaction mixture. An organic solution layer was obtained by an extraction process using EA, dried with anhydrous $MgSO_4$, and then filtered. The filtrate was concentrated and purified by silica gel chromatography, so as to obtain 1.7 g (yield of 17 %) of Compound 2.
HPLC-MS: 1130.62 $[M+H]^+$

Synthesis Example 2: Synthesis of Compound 1

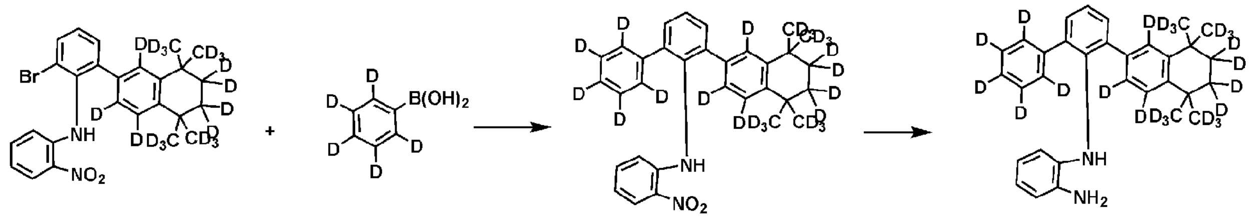

2-F(E) 1-A(A) 1-A(B) 1-A

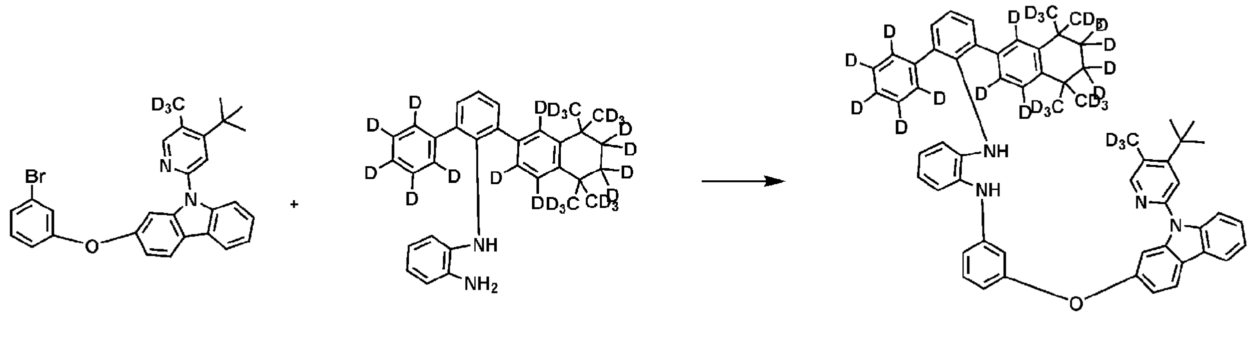

2-E 1-A 1-B

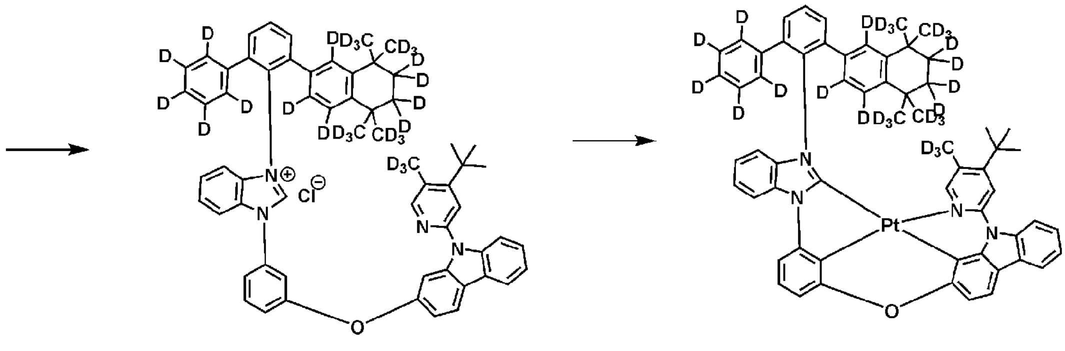

1-C 1

(1) Synthesis of Compound 1-A

(1-1) Synthesis of Compound 1-A(B)

Compound 1-F(E) (16.3 g, 33 mmol), Compound 1-A(A) (5.01 g, 39 mmol), $Pd_2(dba)_3$ (3.01 g, 3.3 mmol), SPhos (2.7 g, 7 mmol), and $K_2CO_3$ (6.82 g, 49 mmol) were mixed with 330 ml of 1,4-dioxane:$H_2O$ (3:1) and stirred at 100 °C for 12 hours. After completion of the reaction, the mixture was cooled at room temperature and was subjected to an extraction process using saturated $NH_4Cl$ and MC. An organic layer extracted therefrom was dried with anhydrous $MgSO_4$ and filtered, and the filtrate was concentrated under reduced pressure. The resulting product was subjected to silica gel column chromatography to obtain 13.0 g (yield of 79 %) of Compound 1-A(B).
HPLC-MS: 499.32 $[M+H]^+$

(1-2) Synthesis of Compound 1-A

In a round-bottom flask, [Compound 1-A(B)] (7.0 g, 14 mmol), Pd/C (10 wt% on carbon, 1.4 g ), and ammonium formate (14.08 g, 281 mmol) were added and mixed with ethanol (140 mL) and stirred under reflux at 80 °C for 4 hours. After completion of the reaction, the temperature was lowered to room temperature, and then, following filteration through celite, EA and a saturated aqueous ammonium chloride solution were added to the reaction mixture. An organic solution layer was obtained by an extraction process using EA, dried with anhydrous $MgSO_4$, and then filtered. The filtrate was concentrated and purified by silica gel chromatography, so as to obtain 6.5 g (yield of 80 %) of [Compound 1-A].
HPLC-MS: 470.43 $[M+H]^+$

(2) Synthesis of Compound 1-B

Compound 1-B (yield of 82 %) was synthesized in the same manner as in the synthesis of Compound 1-G in Synthesis Example 1, except that Compound 1-A was used instead of Compound 1-F.
HPLC-MS: 876.39 $[M+H]^+$

(3) Synthesis of Compound 1-C

Compound 1-C (yield of 95 %) was synthesized in the same manner as in the synthesis of Compound 1-H in Synthesis Example 1, except that Compound 1-B was used instead of Compound 1-G.
HPLC-MS: 886.39 $[M+H]^+$

(4) Synthesis of Compound 1

Compound 1 (yield of 16 %) was synthesized in the same manner as in the synthesis of Compound 1 in Synthesis Example 1, except that Compound 1-C was used instead of Compound 1-H.
HPLC-MS: 1079.60 $[M+H]^+$

Synthesis Example 3: Synthesis of Compound 46

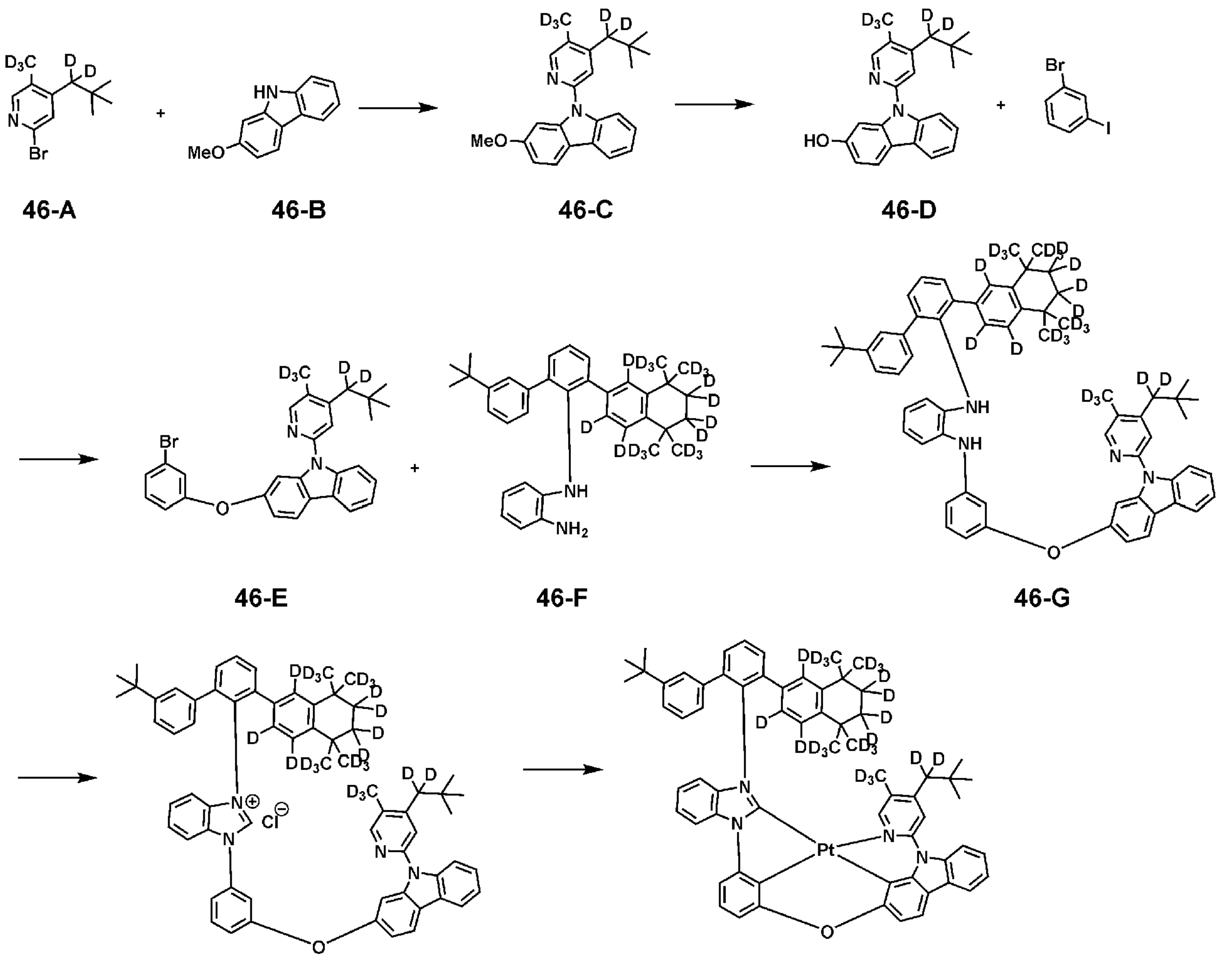

46-A 46-B 46-C 46-D

46-E 46-F 46-G

46-H 46

(1) Synthesis of Compound 46-C

Compound 1-A (yield of 89 %) was synthesized in the same manner as in the synthesis of Compound 1-C in Synthesis Example 1, except that Compound 46-A was used instead of Compound 1-A.
HPLC-MS: 364.20 [M+H]$^+$

(2) Synthesis of Compound 46-D

Compound 46-D (yield of 80 %) was synthesized in the same manner as in the synthesis of Compound 1-D in Synthesis Example 1, except that Compound 46-C was used instead of Compound 1-C.
HPLC-MS: 350.18 [M+H]$^+$

(3) Synthesis of Compound 46-E

Compound 46-E (yield of 73 %) was synthesized in the same manner as in the synthesis of Compound 1-E in Synthesis Example 1, except that Compound 46-D was used instead of Compound 1-D.
HPLC-MS: 506.11 [M+H]$^+$

(4) Synthesis of Compound 46-G

Compound 46-G (yield of 84 %) was synthesized in the same manner as in the synthesis of Compound 1-G in Synthesis Example 1, except that Compound 46-E was used instead of Compound 1-E.
HPLC-MS: 944.68 [M+H]$^+$

(5) Synthesis of Compound 46-H

Compound 46-H (yield of 95 %) was synthesized in the same manner as in the synthesis of Compound 1-H in Synthesis Example 1, except that Compound 46-G was used instead of Compound 1-G.
HPLC-MS: 954.66 [M+H]$^+$

(6) Synthesis of Compound 46

Compound 46 (yield of 23 %) was synthesized in the same manner as in the synthesis of Compound 1 in Synthesis Example 1, except that Compound 46-H was used instead of Compound 1-H.
HPLC-MS: 1147.67 [M+H]$^+$

Synthesis Example 4: Synthesis of Compound 91

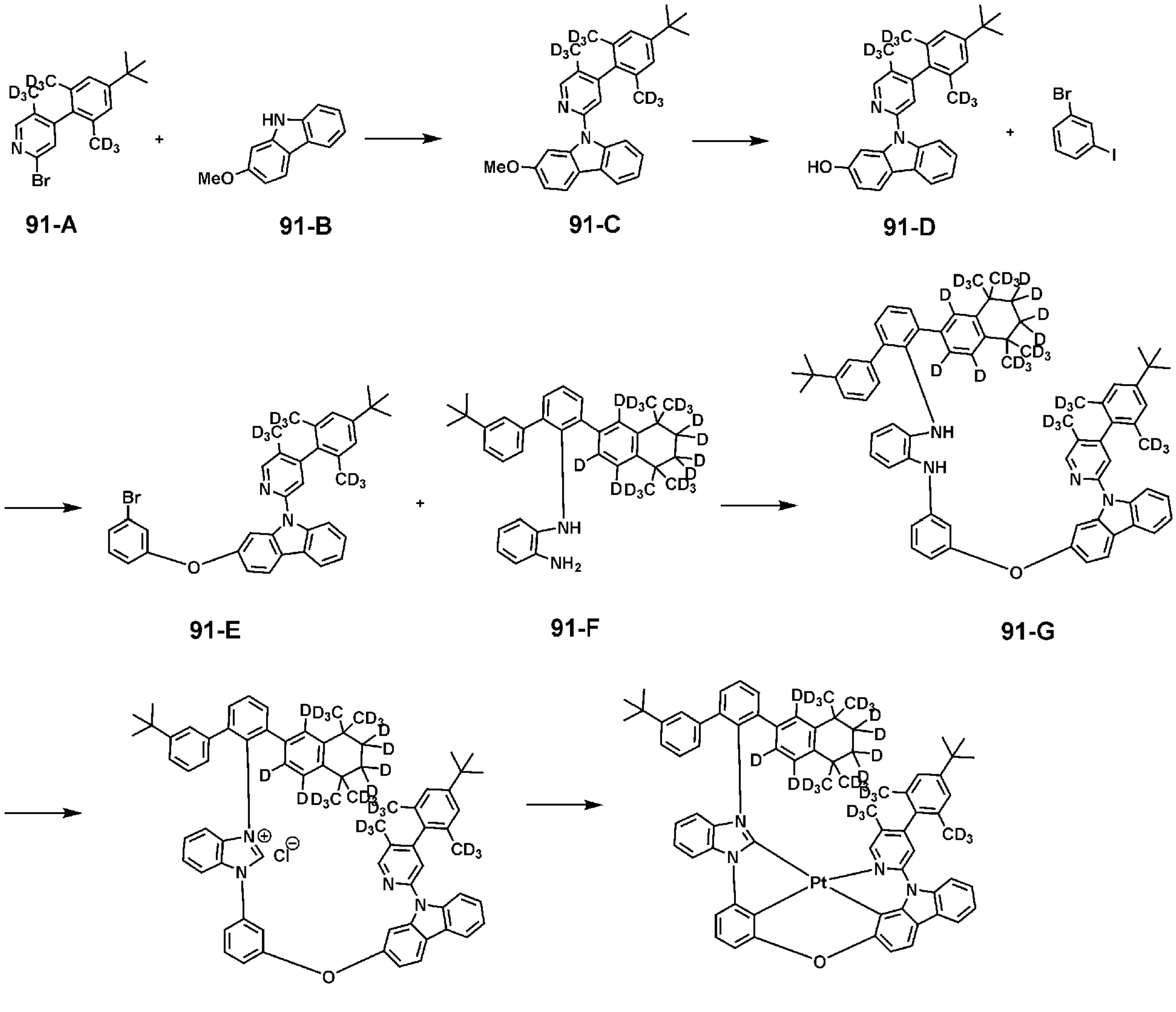

91-A 91-B 91-C 91-D

91-E 91-F 91-G

91-H 91

1) Synthesis of Compound 91-C

Compound 91-C (yield of 62 %) was synthesized in the same manner as in the synthesis of Compound 1-C in Synthesis Example 1, except that Compound 91-A was used instead of Compound 1-A.
HPLC-MS: 460.32 $[M+H]^+$

(2) Synthesis of Compound 91-D

Compound 91-D (yield of 88 %) was synthesized in the same manner as in the synthesis of Compound 1-D in Synthesis Example 1, except that Compound 91-C was used instead of Compound 1-C.
HPLC-MS: 447.31 $[M+H]^+$

(3) Synthesis of Compound 91-E

Compound 91-E (yield of 75 %) was synthesized in the same manner as in the synthesis of Compound 1-E in Synthesis Example 1, except that Compound 91-D was used instead of Compound 1-D.
HPLC-MS: 601.25 $[M+H]^+$

(4) Synthesis of Compound 91-G

Compound 91-G (yield of 79 %) was synthesized in the same manner as in the synthesis of Compound 1-G in Synthesis Example 1, except that Compound 91-E was used instead of Compound 1-E.

HPLC-MS: 1040.77 $[M+H]^+$

(5) Synthesis of Compound 91-H

Compound 91-H (yield of 93 %) was synthesized in the same manner as in the synthesis of Compound 1-H in Synthesis Example 1, except that Compound 91-G was used instead of Compound 1-G.
HPLC-MS: 1050.75 $[M+H]^+$

(6) Synthesis of Compound 91

Compound 91 (yield of 36 %) was synthesized in the same manner as in the synthesis of Compound 1 in Synthesis Example 1, except that Compound 91-H was used instead of Compound 1-H.
HPLC-MS: 1242.70 $[M+H]^+$

Example 1

An ITO glass substrate was cut to a size of 50 mm x 50 mm x 0.5 mm and then, sonicated in acetone isopropyl alcohol and pure water, each for 15 minutes, and then, washed by exposure to UV ozone for 30 minutes.
Subsequently, m-MTDATA was deposited at a deposition rate of 1 Å /sec on the ITO electrode (i.e., anode) of the glass substrate to form a hole injection layer having a thickness of 600 Å, and $\alpha$-NPD was deposited at a deposition rate of 1 Å /sec on the hole injection layer to form a hole transport layer having a thickness of 250 Å.
Compound 1 (as a dopant) and CBP (as a host) were co-deposited at a deposition rate of 0.1 Å/sec and 1 Å/sec, respectively, on the hole transport layer to form an emission layer having a thickness of 400 Å.
BAlq was deposited at a deposition rate of 1 Å/sec on the emission layer to form a hole blocking layer having a thickness of 50 Å, $Alq_3$ was deposited on the hole blocking layer to form an electron transport layer having a thickness of 300 Å, LiF was deposited on the electron transport layer to form an electron injection layer having a thickness of 10 Å, and Al was vacuum-deposited on the electron injection layer to form a second electrode (i.e., a cathode) having a thickness of 1,200 Å, thereby completing the manufacture of an organic light-emitting device having a structure of ITO / m-MTDATA (600 Å) / $\alpha$-NPD (250 Å) / CBP + compound 1 (10 wt%) (400 Å) / BAlq (50 Å) / $Alq_3$ (300 Å) / LiF (10 Å) / Al (1,200 Å).

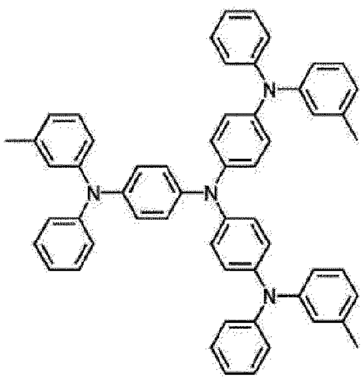

m-MTDATA

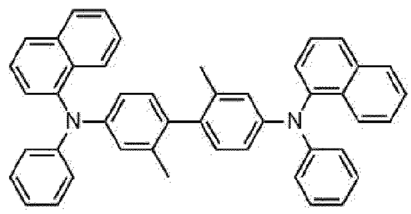

α-NPD

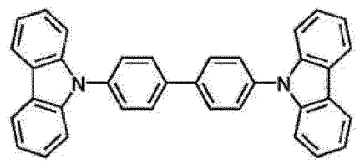

CBP

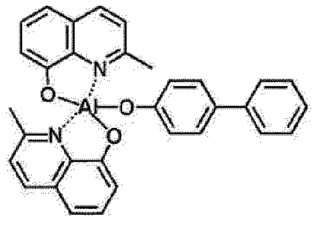

BAlq

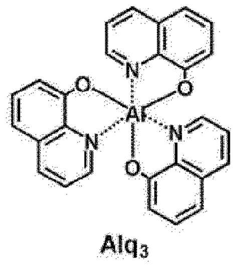

$Alq_3$

Examples 2 to 4 and Comparative Examples 1 to 4

Organic light-emitting devices were manufactured in the same manner as in Example 1, except that Compounds

shown in Table 2 were each used instead of Compound 1 as a dopant in forming an emission layer.

Evaluation Example 1: Characterization of organic light-emitting device

For each of the organic light-emitting devices of Examples 1 to 4 and Comparative Examples 1 to 4, full width at half maximum (FWHM), maximum emission wavelength ($\lambda_{max}$), and lifespan characteristics ($T_{95}$) were evaluated, and results thereof are shown in Table 2. As evaluation apparatuses, a current-voltage meter (Keithley 2400) and a luminance meter (Minolta Cs-1000A) were used. The lifespan characteristics ($T_{95}$) were evaluated by measuring the time required for the luminance to reach 95 % of the initial luminance of 100 %, and were recorded as relative values in Table 2.

Table 2

| | Dopant in emission layer | FWHM (nm) | $\lambda_{max}$ (nm) | $T_{95}$ (relative value, %) |
|---|---|---|---|---|
| Example 1 | Compound 1 | 16 | 461 | 101 % |
| Example 2 | Compound 2 | 17 | 461 | 122 % |
| Example 3 | Compound 46 | 17 | 461 | 118 % |
| Example 4 | Compound 91 | 18 | 462 | 102 % |
| Comparative Example 1 | Compound A | 17 | 461 | 37 % |
| Comparative Example 2 | Compound B | 16 | 460 | 81 % |
| Comparative Example 3 | Compound C | 17 | 463 | 86 % |
| Comparative Example 4 | Compound D | 21 | 461 | 70 % |

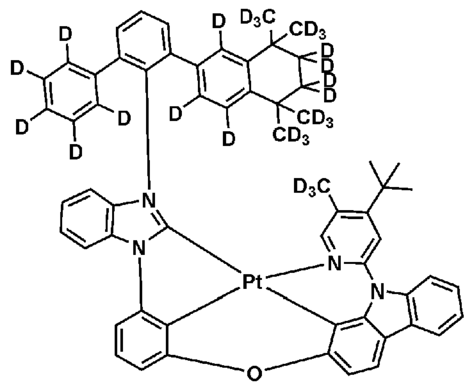

1

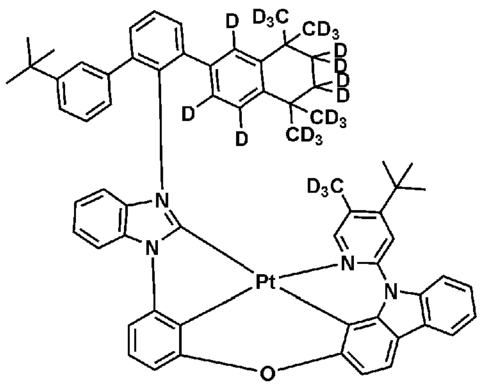

2

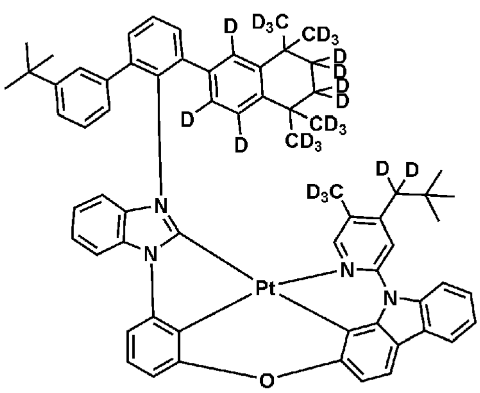

46

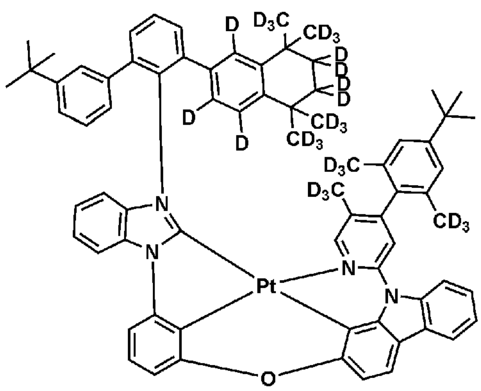

91

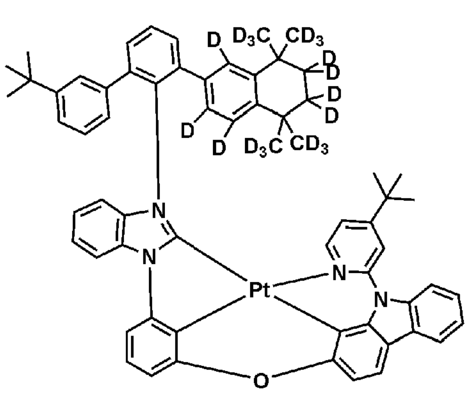

**A**

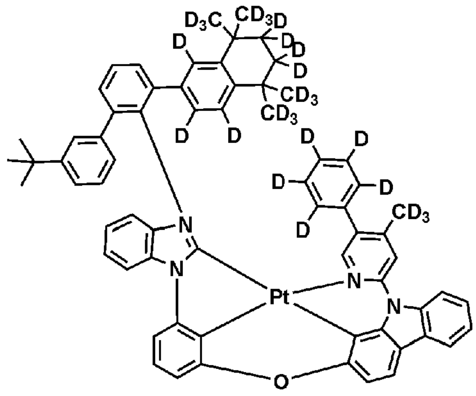

**B**

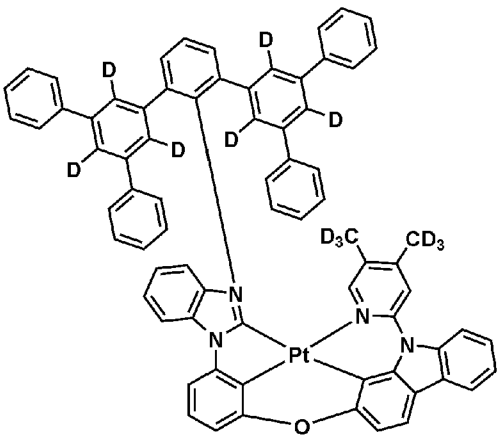

**C**

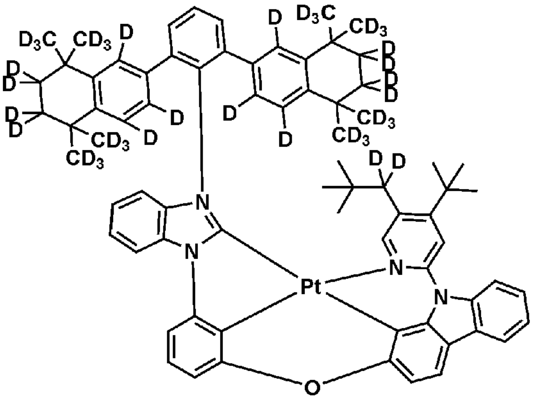

**D**

Referring to Table 2, it was confirmed that the organic light-emitting devices according to an embodiment had a long lifespan and were suitable for emission of deep blue light. In particular, the organic light-emitting devices of Examples 1 to 4 had significantly excellent lifespan characteristics than those of the organic light-emitting devices of Comparative Examples 1 to 4.

Example 5

A glass substrate with an ITO electrode located thereon was cut to a size of 50 mm x 50 mm x 0.5 mm and then, sonicated in acetone isopropyl alcohol and pure water, each for 15 minutes, and then, washed by exposure to UV ozone for 30 minutes.

Subsequently, HAT-CN was deposited on the ITO electrode (i.e., an anode) of the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron blocking layer having a thickness of 50 Å.

A first host (Compound H1), a second host (Compound H2), a sensitizer (Compound 1), and an emitter (Compound BD1-5) were co-deposited on the electron blocking layer to form an emission layer having a thickness of 400 Å. Here, the first host and the second host were mixed at a weight ratio of 60:40, and the amounts of the sensitizer and the emitter were adjusted to be 15 wt% and 1 wt%, respectively, based on the total weight of the first host, the second host, the sensitizer, and the emitter.

DBFPO was deposited on the emission layer to form a hole blocking layer having a thickness of 100 Å, DBFPO and LiQ were co-deposited at a weight ratio of 5:5 on the hole blocking layer to form an electron transport layer having a thickness of 300 Å, LiQ was deposited on the electron transport layer to form an electron injection layer having a thickness of 10 Å, and an Al was deposited on the electron injection layer to form a cathode having a thickness of 1,000 Å, thereby completing the manufacture of an organic light-emitting device.

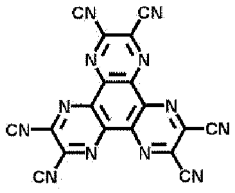

HT-D1(HAT-CN)

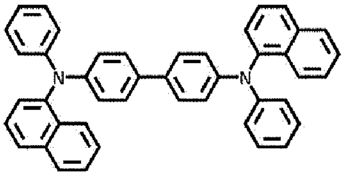

NPB

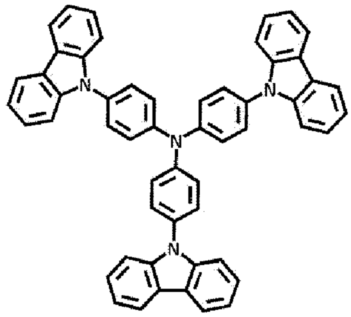

TCTA

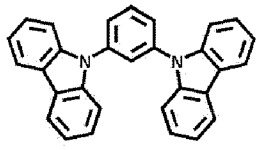

mCP

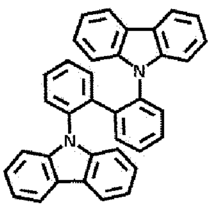

H1

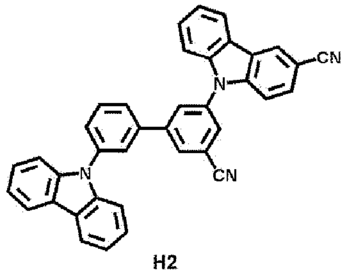

H2

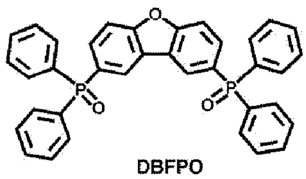

DBFPO

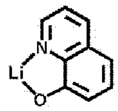

Liq

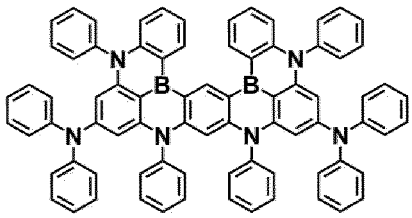

BD1-5

Examples 6 to 8 and Comparative Examples 5 to 9

Organic light-emitting devices were manufactured in the same manner as in Example 5, except that compounds shown in Table 3 were used as a sensitizer in forming an emission layer.

Evaluation Example 2: Characterization of organic light-emitting devices

For each of the organic light-emitting devices of Examples 5 to 8 and Comparative Examples 5 to 9, a maximum emission wavelength ($\lambda_{max}$), external quantum efficiency (EQE), and lifespan characteristics ($T_{95}$) were evaluated, and results thereof are shown in Table 3. As evaluation apparatuses, a current-voltage meter (Keithley 2400) and a luminance meter (Minolta Cs-1000A) were used. The lifespan characteristics ($T_{95}$) were evaluated by measuring the time required for the luminance to reach 95 % of the initial luminance of 100 %, and were recorded as relative values to Comparative Example 9 in Table 3.

Table 3

| | Sensitizer in emission layer | $\lambda_{max}$ (nm) | EQE (relative value, %) | $T_{95}$ (relative value, %) |
|---|---|---|---|---|
| Example 5 | Compound 1 | 462 | 111 % | 152 % |
| Example 6 | Compound 2 | 462 | 108 % | 151 % |
| Example 7 | Compound 46 | 463 | 109 % | 145 % |
| Example 8 | Compound 91 | 463 | 117 % | 118 % |
| Comparative Example 5 | Compound A | 462 | 108 % | 103 % |

(continued)

| | Sensitizer in emission layer | $\lambda_{max}$ (nm) | EQE (relative value, %) | $T_{95}$ (relative value, %) |
|---|---|---|---|---|
| Comparative Example 6 | Compound B | 462 | 106 % | 106 % |
| Comparative Example 7 | Compound C | 463 | 105 % | 86 % |
| Comparative Example 8 | Compound D | 462 | 100 % | 82 % |
| Comparative Example 9 | Compound E | 463 | 100 % | 100 % |

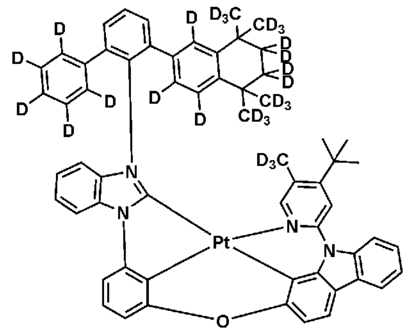

1

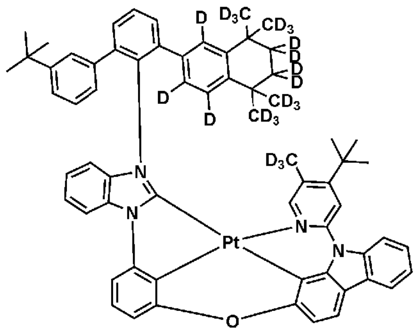

2

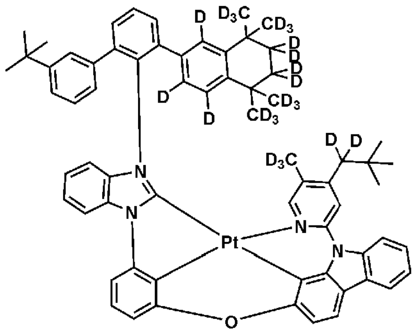

46

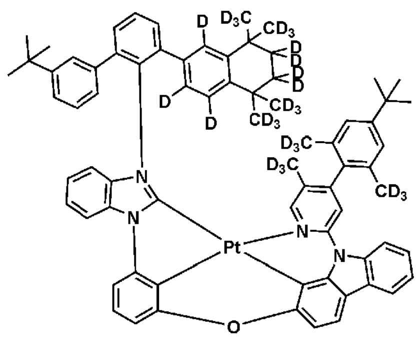

91

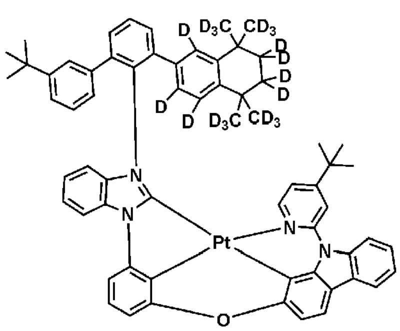

A

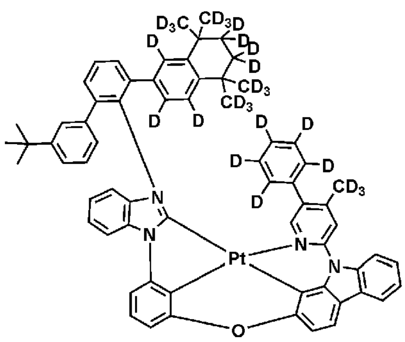

B

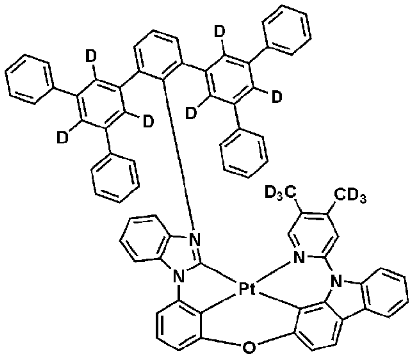

C

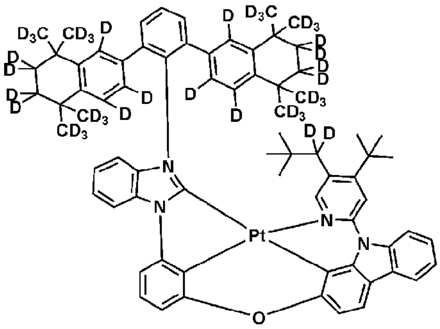

D

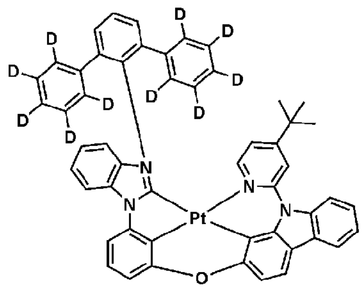

E

Referring to Table 3, it was confirmed that the organic light-emitting devices according to an embodiment had high EQE and a long lifespan and were suitable for emission of deep blue light. In particular, the organic light-emitting devices of Examples 5 to 8 had significantly high EQE and excellent lifespan characteristics than those of the organic light-emitting devices of Comparative Examples 5 to 9.

The organometallic compound has excellent photochemically stability, and an organic light-emitting device using the organometallic compound may have improved efficiency and lifespan. Thus, by using the organometallic compound, a high-quality organic light-emitting device may be realized.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

**1.** An organometallic compound represented by Formula 1:

Formula 1 M1(L11)n11(L12)n12

wherein, in Formula 1,

$M_1$ is a transition metal,
$L_{11}$ is a ligand represented by Formula 1-1,
$L_{12}$ is an organic ligand,
n11 is 1,
n12 is 0, 1, or 2,

Formula 1-1

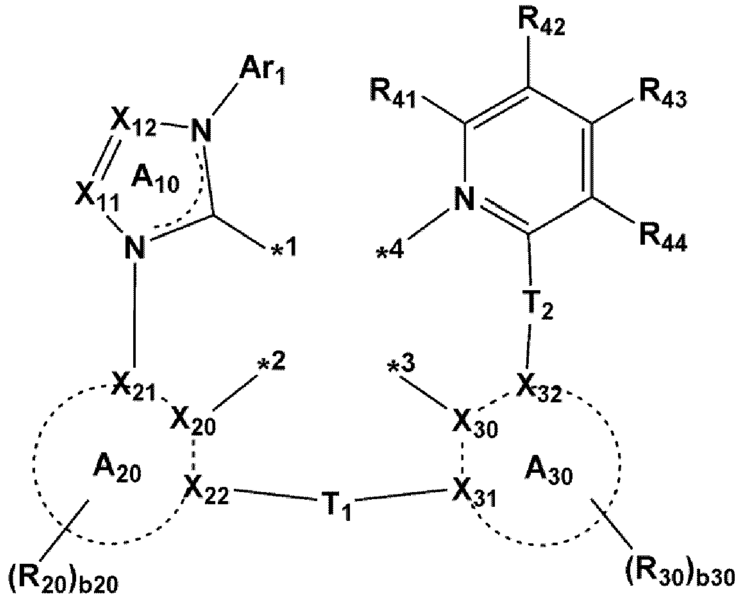

wherein, in Formula 1-1,

*1 to *4 each indicate a binding site to $M_1$,
$A_{10}$ is an N-containing heterocyclic group,
$A_{20}$ and $A_{30}$ are each independently a $C_5$-$C_{30}$ carbocyclic group or a $C_1$-$C_{30}$ heterocyclic group,
$T_1$ is a single bond, *-N($R_1$)-*', *-B($R_1$)-*', *-P($R_1$)-*', *-C($R_1$)($R_2$)-*', *-Si($R_1$)($R_2$)-*', *-Ge($R_1$)($R_2$)-*', *-S-*', *-Se-*', *-O-*', *-C(=O)-*', *-S(=O)-*', *-S(=O)$_2$-*', *-C($R_1$)=C($R_2$)-*', *-C(=S)-*', or *-C=C-*',
$T_2$ is a single bond, *-N($R_3$)-*', *-B($R_3$)-*', *-P($R_3$)-*', *-C($R_3$)($R_4$)-*', *-Si($R_3$)($R_4$)-*', *-Ge($R_3$)($R_4$)-*', *-S-*', *-Se-*', *-O-*', *-C(=O)-*', *-S(=O)-*', *-S(=O)$_2$-*', *-C($R_3$)=C($R_4$)-*', *-C(=S)-*', or *-C=C-*',
$X_{11}$ is C($R_{11}$) or N, and $X_{12}$ is C($R_{12}$) or N,
$X_{20}$ is C or N, and $X_{30}$ is C or N,
$X_{21}$, $X_{22}$, $X_{31}$, and $X_{32}$ are each independently C or N,
$Ar_1$ has a molecular weight of 350 or more and is a group represented by Formula 2,

Formula 2

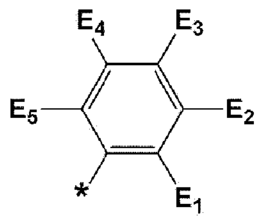

wherein, in Formula 2,

$E_1$ and $E_5$ are each independently deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), or -P(=O)($Q_8$)($Q_9$),

$E_2$ to $E_4$ are each independently hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), or -P(=O)($Q_8$)($Q_9$),

* indicates a binding site to a neighboring atom,

$Ar_1$ is an asymmetric structure,

$R_{11}$ and $R_{12}$ are each independently hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), or -P(=O)($Q_8$)($Q_9$),

$R_{11}$ and $R_{12}$ are optionally bonded to each other to form a $C_5$-$C_{30}$ carbocyclic group unsubstituted or substituted with at least one $R_{10}$ or a $C_1$-$C_{30}$ heterocyclic group unsubstituted or substituted with at least one $R_{10}$,

$R_1$ to $R_4$, $R_{10}$, $R_{20}$, $R_{30}$, $R_{41}$, and $R_{44}$ are each independently hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_2$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), or - P(=O)($Q_8$)($Q_9$),

at least two neighboring groups among $R_1$ to $R_4$, $R_{10}$, $R_{20}$, $R_{30}$, $R_{41}$, and $R_{44}$ are optionally bonded together to form a substituted or unsubstituted $C_6$-$C_{30}$ carbocyclic group or a substituted or unsubstituted $C_1$-$C_{30}$ heterocyclic group,

at least two of $R_{20}$ in the number of b20 are optionally linked together to form a substituted or unsubstituted $C_6$-$C_{30}$ carbocyclic group or a substituted or unsubstituted $C_1$-$C_{30}$ heterocyclic group,

at least two of $R_{30}$ in the number of b30 are optionally linked together to form a substituted or unsubstituted $C_6$-$C_{30}$ carbocyclic group or a substituted or unsubstituted $C_1$-$C_{30}$ heterocyclic group,

b20 and b30 are each independently 1, 2, 3, 4, 5, 6, 7, 8, 9, or 10,

when b20 is 2 or more, two or more of $R_{20}$ are identical to or different from each other, and when b30 is 2 or more, two or more of $R_{30}$ are identical to or different from each other,

$R_{42}$ is a substituted or unsubstituted $C_1$-$C_{60}$ alkyl group, and $R_{42}$ has a molecular weight of 18 or more,

$R_{43}$ is deuterium, -F, -Cl, -Br, -I, -$SF_5$, a hydroxyl group, a cyano group, a nitro group, an amidino group, a

hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted a $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, - $Ge(Q_3)(Q_4)(Q_5)$, $-B(Q_6)(Q_7)$, or $-P(=O)(Q_8)(Q_9)$,
at least one of $R_{42}$ and $R_{43}$ has a molecular weight of 19 or more,
substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group are each independently:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each substituted with deuterium, -F, -Cl, -Br, - I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed hetero-polycyclic group, $-N(Q_{11})(Q_{12})$, - $Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, - $Ge(Q_{23})(Q_{24})(Q_{25})$, $-B(Q_{26})(Q_{27})$, $-P(=O)(Q_{28})(Q_{29})$, or a combination thereof; or
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, or - $P(=O)(Q_{38})(Q_{39})$, and
$Q_1$ to $Q_9$, $Q_{11}$ to $Q_{19}$, $Q_{21}$ to $Q_{29}$, and $Q_{31}$ to $Q_{39}$ are each independently hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid

group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with a $C_1$-$C_{60}$ alkyl group, a $C_6$-$C_{60}$ aryl group substituted with a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group.

**2.** The organometallic compound of claim 1, wherein $M_1$ is platinum (Pt), palladium (Pd), or gold (Au).

**3.** The organometallic compound of claims 1 or 2, wherein $A_{10}$ is a group represented by one of Formulae A10-1 to A10-20:

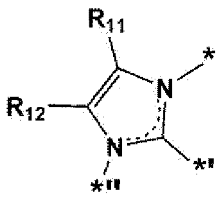
A10-1

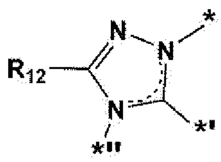
A10-2

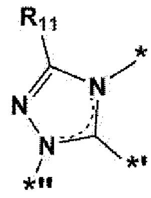
A10-3

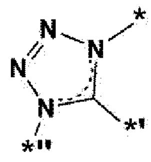
A10-4

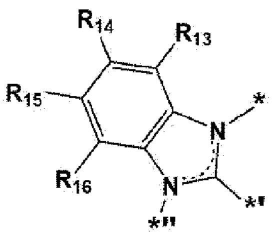
A10-5

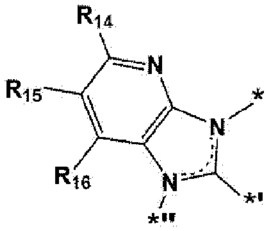
A10-6

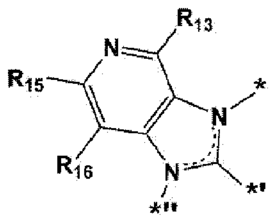
A10-7

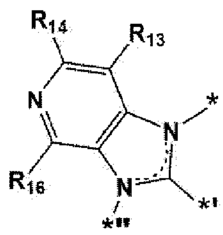
A10-8

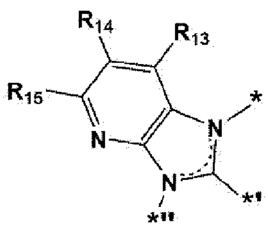
A10-9

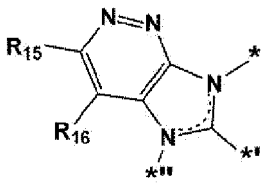
A10-10

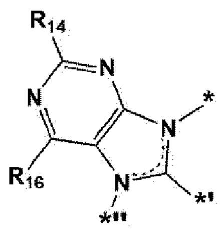
A10-11

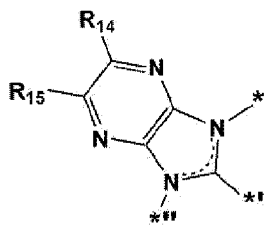
A10-12

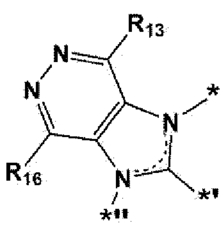
A10-13

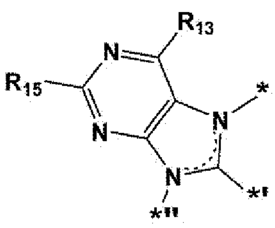
A10-14

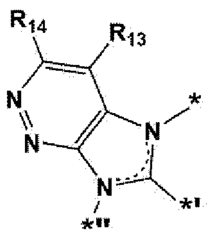
A10-15

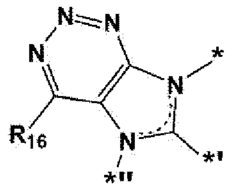
A10-16

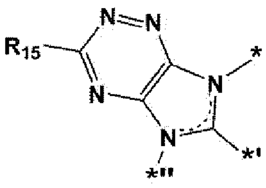

A10-17

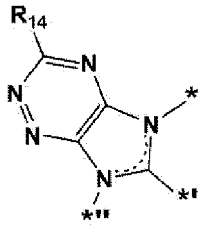

A10-18

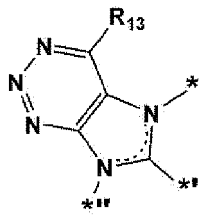

A10-19

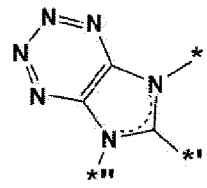

A10-20

wherein, in Formulae A10-1 to A10-20,

$R_{11}$ and $R_{12}$ are each as defined in claim 1,
$R_{13}$ to $R_{16}$ are each independently defined as for $R_{10}$ in claim 1, and
*, *', and *" each indicate a binding site to a neighboring atom.

4. The organometallic compound of any of claims 1-3, wherein $A_{20}$ and $A_{30}$ are each independently a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, an indazole group, a benzoxazole group, a benzothiazole group, a benzoxadiazole group, a benzothiadiazole group, a benzotriazole group, a diazaindene group, a triazaindene group, a 5,6,7,8-tetrahydroisoquinoline group, or a 5,6,7,8-tetrahydroquinoline group.

5. The organometallic compound of any of claims 1-4, wherein $A_{20}$ is a group represented by one of Formulae A20-1 to A20-13:

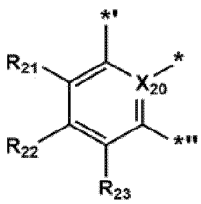

A20-1

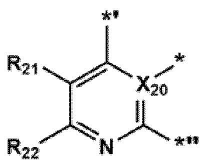

A20-2

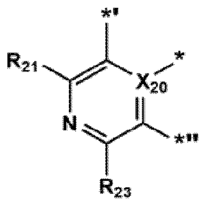

A20-3

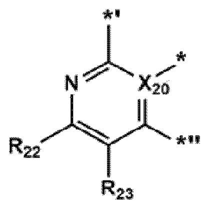

A20-4

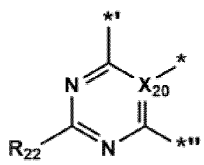

A20-5

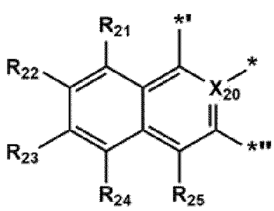

A20-6

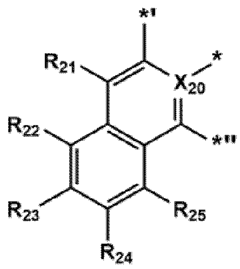

A20-7

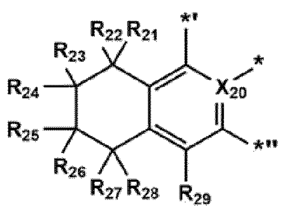

A20-8

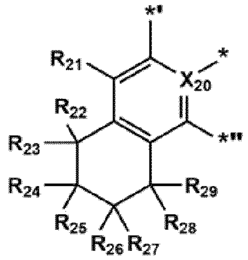

A20-9

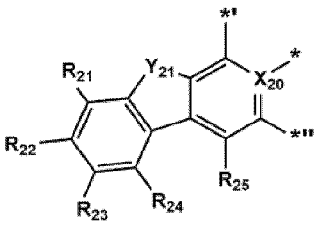

A20-10

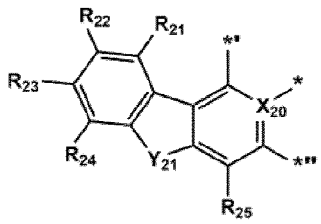

A20-11

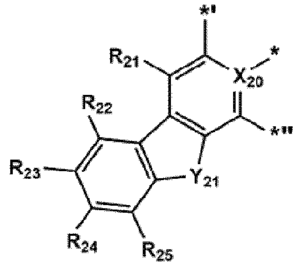

A20-12

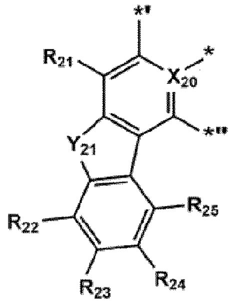

A20-13

wherein, in Formulae A20-1 to A20-13,

$X_{20}$ is as defined in claim 1,
$Y_{21}$ is a single bond, O, S, $N(R_{26})$, $C(R_{26})(R_{27})$, or $Si(R_{26})(R_{27})$,
$R_{21}$ to $R_{29}$ are each independently the same as described in connection with $R_{20}$ in claim 1, and
*, *', and *" each indicate a binding site to a neighboring atom; and/or
wherein $A_{30}$ is a group represented by one of Formulae A30-1 to A30-12:

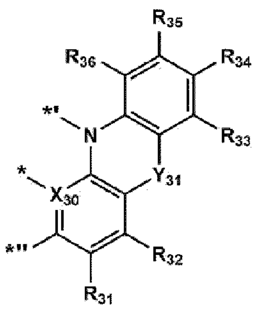

A30-1

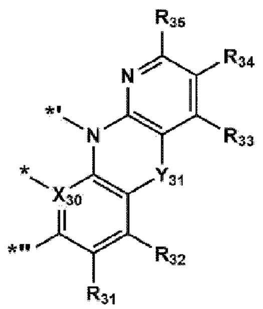

A30-2

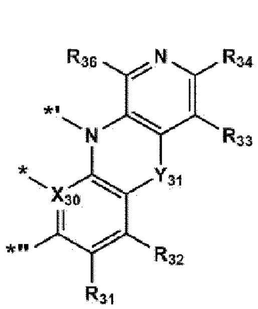

A30-3

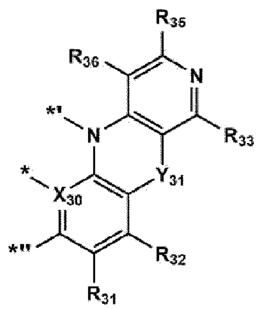

A30-4

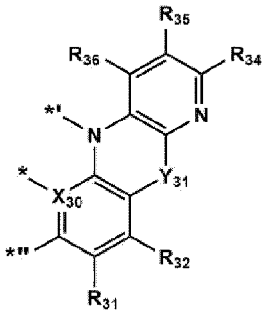

A30-5

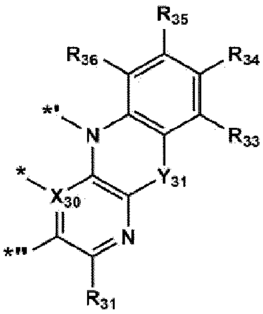

A30-6

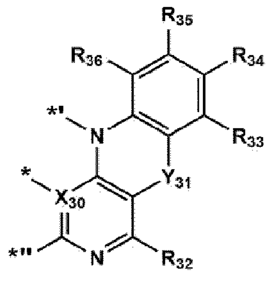

A30-7

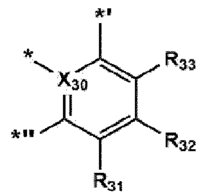

A30-8

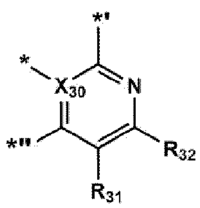

A30-9

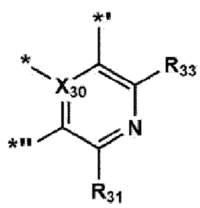

A30-10

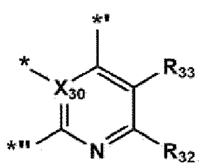

A30-11

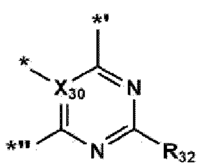

A30-12

wherein, in Formulae A30-1 to A30-12,
$X_{30}$ is as defined in claim 1,

$Y_{31}$ is a single bond, O, S, $N(R_{37})$, $C(R_{37})(R_{38})$, or $Si(R_{37})(R_{38})$,
$R_{31}$ to $R_{38}$ are each independently defined as for $R_{30}$ in claim 1, and
*, *', and *" each indicate a binding site to a neighboring atom.

**6.** The organometallic compound of any of claims 1-5, wherein $Ar_1$ is a group represented by one of Formulae Ar1-1 to Ar1-13:

Formula Ar1-1

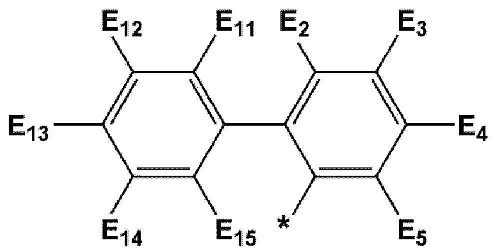

Formula Ar1-2

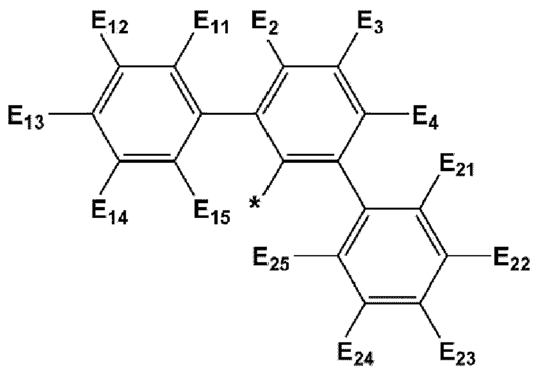

Formula Ar1-3

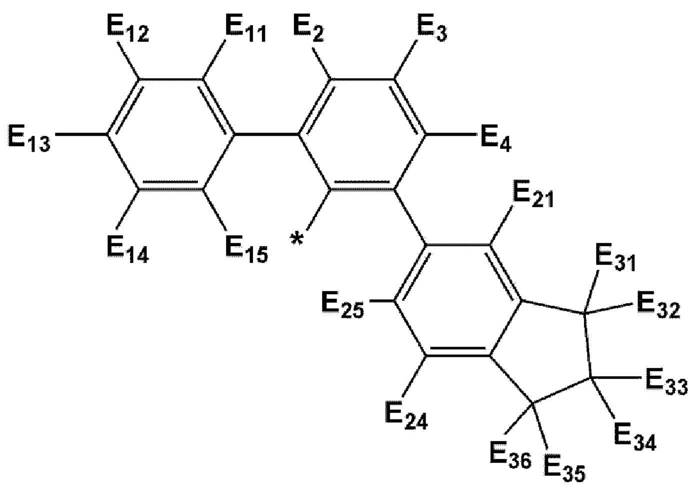

Formula Ar1-4

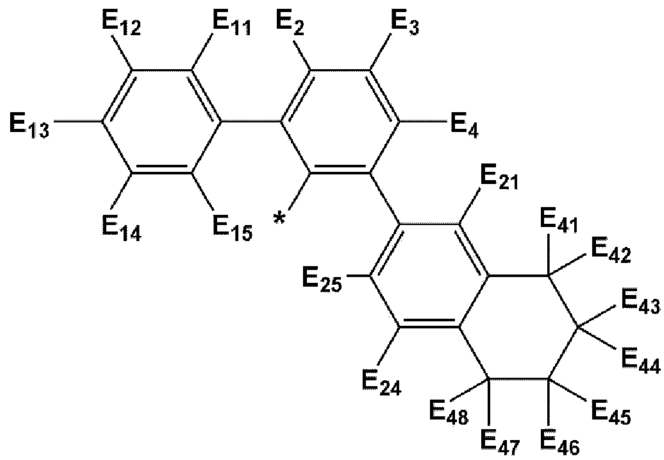

Formula Ar1-5

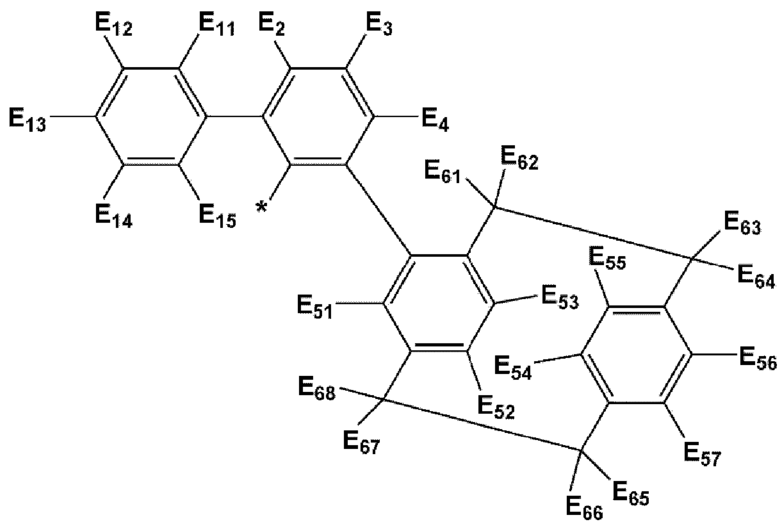

Formula Ar1-6

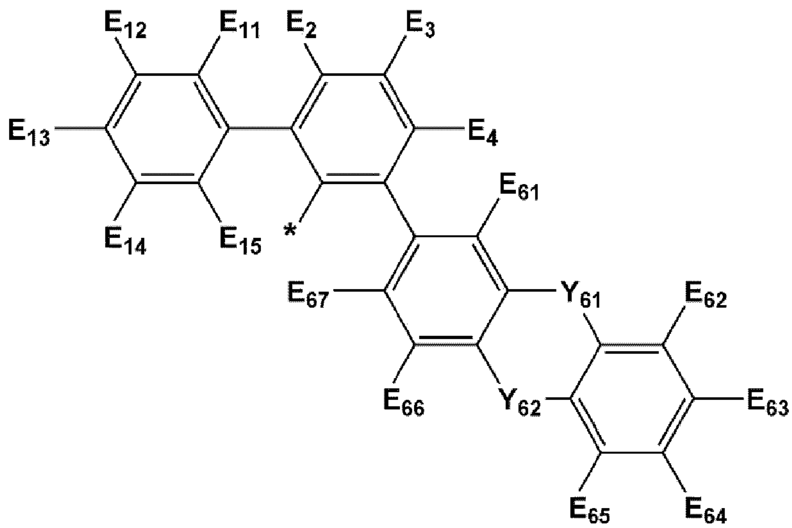

Formula Ar1-7

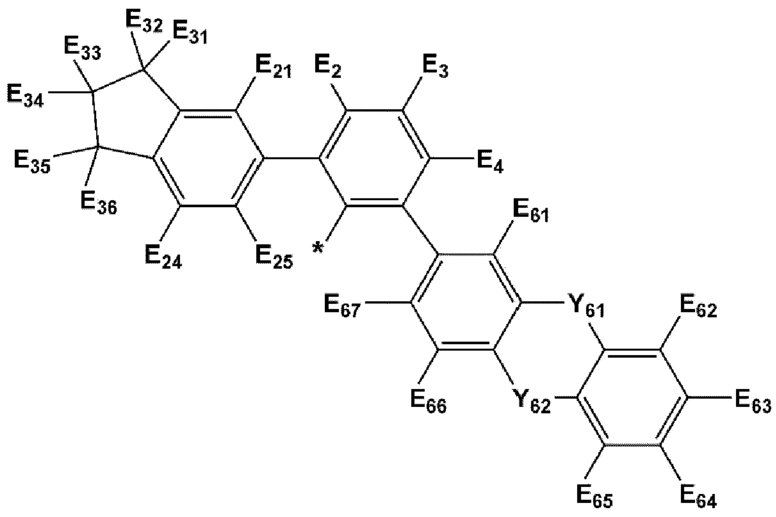

Formula Ar1-8

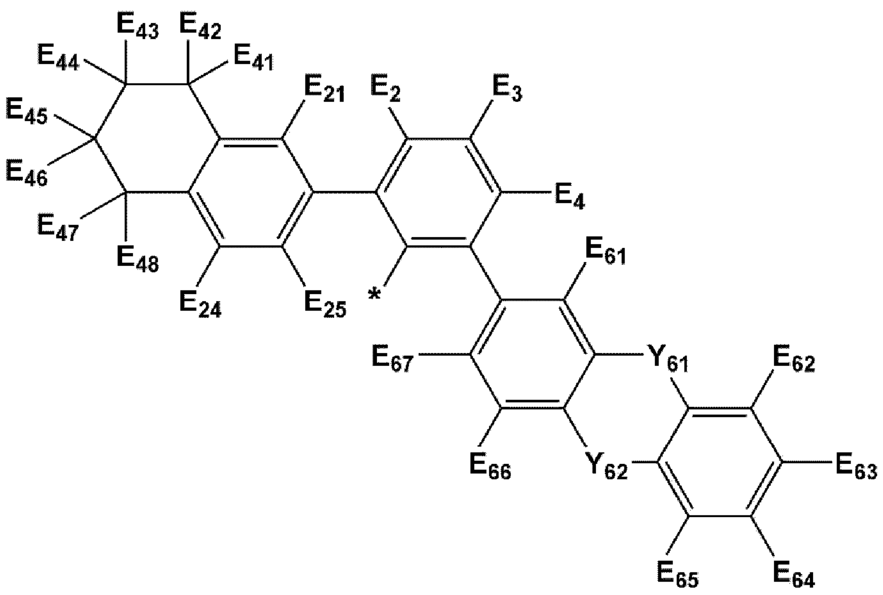

Formula Ar1-9

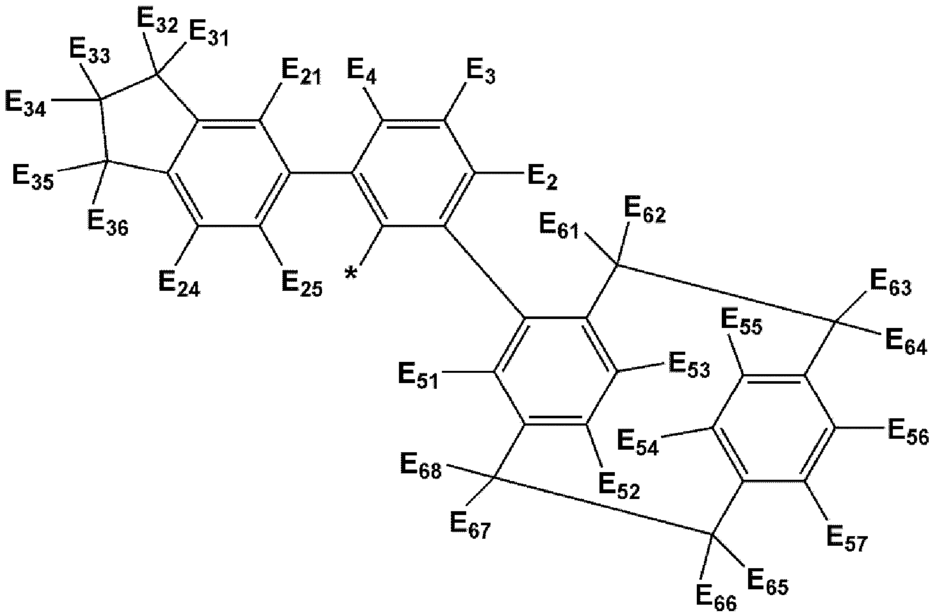

Formula Ar1-10

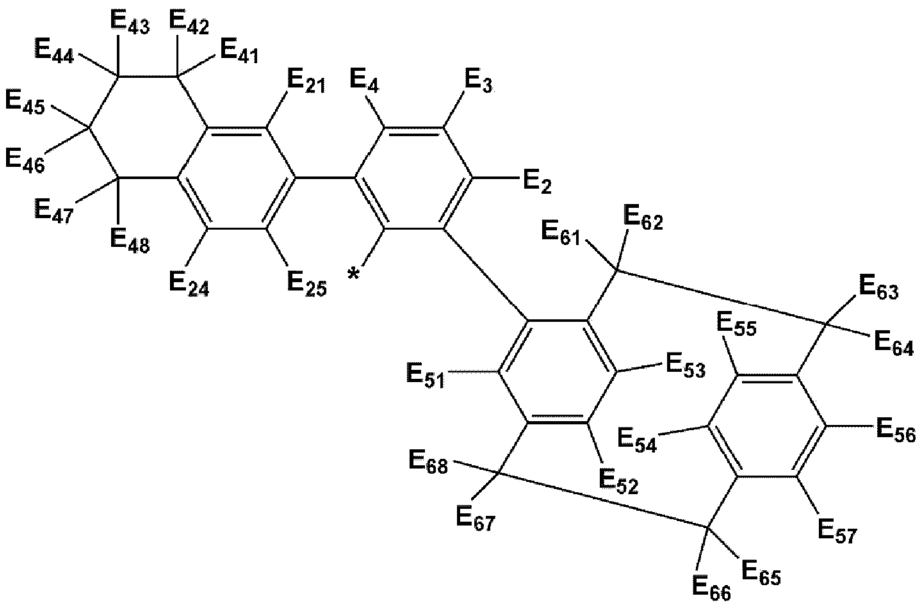

Formula Ar1-11

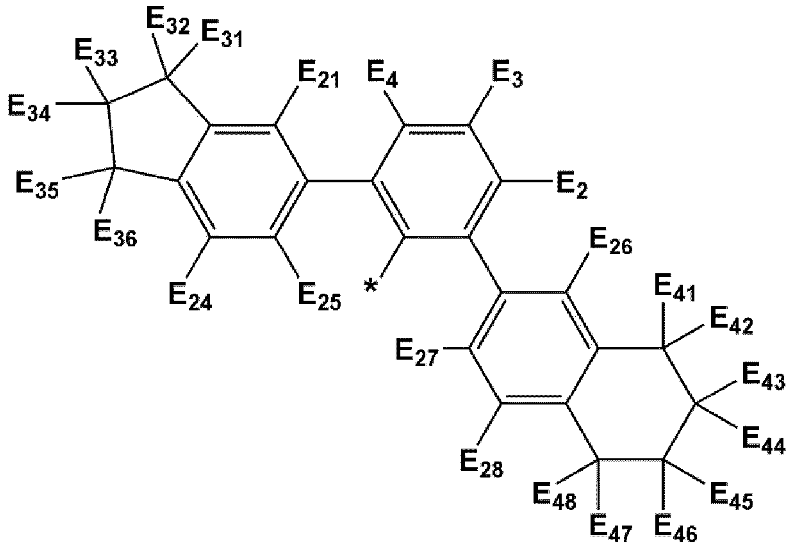

Formula Ar1-12

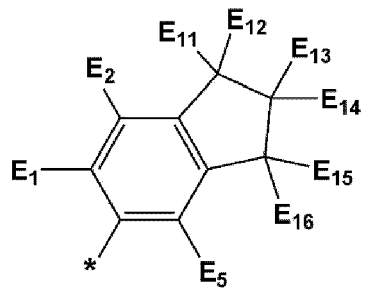

Formula Ar1-13

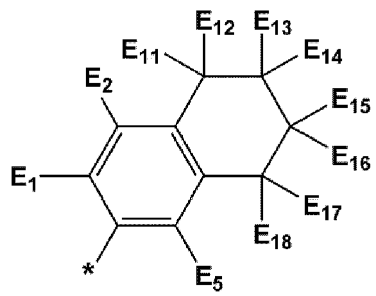

wherein, in Formulae Ar1-1 to Ar1-13,

$E_1$ to $E_5$ are as defined in claim 1,

$Y_{61}$ and $Y_{62}$ are each independently a single bond, O, S, N($E_{68}$), or C($E_{68}$)($E_{69}$),

$E_{11}$ to $E_{18}$, $E_{21}$ to $E_{28}$, $E_{31}$ to $E_{36}$, $E_{41}$ to $E_{48}$, $E_{51}$ to $E_{57}$, and $E_{61}$ to $E_{69}$ are each independently: hydrogen, deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amidino group, a hydrazine group, a hydrazone group, a carboxylic acid or a salt thereof, a sulfonic acid group or a salt thereof, a phosphate group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, a $C_1$-$C_{60}$ alkylthio group,, or a $C_1$-$C_{60}$ alkoxy group, each substituted with deuterium, -F, -Cl, -Br, - **I,** $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid

group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{11}$)($Q_{12}$), - Si($Q_{13}$)($Q_{14}$)($Q_{15}$), -Ge($Q_{13}$)($Q_{14}$)($Q_{15}$), -B($Q_{16}$)($Q_{17}$), -P(=O)($Q_{18}$)($Q_{19}$), or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{21}$)($Q_{22}$), -Si($Q_{23}$)($Q_{24}$)($Q_{25}$), - Ge($Q_{23}$)($Q_{24}$)($Q_{25}$), -B($Q_{26}$)($Q_{27}$), -P(=O)($Q_{28}$)($Q_{29}$), or a combination thereof; or

-N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$), or - P(=O)($Q_{38}$)($Q_{39}$),

two or more of: $E_{11}$ to $E_{18}$; $E_{21}$ to $E_{28}$; $E_{31}$ to $E_{36}$; $E_{41}$ to $E_{48}$; $E_{51}$ to $E_{57}$; and $E_{61}$ to $E_{69}$ are optionally bonded together to form a substituted or unsubstituted $C_5$-$C_{30}$ carbocyclic group or a substituted or unsubstituted $C_1$-$C_{30}$ heterocyclic group, and

* indicates a binding site to a neighboring atom; and/or

wherein $R_1$ to $R_4$, $R_{10}$ to $R_{12}$, $R_{20}$, $R_{30}$, $R_{41}$, and $R_{44}$ are each independently:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{60}$ alkylthio group, or a $C_1$-$C_{20}$ alkoxy group;

a $C_1$-$C_{20}$ alkyl group or a $C_1$-$C_{20}$ alkoxy group, each substituted with deuterium, - F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an

oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{60}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or a combination thereof; or
$-N(Q_1)(Q_2)$, $-Si(Q_3)(Q_4)(Q_5)$, $-Ge(Q_3)(Q_4)(Q_5)$, $-B(Q_6)(Q_7)$, or $-P(=O)(Q_8)(Q_9)$, and
$Q_1$ to $Q_9$ are each independently:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with deuterium, a $C_1$-$C_{10}$ alkyl group, a phenyl group, or a combination thereof.

**7.** The organometallic compound of any of claims 1-6, wherein the organometallic compound represented by Formula 1 is represented by Formula 11 or 12:

Formula 11

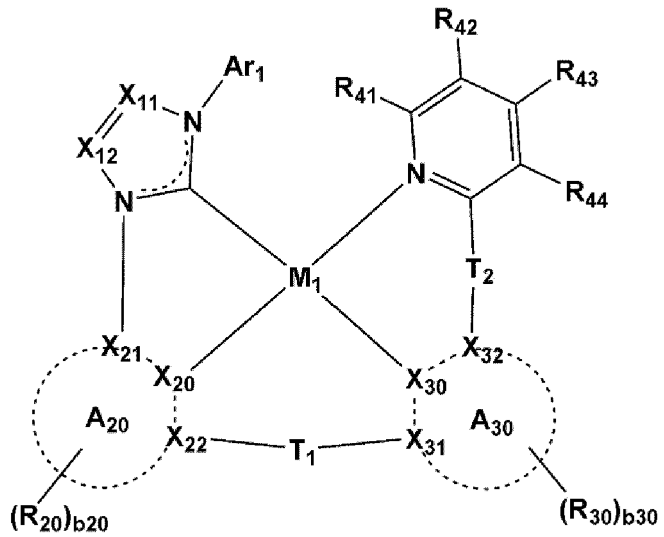

Formula 12

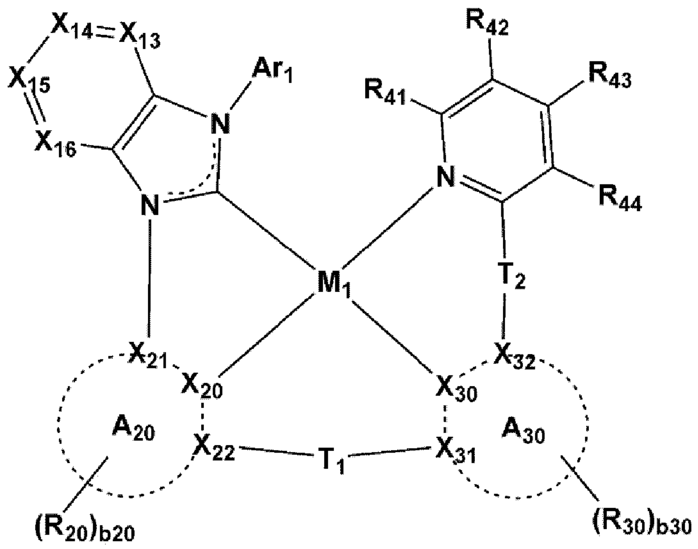

wherein, in Formulae 11 and 12,

$M_1$, $A_{20}$, $A_{30}$, $X_{11}$, $X_{12}$, $X_{20}$ to $X_{22}$, $X_{30}$ to $X_{32}$, $T_1$, $T_2$, $Ar_1$, $R_{20}$, $R_{30}$, $R_{41}$ to $R_{44}$, b20, and b30 are each as defined in claim 1,
$X_{13}$ is $C(R_{13})$ or N, $X_{14}$ is $C(R_{14})$ or N, $X_{15}$ is $C(R_{15})$ or N, and $X_{16}$ is $C(R_{16})$ or N, and
$R_{13}$ to $R_{16}$ are each independently defined as for $R_{10}$ in claim 1.

**8.** The organometallic compound of any of claims 1-7, wherein the organometallic compound is one of Compounds 1 to 324:

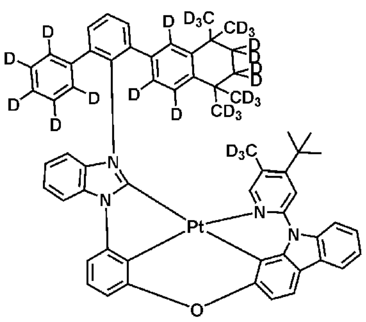

1

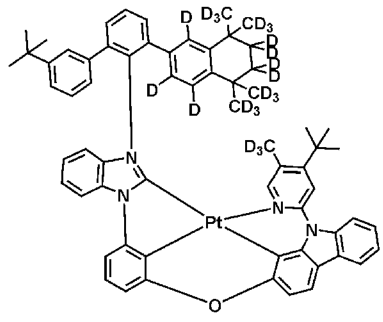

2

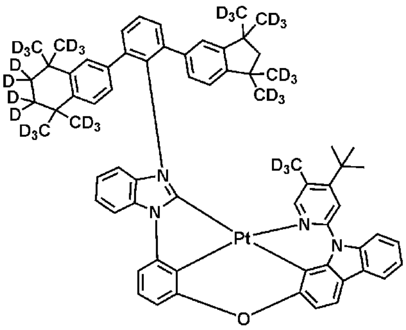

3

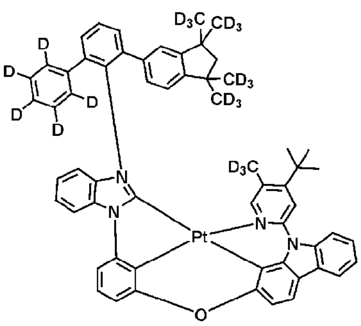

4

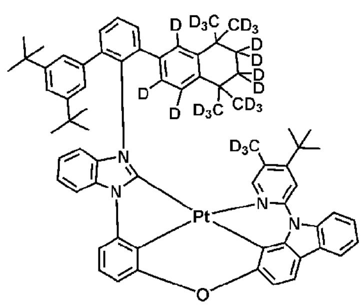

5

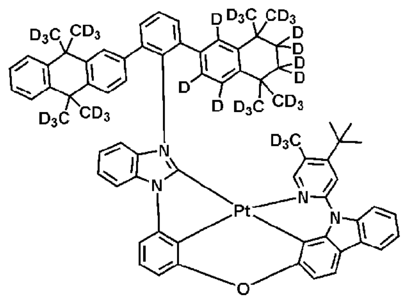

6

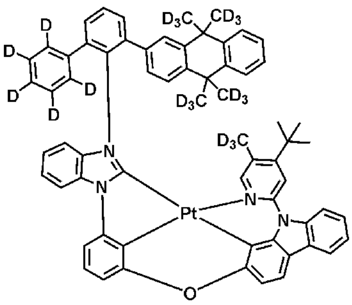

7

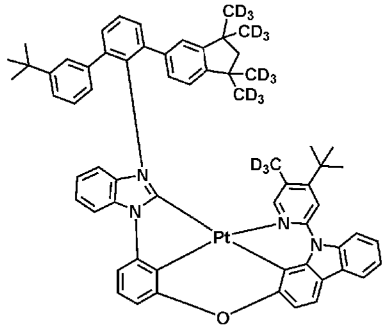

8

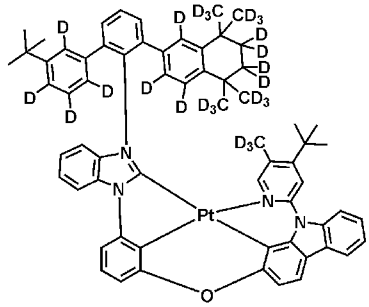

9

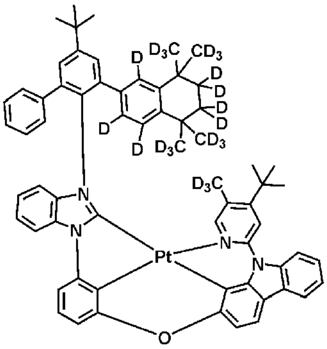

10

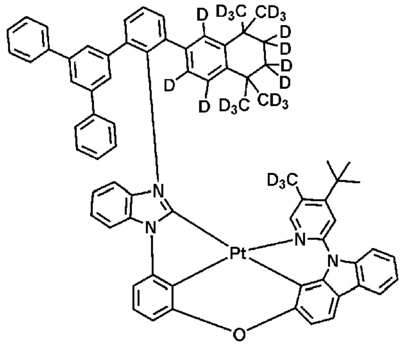

11

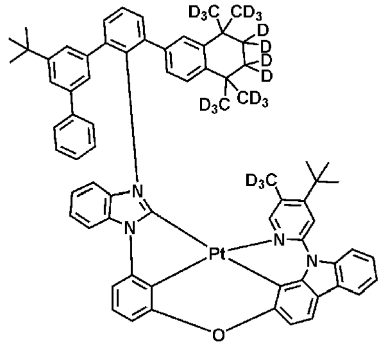

12

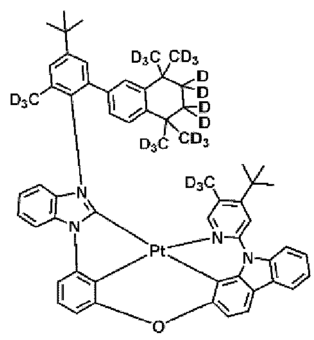

**13**

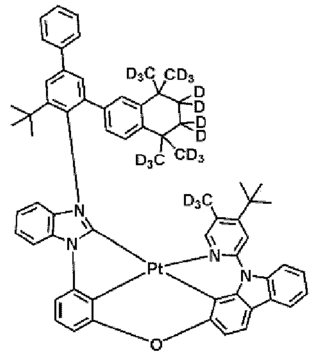

**14**

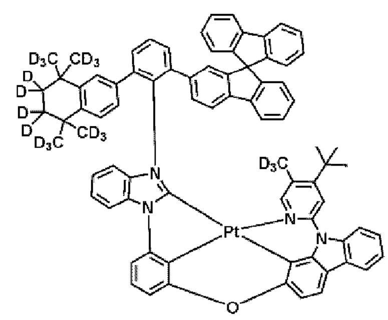

**15**

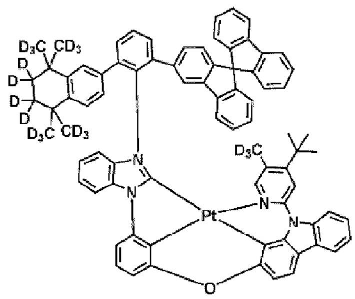

**16**

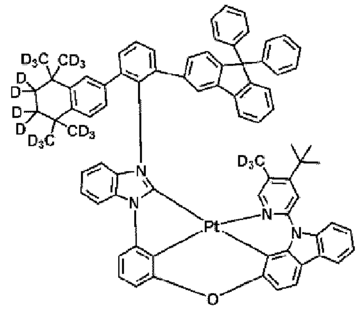

**17**

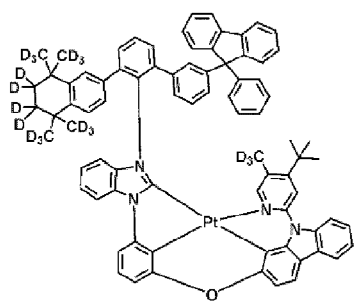

**18**

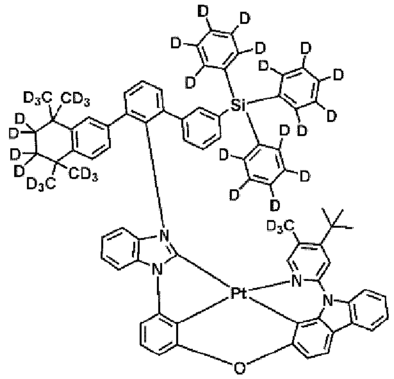

**19**

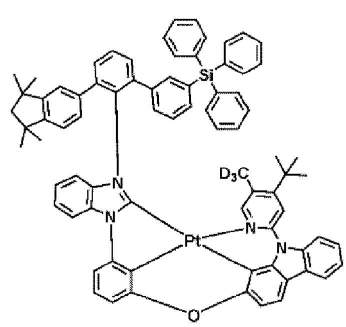

**20**

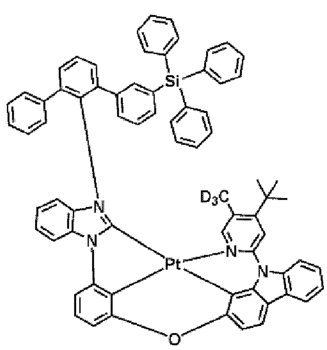

**21**

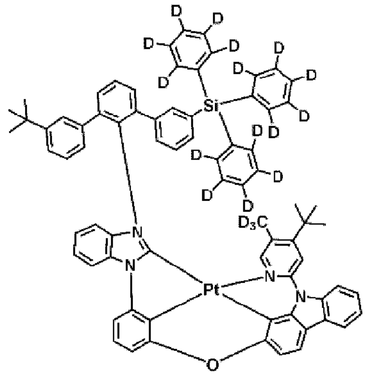

**22**

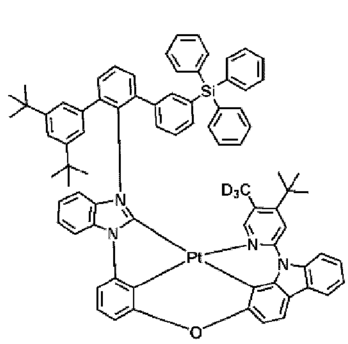

**23**

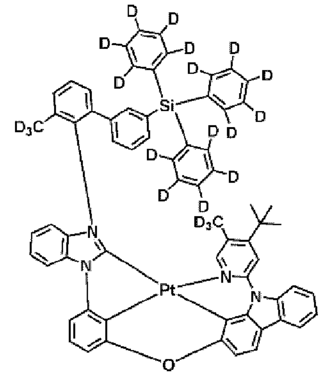

**24**

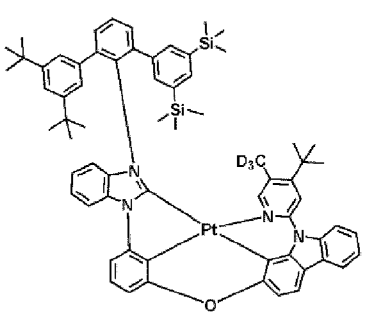

25

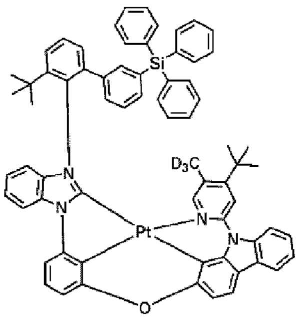

26

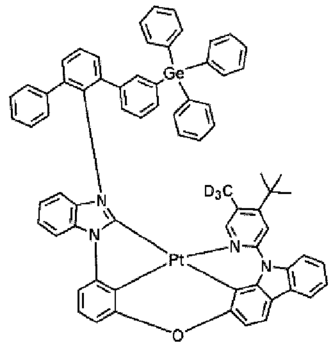

27

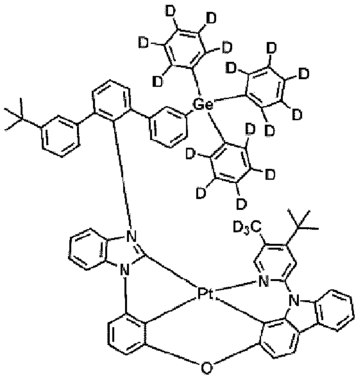

28

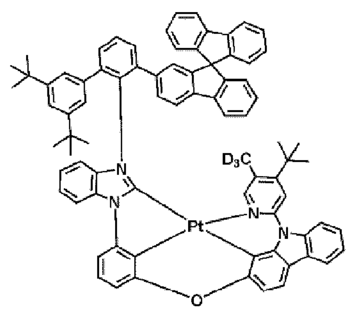

29

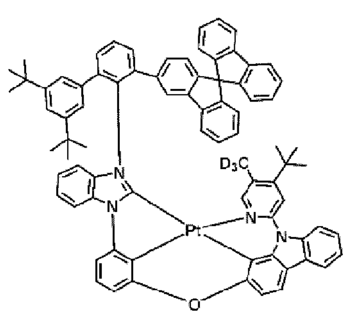

30

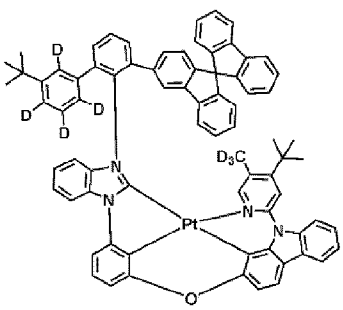

31

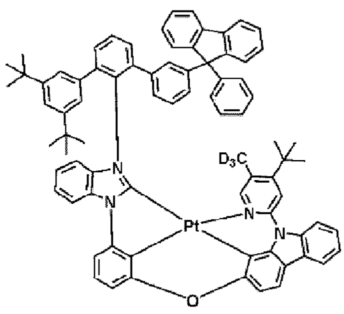

32

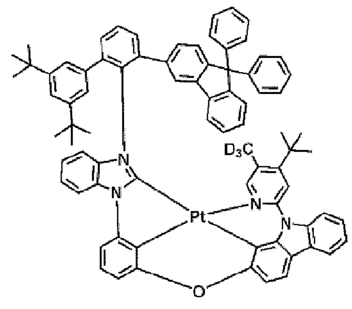

33

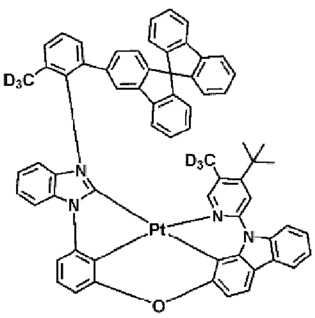

34

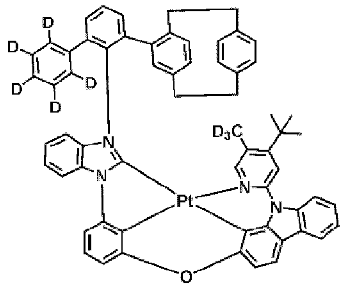

35

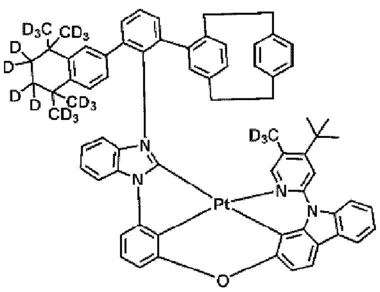

36

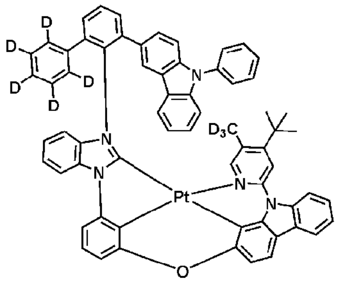

37

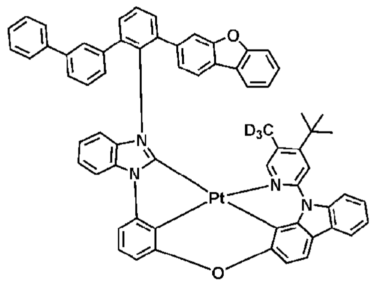

38

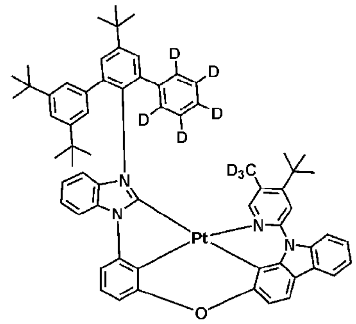

39

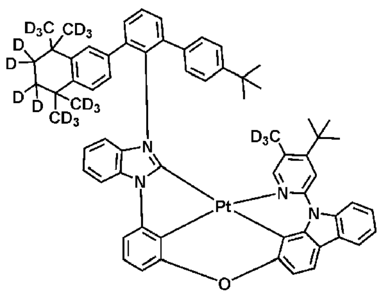

40

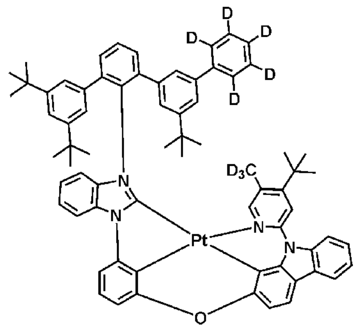

41

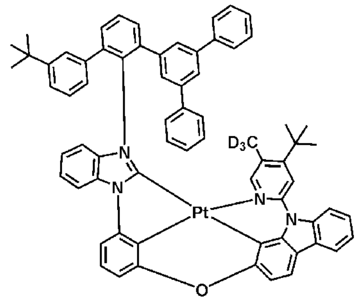

42

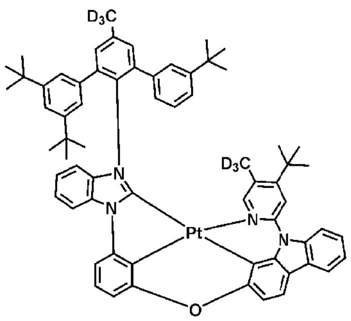

43

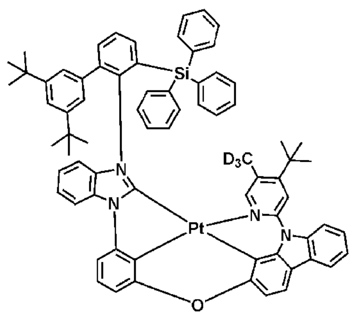

44

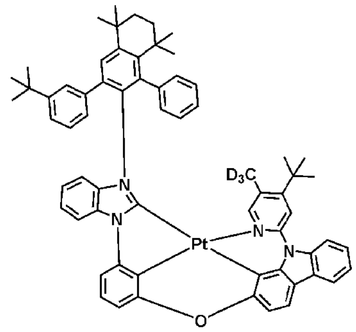

45

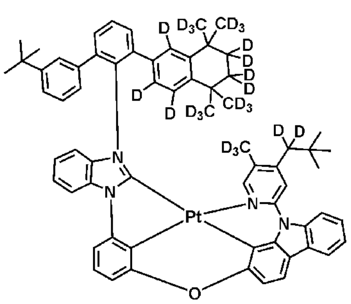

46

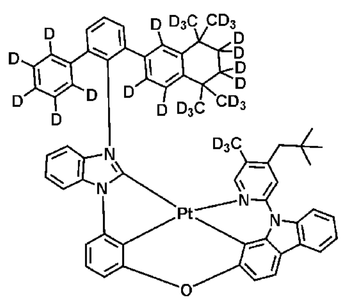

47

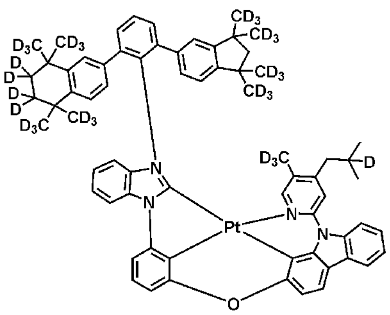

48

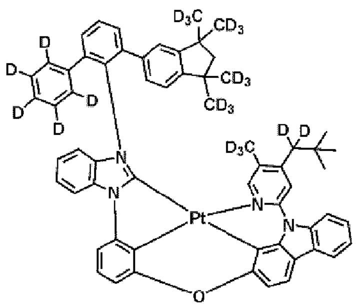

49

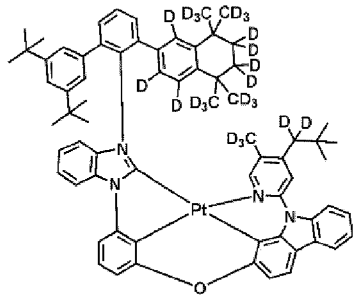

50

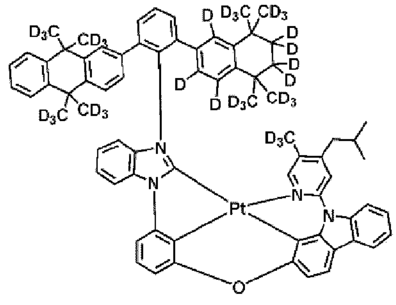

51

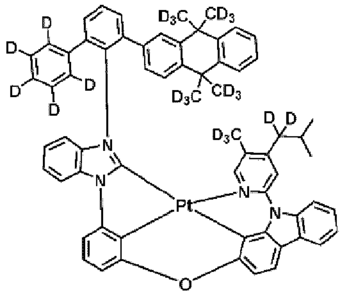

52

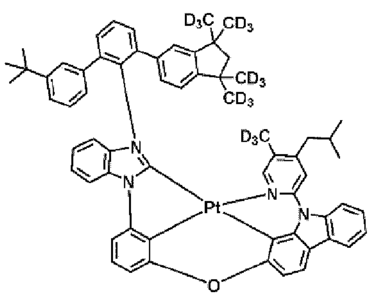

53

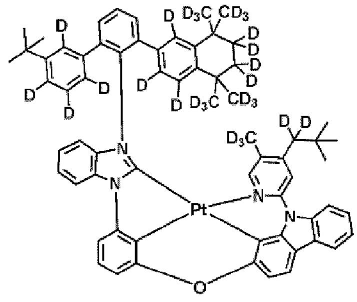

54

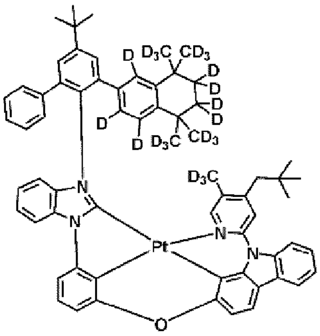

55

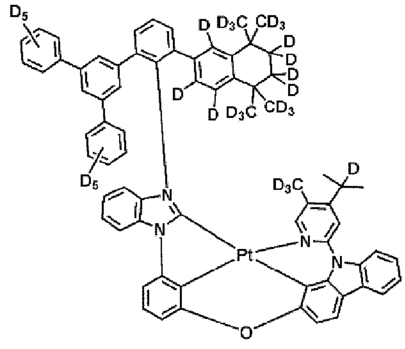

56

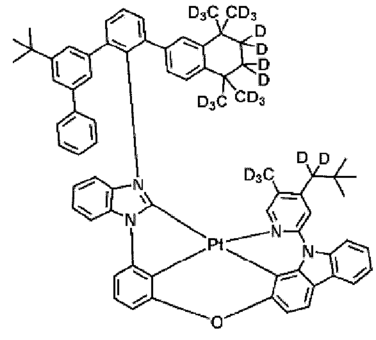

57

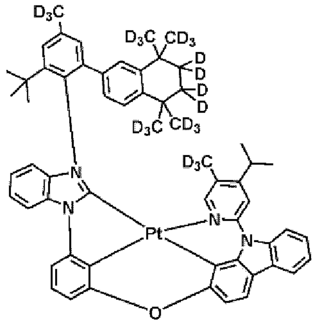

58

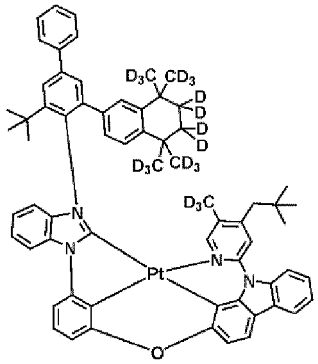

59

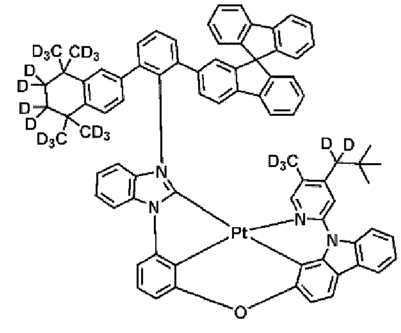

60

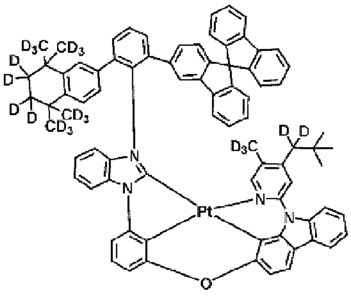

61

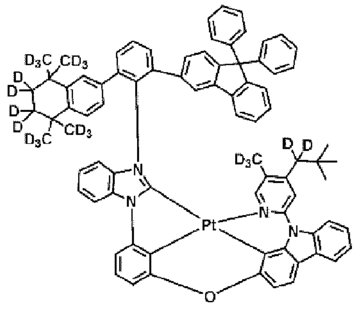

62

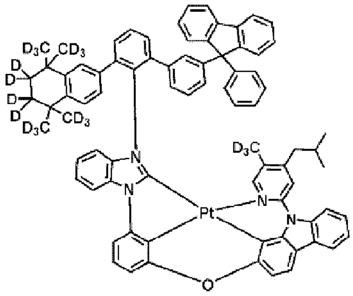

63

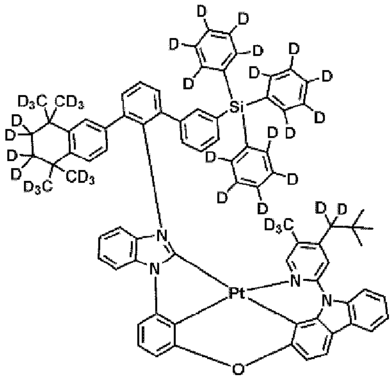

64

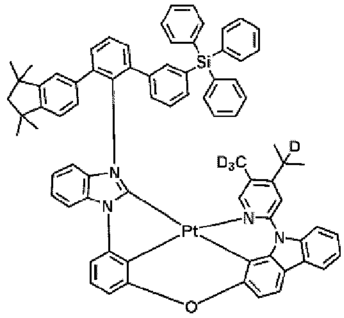

65

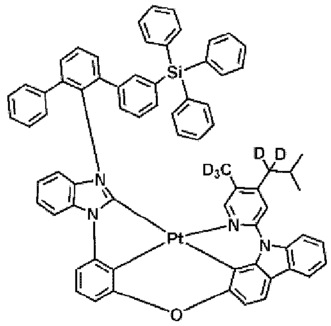

66

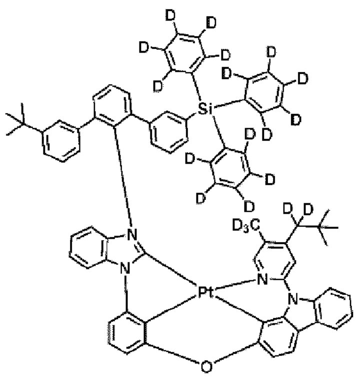

67

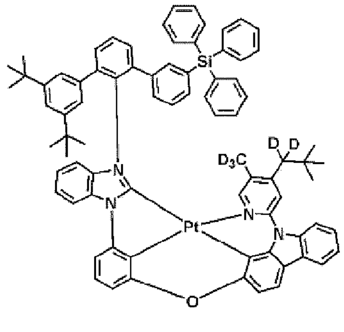

68

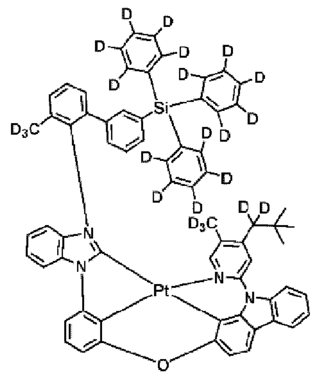

69

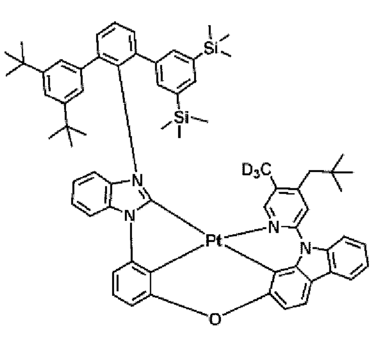

70

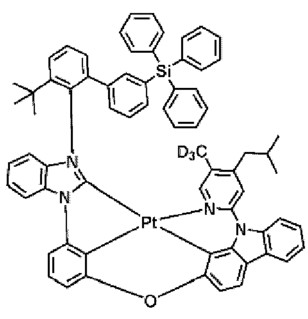

71

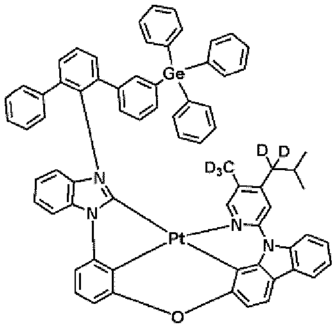

72

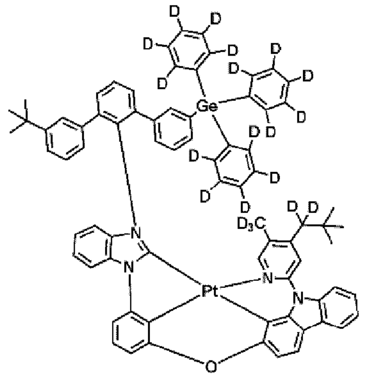

73

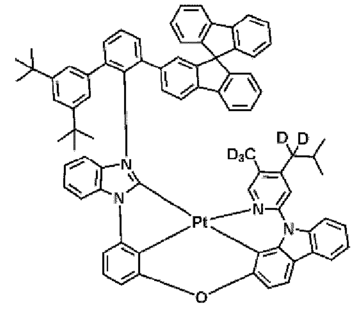

74

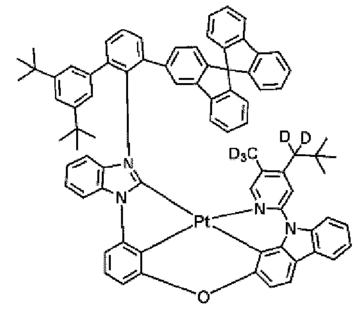

75

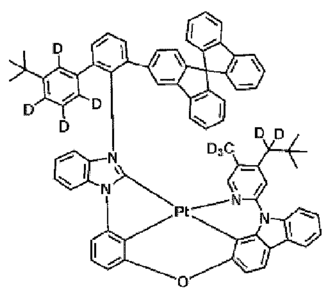

76

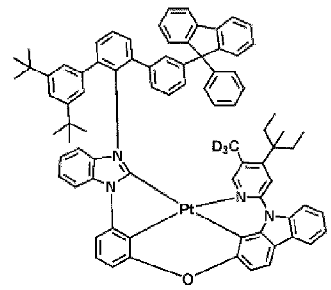

77

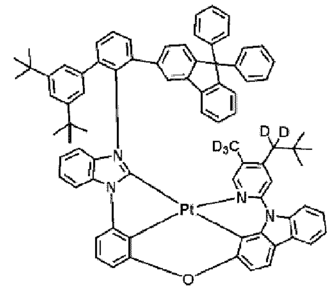

78

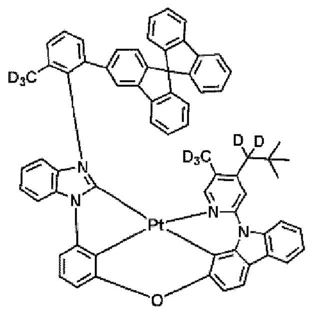

79

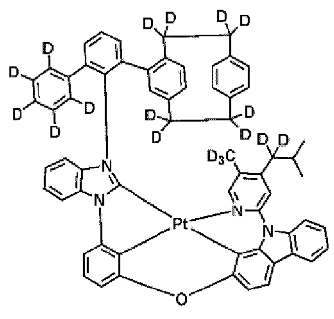

80

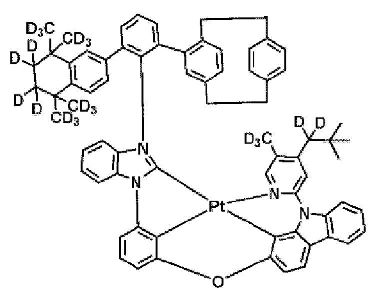

81

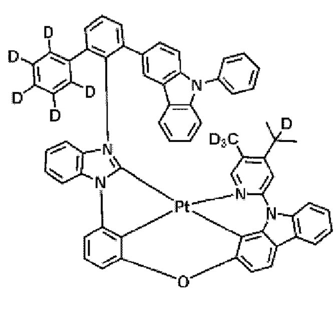

82

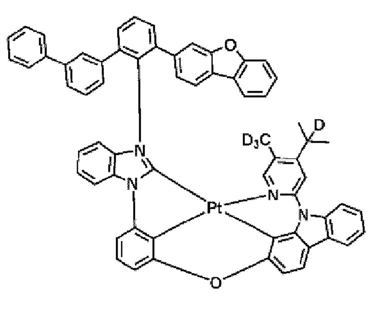

83

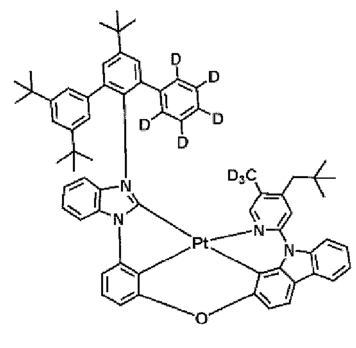

84

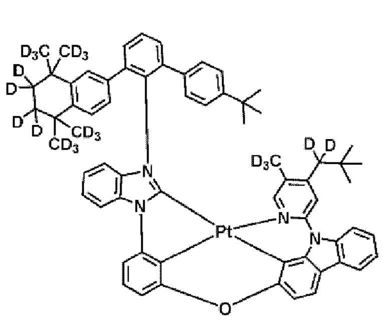

**85**

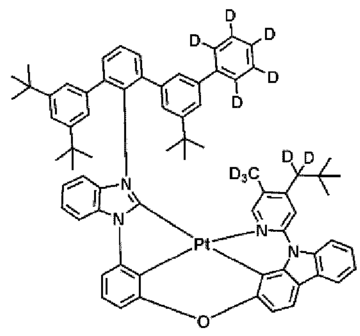

**86**

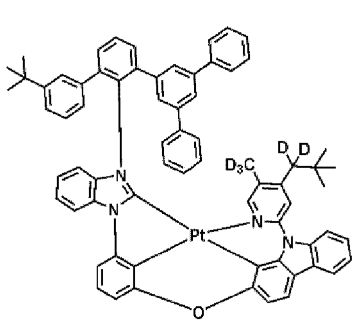

**87**

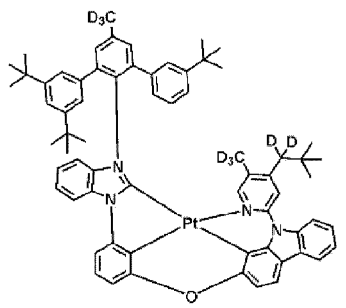

**88**

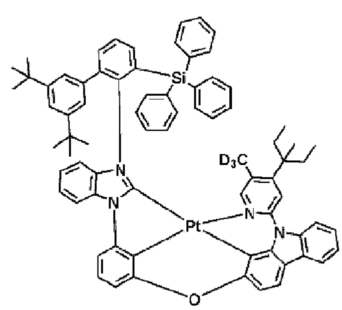

**89**

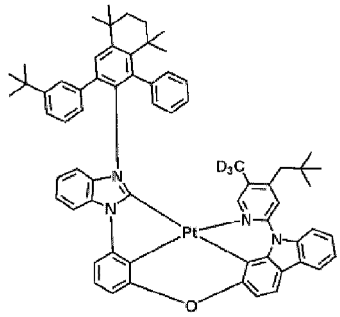

**90**

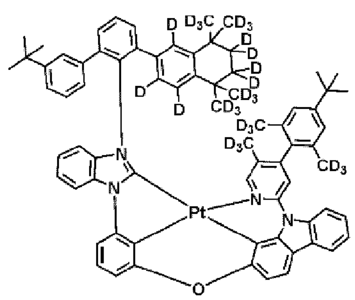

**91**

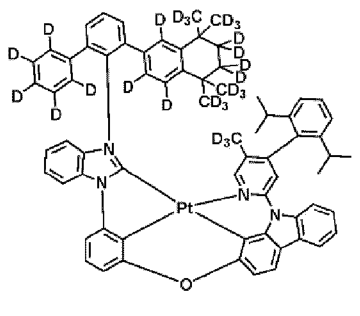

**92**

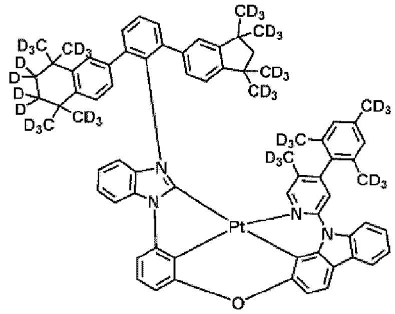

**93**

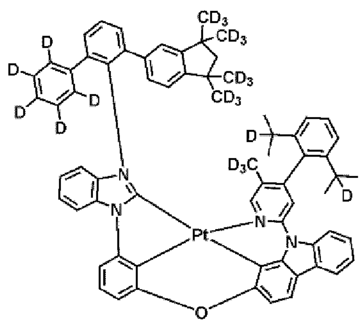

**94**

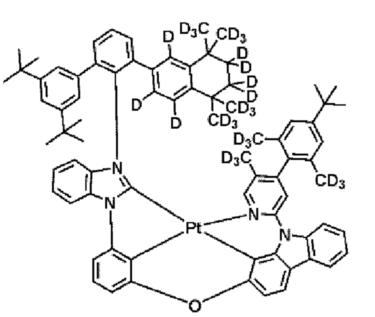

**95**

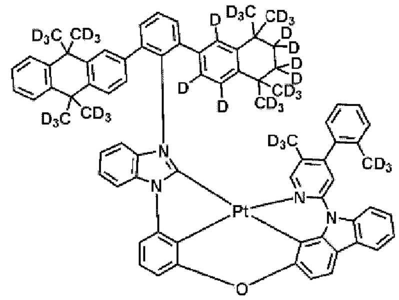

**96**

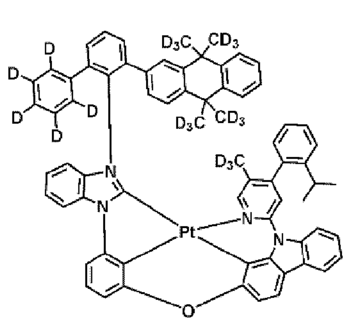

97

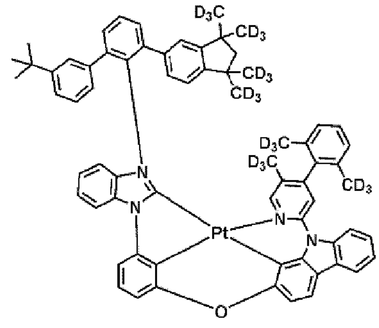

98

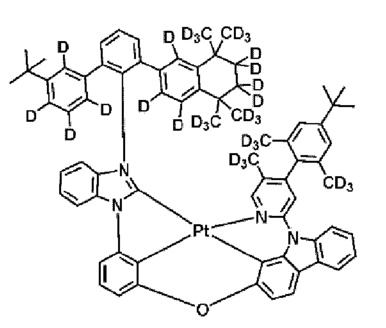

99

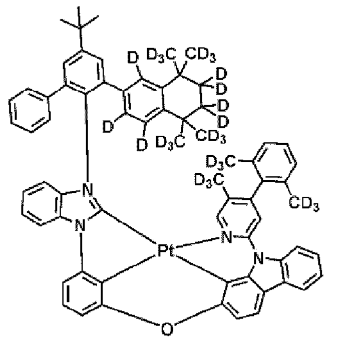

100

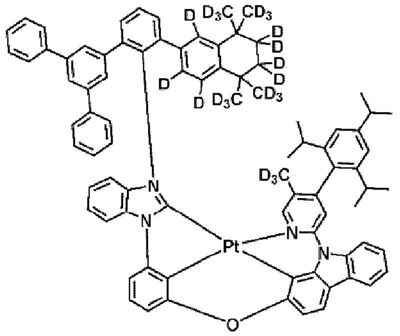

101

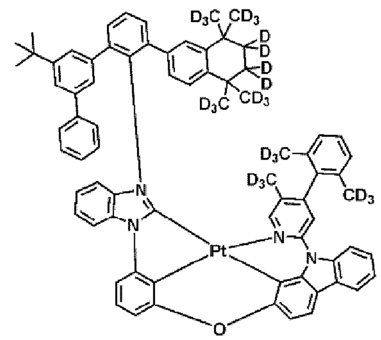

102

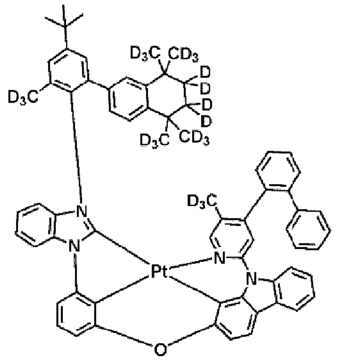

103

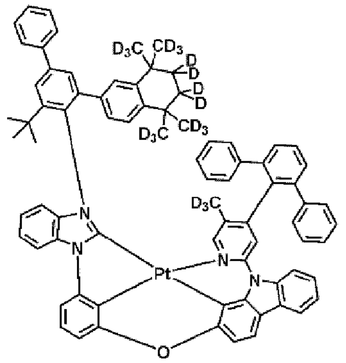

104

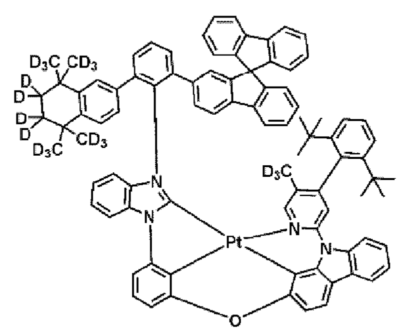

105

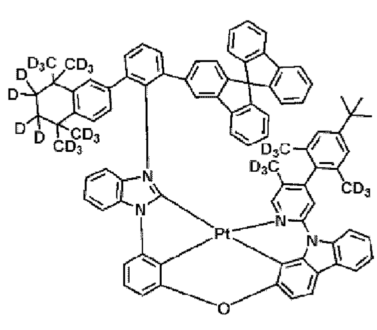

106

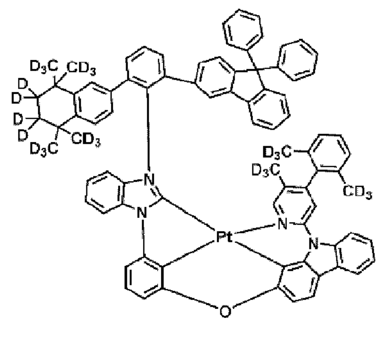

107

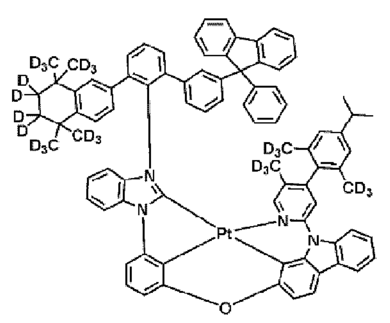

108

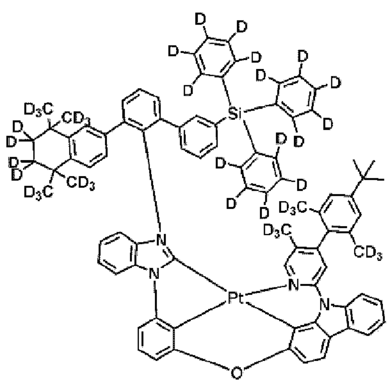

109

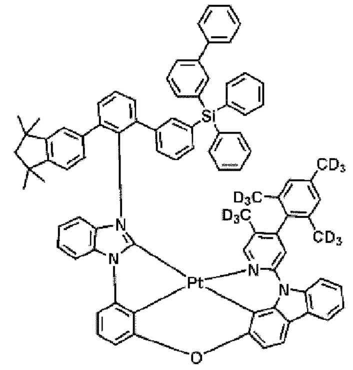

110

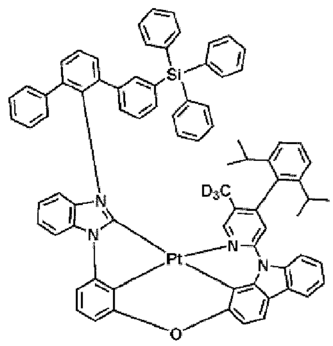

111

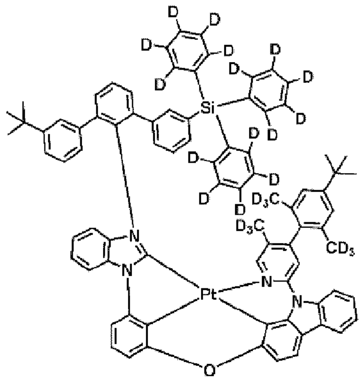

112

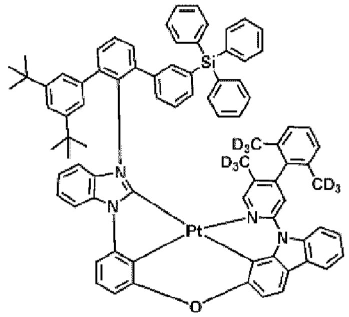

113

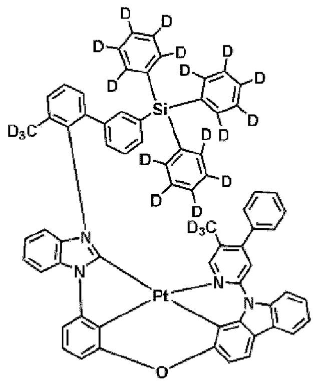

114

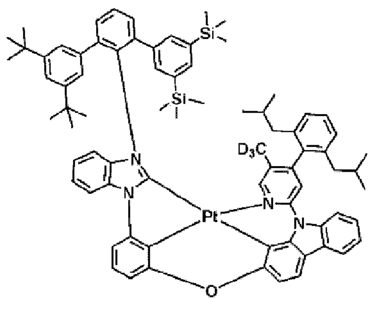

115

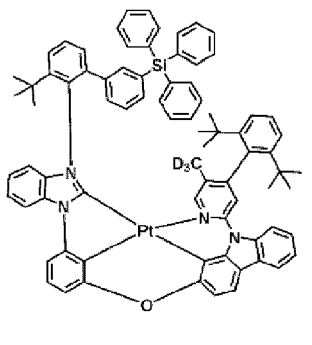

116

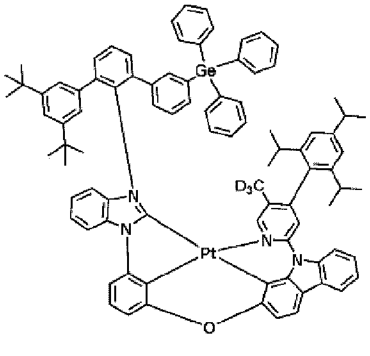

117

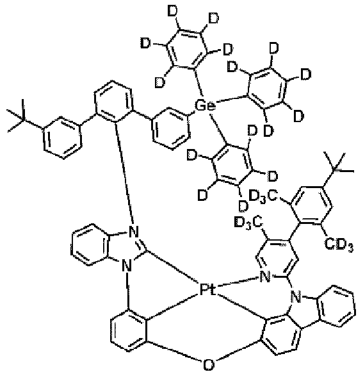

118

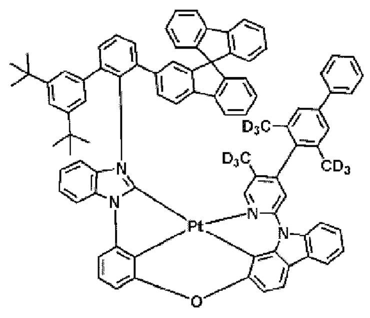

119

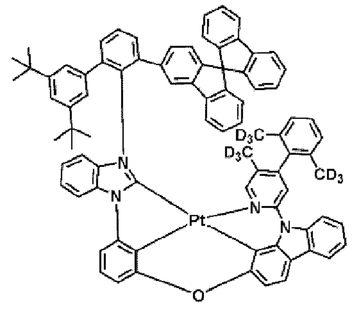

120

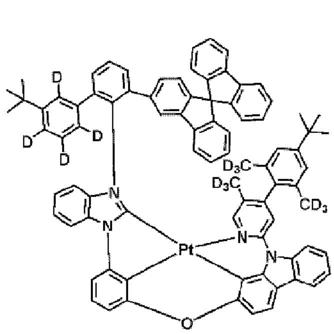

121

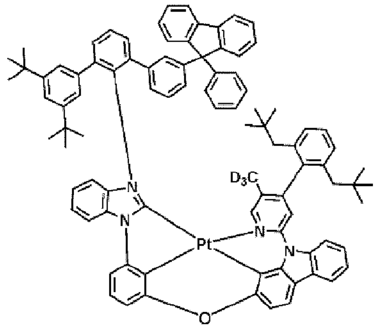

122

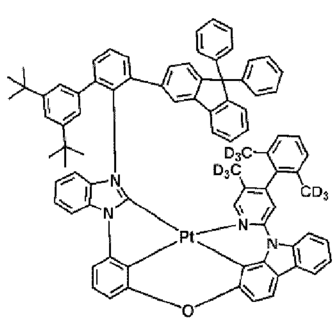

123

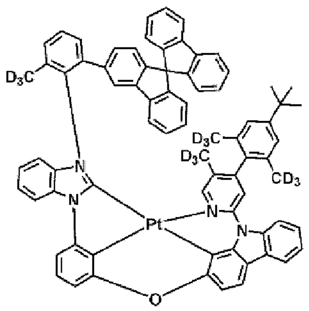

124

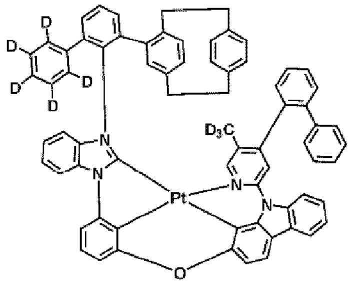

125

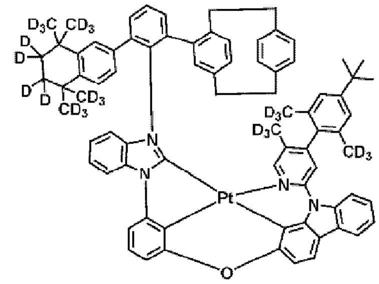

126

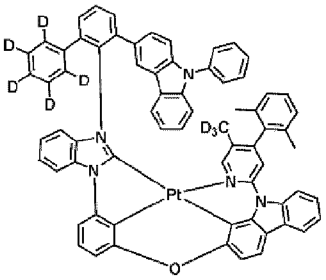

127

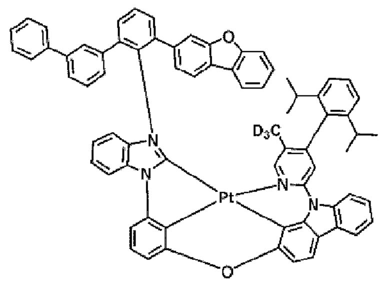

128

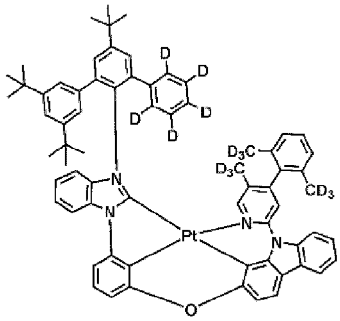

129

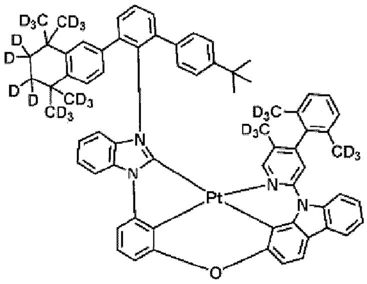

130

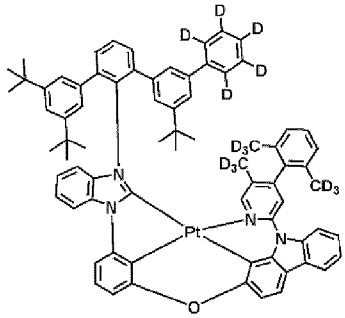

131

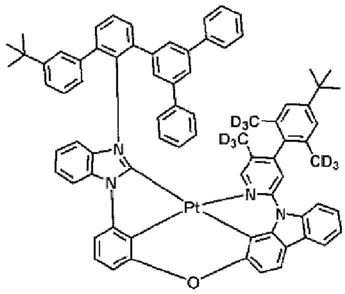

132

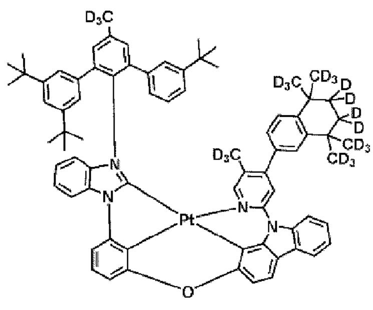

133

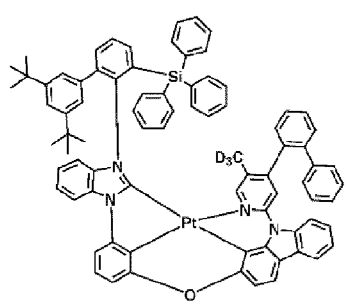

134

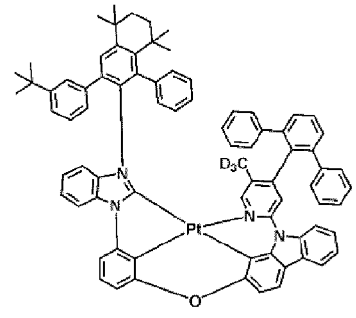

135

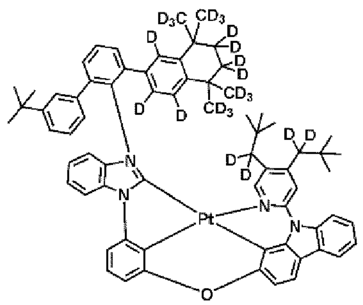

136

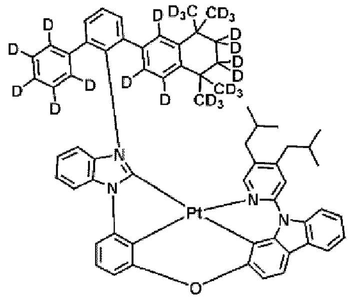

137

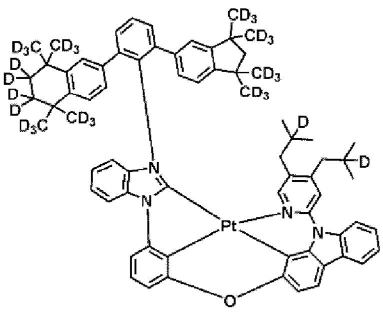

138

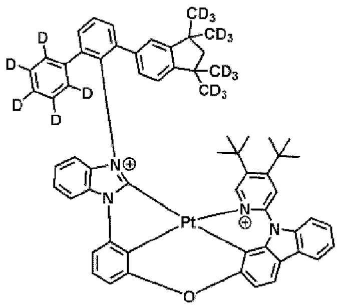

139

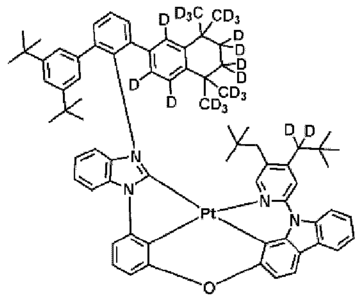

140

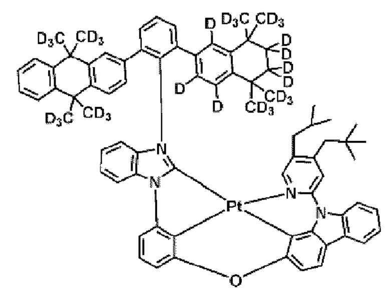

141

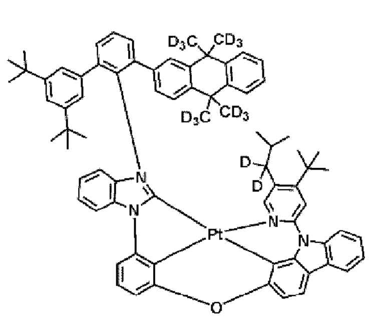

142

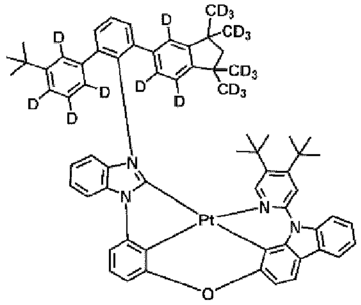

143

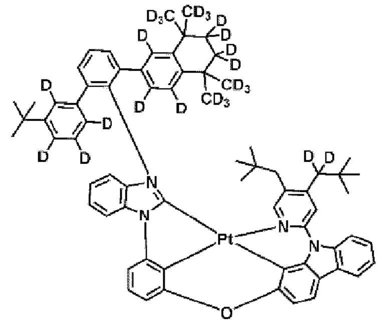

144

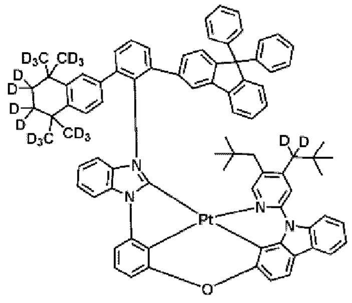

157

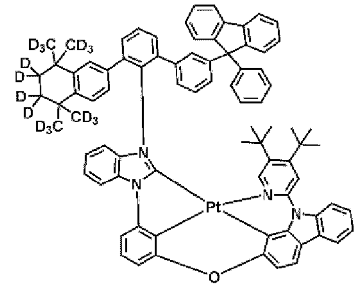

158

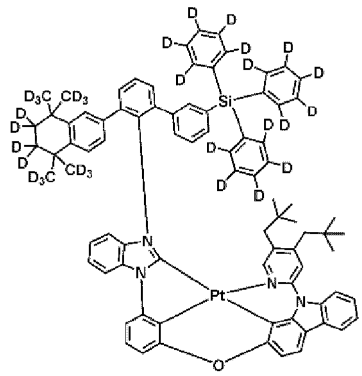

159

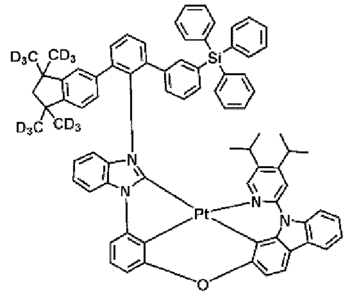

160

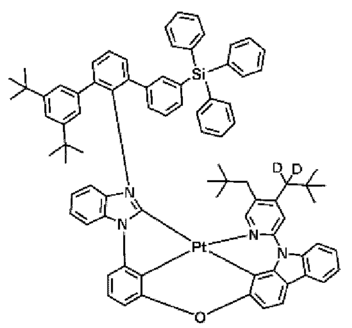

161

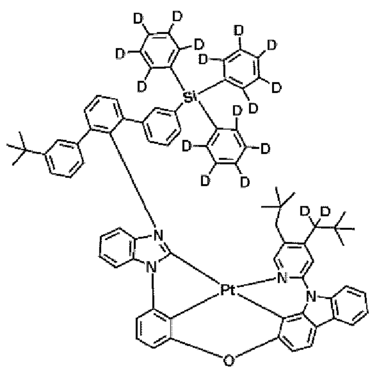

162

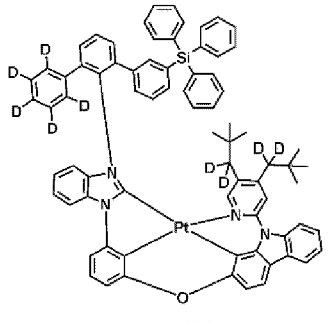

163

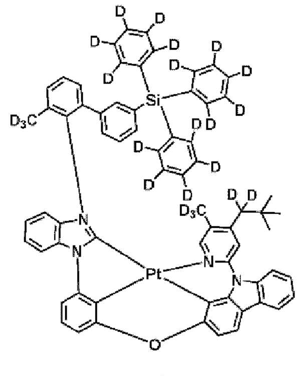

164

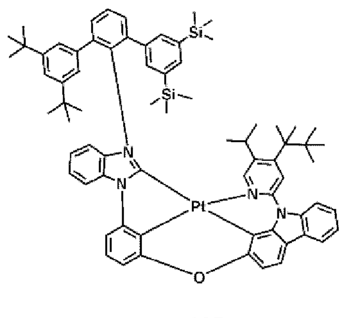

165

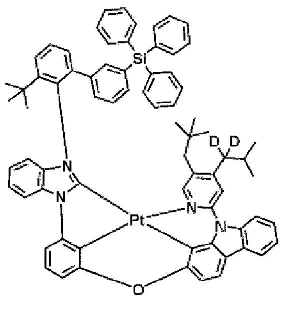

166

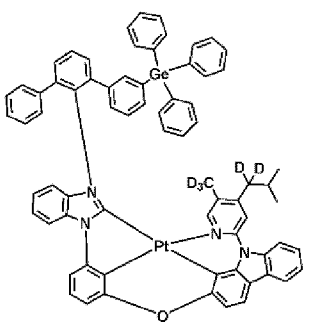

167

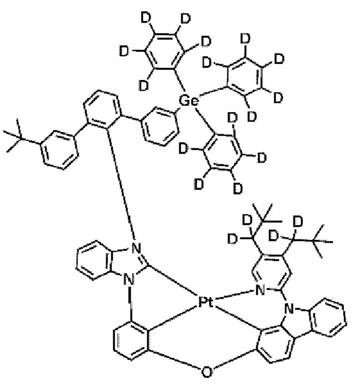

168

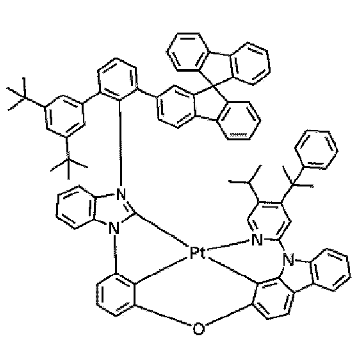

**169**

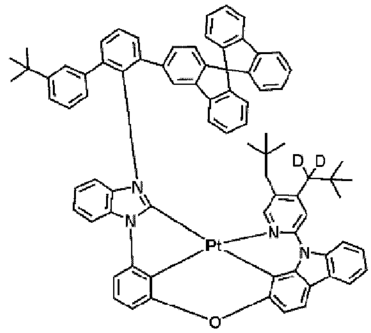

**170**

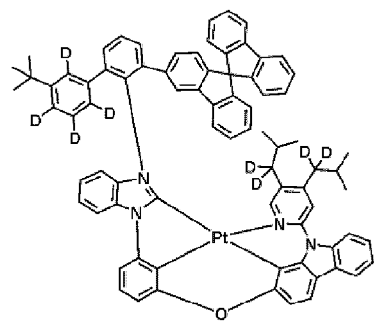

**171**

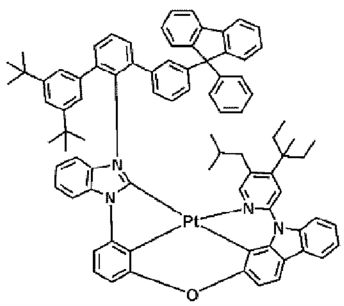

**172**

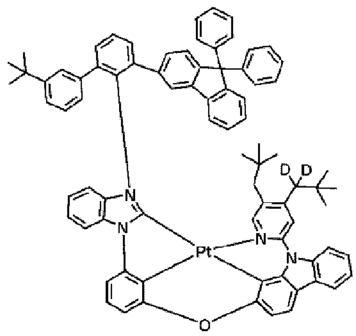

173

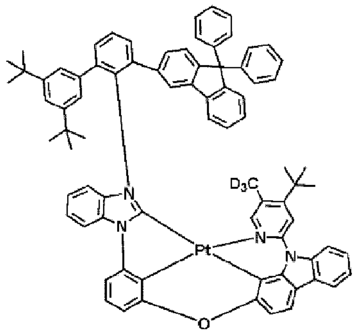

**174**

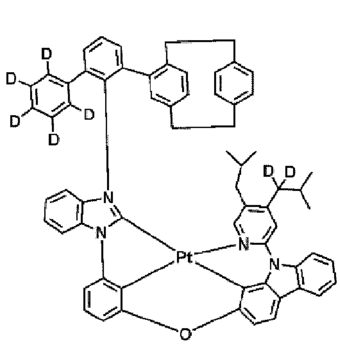

**175**

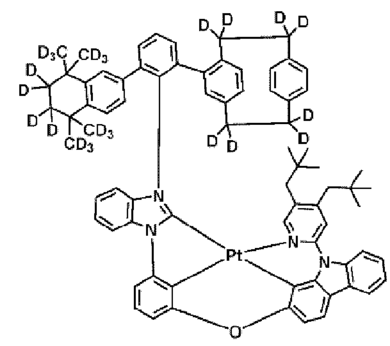

**176**

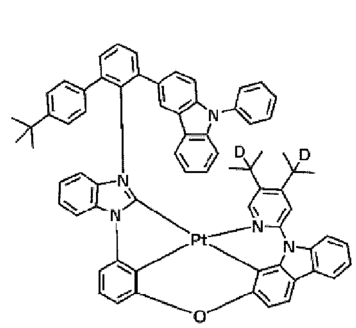

**177**

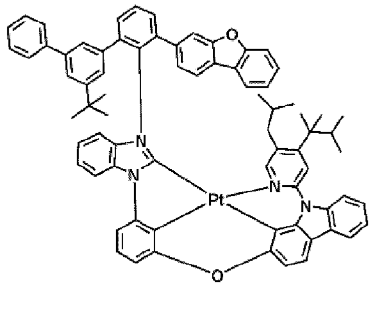

**178**

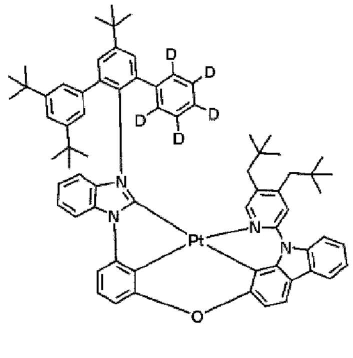

**179**

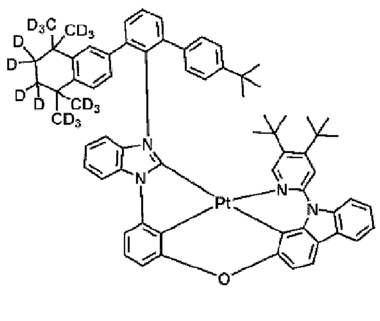

**180**

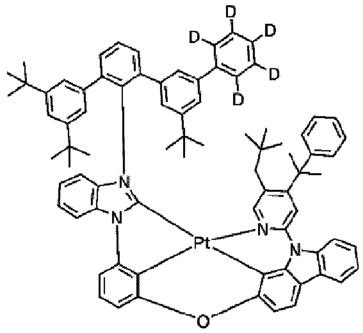

181

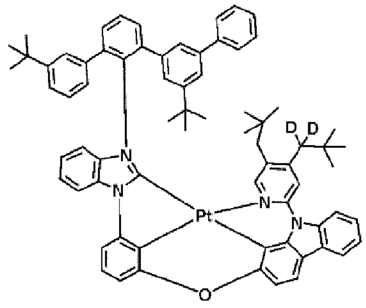

182

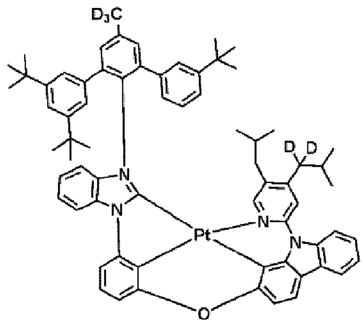

183

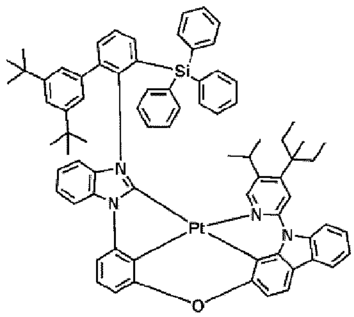

184

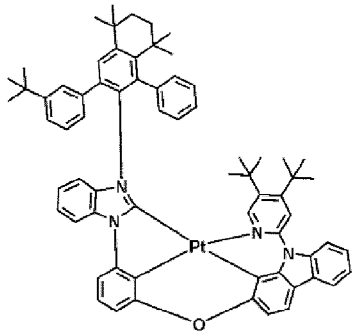

185

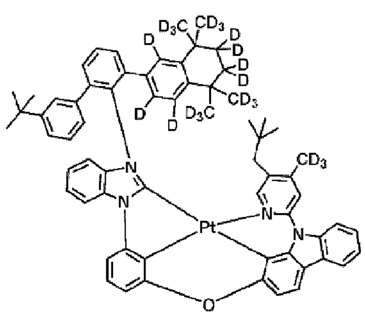

186

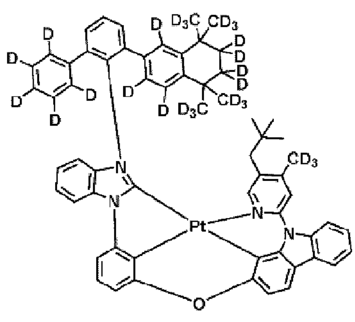

187

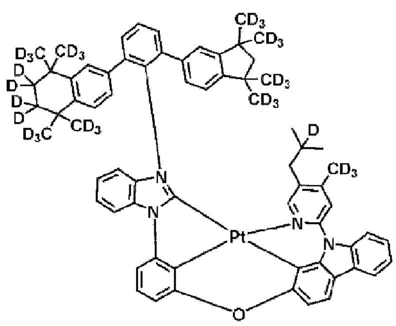

188

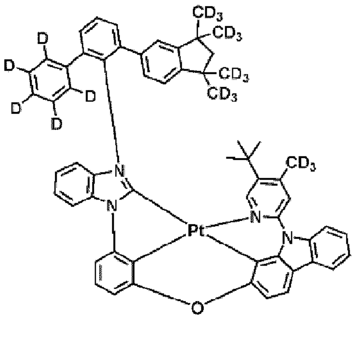

189

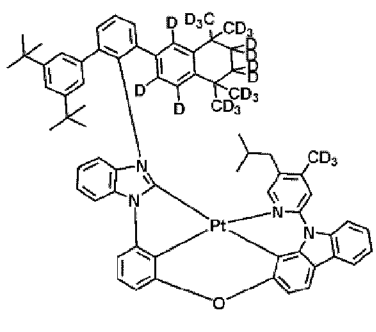

190

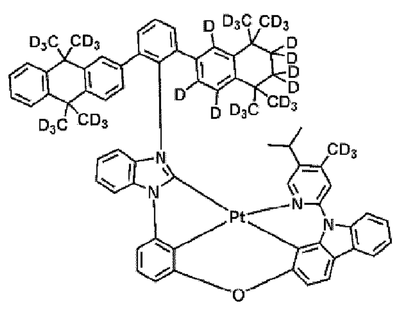

191

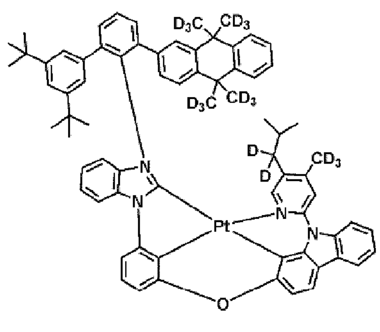

192

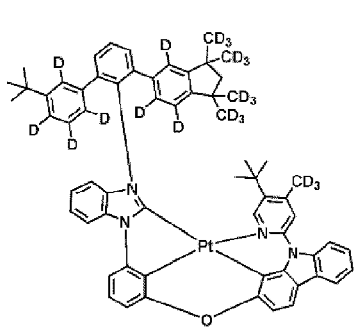
193

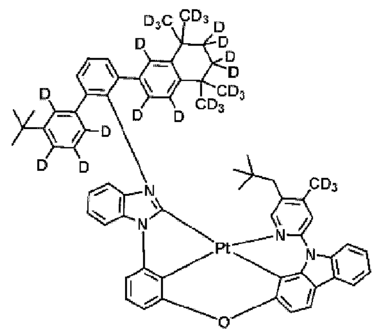
194

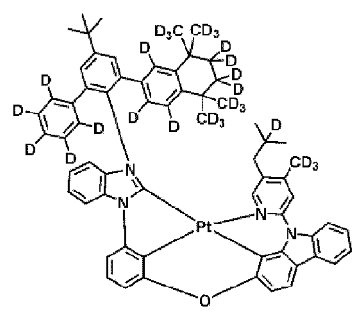
195

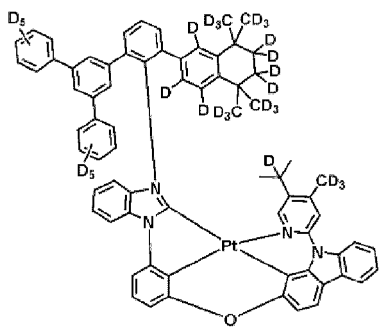
196

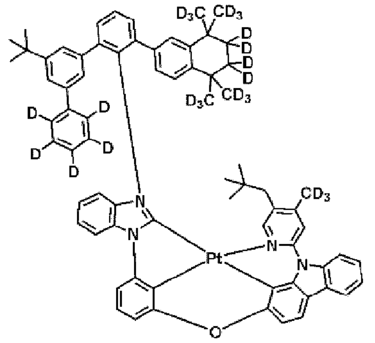
197

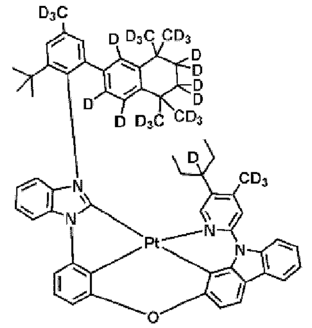
198

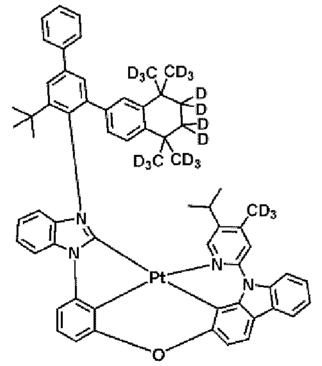
199

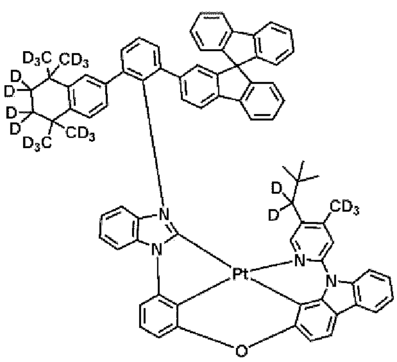
200

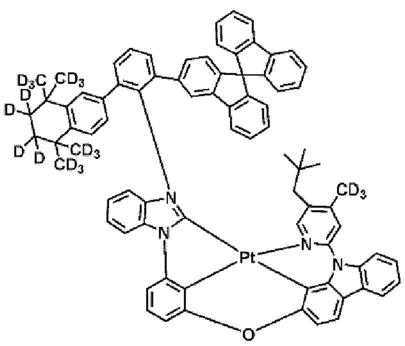
201

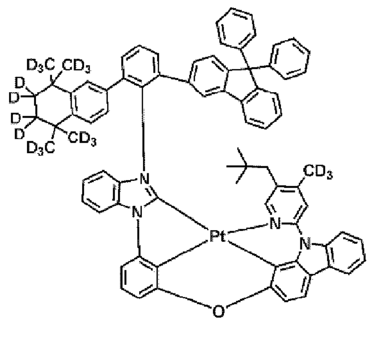
202

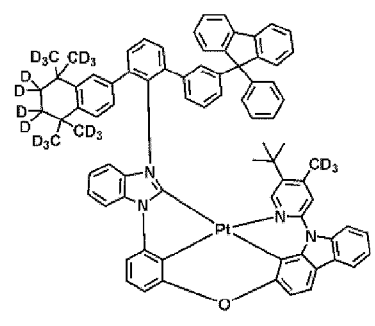
203

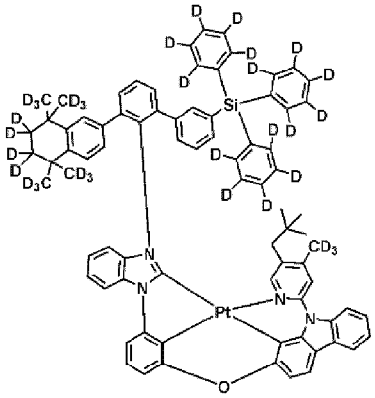
204

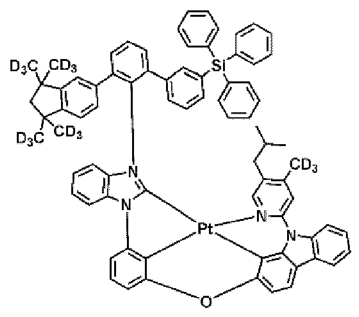

205

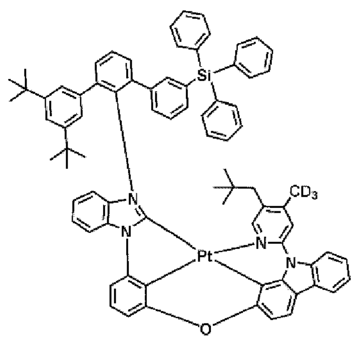

206

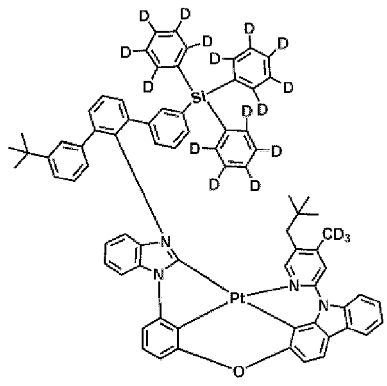

207

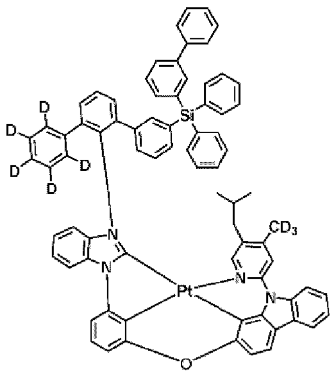

208

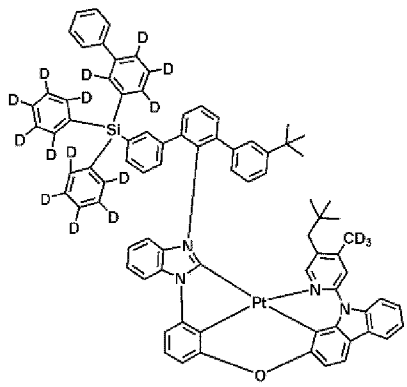

209

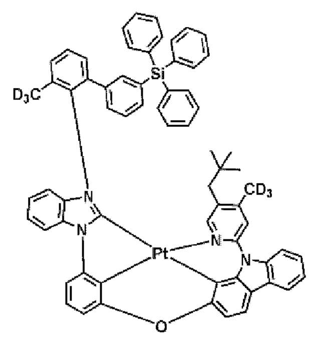

210

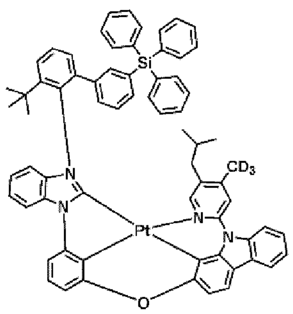

211

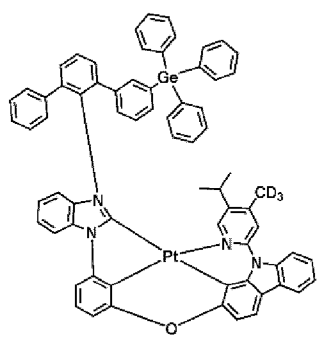

212

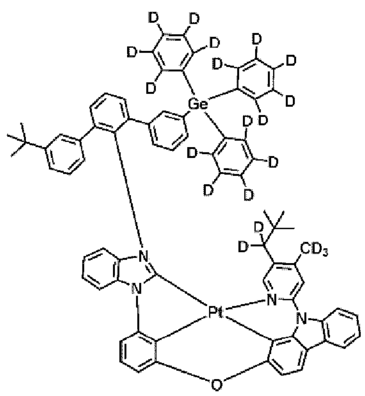

213

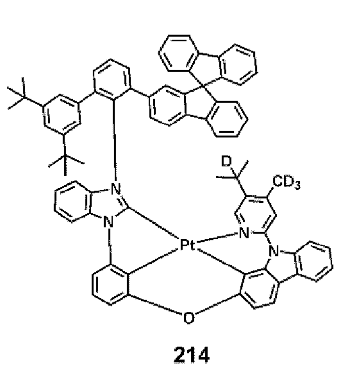

214

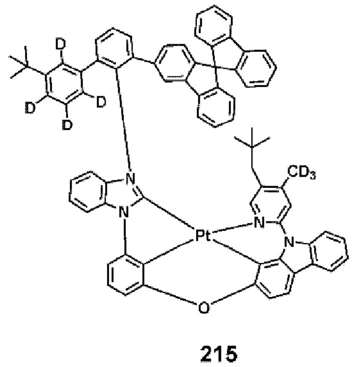

215

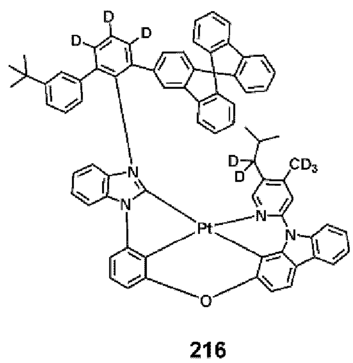

216

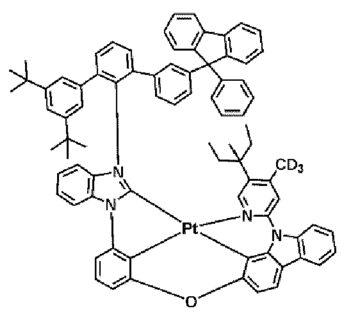

217

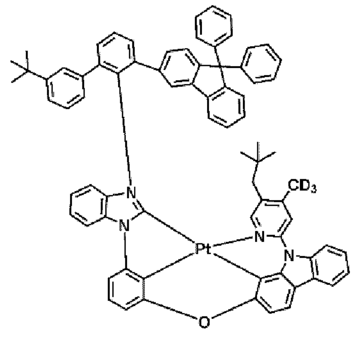

218

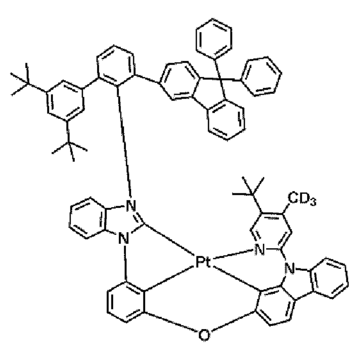

219

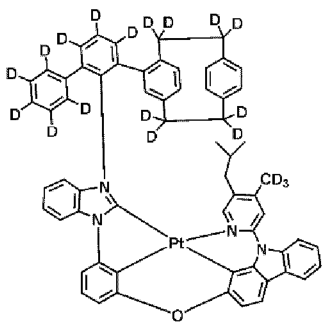

220

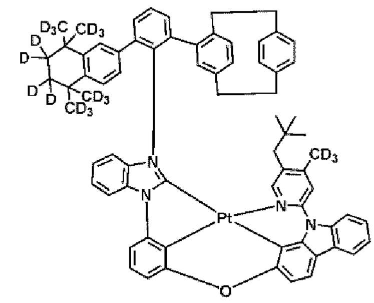

221

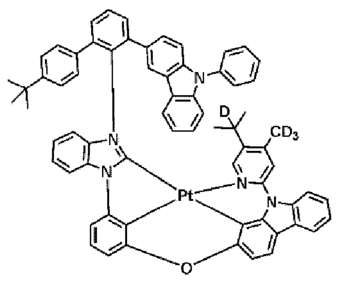

222

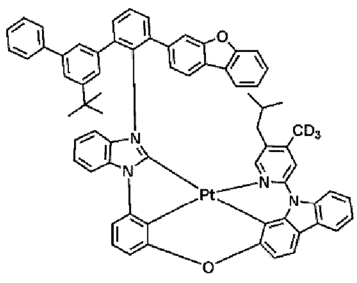

223

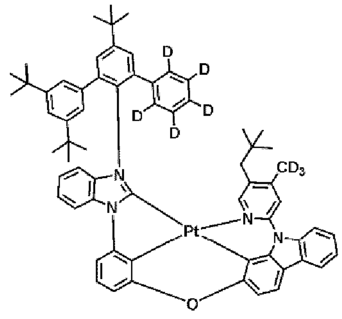

224

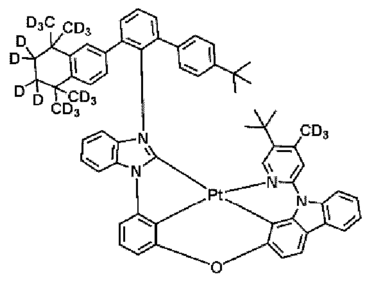

225

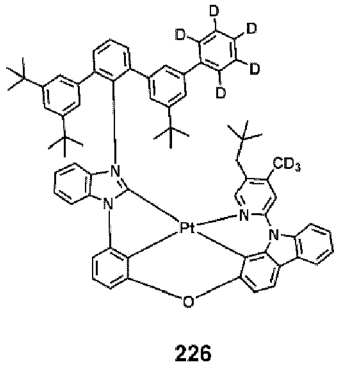

226

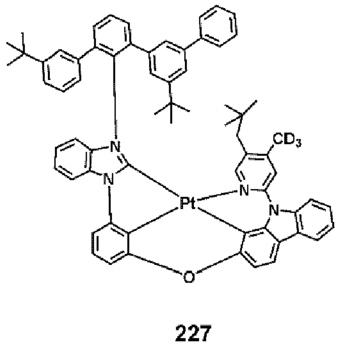

227

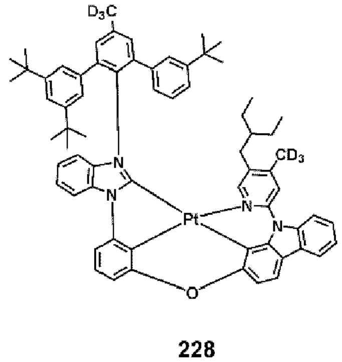

228

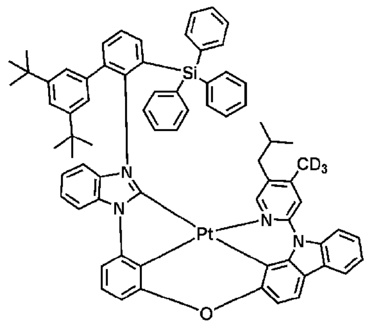

229

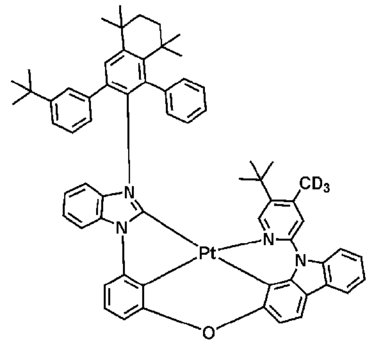

230

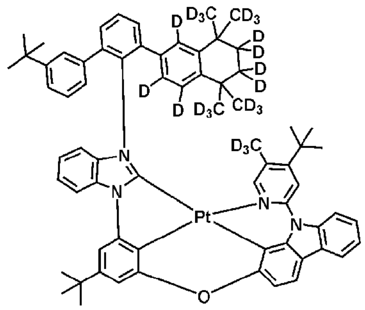

231

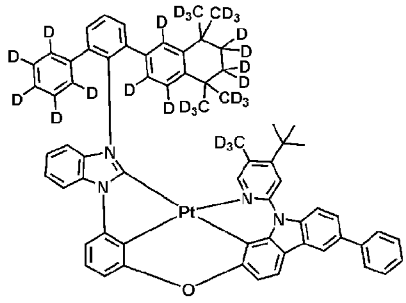

232

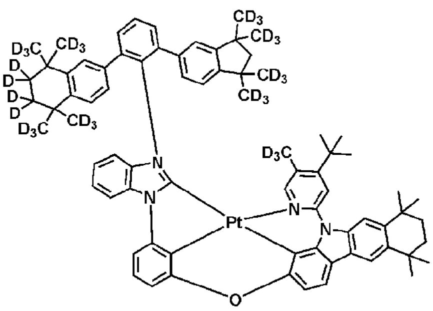

233

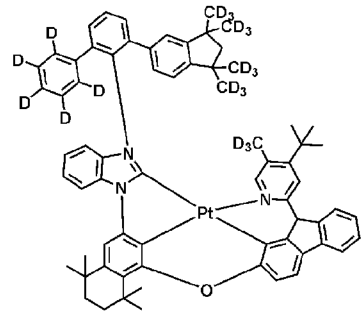

234

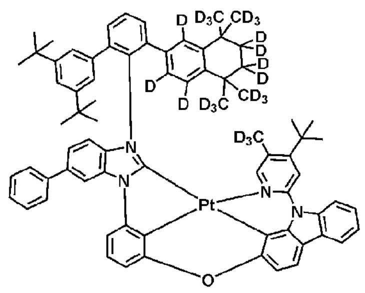

235

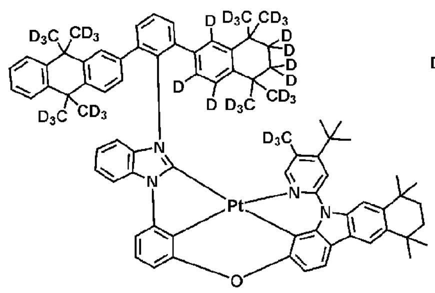

236

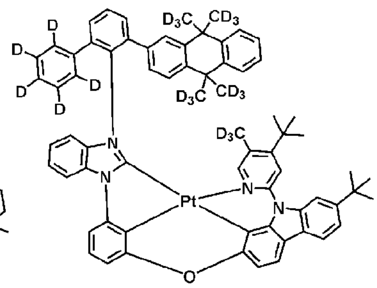

237

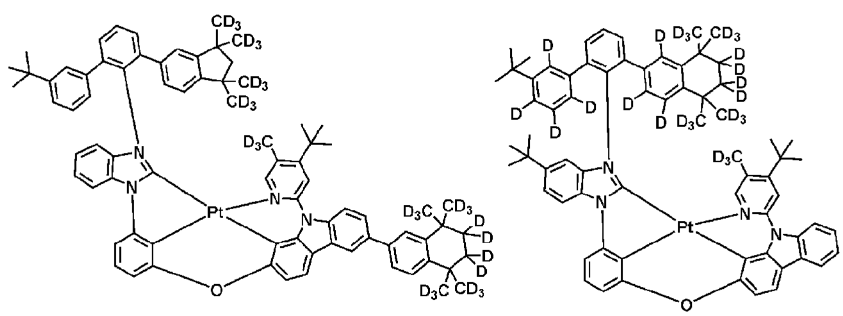

238

239

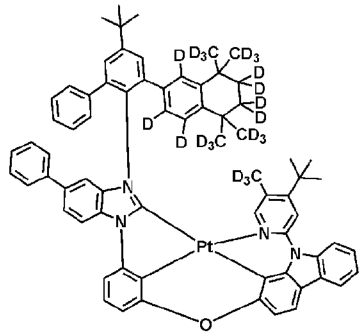

240

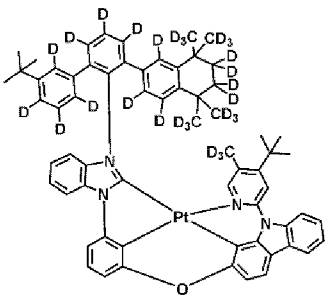

241

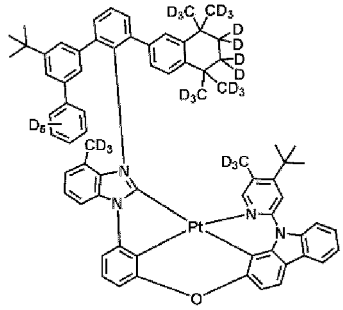

242

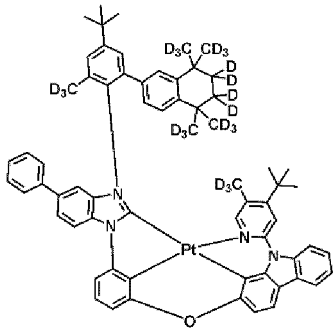

243

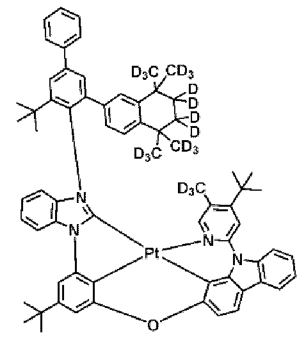

244

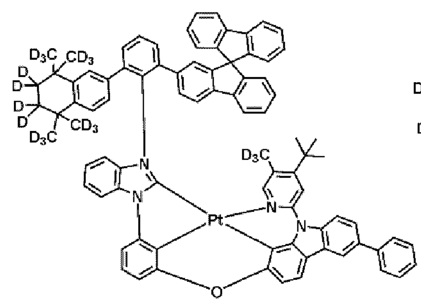

245

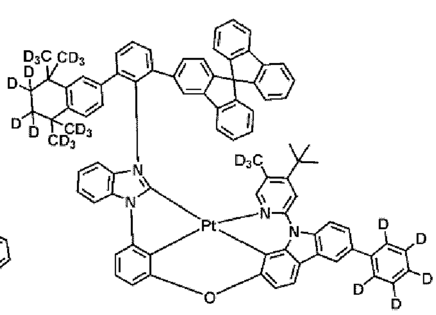

246

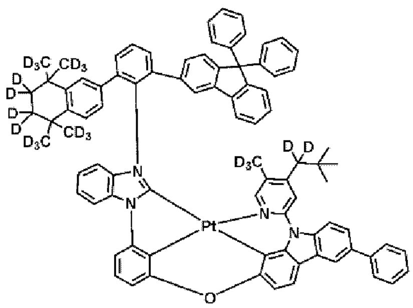

247

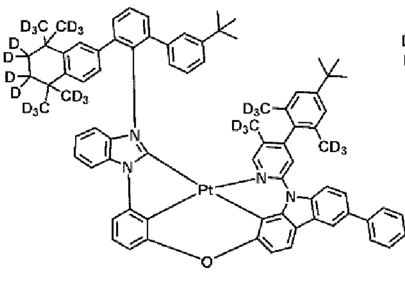

248

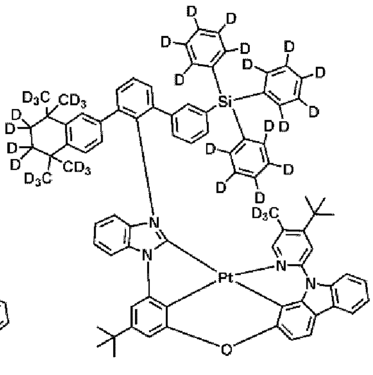

249

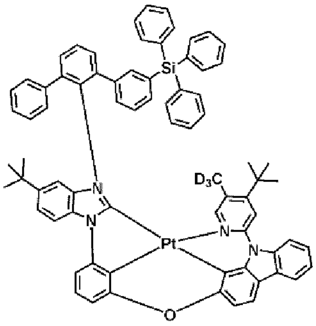

250

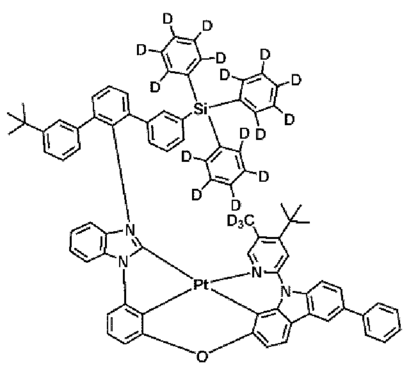

251

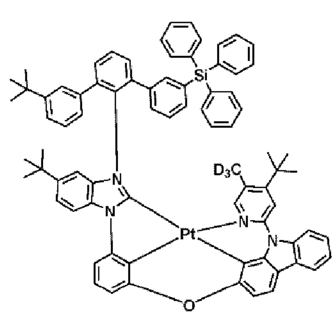

252

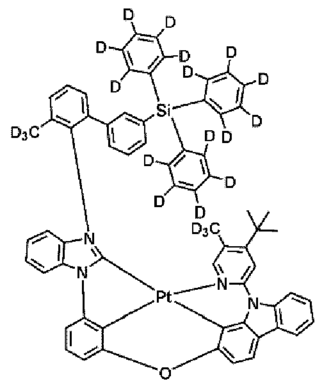

253

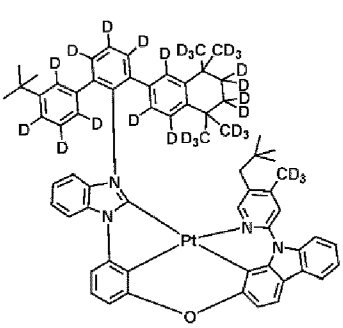

254

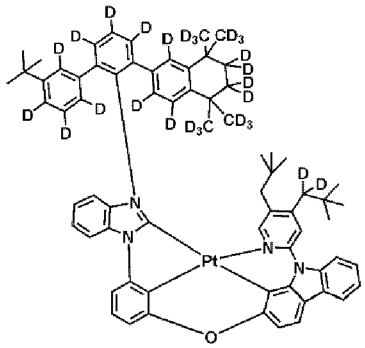

255

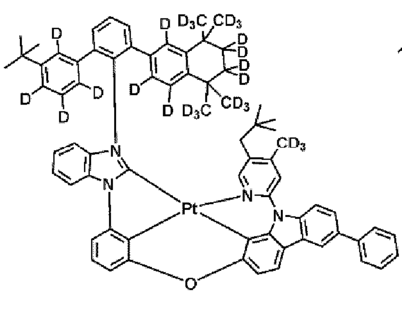

256

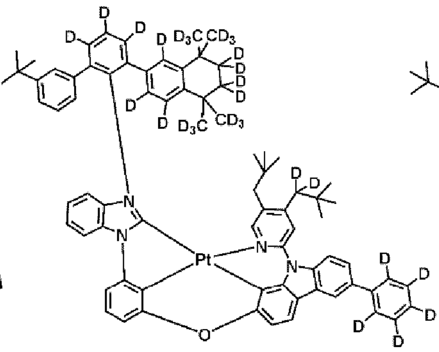

257

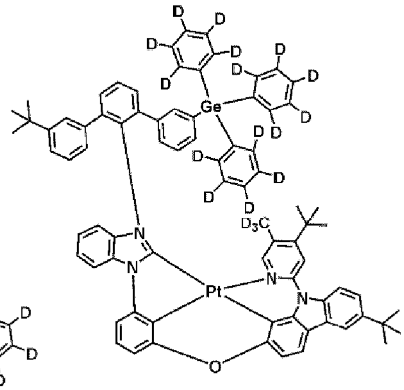

258

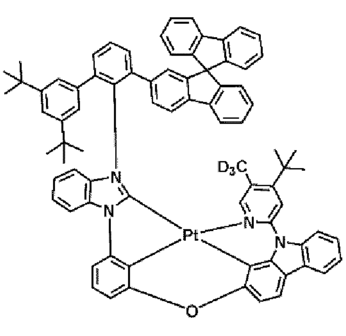

259

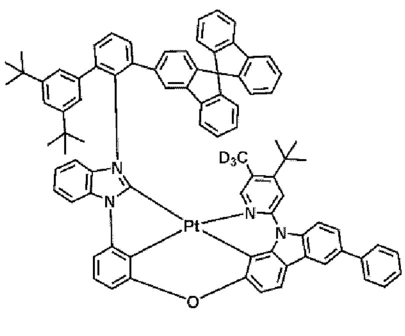

260

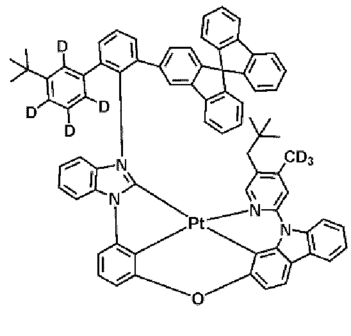

261

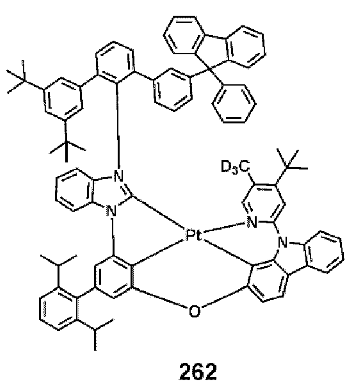

262

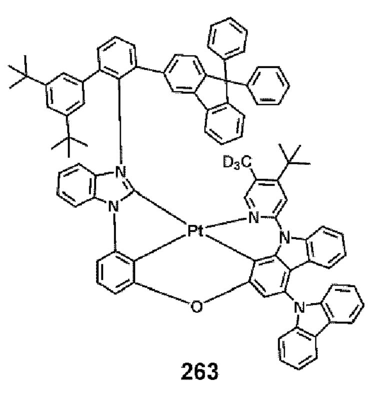

263

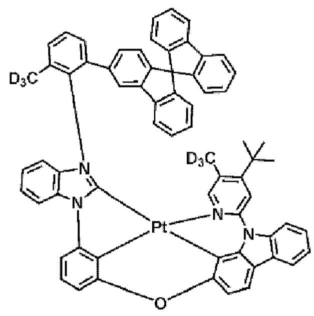

264

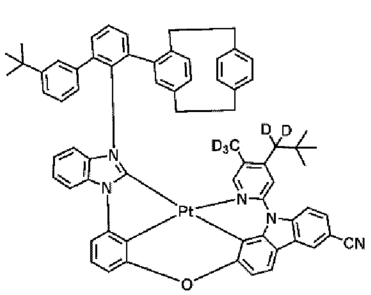

265

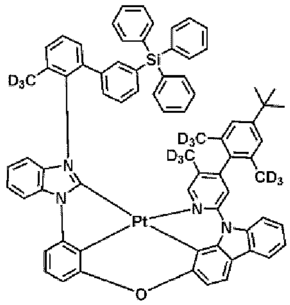

266

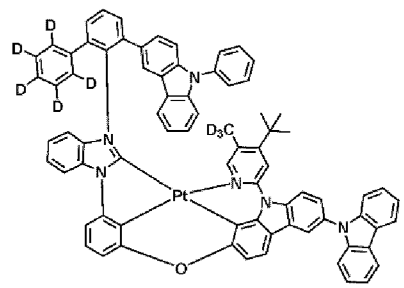

267

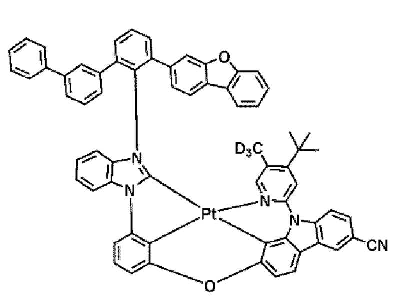

268

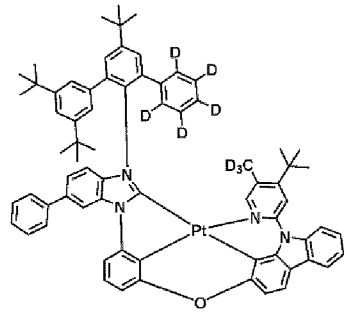

269

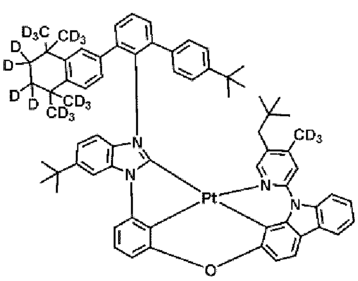

270

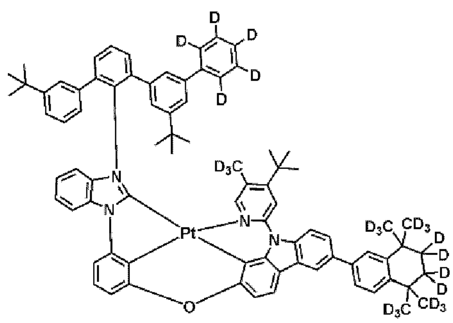

271

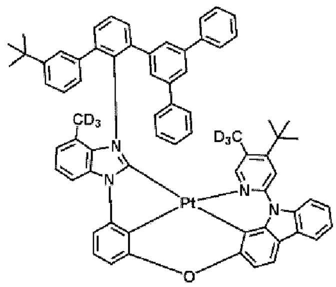

272

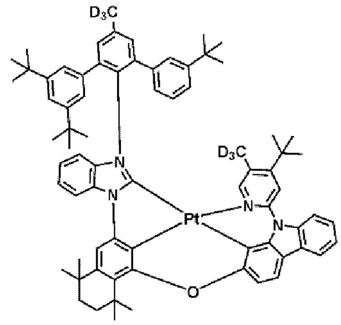

273

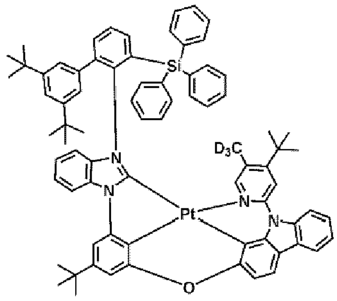

274

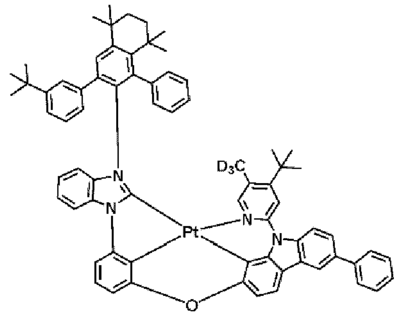

275

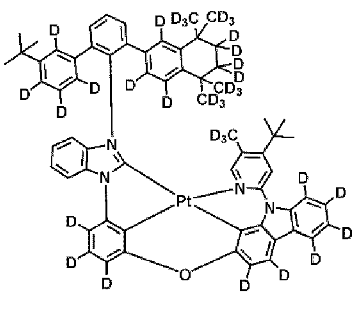

276

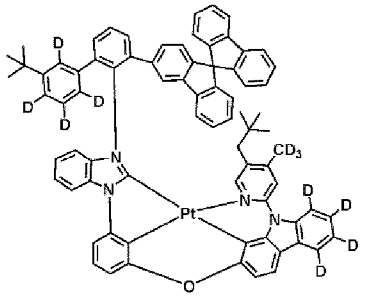

**277**

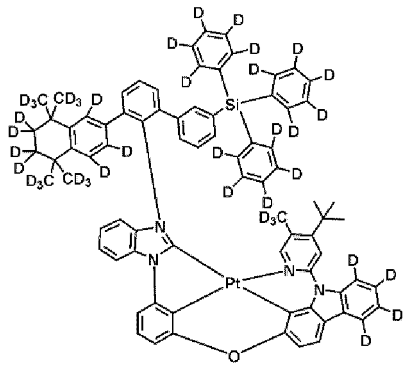

**278**

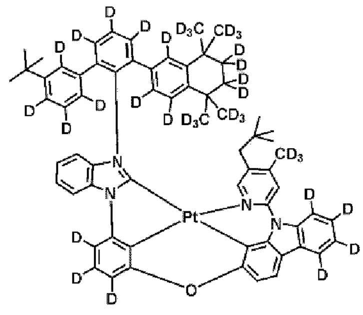

**279**

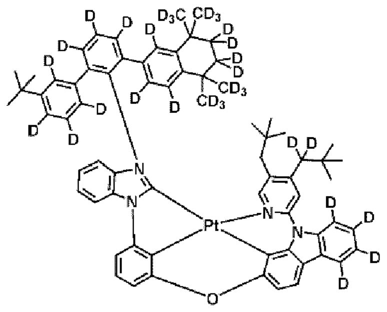

**280**

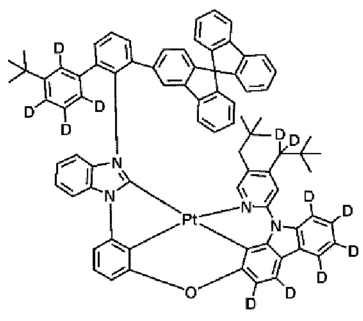

**281**

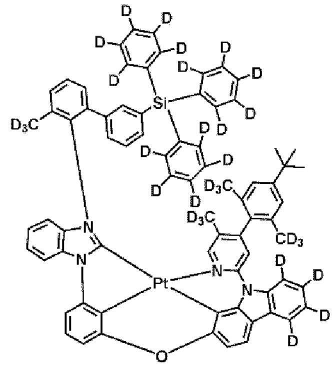

**282**

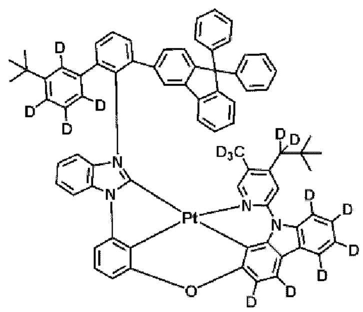

**283**

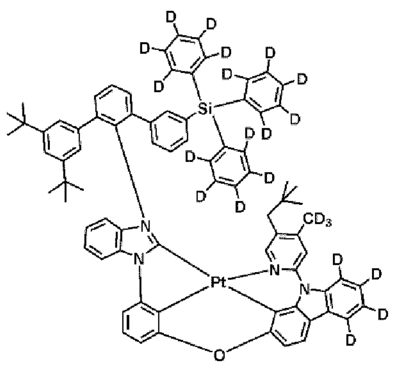

**284**

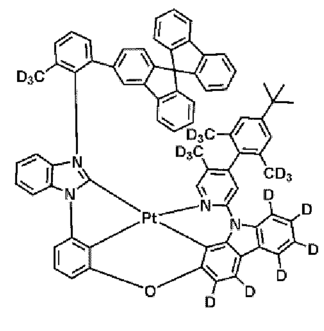

**285**

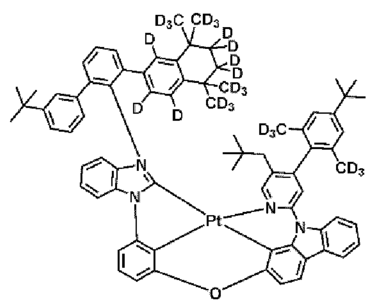

**286**

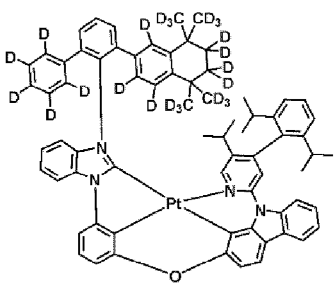

**287**

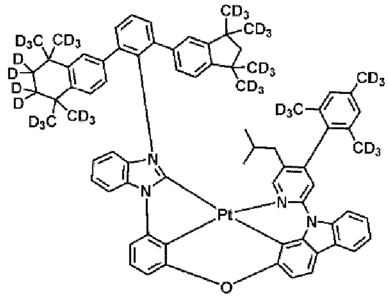

**288**

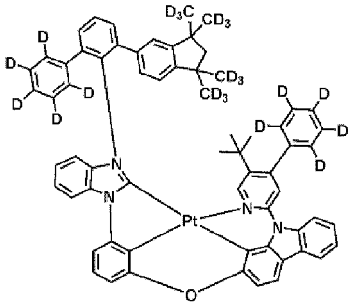

**289**

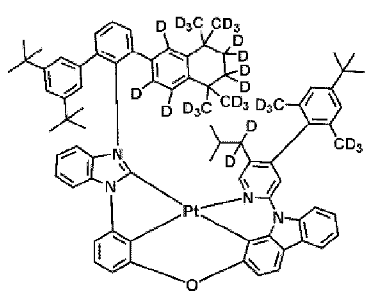

**290**

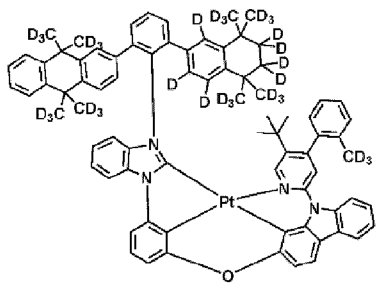

**291**

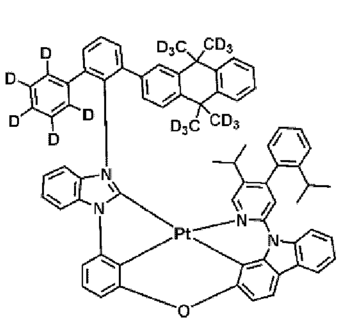

**292**

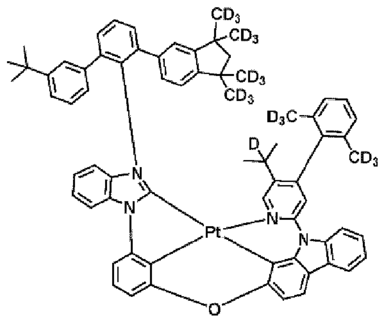

**293**

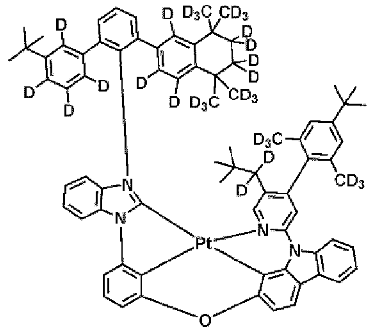

**294**

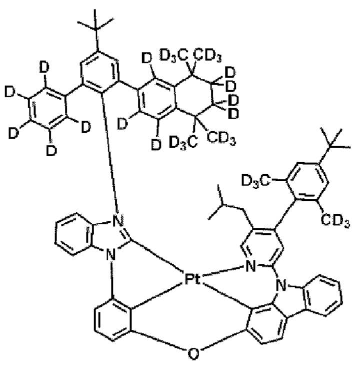

**295**

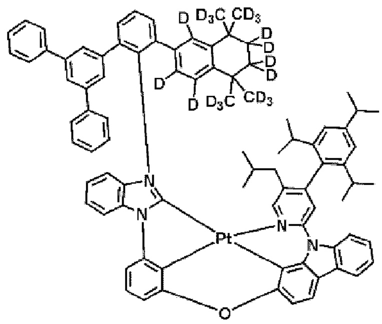

**296**

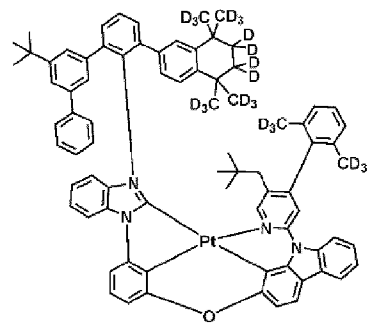

**297**

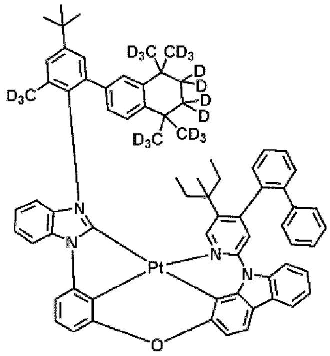

**298**

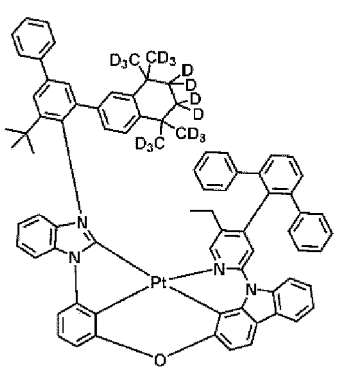

**299**

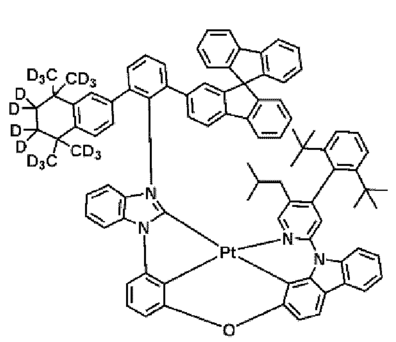

**300**

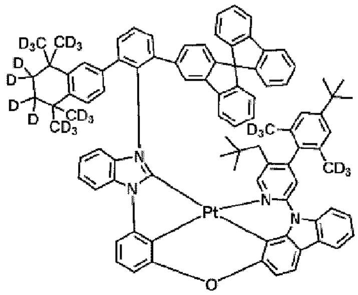

301

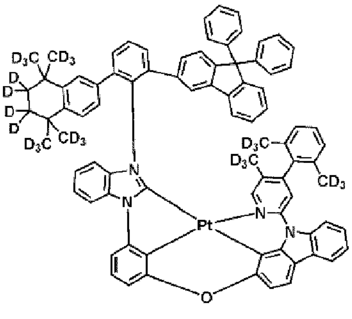

302

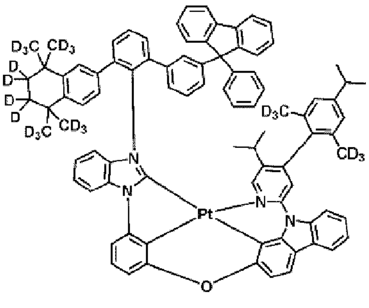

303

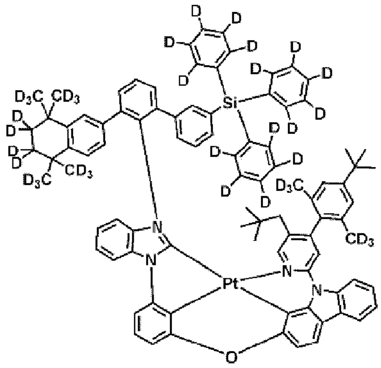

304

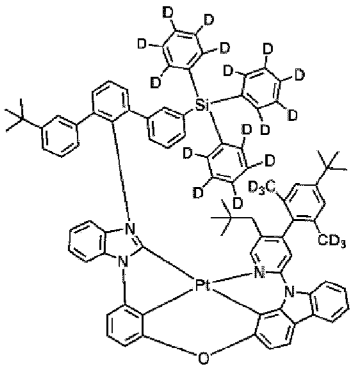

305

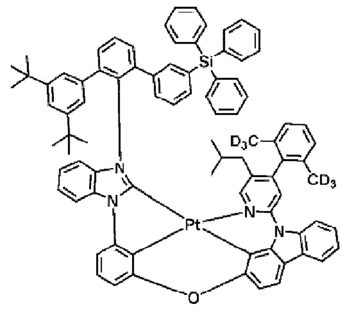

306

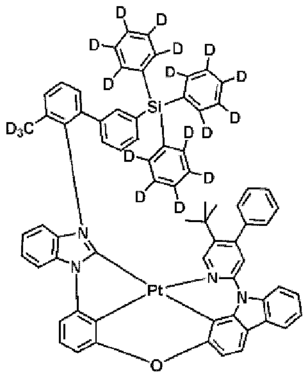

307

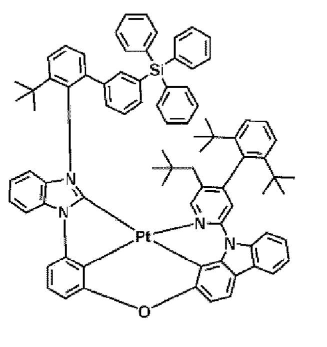

308

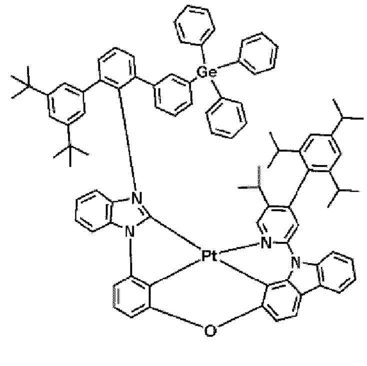

309

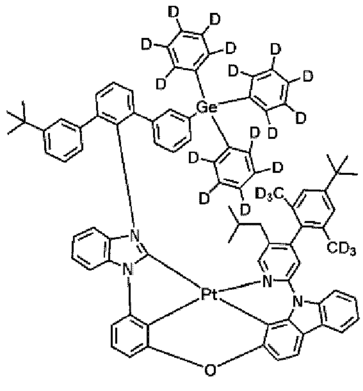

310

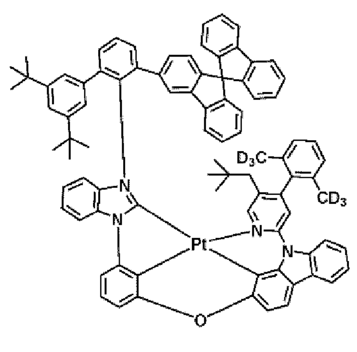

311

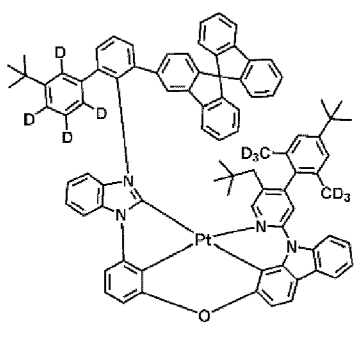

312

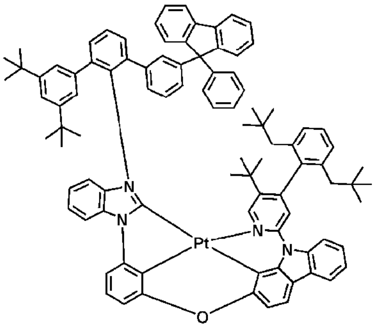

313

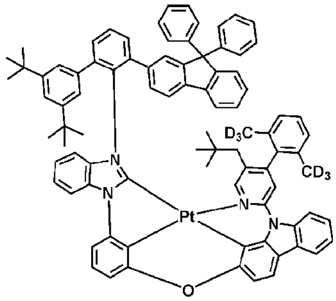

314

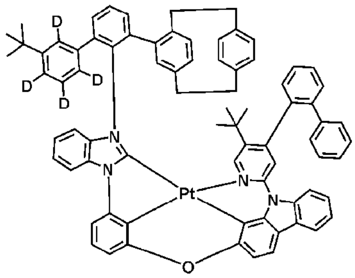

315

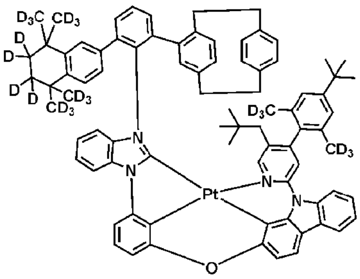

316

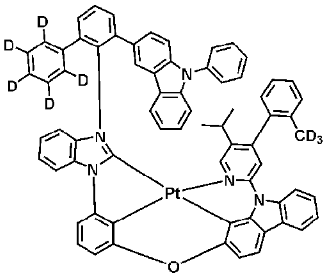

317

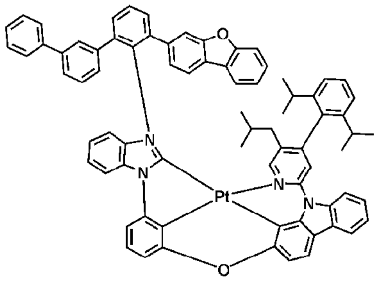

318

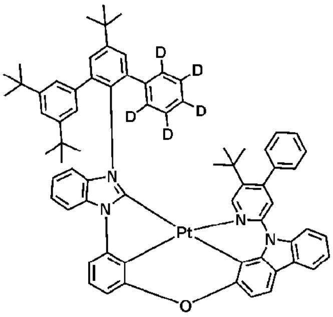

319

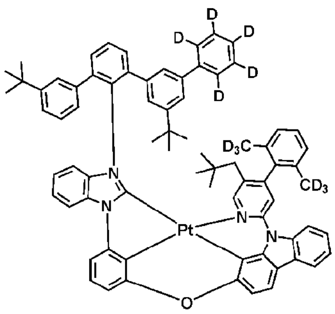

320

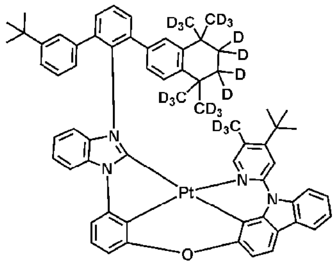

321

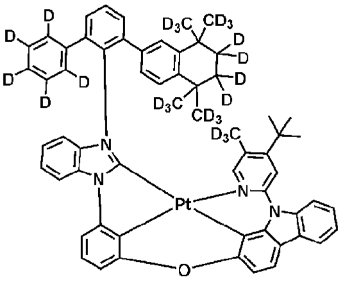

322

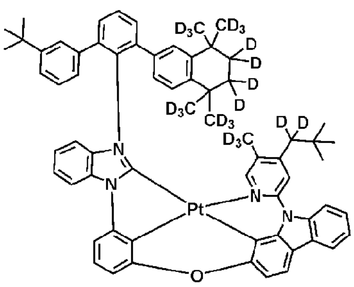

323

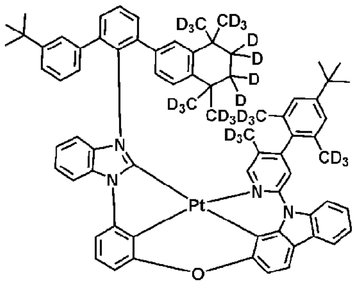

324

.

**9.** An organic light-emitting device comprising:

a first electrode;
a second electrode; and

an organic layer arranged between the first electrode and the second electrode,
wherein
wherein the organic layer comprises the organometallic compound of any of claims 1-8;
preferably wherein
the organic layer comprises an emission layer, and
the emission layer comprises the organometallic compound.

**10.** The organic light-emitting device of claim 9, wherein the emission layer emits light having a maximum emission wavelength in a range of 400 nm to 490 nm.

**11.** The organic light-emitting device of claims 9 or 10, wherein

the emission layer comprises a host and an emitter, and
the emitter includes the organometallic compound.

**12.** The organic light-emitting device of claims 9 or 10, wherein

the emission layer comprises a host, a sensitizer, and an emitter, and
the sensitizer includes the organometallic compound;
preferably wherein the host comprises a hole-transporting host, an electron-transporting host, a bipolar host, or a combination thereof.

**13.** The organic light-emitting device of claim 12, wherein the emitter is a metal-free organic compound; and/or wherein the host and the sensitizer do not substantially emit light, and the emitter emits light.

**14.** The organic light-emitting device of any of claims 9-13, wherein

the organic layer includes a hole transport region arranged between the first electrode and the emission layer and an electron transport region arranged between the emission layer and the second electrode,
the hole transport region comprises at least one of a hole injection layer, a hole transport layer, an electron blocking layer, or a combination thereof,
the electron transport region comprises at least one of a hole blocking layer, an electron transport layer, an electron injection layer or a combination thereof, and
at least one of the hole transport region and the electron transport region comprises the organometallic compound.

**15.** An electronic apparatus comprising the organic light-emitting device of any of claims 9-14.

FIG. 1

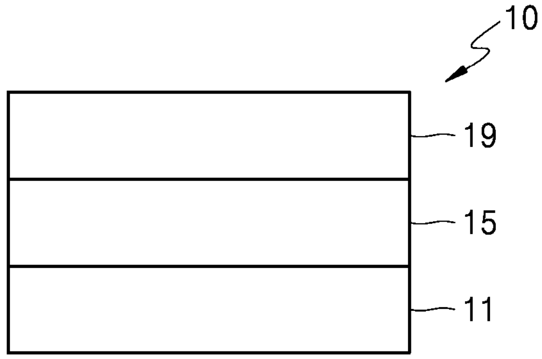
10
19
15
11

FIG. 2

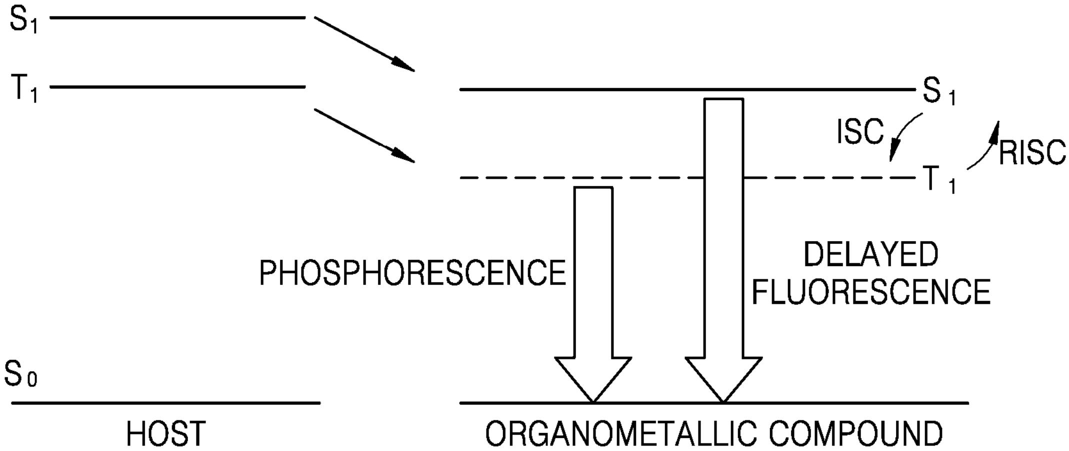
S1
T1
S1
ISC
RISC
T1
PHOSPHORESCENCE
DELAYED
FLUORESCENCE
S0
HOST
ORGANOMETALLIC COMPOUND

FIG. 3

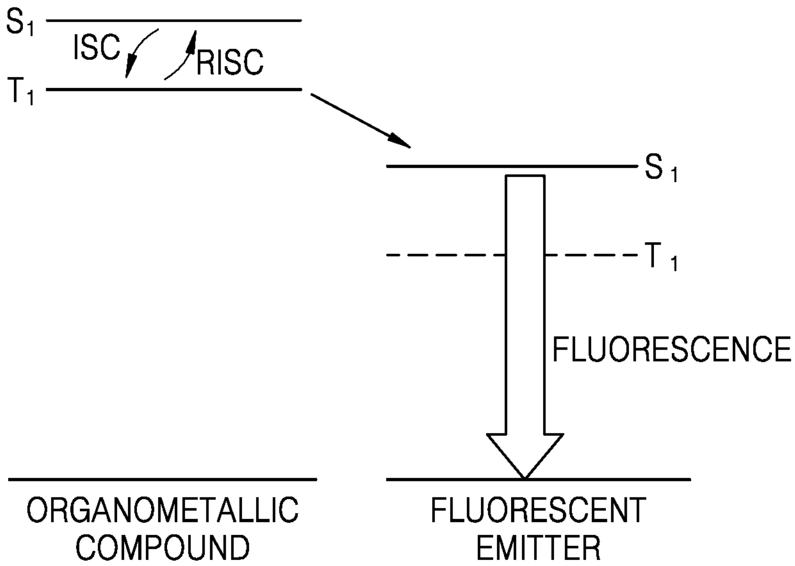
S1
ISC
RISC
T1
S1
T1
FLUORESCENCE
ORGANOMETALLIC COMPOUND
FLUORESCENT EMITTER

FIG. 4

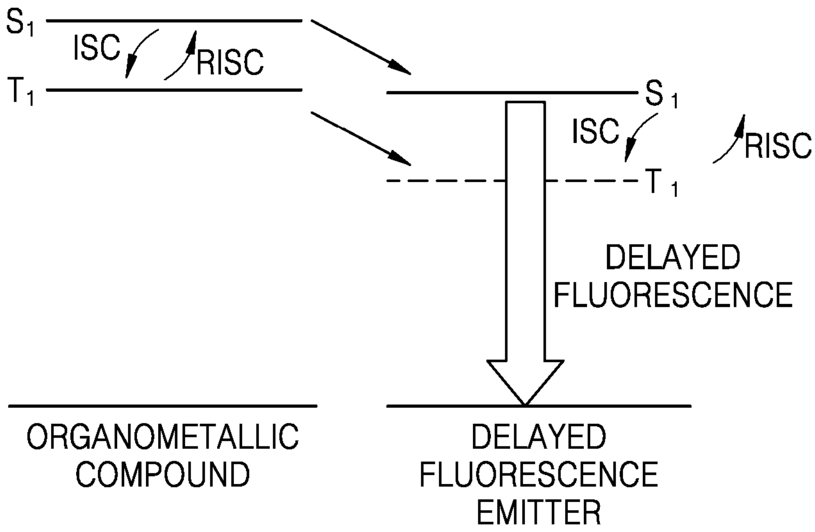
S1
ISC
RISC
T1
S1
ISC
RISC
T1
DELAYED FLUORESCENCE
ORGANOMETALLIC COMPOUND
DELAYED FLUORESCENCE EMITTER